# EUROPEAN PATENT SPECIFICATION

(11) **EP 4 545 541 B1**
(45) Date of publication and mention of the grant of the patent: **18.02.2026**
(21) Application number: 23849121.1
(22) Date of filing: 30.06.2023
(51) Int. Cl.: C09K 11/06, C07F 15/00, H10K 50/11, H10K 85/30, H10K 101/10

(54) **CIRCULARLY POLARIZED LIGHT-EMITTING MATERIAL AND USE, LIGHT-EMITTING DISPLAY DEVICE, AND DISPLAY APPARATUS**
ZIRKULAR POLARISIERTES LICHTEMITTIERENDES MATERIAL UND VERWENDUNG, LICHTEMITTIERENDE ANZEIGEVORRICHTUNG UND ANZEIGEVORRICHTUNG
MATÉRIAU ÉLECTROLUMINESCENT À POLARISATION CIRCULAIRE ET UTILISATION, DISPOSITIF D'AFFICHAGE ÉLECTROLUMINESCENT ET APPAREIL D'AFFICHAGE

(30) Priority: 01.08.2022 CN 202210913851
(43) Date of publication of application: 30.04.2025
(73) Proprietor: Zhejiang University of Technology, Hangzhou, Zhejiang 310014 (CN); Zhejiang Huaxian Photoelectricity Technology Co., Ltd, Jiaxing, Zhejiang 314107 (CN)
(72) Inventor: LI, Guijie, Hangzhou, Zhejiang 310014 (CN); SUN, Yulu, Hangzhou, Zhejiang 310014 (CN); SHE, Yuanbin, Hangzhou, Zhejiang 310014 (CN); ZHAO, Xiaoyu, Jiaxing, Zhejiang 314107 (CN)
(74) Representative: Chung, Hoi Kan
(86) International application number: PCT/CN2023/104611
(87) International publication number: WO 2024/027411

(56) References cited:
- CN-A- 107 573 383
- CN-A- 113 717 232
- CN-A- 114 773 395
- CN-A- 114 773 395
- CN-A- 115 160 379
- US-A1- 2016 240 800
- ZHANG, HUAHONG; YANG, QIANYING; DIAO, ZIXUAN; ZHOU, ZONGMEI; XU, GUO: "Research Progress on Circular Polarized Phosphorescence Materials Based on Transition Metal Complexes", JOURNAL OF HAINAN NORMAL UNIVERSITY (NATURAL SCIENCE), vol. 33, no. 4, 31 December 2020 (2020-12-31), pages 391 - 402, 423, XP009552780, ISSN: 1674-4942, DOI: 10.12051/j.issn.1674-4942.2020.04.005

## Description

### TECHNICAL FIELD

The present invention relates to a circularly polarized light-emitting material and the use thereof, and more particularly to a central chiral-induced helical-chiral tetradentate cyclometalated platinum (II) and palladium (II) complex circularly polarized light-emitting material based on phenyl-benzimidazole and a derivative thereof, and a use.

### BACKGROUND

Circularly polarized luminescence (CPL) is a phenomenon in which levorotatory or dextrorotatory circularly polarized light is emitted from a chiral light-emitting material upon excitation, and therefore, the design development of a chiral light-emitting material is critical in this field. With the in-depth study of researchers, circularly polarized light-emitting materials have important applications in 3D display, data storage, quantum computing, optical anti-counterfeiting, biological imaging, and asymmetric synthesis.

Cyclometalated platinum (II) and palladium (II) complexes phosphorescent materials can make full use of all singlet and triplet excitons generated by electroexcitation due to their heavy atom effect, so the maximum theoretical quantum efficiency can be up to 100%, so such complexes are an ideal light-emitting material. Bidentate cyclometalated platinum (II) and palladium (II) complexes are less rigid. Due to the easy distortion and vibration of two bidentate ligands, the energy of excited state material molecules is dissipated in a non-radiative manner, resulting in a decrease in their luminescence quantum efficiency (Inorg. Chem. 2002, 41, 3055). Although the cyclometalated platinum (II) and palladium (II) complexes based on tridentate ligands can improve the luminescence quantum efficiency due to their enhanced molecular rigidity (Inorg. Chem. 2010, 49, 11276), the second monodentate ligands (such as Cl⁻, phenoxy anion, alkyne anion, carbene, etc.) greatly decrease the chemical stability and thermal stability of the complexes, and it is difficult to purify the complexes by sublimation for the preparation of OLED devices. Therefore, both bidentate and tridentate ligand-based cyclometalated complex light-emitting materials are disadvantageous for their use in stable and efficient OLED devices. The central metal ions of divalent cyclometalated platinum (II) and palladium (II) complexes are both dsp² hybridized and easily coordinate with tetradentate ligands to form stable and rigid planar quadrilateral molecules. The high molecular rigidity suppresses nonradiative relaxation due to molecular vibration and rotation, reduces the energy loss of excited state material molecules, and thus facilitates the improvement of the luminescence quantum efficiency of material molecules. Due to the steric hindrance of the two terminal aryl groups of the tetradentate ligand of the cyclometalated platinum (II) and palladium (II) complexes, the material molecules present a distorted quadrilateral configuration (Chem. Mater. 2020, 32, 537), which theoretically has the property of helical-chirality. However, the molecules are easily racemized by the up-down vibration of the two terminal aryl groups of the ligand in solution or during heating sublimation, and the enantiomers cannot be separated. It is very difficult to obtain optically pure cyclometalated platinum (II) and palladium (II) complexes that do not have the property of circularly polarized luminescence. Therefore, how to design and develop optically pure cyclometalated platinum (II) and palladium (II) complex materials with high chemical and thermal stability and circular polarization luminescence properties is of great significance and practical value for their applications in circular polarization luminescence OLED devices (CP-OLED) and is also an urgent problem to be solved in the field of CP-OLED.

### SUMMARY

It is an object of the present invention to provide a central chiral-induced helical-chiral tetradentate cyclometalated platinum (II) and palladium (II) complex circularly polarized light-emitting material and a use thereof in view of the lack of development of the current circularly polarized light-emitting material. The helical-chiral metal complex molecule can, by means of a central chiral segment L^{a} in a tetradentate ligand, autonomously induce the whole tetradentate ligand to coordinate with metal ions in a small steric hindrance manner to form an optically pure helical-chiral metal complex circularly polarized light-emitting material that does not require chiral resolution, has high chemical stability and thermal stability. This material has important applications in circularly polarized light-emitting elements.

The object of the present invention is achieved by the following technical solution:

A central chiral-induced helical-chiral tetradentate cyclometalated platinum (II) and palladium (II) complex circularly polarized light-emitting material based on phenyl-benzimidazole and a derivative thereof, characterized in that it has chemical formulas as shown in general formulas (1), (1'), (2), and (2'), where (1) and (1'), (2) and (2') are enantiomers of each other: 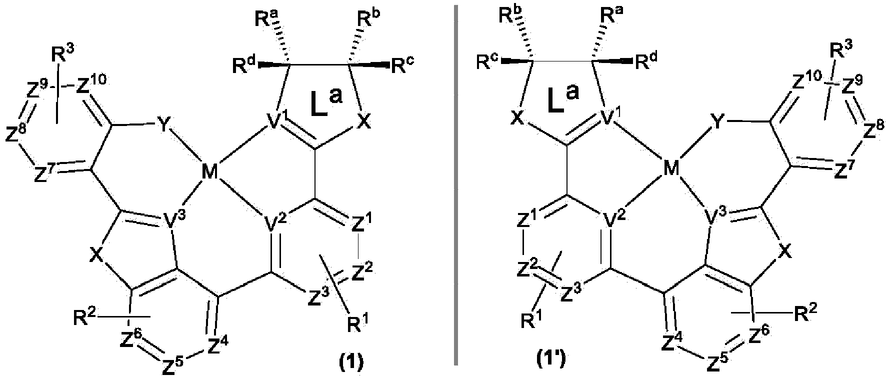 or 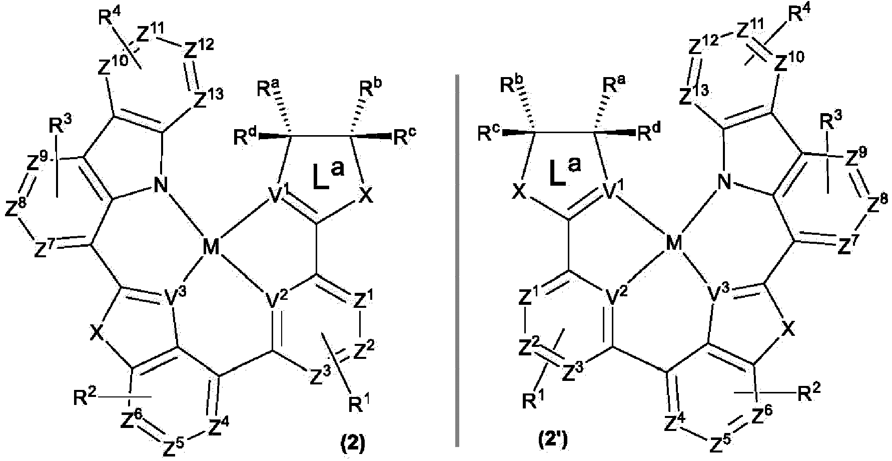
wherein M is Pt or Pd; V¹, V², and V³ are each independently N or C;
L^{a} is a five-membered central chiral carbocyclic or heterocyclic ring;
X is O, S, CR^{x}R^{y}, C = O, SiR^{x}R^{y}, GeR^{x}R^{y}, NR^{z}, PR^{z}, R^{z}P = O, AsR^{z}, R^{z}As = O, S = O, SO₂, Se, Se = O, SeO₂, BH, BR^{z}, R^{z}Bi = O, or BiR^{z};
Y is O, S;
Z¹, Z², Z³, Z⁴, Z⁵, Z⁶, Z⁷, Z⁸, Z⁹, Z¹⁰, Z¹¹, Z¹², and Z¹³ are each independently N or C;
R¹, R², R³, R⁴, R^{a}, R^{b}, R^{c}, and R^{d} each independently represent mono-, di-, tri-, tetra-substituted or unsubstituted, while R¹, R², R³, R⁴, R^{a}, R^{b}, R^{c}, and R^{d} are each independently hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, acylamino, alkoxycarbonylamino, aryloxycarbonylamino, sulfonylamino, sulfamoyl, carbamoyl, alkylthio, sulfinyl, ureido, phosphorylamino, imino, sulfo, carboxy, hydrazino, substituted silyl, or a combination thereof, wherein R^{a} and R^{b} are different substituents in the same molecule; two or more adjacent R¹, R², R³, and R⁴ are optionally linkable to form a fused ring; any two of R^{a}, R^{b}, R^{c}, and R^{d} are linkable to form a cyclic system.

Further, the central chiral-induced helical-chiral tetradentate cyclometalated platinum (II) and palladium (II) complex circularly polarized light-emitting material having general formulas (1), (1'), (2), and (2') described above, preferably has following general formulas (1-A) and (2-A) and their enantiomers (1'-A) and (2'-A): 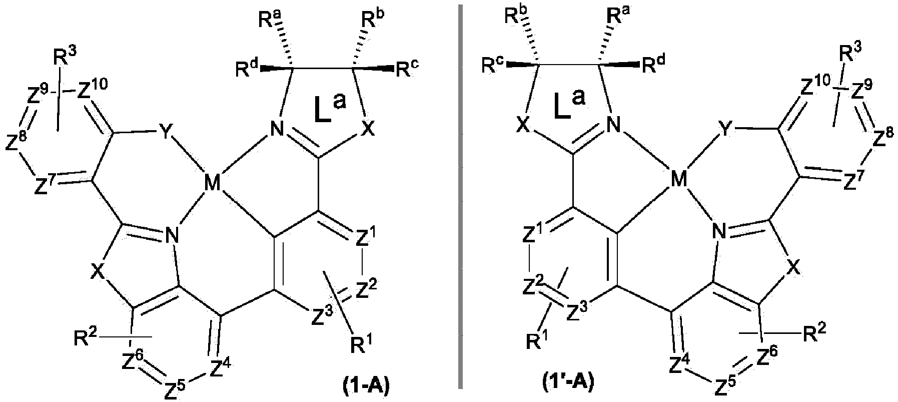 or 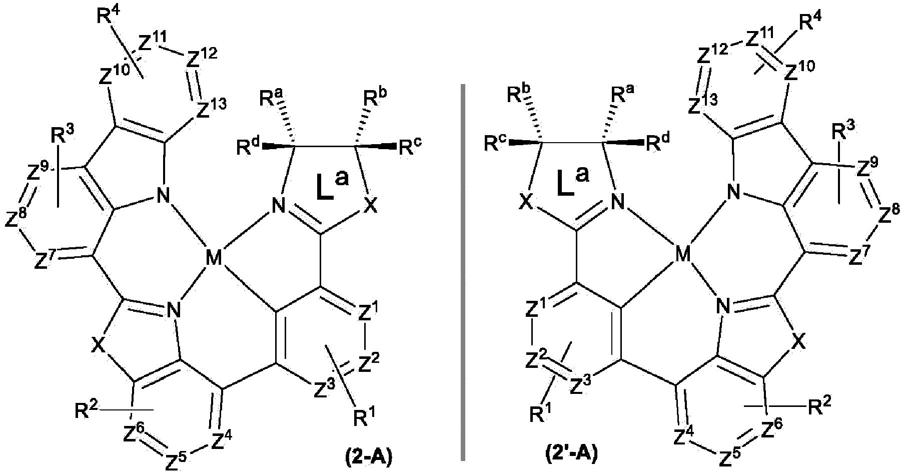
wherein M is Pt or Pd;
L^{a} is a five-membered central chiral carbocyclic or heterocyclic ring;
X is O, S, CR^{x}R^{y}, C = O, SiR^{×}R^{y}, GeR^{x}R^{y}, NR^{z}, PR^{z}, R^{z}P = O, AsR^{z}, R^{z}As = O, S = O, SO₂, Se, Se = O, SeO₂, BH, BR^{z}, R^{z}Bi = O, or BiR^{z};
Y is O, S;
Z¹, Z², Z³, Z⁴, Z⁵, Z⁶, Z⁷, Z⁸, Z⁹, Z¹⁰, Z¹¹, Z¹², and Z¹³ are each independently N or C;
R¹, R², R³, R⁴, R^{a}, R^{b}, R^{c}, and R^{d} each independently represent mono-, di-, tri-, tetra-substituted or unsubstituted, while R¹, R², R³, R⁴, R^{a}, R^{b}, R^{c}, and R^{d} are each independently hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, acylamino, alkoxycarbonylamino, aryloxycarbonylamino, sulfonylamino, sulfamoyl, carbamoyl, alkylthio, sulfinyl, ureido, phosphorylamino, imino, sulfo, carboxy, hydrazino, substituted silyl, or a combination thereof, wherein R^{a} and R^{b} are different substituents in the same molecule; two or more adjacent R¹, R², R³, and R⁴ are optionally linkable to form a fused ring; any two of R^{a}, R^{b}, R^{c}, and R^{d} are linkable to form a cyclic system.

Further, the central chiral-induced helical-chiral tetradentate cyclometalated platinum (II) and palladium (II) complex circularly polarized light-emitting material described above, having a general structure preferably selected from, but not limited thereto, a group consisting of: 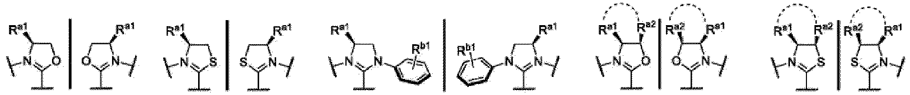 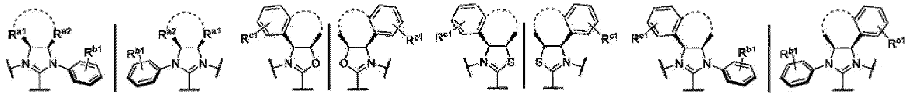 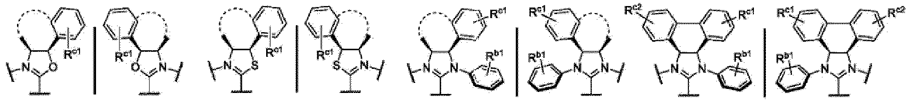 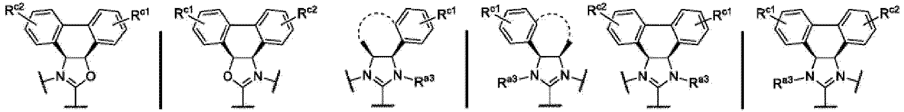
wherein R^{a1}, R^{a2}, and R^{a3} each independently represent hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, amido, alkoxycarbonylamino, aryloxycarbonylamino, sulfonylamino, sulfamoyl, carbamoyl, alkylthio, sulfinyl, ureido, phosphoryl amino, imino, sulfo, carboxy, hydrazino, substituted silyl, or combinations thereof;
wherein R^{b1}, R^{c1}, and R^{c2} each independently represent mono-, di-, tri-, tetra-substituted or unsubstituted, while R^{b1}, R^{c1}, and R^{c2} are each independently hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, amido, alkoxycarbonylamino, aryloxycarbonylamino, sulfonylamino, sulfamoyl, carbamoyl, alkylthio, sulfinyl, ureido, phosphoryl amino, imino, sulfo, carboxy, hydrazino, substituted silyl, or combinations thereof; two or more adjacent R^{b1}, R^{c1}, and R^{c2} are optionally linkable to form a fused ring.

Further, the above-mentioned central chiral segment L^{a} may further specifically have the following structure, but is not limited thereto:

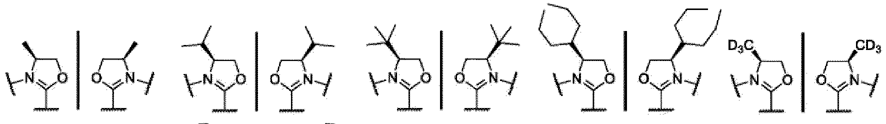

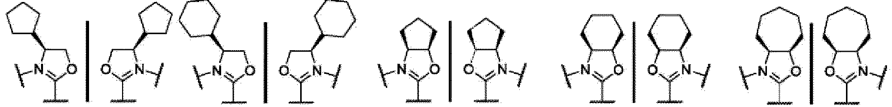

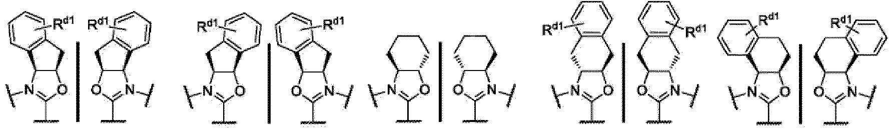

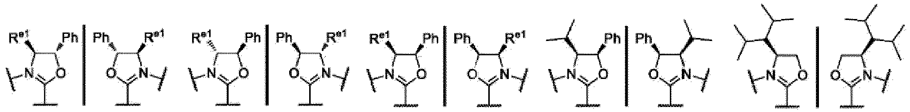

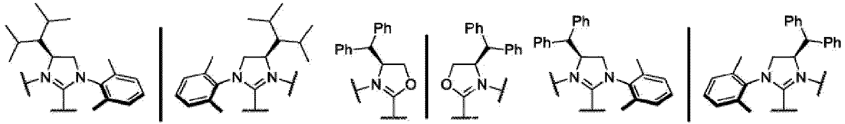

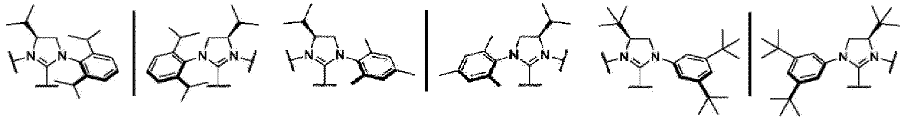

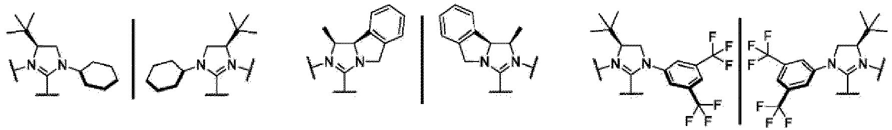

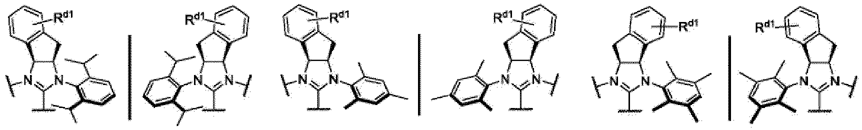

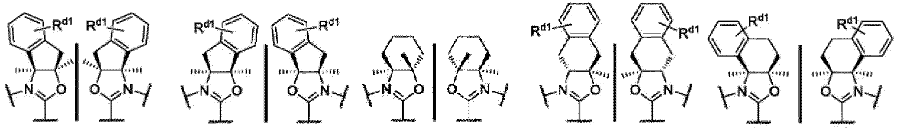

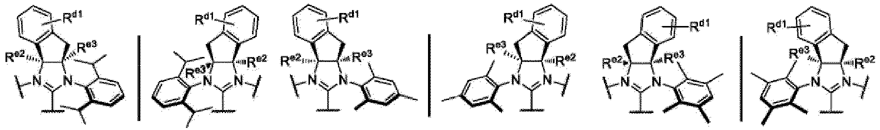

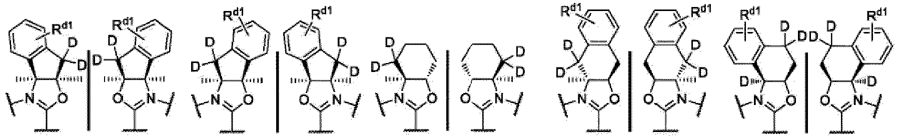

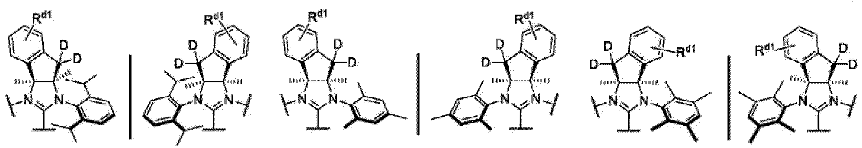

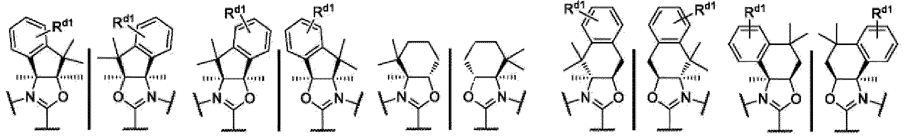

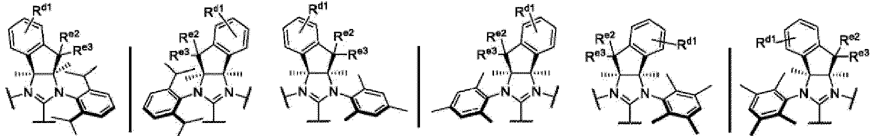

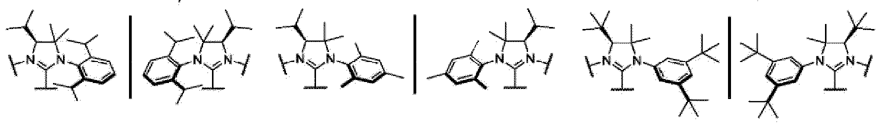

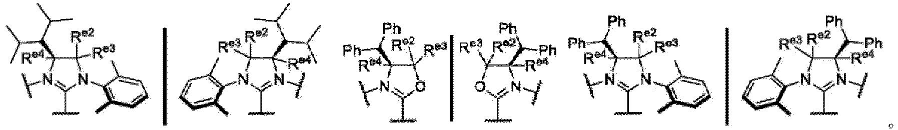

wherein R^{d1} represents mono-, di-, tri-, tetra-substituted or unsubstituted, while R^{b1} is independently hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, amido, alkoxycarbonylamino, aryloxycarbonylamino, sulfonylamino, sulfamoyl, carbamoyl, alkylthio, sulfinyl, ureido, phosphorylamino, imino, sulfo, carboxy, hydrazino, substituted silyl, or combinations thereof; two or more adjacent R^{d1} are optionally linkable to form a fused ring; R^{e1}, R^{e2}, R^{e3}, and R^{e4} are independently represent hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, amido, alkoxycarbonylamino, aryloxycarbonylamino, sulfonylamino, sulfamoyl, carbamoyl, alkylthio, sulfinyl, ureido, phosphorylamino, imino, sulfo, carboxy, hydrazino, substituted silyl, or combinations thereof.

Further, the central chiral-induced helical-chiral tetradentate cyclometalated platinum (II) and palladium (II) complex circularly polarized light-emitting material described above has a structure preferably selected from the following structures and enantiomers thereof, but not limited thereto:

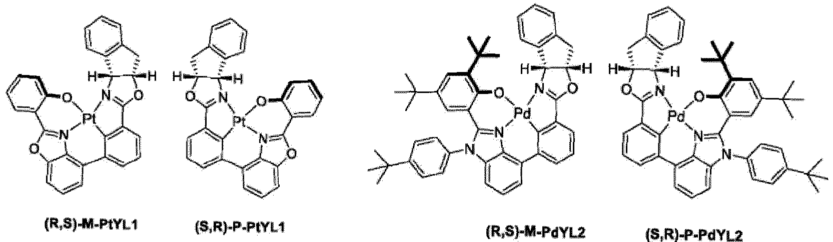

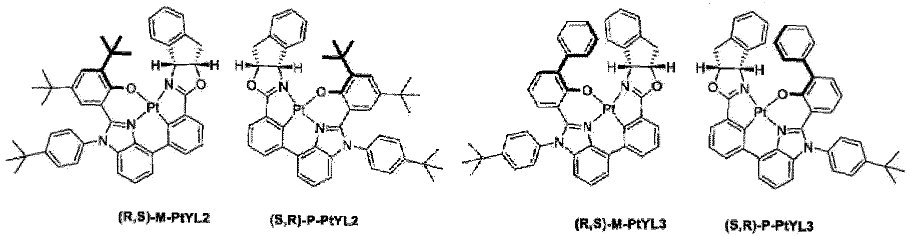

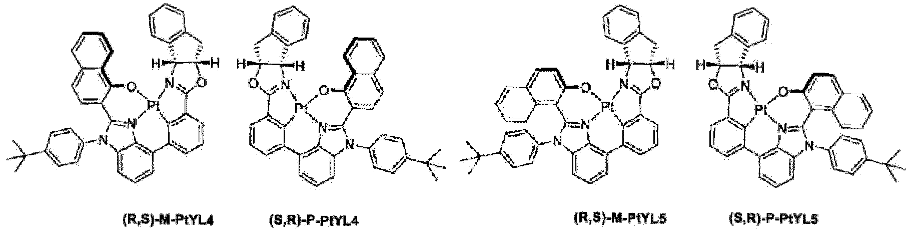

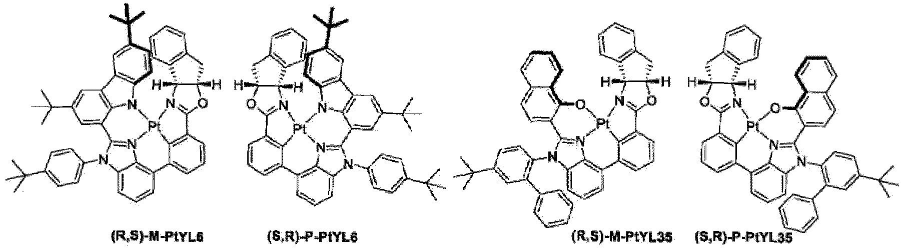

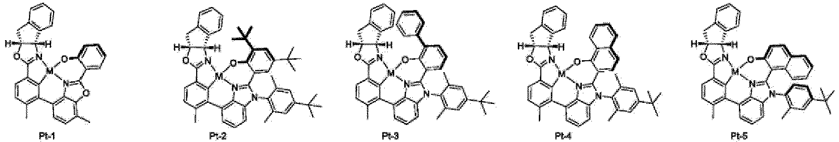

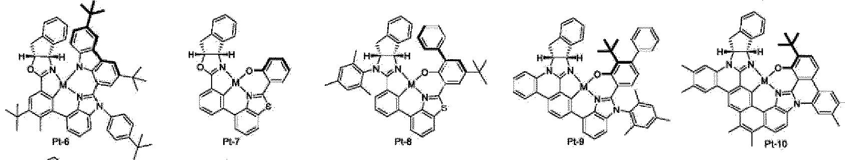

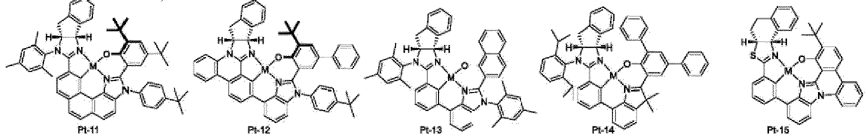

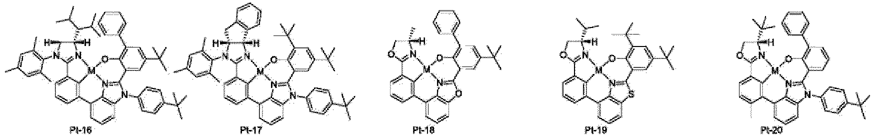

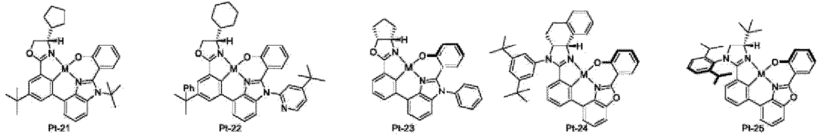

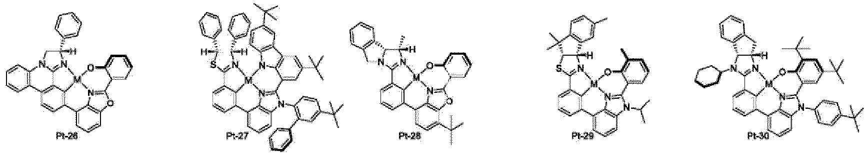

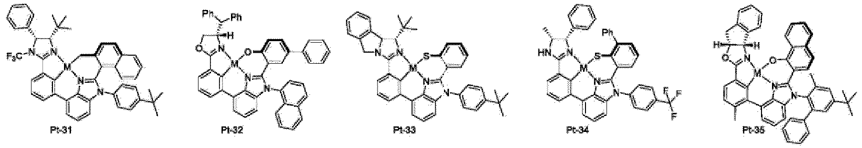

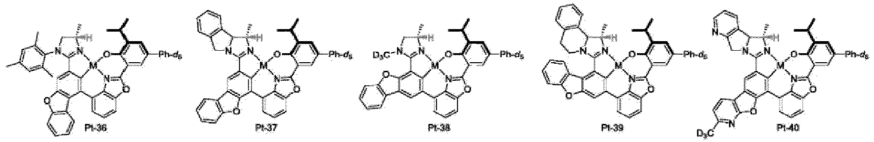

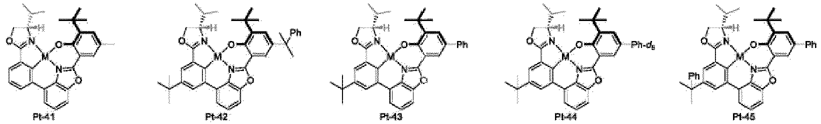

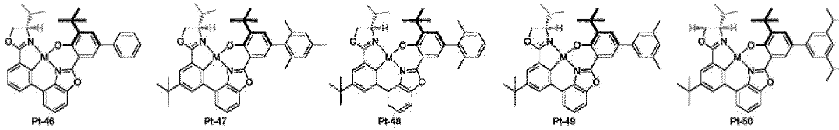

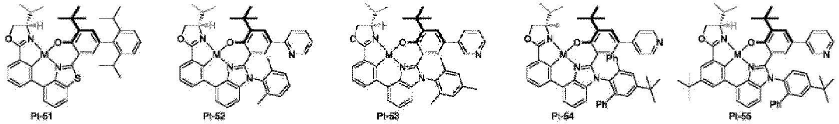

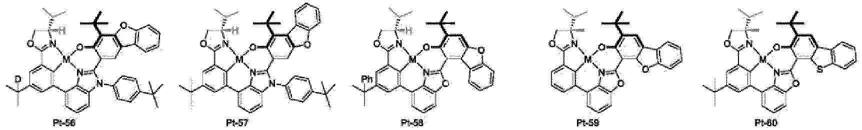

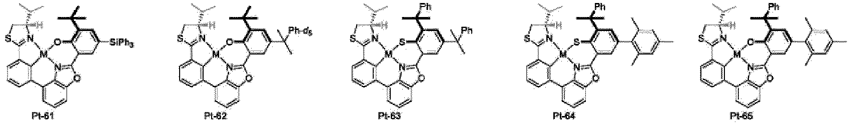

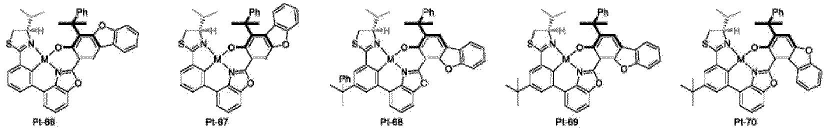

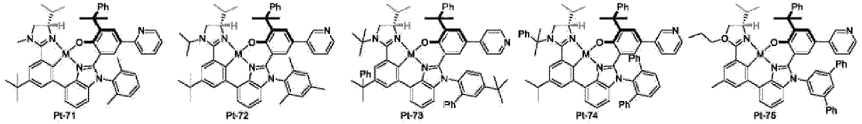

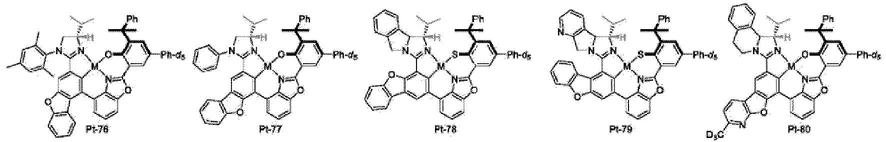

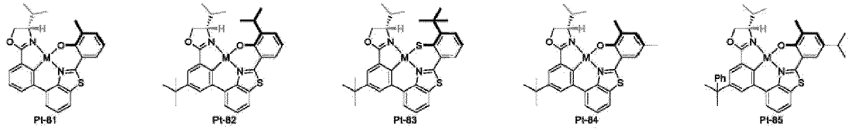

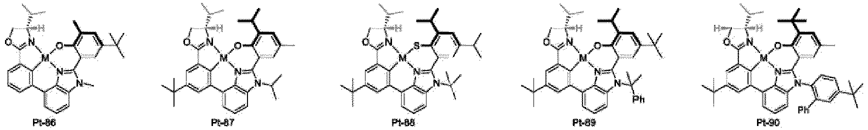

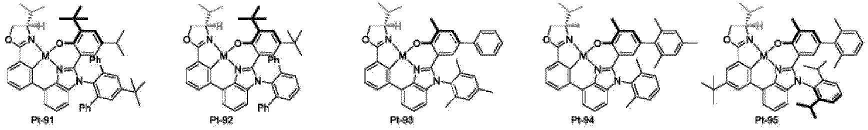

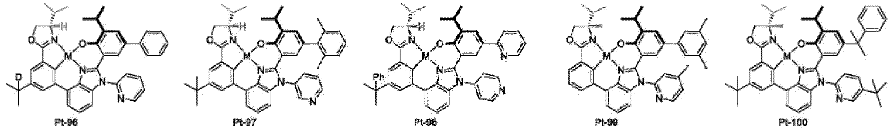

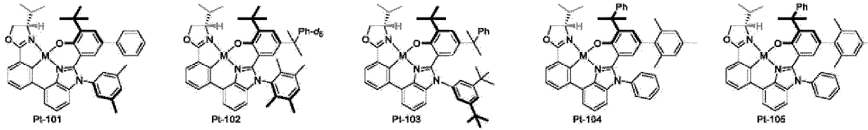

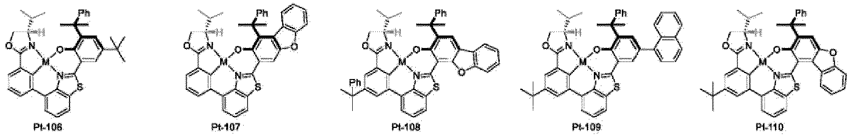

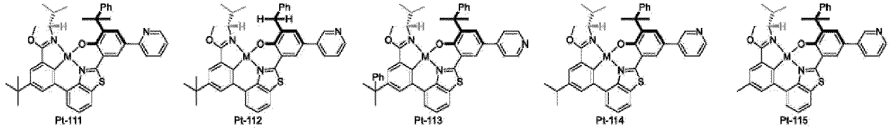

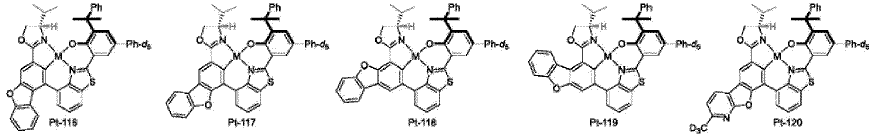

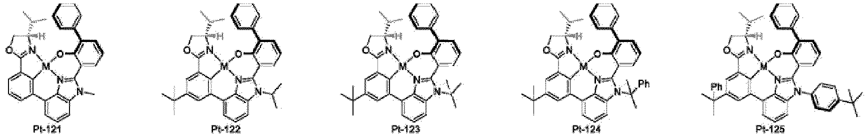

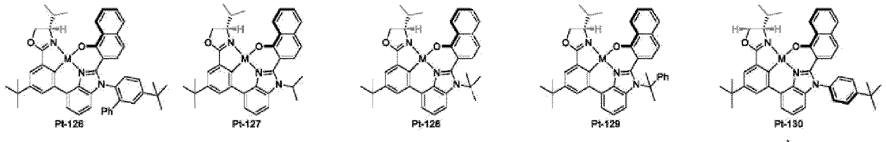

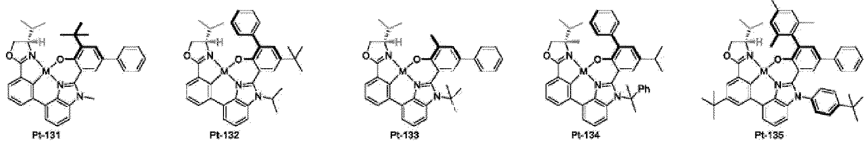

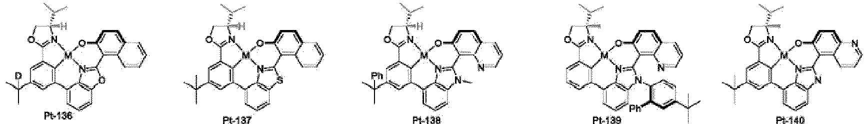

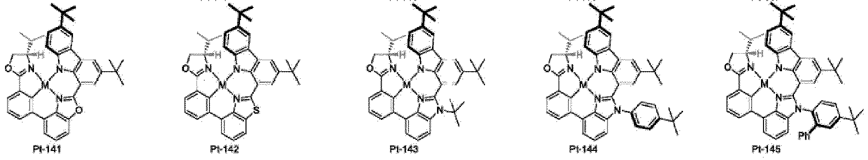

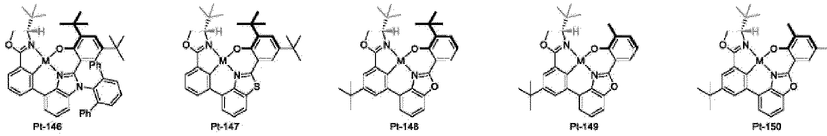

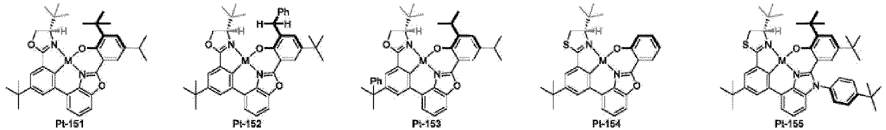

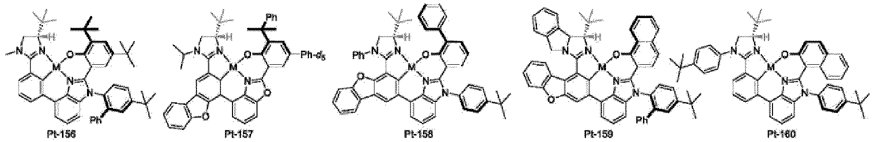

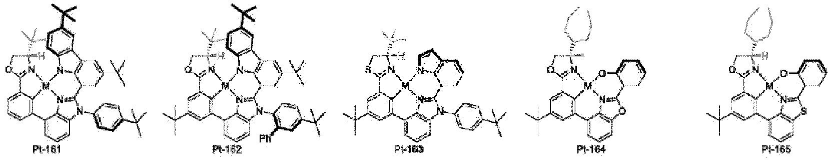

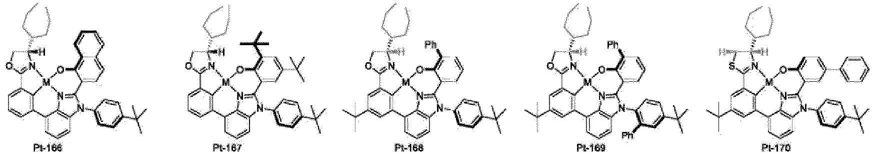

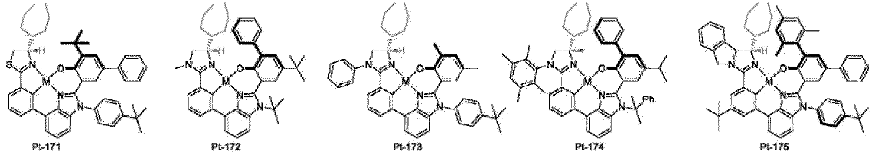

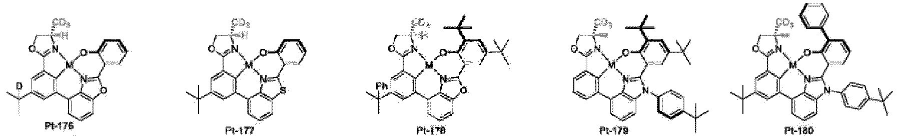

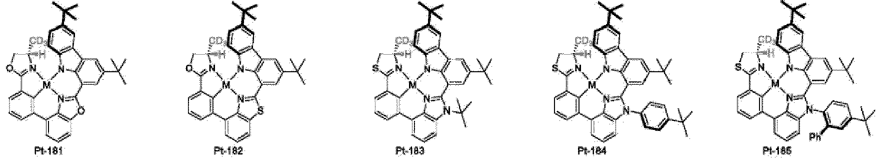

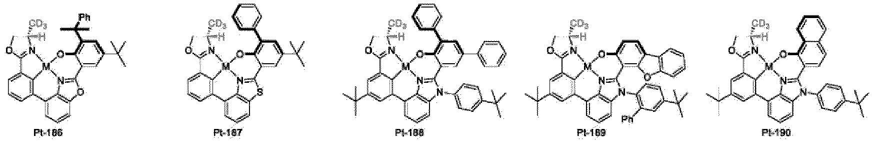

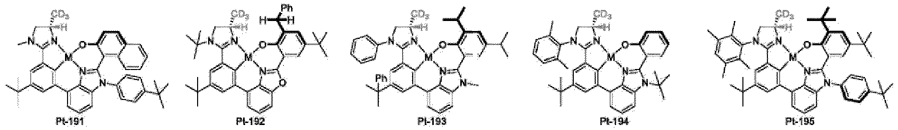

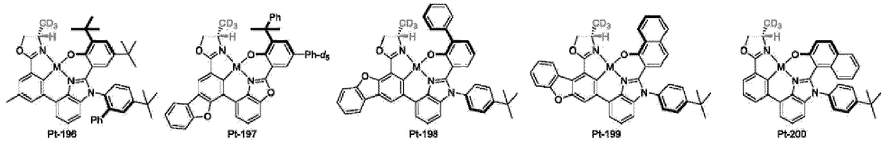

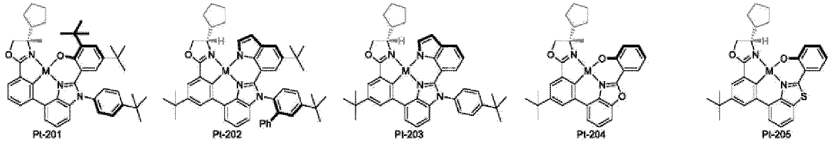

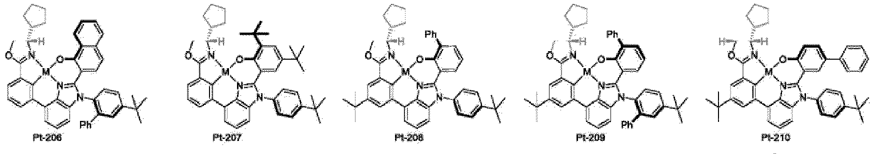

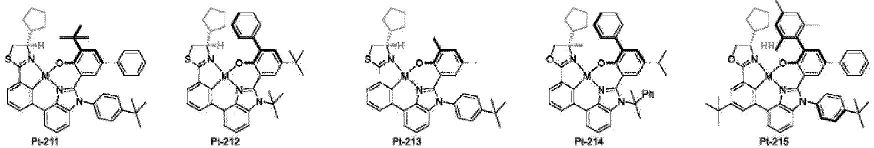

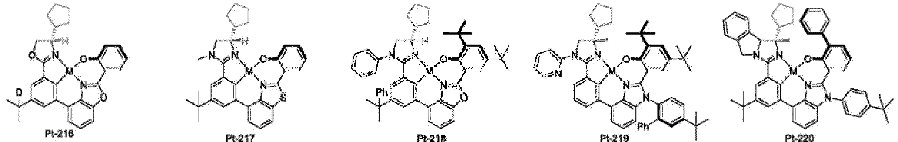

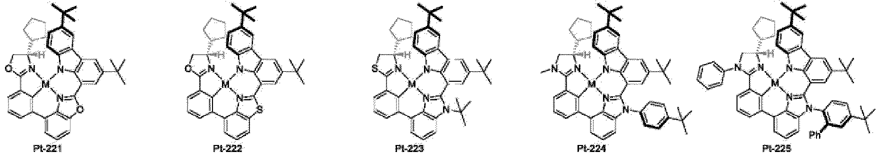

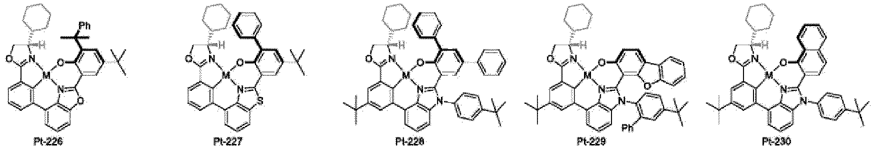

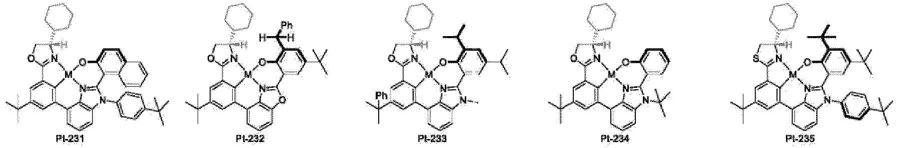

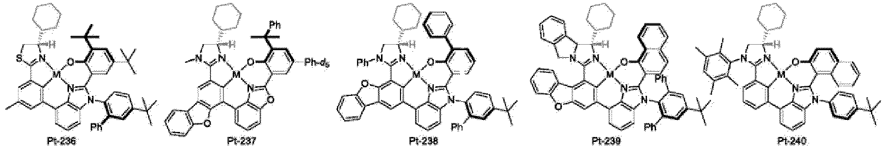

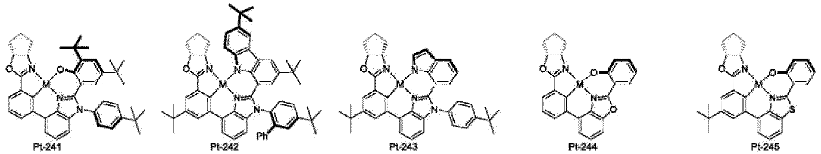

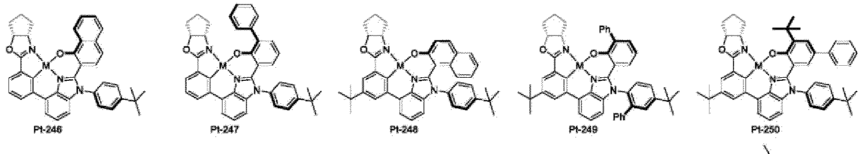

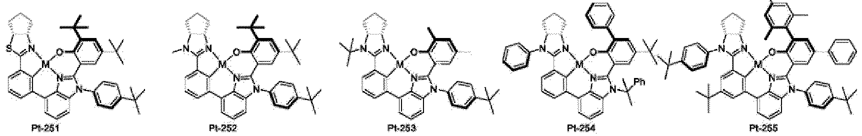

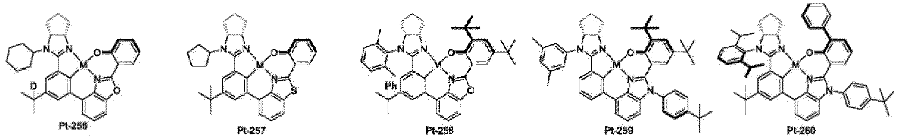

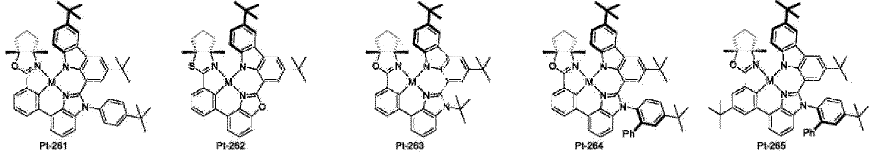

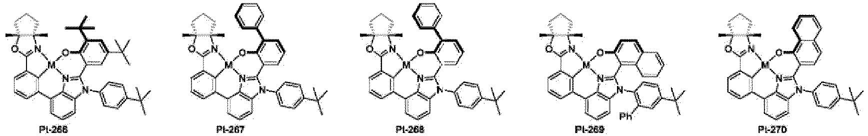

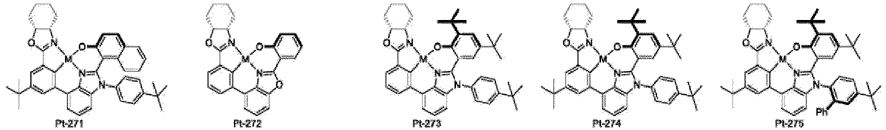

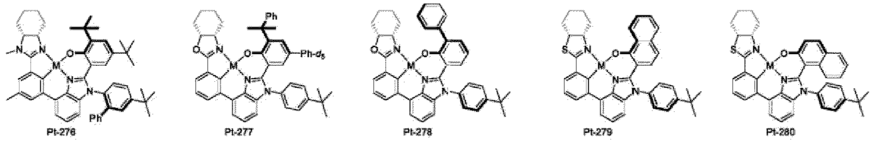

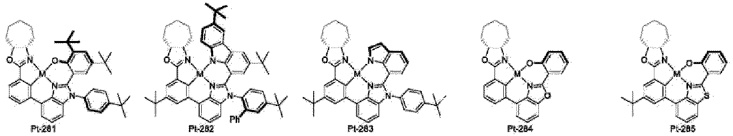

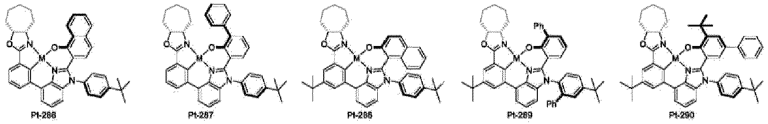

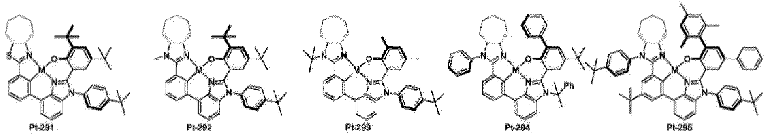

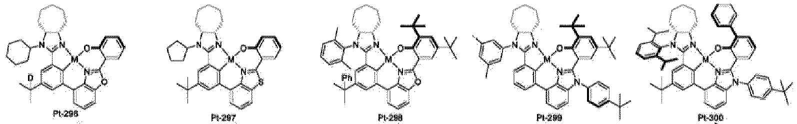

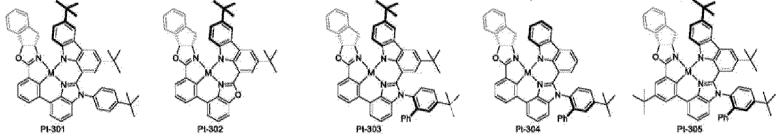

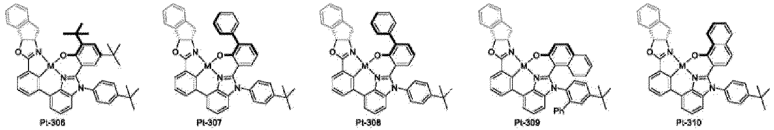

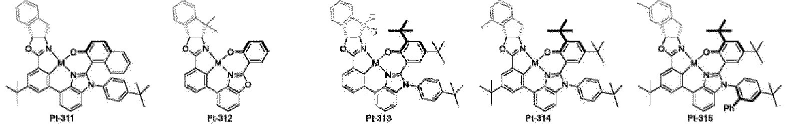

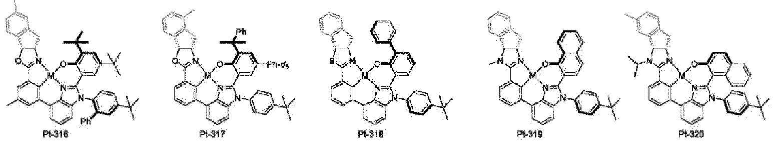

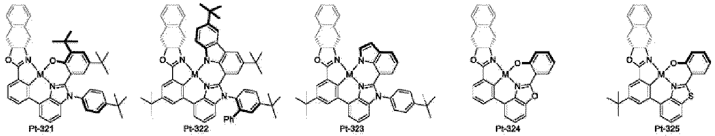

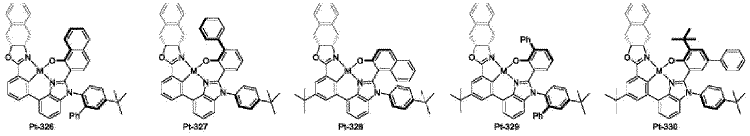

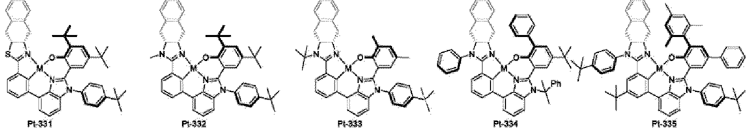

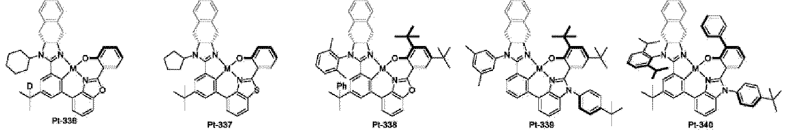

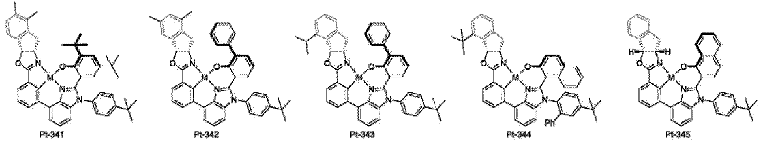

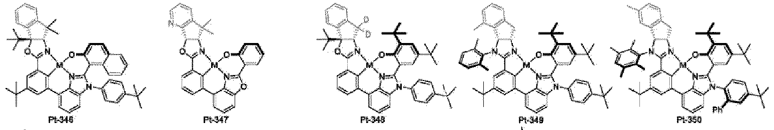

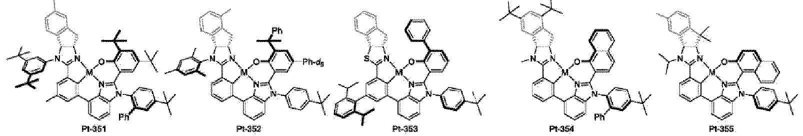

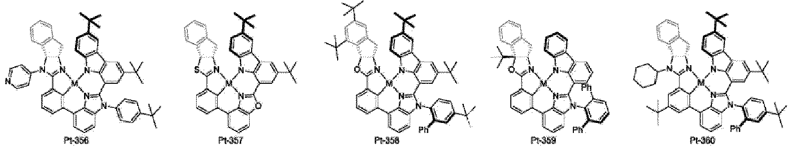

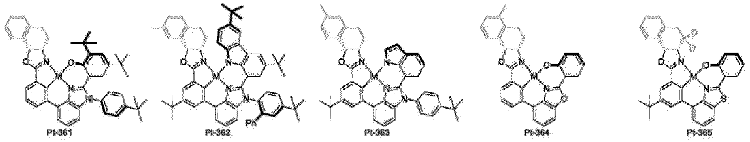

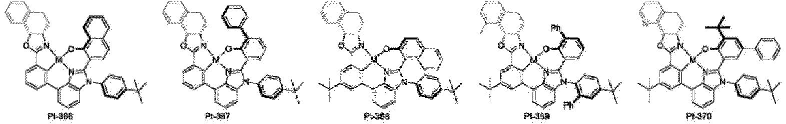

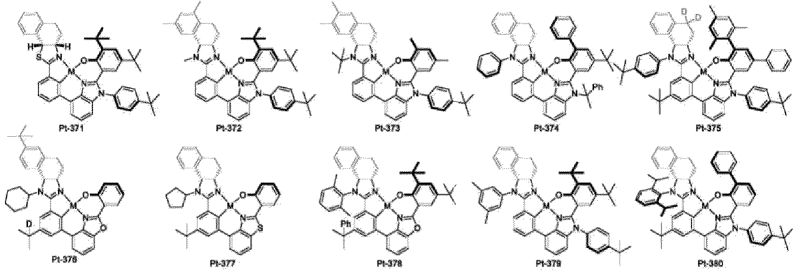

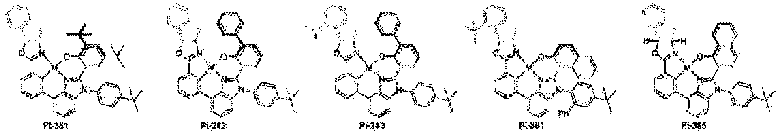

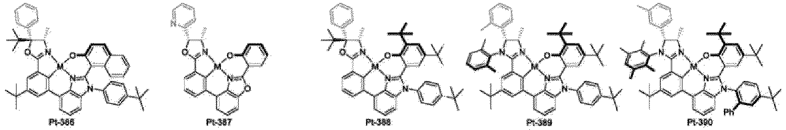

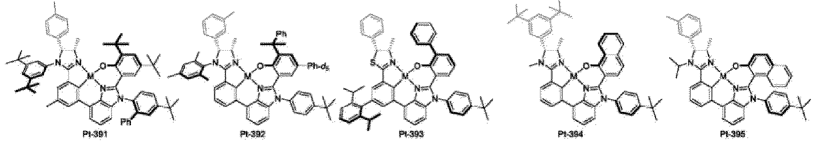

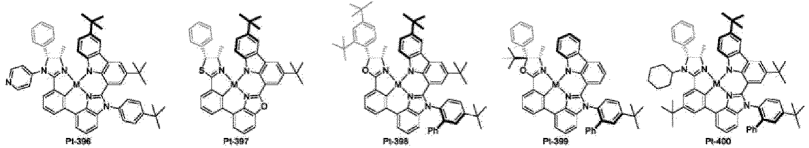

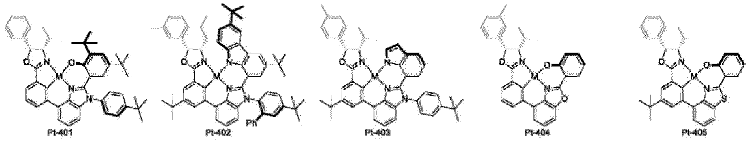

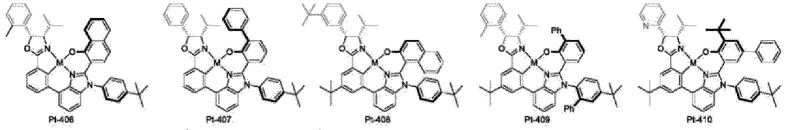

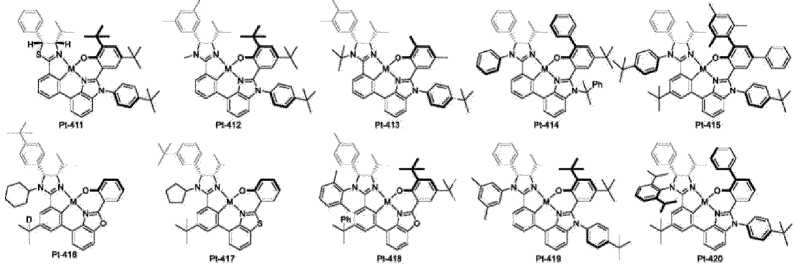

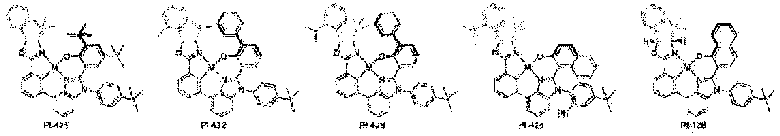

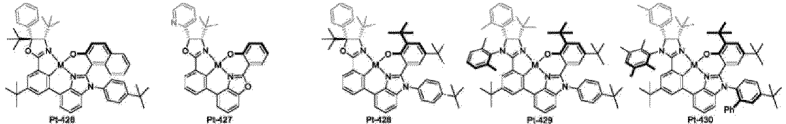

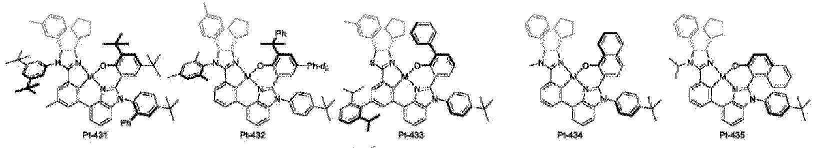

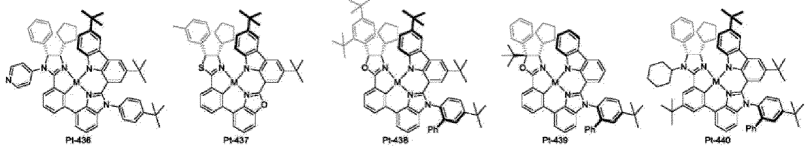

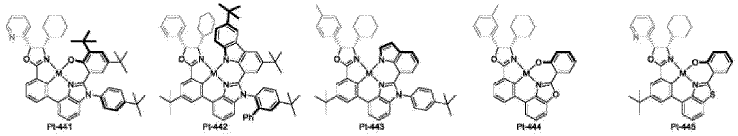

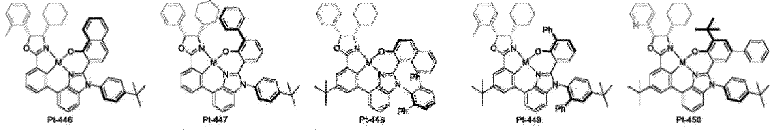

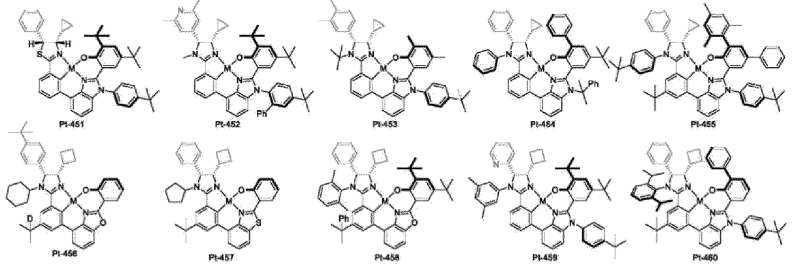

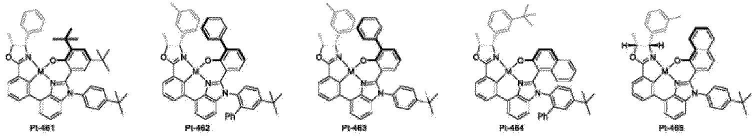

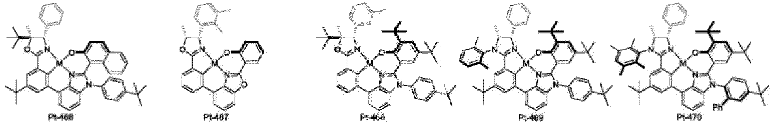

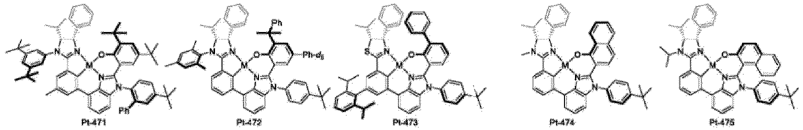

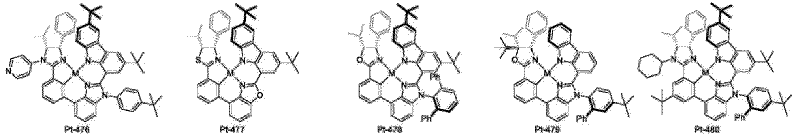

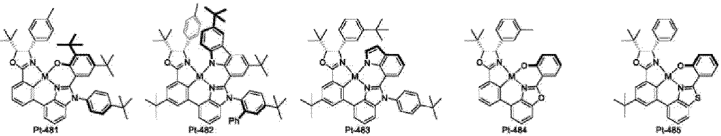

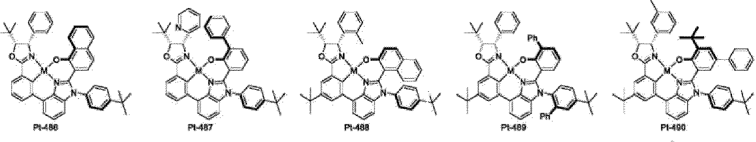

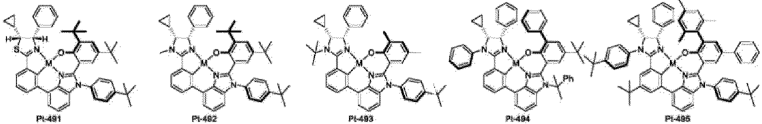

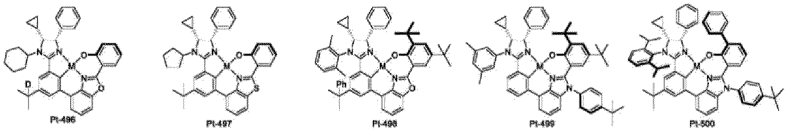

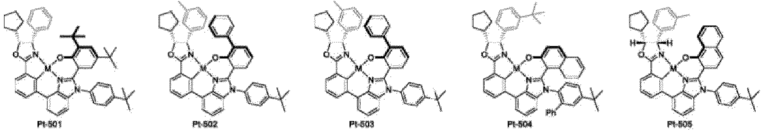

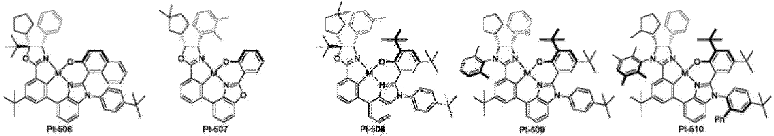

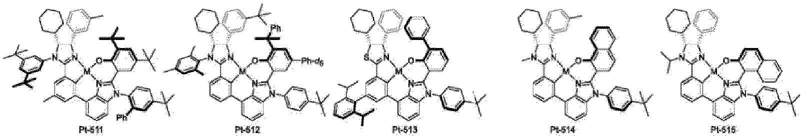

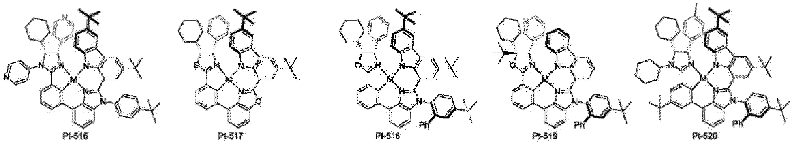

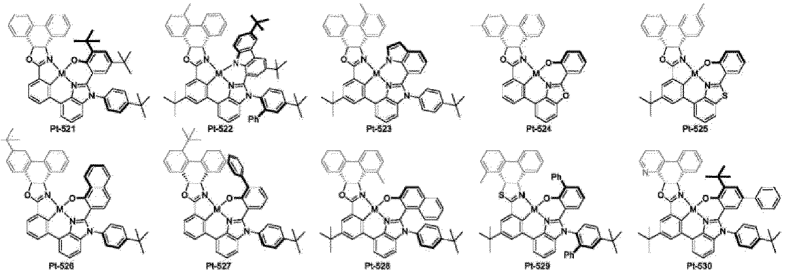

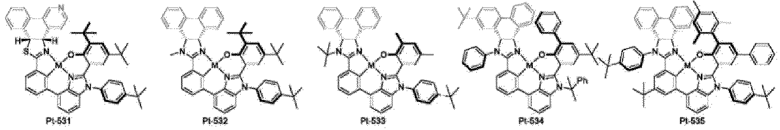

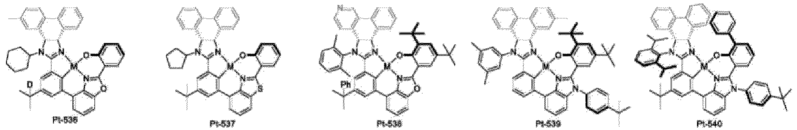

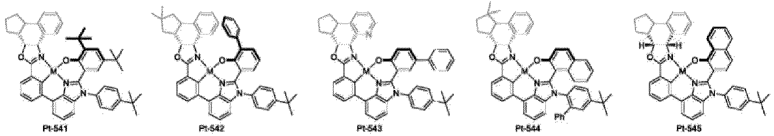

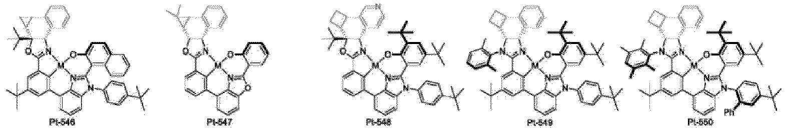

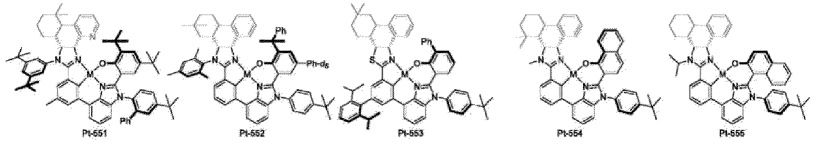

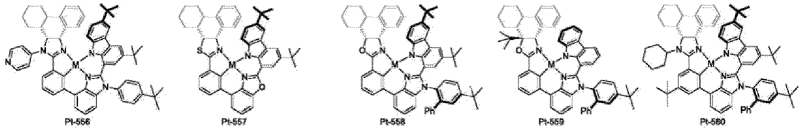

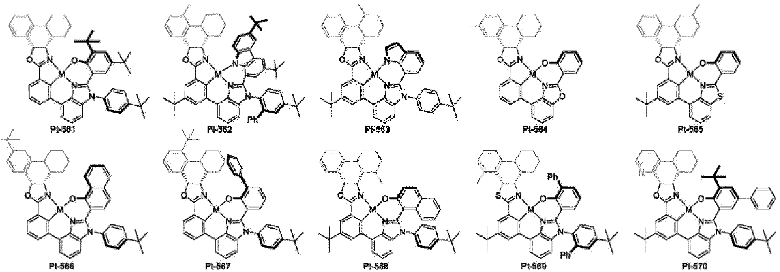

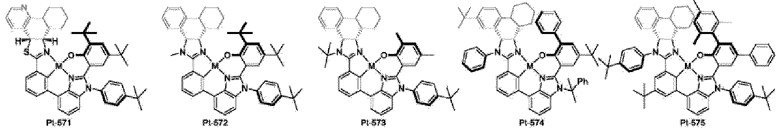

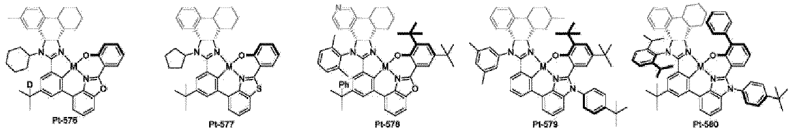

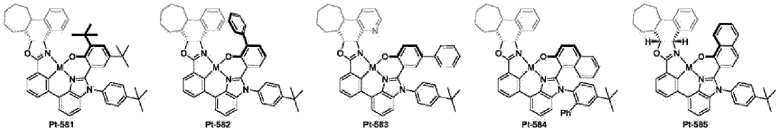

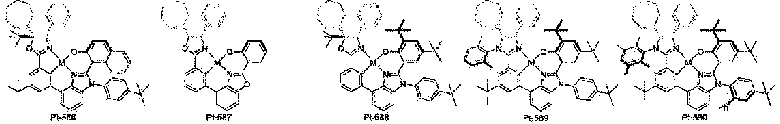

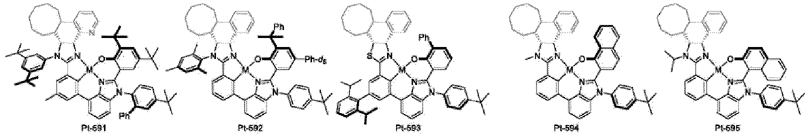

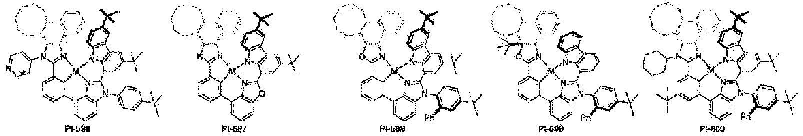

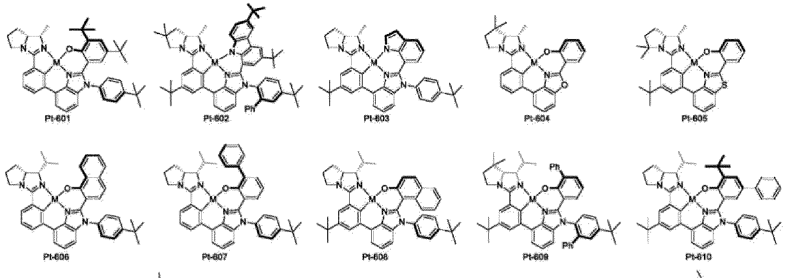

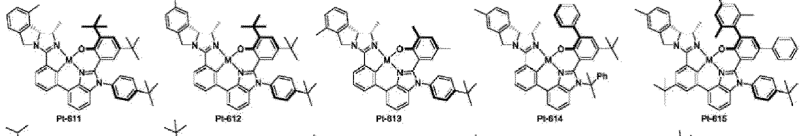

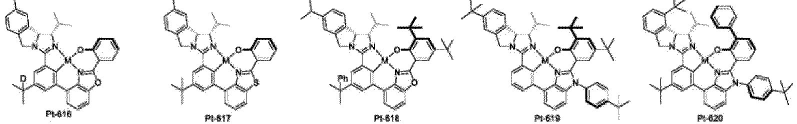

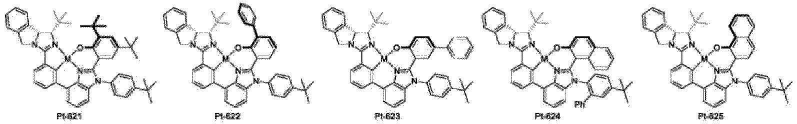

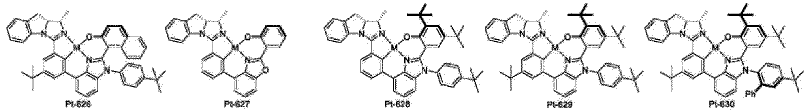

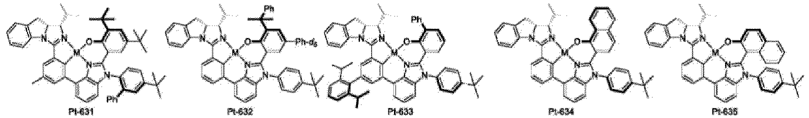

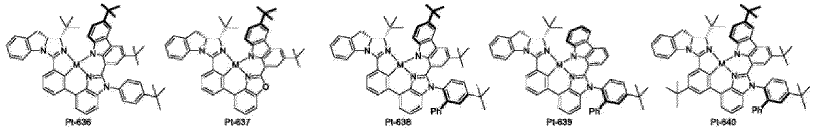

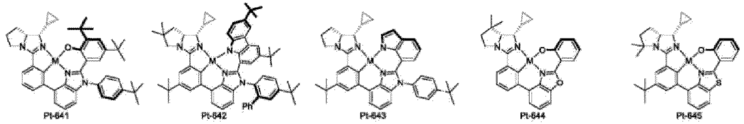

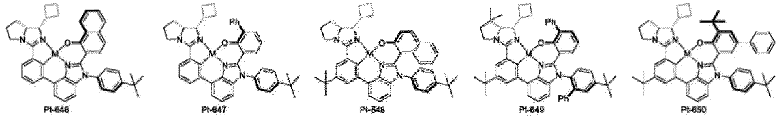

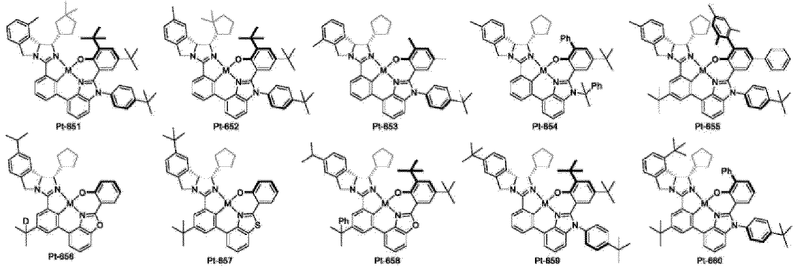

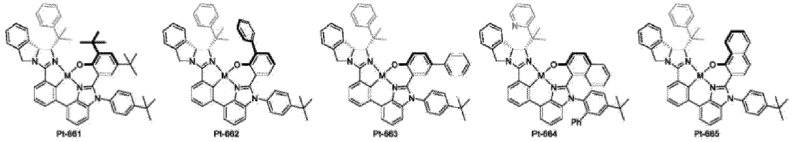

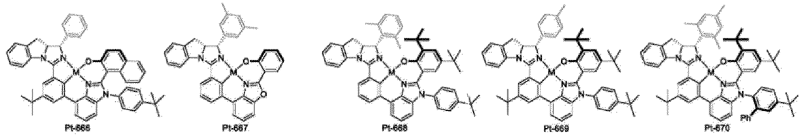

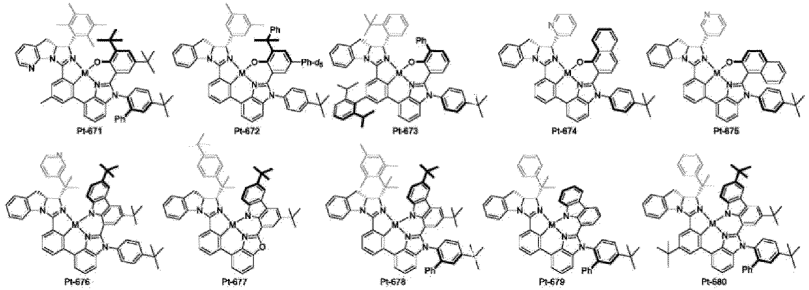

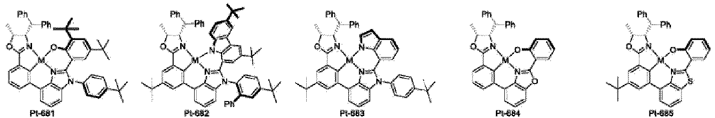

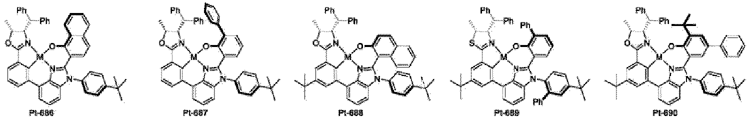

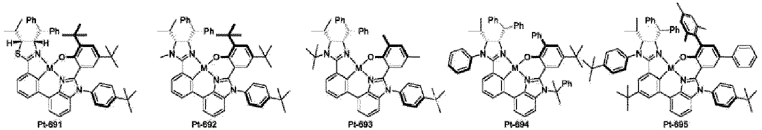

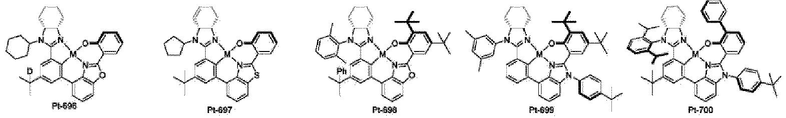

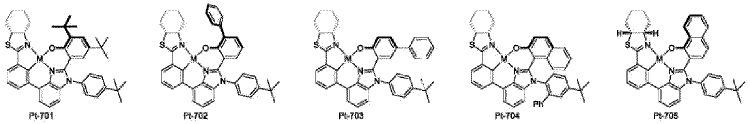

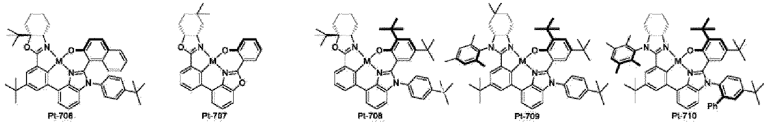

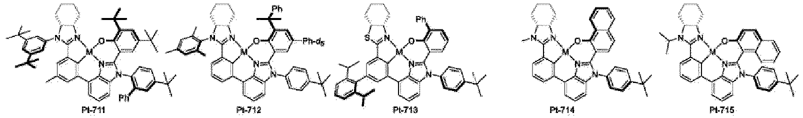

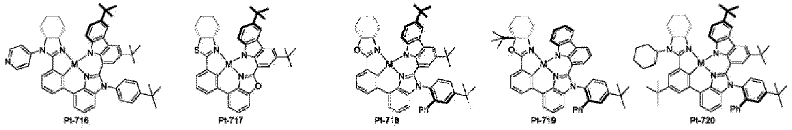

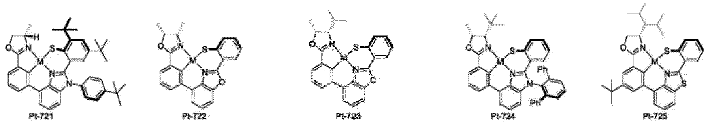

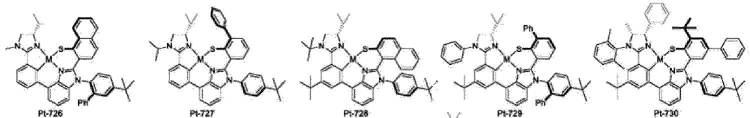

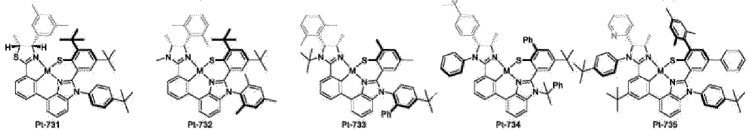

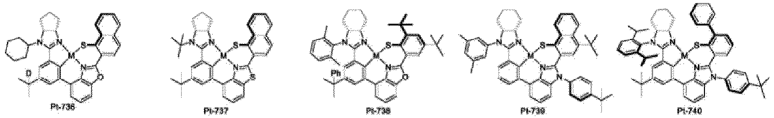

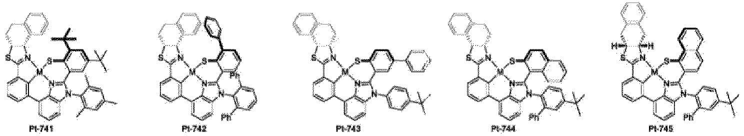

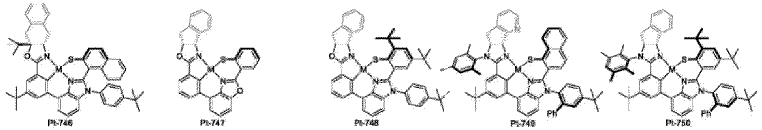

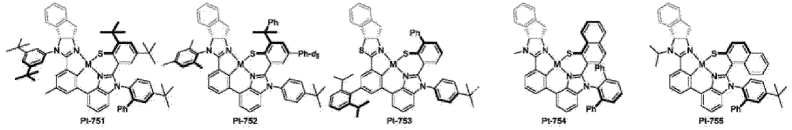

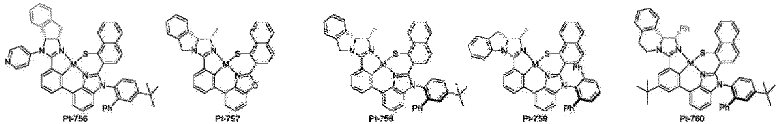

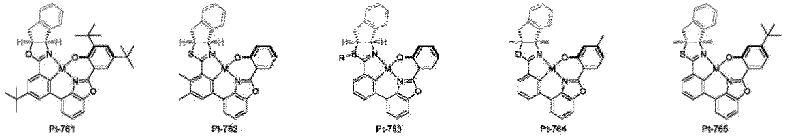

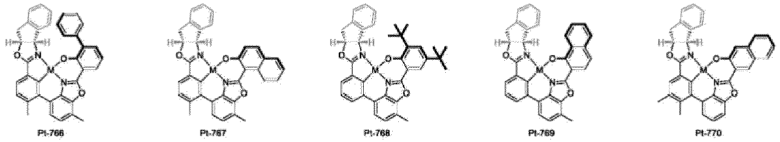

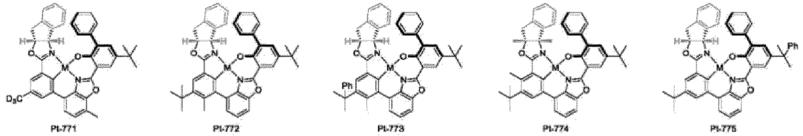

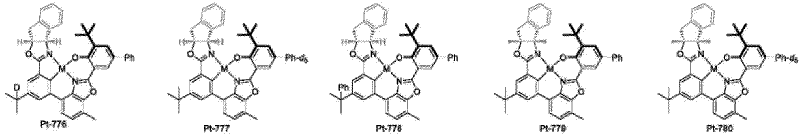

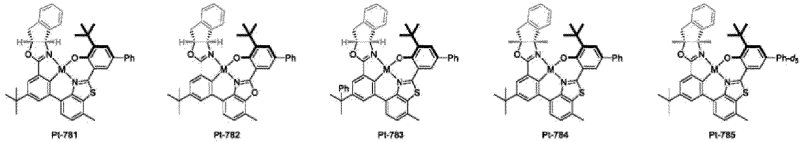

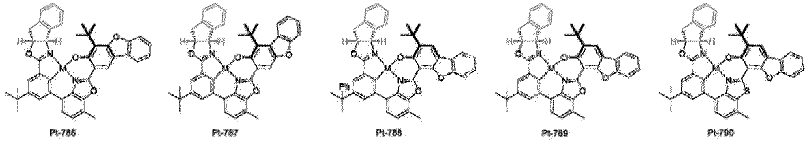

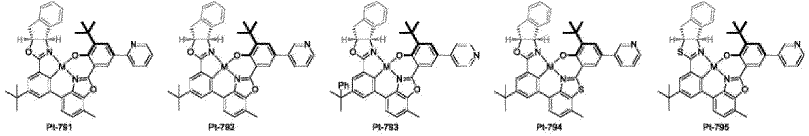

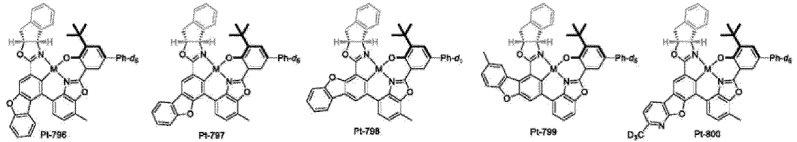

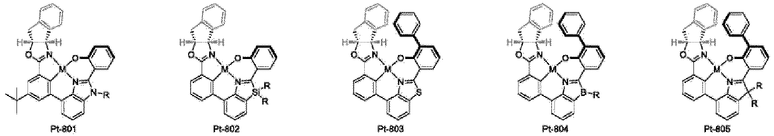

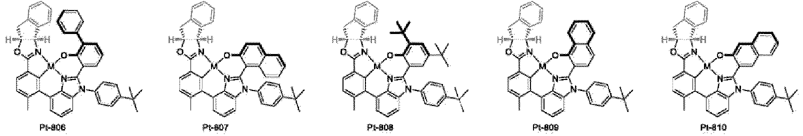

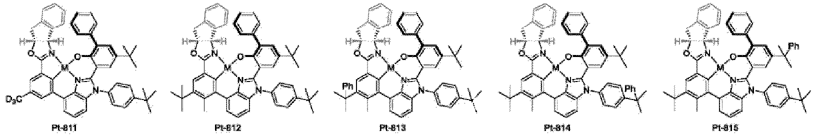

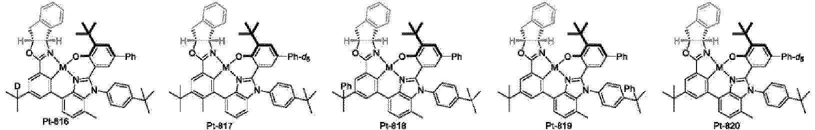

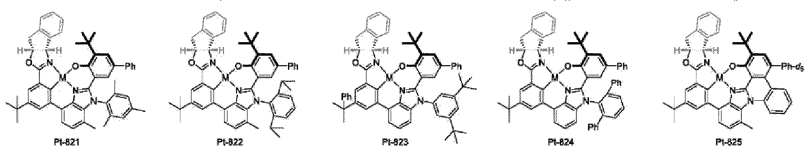

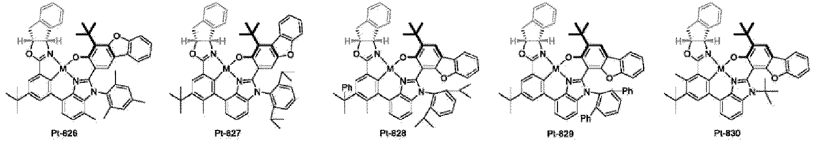

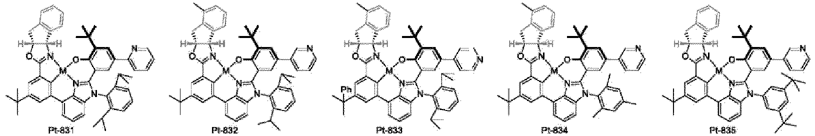

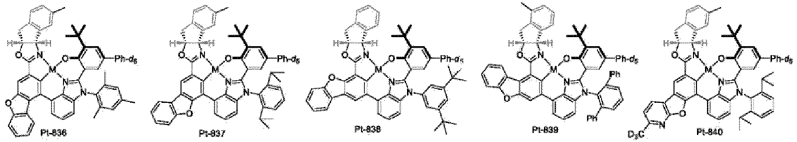

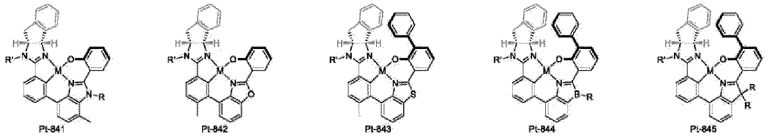

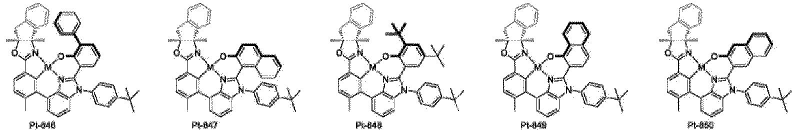

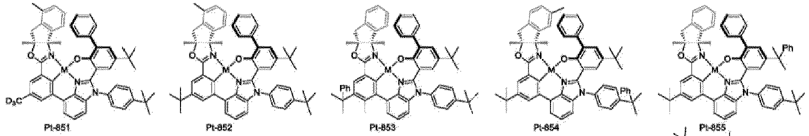

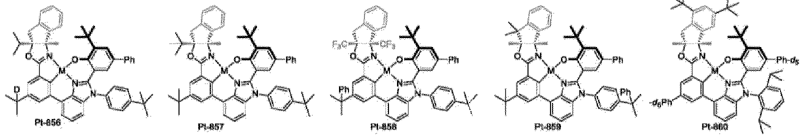

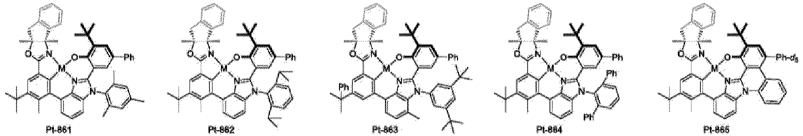

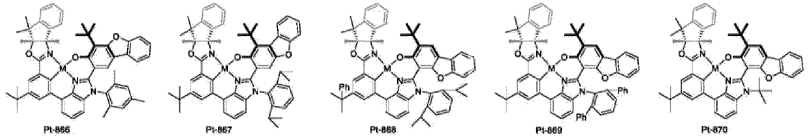

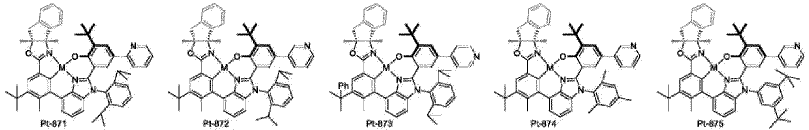

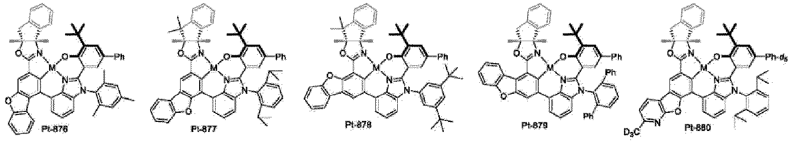

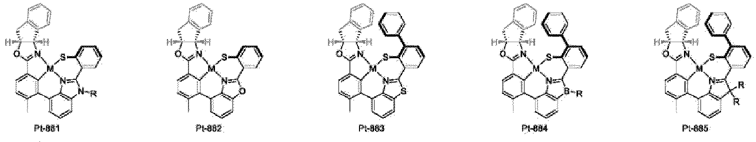

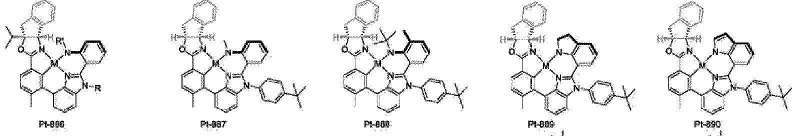

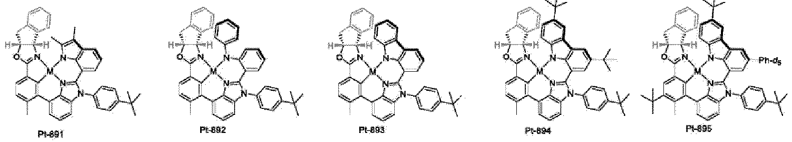

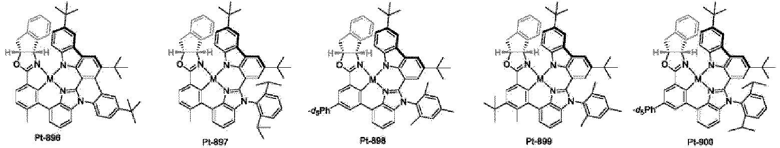

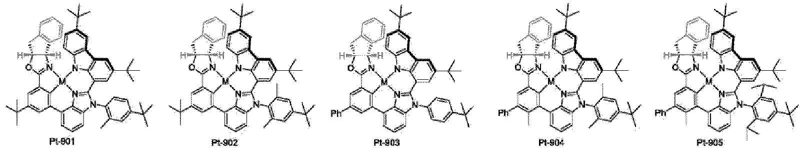

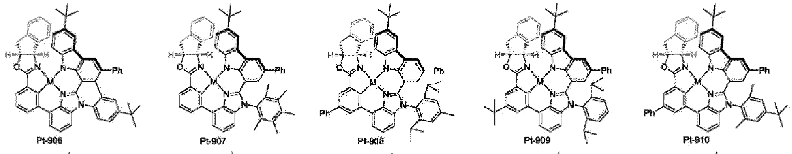

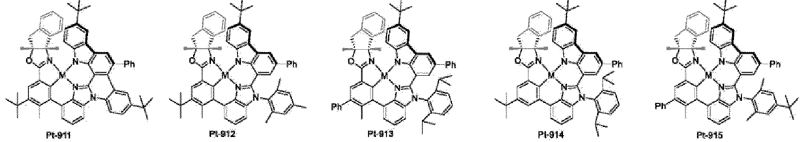

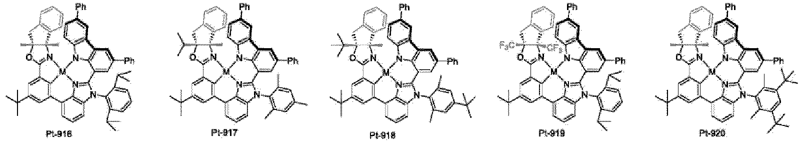

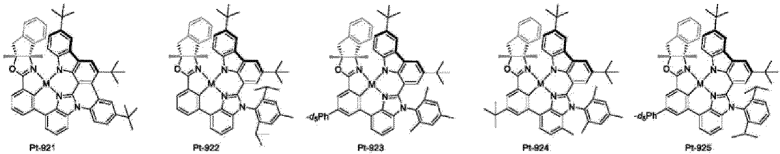

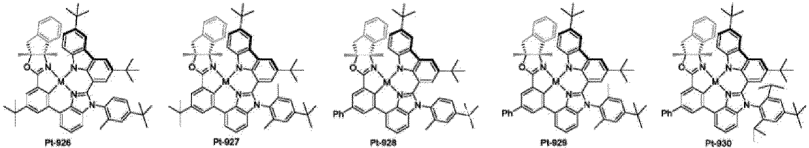

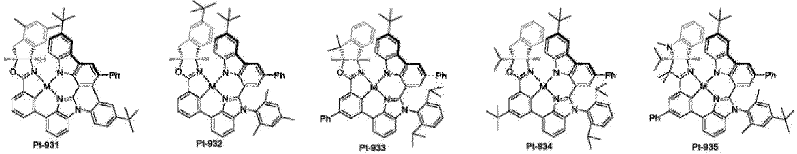

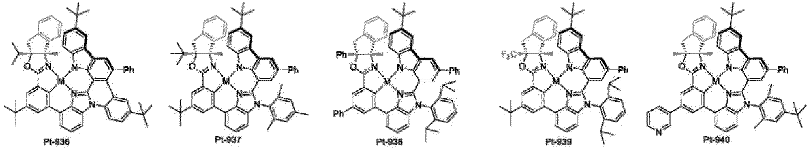

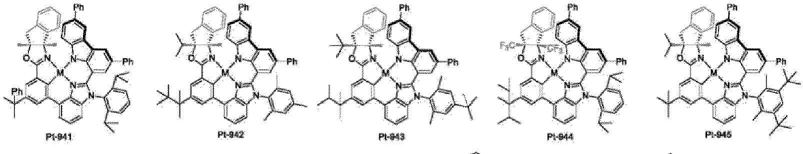

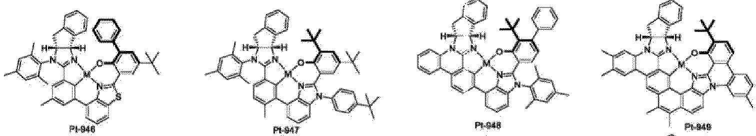

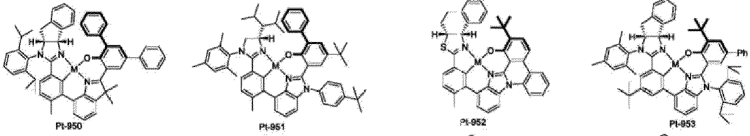

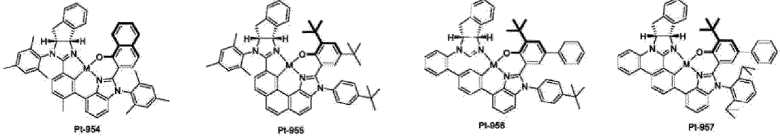

wherein M is Pt or Pd; R and R' are each independently hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, amido, alkoxycarbonylamino, aryloxycarbonylamino, sulfonylamino, sulfamoyl, carbamoyl, alkylthio, sulfinyl, ureido, phosphorylamino, imino, sulfo, carboxy, hydrazino, substituted silyl.

Further, use of the helical-chiral tetradentate cyclometalated platinum (II) and palladium (II) complex circularly polarized light-emitting material described above in a light-emitting device, a 3D display device, a three-dimensional imaging device, an optical information encryption device, an information storage device, a biological imaging device.

Further, the light-emitting device described above, wherein the light-emitting device is a light-emitting diode or a light-emitting electrochemical cell.

Further, a full-color display comprising the light-emitting device described above.

Further, a light-emitting display device characterized by comprising the light-emitting device described above.

Further, the use described above, wherein the light-emitting device comprises a first electrode, a second electrode, and at least one organic layer disposed between the first electrode and the second electrode, the organic layer comprising the helical-chiral tetradentate cyclometalated platinum (II) and palladium (II) complex circularly polarized light-emitting material described above.

Further, a display apparatus comprising an organic light-emitting element, wherein the organic light-emitting element comprises a first electrode, a second electrode, and at least one organic layer disposed between the first electrode and the second electrode, the organic layer comprising the helical-chiral tetradentate cyclometalated platinum (II) and palladium (II) complex circularly polarized light-emitting material described above .

### Advantageous Effect of the Disclosure

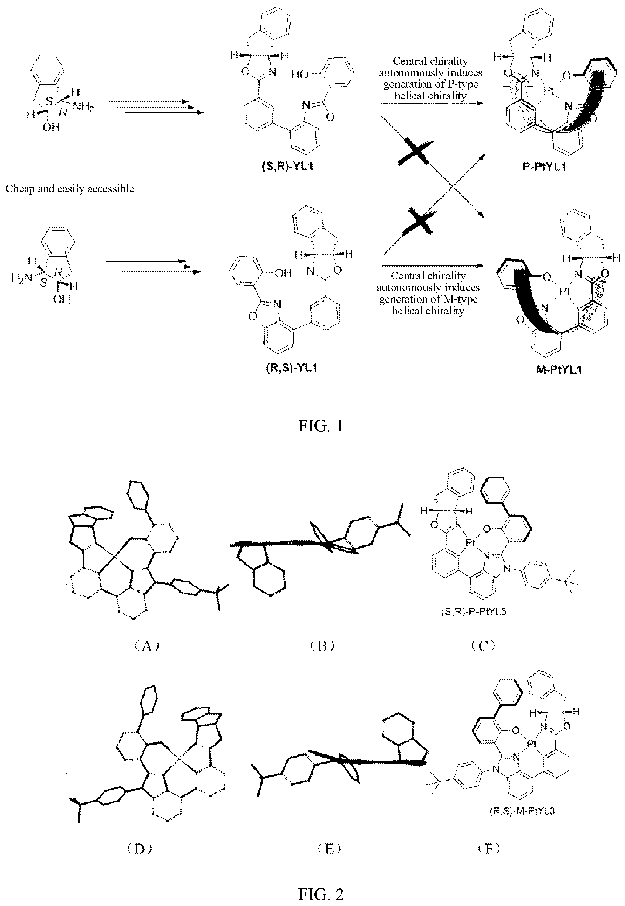

(1) Generation of central chiral autonomously induced helical-chirality: by designing and developing a tetradentate ligand containing a central chiral segment L^{a}, the entire tetradentate cyclometalated platinum (II) and palladium (II) complex molecule is in a twisted quadrilateral configuration by exploiting the steric hindrance effect between the tetradentate ligand and the other terminal ligand L³ or L⁴; at the same time, the central chiral segment L^{a} can autonomously induce the whole tetradentate ligand to coordinate with the metal ion in a less sterically hindered manner, forming an optically pure helical-chiral tetradentate cyclometalated platinum (II) and palladium (II) complex circularly polarized light-emitting materials centered on the metal ion. As shown in FIG. 1.
(2) Optically pure starting materials are cheap and easily accessible: both chiral optically pure enantiomers required for the preparation of a tetradentate ligand containing a central chirality L^{a} are commercially easily available compounds that facilitate the preparation of two chiral optically pure tetradentate ligands in large quantities.
(3) The circularly polarized light-emitting material does not require chiral resolution: the two chiral optically pure enantiomers circularly polarized light-emitting material of helical-chiral tetradentate cyclometalated complex platinum (II) and palladium (II) complexes can be conveniently prepared from the above-mentioned two chiral optically pure tetradentate ligands, without the need of separation and purification by chiral column, and without the limitation of high-cost chiral resolution, thus greatly reducing the preparation cost of the materials.
(4) High material chemical and thermal stability: the tetradentate ligands can be well coordinated with platinum (II) and palladium (II) metal ions hybridized with dsp² to form stable and rigid quadrilateral molecules with high chemical stability. At the same time, due to the designed larger steric effect between the central chiral ligand L^{a} and the other terminal ligand L³ or L⁴, the whole metal complex molecule can form a stable helical-chiral tetradentate cyclometalated complex, so that the racemization does not occur in solution or high temperature sublimation process and the circularly polarized luminescence property is lost.

### BRIEF DESCRIPTION OF DRAWINGS

FIG. 1 is a conceptual diagram showing the design of an optically pure helical-chiral tetradentate cyclometalated complex circularly polarized light-emitting material centered on a metal ion;
In FIG. 2, figure (A) is a front view of the molecular structure of *(S,* R)-P-PtYL3 optimized by DFT calculation; figure (B) is a top view of the molecular structure of *(S, R)-P-*PtYL3 optimized by DFT calculation; figure (C) is a molecular structure formula of *(S, R)-P-*PtYL3; figure (D) is a front view of the molecular structure of *(R, S)-M*-PtYL3 optimized by DFT calculation; figure (E) is a top view of the molecular structure of *(R, S)-M-*PtYL3 optimized by DFT calculation; and figure (F) is a molecular structure formula of *(R, S)-M-*PtYL3;
FIG. 3 shows the emission spectra of optically pure *(R, S)-M-*PtYL1 and *(S, R)-P-*PtYL1 in a dichloromethane solution under a deoxygenated condition at room temperature;
FIG. 4 shows the emission spectra of optically pure *(R, S)-M*-PtYL2 and *(S, R)-P-*PtYL2 in a dichloromethane solution under a deoxygenated condition at room temperature;
FIG. 5 shows the emission spectra of optically pure *(R, S)-M*-PtYL3 and *(S, R)-P-*PtYL3 in a dichloromethane solution under a deoxygenated condition at room temperature;
FIG. 6 shows the emission spectra of optically pure *(R, S)-M*-PtYL4 and *(S, R)-P-*PtYL4 in a dichloromethane solution under a deoxygenated condition at room temperature;
FIG. 7 shows the emission spectra of optically pure *(R, S)-M-*PtYL5 and *(S, R)-P-*PtYL5 in a dichloromethane solution under a deoxygenated condition at room temperature;
FIG. 8 shows the emission spectra of optically pure *(R, S)-M-PtYL6* and *(S, R)-P-*PtYL6 in a dichloromethane solution under a deoxygenated condition at room temperature;
FIG. 9 shows the emission spectra of optically pure *(R*, *S)-M*-PdYL2 and *(S, R)-P-*PdYL2 in a dichloromethane solution under a deoxygenated condition at room temperature;
FIG. 10 shows the emission spectra of optically pure *(S*, *R)-P*-PtYL35 in a dichloromethane solution under a deoxygenated condition at room temperature;
FIG. 11 shows a schematic diagram of the HOMO and LUMO orbital distributions and molecular structural formulas of compounds *P*-PtYL1, *P*-PtYL2, *P*-PtYL3, and *P*-PtYL4, respectively;
FIG. 12 is a schematic diagram of HOMO and LUMO orbital distributions and molecular structural formulas of compounds *P*-PtYL5 (naphthalene ring facing inwards), *P-*PtYL5 (naphthalene ring facing outwards) and *P*-PtYL6, respectively;
FIG. 13 shows the HOMO and LUMO orbital distributions and molecular structural formulas of compounds *P*-PtYL7, *P*-PtYL8, *P*-PtYL9, and *P*-PtYL10, respectively;
FIG. 14 shows the HOMO and LUMO orbital distributions and molecular structural formulas of compounds *P*-PtYL11, *P*-PtYL12, *P*-PtYL13, and *P*-PtYL14, respectively;
FIG. 15 shows a schematic diagram of the HOMO and LUMO orbital distributions and molecular structural formulas of compounds *P*-PtYL15, *P*-PtYL16, *P*-PtYL17, and *P-*PtYL18, respectively;
FIG. 16 shows the HOMO and LUMO orbital distributions and molecular structural formulas of compounds *P*-PtYL19, *P*-PtYL20, *P*-PtYL21, and *P*-PtYL22, respectively;
FIG. 17 shows the HOMO and LUMO orbital distributions and molecular structural formulas of compounds *P*-PtYL23, *P*-PtYL24, *P*-PtYL25, and *P*-PtYL26, respectively;
FIG. 18 shows the HOMO and LUMO orbital distributions and molecular structural formulas of compounds *P*-PtYL27, *P*-PtYL28, *P*-PtYL29, and *P*-PtYL30, respectively;
FIG. 19 shows the HOMO and LUMO orbital distributions and molecular structural formulas of compounds *P*-PtYL31, *P*-PtYL32, *P*-PtYL33, and *P*-PtYL34, respectively;
FIG. 20 shows the circular dichroism spectra of optically pure *(R, S)-M-*PtYL1 and *(S, R)-P*-PtYL1 in dichloromethane solution, respectively;
FIG. 21 shows the circular dichroism spectra of optically pure *(R*, *S)-*M-PtYL2 and *(S, R)-P*-PtYL2 in dichloromethane solution, respectively;
FIG. 22 shows the circular dichroism spectra of optically pure *(R, S)-M-*PtYL3 and *(S, R)-P*-PtYL3 in dichloromethane solution, respectively;
FIG. 23 shows the circular dichroism spectra of optically pure *(R, S)-M*-PtYL4 and *(S, R)-P*-PtYL4 in dichloromethane solution, respectively;
FIG. 24 shows the circular dichroism spectra of optically pure *(R, S)-M-*PtYL5 and *(S, R)-P*-PtYL5 in dichloromethane solution, respectively;

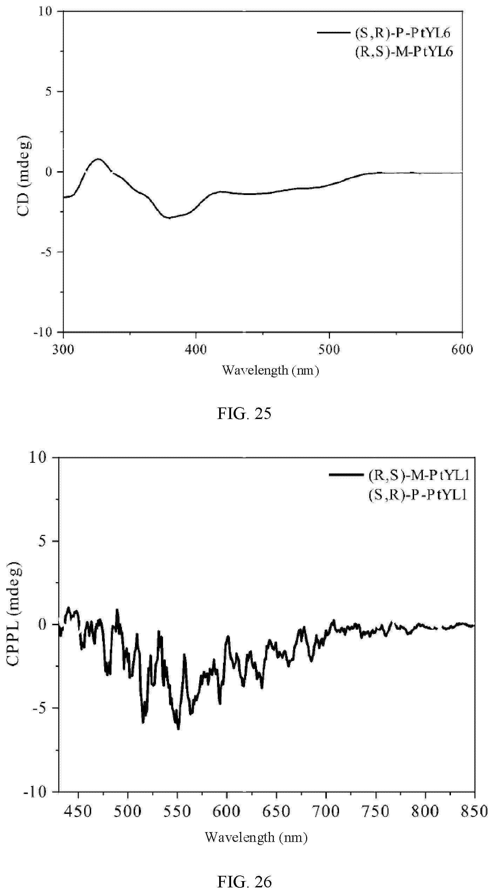

FIG. 25 shows the circular dichroism spectra of optically pure *(R, S)-M-*PtYL6 and *(S, R)-P*-PtYL6 in dichloromethane solution, respectively;
FIG. 26 shows the circular dichroism spectra of optically pure *(R, S)-M-*PtYL1 and *(S, R)-P*-PtYL1 in dichloromethane solution under a deoxygenated condition at room temperature, respectively;

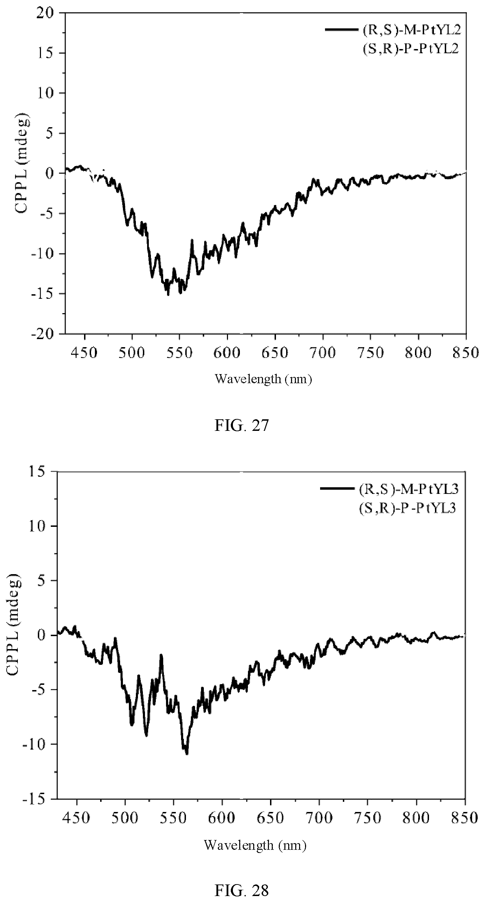

FIG. 27 shows the circular dichroism spectra of optically pure *(R, S)-M-*PtYL2 and *(S, R)-P*-PtYL2 in dichloromethane solution under a deoxygenated condition at room temperature, respectively;
FIG. 28 shows the circular dichroism spectra of optically pure *(R, S)-M-*PtYL3 and *(S, R)-P-*PtYL3 in dichloromethane solution under a deoxygenated condition at room temperature, respectively;

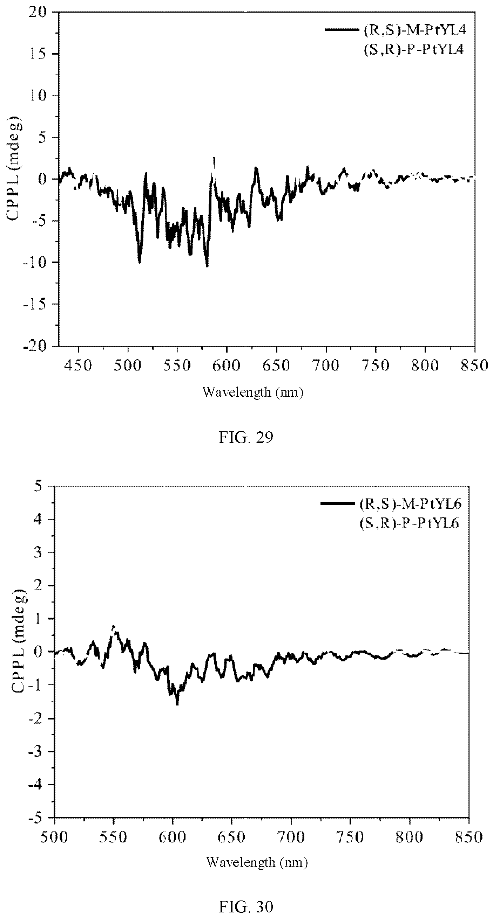

FIG. 29 shows the circular dichroism spectra of optically pure *(R, S)-M-*PtYL4 and *(S, R)-P*-PtYL4 in dichloromethane solution under a deoxygenated condition at room temperature, respectively;
FIG. 30 shows the circular dichroism spectra of optically pure *(R, S)-M-*PtYL6 and *(S, R)-P*-PtYL6 in dichloromethane solution under a deoxygenated condition at room temperature, respectively;

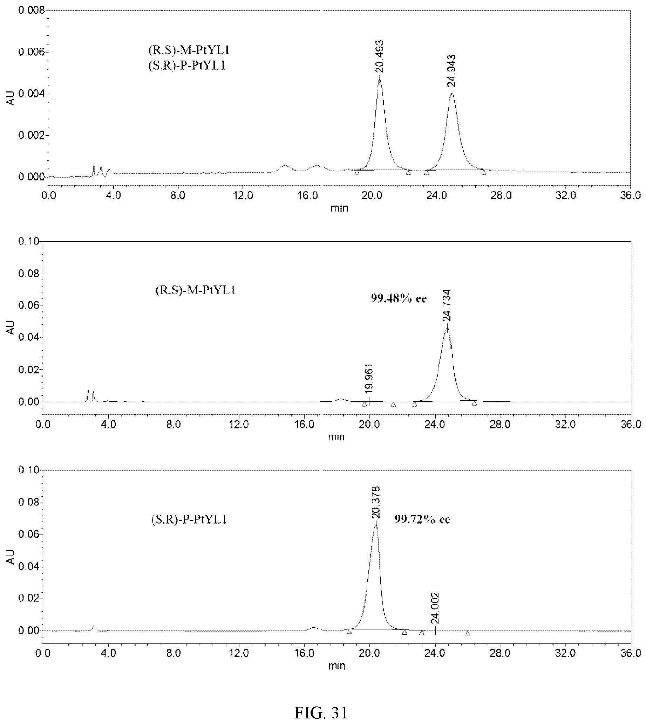

FIG. 31 shows the peak spectra of optically pure *(R, S)-M-*PtYL1 and *(S, R)-P*-PtYL1 mixtures, as well as single optically pure *(R, S)-M-*PtYL1 and single optically pure *(S, R)-P-*PtYL1 in high-performance liquid chromatography (HPLC); and
FIG. 32 is a schematic diagram of the structure of an organic light-emitting element.

### DETAILED DESCRIPTION OF THE EMBODIMENTS

Hereinafter, the present invention will be described in detail. The description of the constituent elements recorded below is sometimes based on representative embodiments or specific examples of the present invention, but the present invention is not limited to such embodiments or specific examples.

The following examples illustrate specific examples of circularly polarized light-emitting materials of the present invention represented by the above general formulas, however, they are not interpreted as limiting the present invention.

The disclosure can be understood more readily by reference to the following detailed description and examples contained therein. Before disclosing and describing the compounds, devices, and/or methods of the present invention, it should be understood that unless otherwise specified, they are not limited to specific synthesis methods or specific reagents, as they may vary. It should also be understood that the terms used in the present invention are only for describing specific aspects and are not intended to be limiting. Although any similar or equivalent methods and materials described in the present invention can be used in this practice or experiment, exemplary methods and materials are now described.

The singular forms of the terms "a/an", and "the" used in the specification and the appended claims include plural references, otherwise the context may specify otherwise. Thus, for example, reference to "a component" includes mixtures of two or more components.

The term "optional" or "optionally" used in the present invention means that the event or situation described subsequently may or may not occur, and the description includes instances where the event or situation occurs and instances where it did not occur.

Disclosed are components useful for preparing the compositions described herein, as well as the compositions themselves to be used in the methods disclosed herein. The present invention discloses these and other materials, and it should be understood that combinations, subsets, interactions, groups, etc. of these substances are disclosed. Although it is not possible to specifically disclose each different individual and total combination and arrangement of these compounds, as well as specific references, each has its own specific ideas and descriptions. For example, if a particular compound is disclosed and discussed and a number of modifications that can be made to a number of molecules including the compounds are discussed, specifically contemplated is each and every combination and possible modifications of the compound and the modifications that can be made unless specifically indicated to the contrary. Therefore, if a class of molecules A, B, and C, as well as a class of molecules D, E, and F, and examples of combination molecules A-D are disclosed, even if not individually recorded, it is considered to disclose each individual and overall meaning combination, A-E, A-F, B-D, B-E, B-F, C-D, C-E, and C-F. Likewise, any subset or combination of these is also disclosed. For example, the subset of A-E, B-F, and C-E is also disclosed. This concept applies to all aspects of the present invention, including but not limited to the steps in the methods of preparing and using the composition. Thus, if there are a variety of additional steps that can be performed it is understood that each of these additional steps can be performed with a specific embodiment or combination of embodiments of the method.

The linking atoms used in the present invention can link two groups, for example, N and C. The linking atom can optionally (if valency permits) attach other chemical groups. For example, an oxygen atom will not have any other chemical group attached because the valence bond once two atoms (e.g. N or C) are bonded is satisfied. Conversely, when carbon is the linking atom, two additional chemical groups can be attached to the carbon atom. Suitable chemical groups include but are not limited to, hydrogen, hydroxyl, alkyl, alkoxy, =O, halogen, nitro, amine, amide, sulfhydryl, aryl, heteroaryl, cycloalkyl, and heterocyclyl.

As used herein, the term "cyclic structure" or like terms refers to any cyclic chemical structure including, but not limited to, aryl, heteroaryl, cycloalkyl, cycloalkenyl, heterocyclyl, carbene, and N-heterocyclic carbene.

As used herein, the term "substituted" or like terms refers to encompass all permissible substituents of organic compounds. Broadly speaking, the permissible substituents include cyclic and non-cyclic, branched and unbranched, carbocyclic and heterocyclic, aromatic and non-aromatic substituents of organic compounds. For example, exemplary substituents include those described below. The permissible substituents may be one or more and the same or different for appropriate organic compounds. For purposes of this invention, a heteroatom (e.g. nitrogen) can have a hydrogen substituent and/or any permissible substituent of the organic compound described herein which satisfies the valences of the heteroatom. The present invention is not intended to be limited in any manner by the permissible substituents of organic compounds. Likewise, the term "substituted" or "substituted with" includes the implicit proviso that such substitution is in accordance with a permitted valence of the substituted atom and the substituent and that the substitution results in a stable compound (e.g. a compound that does not spontaneously undergo transformation such as by rearrangement, cyclization, elimination, etc.). In certain aspects, unless expressly stated to the contrary, individual substituents can be further optionally substituted (i.e. further substituted or unsubstituted).

In defining various terms, "R1", "R2", "R3", and "R4" are used as general symbols in the present invention to represent various specific substituents. These symbols can be any substituent, not limited to those disclosed in the present invention. When they are defined as certain substituents in one example, they can also be defined as some other substituents in another example.

The term "alkyl" as used herein is a branched or unbranched saturated hydrocarbon group of 1 to 30 carbon atoms such as methyl, ethyl, n-propyl, isopropyl, n-butyl, isobutyl, sec-butyl, tert-butyl, n-pentyl, isopentyl, sec-pentyl, neopentyl, hexyl, heptyl, octyl, nonyl, decyl, dodecyl, tetradecyl, hexadecyl, eicosyl, tetracosyl and the like. The alkyl may be cyclic or acyclic. The alkyl may be branched or unbranched. The alkyl may be substituted or unsubstituted. For example, the alkyl may be substituted with one or more groups including, but not limited to, an optionally substituted alkyl, cycloalkyl, alkoxy, amino, ether, halo, hydroxy, nitro, silyl, thio-oxo, or mercapto group as described herein. A "lower alkyl" group is an alkyl containing from 1 to 6 (e.g., 1 to 4) carbon atoms.

Throughout the specification, "alkyl" generally refers to both unsubstituted alkyl and substituted alkyl; however, substituted alkyl groups are also specifically mentioned in the present invention by identifying specific substituents on the alkyl group. For example, the term "halogenated alkyl" or "haloalkyl" specifically refers to an alkyl group substituted with one or more halogens (e.g. fluorine, chlorine, bromine, or iodine). The term "alkoxyalkyl" specifically refers to an alkyl substituted with one or more alkoxy groups, as described below. The term "alkylamino" specifically refers to an alkyl substituted with one or more amino groups, as described below, and the like. When "alkyl" is used in one instance and a specific term such as "alkyl alcohol" is used in another instance, it is not meant to imply that the term "alkyl" does not refer to specific terms such as "alkyl alcohol" and the like at the same time.

This practice also applies to other groups described herein. That is, when a term such as "cycloalkyl" refers to both unsubstituted and substituted cycloalkyl moieties, the substituted moiety may additionally be specifically identified in the present invention; for example, a specifically substituted cycloalkyl may be referred to as, for example, "alkylcycloalkyl". Similarly, a substituted alkoxy group may be specifically referred to as, for example, a "haloalkoxy", and a specific substituted alkenyl group may be, for example, an "enol", and the like. Likewise, the use of a general term such as "cycloalkyl" and a specific term such as "alkylcycloalkyl" does not imply that the general term does not simultaneously encompass the specific term.

The term "cycloalkyl" as used herein is a non-aromatic carbon-based ring of 3 to 30 carbon atoms composed of at least three carbon atoms. Examples of "cycloalkyl" include but are not limited to cyclopropyl, cyclobutyl, cyclopentyl, cyclohexyl, and cyclononyl. The term "heterocycloalkyl" is a class of cycloalkyl as defined above and is included within the meaning of the term "cycloalkyl" wherein at least one ring carbon atom is substituted with a heteroatom such as, but not limited to nitrogen, oxygen, sulfur, or phosphorus. The cyclic and heterocyclic alkyl groups can be substituted or unsubstituted. The cyclic and heterocyclic alkyl groups may be substituted with one or more functional groups, including but not limited to alkyl, cycloalkyl, alkoxy, amino, ether, halo, hydroxy, nitro, silyl, thio-oxo, and mercapto group as described herein.

As used herein, the term "polyolefin group" refers to a group containing two or more CH₂ groups attached to each other. A "polyolefin group" may be represented as -(CH₂) a-, where "a" is an integer between 2 and 500.

As used herein, the terms "alkoxy" and "alkoxy group" refer to an alkyl or cycloalkyl group having 1 to 30 carbon atoms bonded through an ether linkage; that is, "alkoxy" may be defined as -OR¹, wherein R¹ is alkyl or cycloalkyl as defined above. An "alkoxy" also includes the alkoxy polymers just described; that is, the alkoxy group can be a polyether, such as -OR¹-OR² or -OR¹-(OR²) ₐ-OR³, where "a" is an integer from 1 to 500, and R¹, R², and R³ are each independently an alkyl group, a cycloalkyl group, or a combination thereof.

The term "alkenyl" as used herein is a hydrocarbon group of 2 to 30 carbon atoms, the structural formula of which contains at least one carbon-carbon double bond. Asymmetric structures such as (R¹R²)C = C(R³R⁴) include E and Z isomers. This can be presumed in the formulas of the present invention where an asymmetric alkene is present, or it can be explicitly indicated by the bond symbol C=C. The alkenyl may be substituted with one or more groups including, but not limited to, alkyl, cycloalkyl, alkoxy, alkenyl, cycloalkenyl, alkynyl, cycloalkynyl, aryl, heteroaryl, aldehyde, amino, carboxyl, ester, ether, halogen, hydroxyl, ketone, azido, nitro, silyl, thio-oxo, or mercapto group as described herein.

The term "cyclohexene" used in the present invention refers to a nonaromatic carbon-based ring having 3 to 30 carbon atoms, consisting of at least 3 carbon atoms and containing at least one carbon-carbon double bond, i.e. C=C. Examples of cyclohexene groups include but are not limited to cyclopropenyl, cyclobutenyl, cyclopentenyl, cyclopentadienyl, cyclohexene, cyclohexadiene, cyclohexene, etc. The term "heterocycloalkenyl" is a class of cycloalkenyl as defined above, and is included within the meaning of the term "cycloalkenyl", wherein at least one carbon atom of the ring is substituted with a heteroatom such as, but not limited to, nitrogen, oxygen, sulfur, or phosphorus. Cycloalkenyl and heterocycloalkenyl can be substituted or unsubstituted. The cycloalkenyl and heterocycloalkenyl may be substituted with one or more groups including, but not limited to, alkyl, cycloalkyl, alkoxy, alkenyl, cycloalkenyl, alkynyl, cycloalkynyl, aryl, heteroaryl, aldehyde, amino, carboxyl, ester, ether, halogen, hydroxyl, ketone, azido, nitro, silyl, thio-oxo, or mercapto group as described herein.

As used herein, the term "alkynyl" is a hydrocarbon group having from 2 to 30 carbon atoms, the structural formula of which contains at least one carbon-carbon triple bond. The alkynyl may be substituted with one or more groups including, but not limited to, alkyl, cycloalkyl, alkoxy, alkenyl, cycloalkenyl, alkynyl, cycloalkynyl, aryl, heteroaryl, aldehyde, amino, carboxyl, ester, ether, halogen, hydroxyl, ketone, azido, nitro, silyl, thio-oxo, or mercapto group as described herein.

The term "cycloalkynyl" as used herein is a non-aromatic carbon-based ring containing at least 7 carbon atoms and containing at least one carbon-carbon triple bond. Examples of "cycloalkynyl" include but are not limited to cycloheptylynyl, cyclooctynyl, cyclononynyl, etc. The term "heterocycloalkynyl" is a cycloalkenyl group as defined above and is included within the meaning of the term "cycloalkynyl" wherein at least one of the carbon atoms of the ring is substituted with a heteroatom such as, but not limited to, nitrogen, oxygen, sulfur, or phosphorus. Cycloalkynyl and heterocycloalkynyl may be substituted or unsubstituted. The cycloalkynyl and heterocycloalkynyl may be substituted with one or more groups including, but not limited to, alkyl, cycloalkyl, alkoxy, alkenyl, cycloalkenyl, alkynyl, cycloalkynyl, aryl, heteroaryl, aldehyde, amino, carboxyl, ester, ether, halogen, hydroxyl, ketone, azido, nitro, silyl, thio-oxo, or mercapto group as described herein.

The term "aryl" used in the present invention refers to any group containing 60 carbon atoms or less of any carbon-based aromatic group, including but not limited to phenyl, naphthyl, phenyl, biphenyl, phenoxyphenyl, anthracene, phenanthrene, etc. The term "aryl" also includes "heteroaryl", which is defined as a group containing an aromatic group having at least one heteroatom in the ring. Examples of heteroatoms include but are not limited to, nitrogen, oxygen, sulfur, or phosphorus. Likewise, the term "non-heteroaryl" (which is also encompassed by the term "aryl") defines groups that contain aromatic groups that are free of a heteroatom. The aryl may be substituted or unsubstituted. The aryl may be substituted with one or more groups including, but not limited to, alkyl, cycloalkyl, alkoxy, alkenyl, cycloalkenyl, alkynyl, cycloalkynyl, aryl, heteroaryl, aldehyde, amino, carboxyl, ester, ether, halogen, hydroxyl, ketone, azido, nitro, silyl, thio-oxo, or mercapto group as described herein. The term "biaryl" is a specific type of aryl and is included in the definition of "aryl". Biaryl refers to two aryls bound together via a fused ring structure, as in naphthalene, or connected via one or more carbon-carbon bonds, as in biphenyl.

The term "aldehyde" as used herein is represented by the formula -C(O)H. Throughout the specification, "C(O)" is a shorthand form of carbonyl (i.e. C=O).

The term "amine" or "amino" as used herein is represented by the formula -NR¹R², wherein R¹ and R² can be independently selected from hydrogen, alkyl, cycloalkyl, alkenyl, cycloalkenyl, alkynyl, cycloalkynyl, aryl, or heteroaryl.

The term "alkylamino" as used herein is represented by the formula -NH(-alkyl), wherein alkyl is as described herein. Representative examples include but are not limited to methyl amino, ethyl amino, propyl amino, isopropyl amino, butyl amino, isobutyl amino, sec-butyl amino, tertiary butyl amino, pentyl amino, isopentyl amino, tertiary pentyl amino, hexyl amino, etc.

The term "dialkylamino" as used herein is represented by the formula -N(-alkyl)₂, wherein alkyl is as described herein. Representative examples include but are not limited to, dimethylamino, diethylamino, dipropylamino, diisopropylamino, dibutylamino, diisobutylamino, di-sec-butylamino, di-tert-butylamino, dipentylamino, diisopentylamino, di-tert-pentylamino, dihexylamino, N-ethyl-N-methylamino, N-methyl-N-propylamino, N-ethyl-N-propylamino, and the like.

The term "carboxylic acid" as used herein is represented by the formula -C(O)OH.

The term "ester" as used herein is represented by the formula OC(O)R¹ or -C(O)OR¹, wherein R¹ can be an alkyl, cycloalkyl, alkenyl, cycloalkenyl, alkynyl, cycloalkynyl, aryl or heteroaryl as described herein. The term "polyester" as used herein is represented by the formula -(R¹O(O)C-R²-C(O)O)ₐ- or -(R¹O(O)C-R²-OC(O))ₐ-, wherein R¹ and R² may independently be an alkyl, cycloalkyl, alkenyl, cycloalkenyl, alkynyl, cycloalkynyl, aryl or heteroaryl as described herein and "a" is an integer from 1 to 500. The term "polyester" is used to describe a group produced by the reaction between a compound having at least two carboxyl groups and a compound having at least two hydroxyl groups.

The term "ether" as used herein is represented by the formula R¹OR², wherein R¹ and R² can be, independently, an alkyl, cycloalkyl, alkenyl, cycloalkenyl, alkynyl, cycloalkynyl, aryl, or heteroaryl described herein. The term "polyether" as used herein is represented by the formula -(R¹O-R²O)ₐ-, where R¹ and R² may independently be an alkyl, cycloalkyl, alkenyl, cycloalkenyl, alkynyl, cycloalkynyl, aryl or heteroaryl group as described herein and "a" is an integer from 1 to 500. Examples of polyether groups include polyethylene oxide, polypropylene oxide, and polybutylene oxide.

The term "halogen" used in the present invention refers to halogen fluorine, chlorine, bromine, and iodine.

The term "heterocyclyl" as used herein refers to monocyclic and polycyclic non-aromatic ring systems having 3 to 30 carbon atoms, and "heteroaryl" as used herein refers to monocyclic and polycyclic aromatic ring systems having no more than 60 carbon atoms, wherein at least one of the ring members is not carbon. The term includes azetidinyl, dioxanyl, furanyl, imidazolyl, isothiazolyl, isoxazolyl, morpholinyl, oxazolyl (oxazolyl including 1, 2, 3-oxadiazolyl, 1, 2, 5-oxadiazolyl and 1, 3, 4-oxadiazolyl), piperazinyl, piperidinyl, pyrazinyl, pyrazolyl, pyridazinyl, pyridinyl, pyrimidinyl, pyrrolyl, pyrrolidinyl, tetrahydrofuranyl, tetrahydropyranyl, tetrazinyl including 1, 2, 4, 5-tetrazinyl, tetrazolyl including 1, 2, 3, 4-tetrazolyl and 1, 2, 4, 5-tetrazolyl, thiadiazolyl including 1, 2, 3-thiadiazolyl, 1, 2, 5-thiadiazolyl, and 1, 3, 4-thiadiazolyl, thiazolyl, thienyl, triazinyl including 1, 3, 5-triazinyl and 1, 2, 4-triazinyl, triazolyl including 1, 2, 3-triazolyl and 1, 3, 4-triazolyl, and the like.

The term "hydroxy" as used herein is represented by the formula -OH.

The term "ketone" as used herein is represented by the formula R¹C(O)R², where R¹ and R² can be, independently, an alkyl, cycloalkyl, alkenyl, cycloalkenyl, alkynyl, cycloalkynyl, aryl, or heteroaryl as described herein.

The term "azido" as used herein is represented by the formula -N₃.

The term "nitro" as used herein is represented by the formula -NO₂.

The term "nitrile" as used herein is represented by the formula -CN.

The term "silyl" as used herein is represented by the formula -SiR¹R²R³, wherein R¹, R², and R³ can be independently hydrogen or an alkyl, cycloalkyl, alkoxy, alkenyl, cycloalkenyl, alkynyl, cycloalkynyl, aryl, or heteroaryl as described herein.

The term "thio-oxo group" as used herein is represented by the formula -S(O)R¹, -S(O) ₂R¹, -OS(O) ₂R¹, or -OS(O) ₂OR¹, wherein R¹ can be hydrogen or an alkyl, cycloalkyl, alkenyl, cycloalkenyl, alkynyl, cycloalkynyl, aryl, or heteroaryl as described herein. Throughout this specification "S(O)" is a shorthand form of S=O. The term "sulfonyl", as used herein, refers to a thio-oxo group represented by the formula -S(O) ₂R¹, wherein R¹ can be alkyl, cycloalkyl, alkenyl, cycloalkenyl, alkynyl, cycloalkynyl, aryl, or heteroaryl. The term "sulfone" as used herein is represented by the formula R¹S(O) ₂R², wherein R¹ and R² may independently be an alkyl, cycloalkyl, alkenyl, cycloalkenyl, alkynyl, cycloalkynyl, aryl or heteroaryl as described herein. The term "sulfoxide" as used herein is represented by the formula R¹S(O)R², where R¹ and R² can be, independently, an alkyl, cycloalkyl, alkenyl, cycloalkenyl, alkynyl, cycloalkynyl, aryl, or heteroaryl as described herein.

The term "mercapto group" as used herein is represented by the formula -SH.

As used herein, "R¹", "R²", "R³"... "Rⁿ" (where n is an integer) can independently have one or more of the groups listed above. For example, if R¹ is a straight-chain alkyl group, one hydrogen atom of the alkyl group may be optionally substituted with hydroxyl, alkoxy, alkyl, halogen, and the like. Depending on the group selected, the first group may be incorporated within the second group, or the first group may be pendant, i.e. attached, to the second group. For example, for the phrase "amino-containing alkyl", the amino group can be incorporated within the backbone of the alkyl group. Optionally, the amino group may be attached to the backbone of the alkyl group. The nature of the selected group will determine whether the first group is embedded in or attached to the second group.

The compounds of the invention may contain "optionally substituted" moieties. In general, the term "substituted" (whether preceded by the term "optionally" or not) means that one or more hydrogens of the designated moiety are replaced with a suitable substituent. Unless otherwise specified, "optionally substituted" groups may have a suitable substituent at each substitutable position of the group, and when one or more positions in any given structure can be substituted by one or more substituents selected from the specified group, the substituents may be the same or different at each position. Combinations of substituents envisioned by this invention are preferably those that result in the formation of stable or chemically feasible compounds. It can also be envisioned that in certain aspects unless explicitly stated to the contrary, each substituent may be further optionally substituted (i.e., further substituted or unsubstituted).

The structure of the compound can be represented by the following formula:

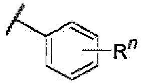

It is understood to be equivalent to the following formulas: 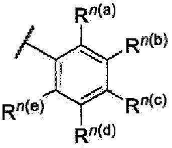 where n is usually an integer. That is, Rⁿ is understood to mean five individual substituents R^{n(a)}, R^{n(b)}, R^{n(c)}, R^{n(d)}, and R^{n(e)}. The "individual substituent" means that each R substituent can be independently defined. For example, if in one instance R^{n(a)} is halogen, then in that instance R^{n(b)} is not necessarily halogen.

R¹, R², R³, R⁴, R⁵, R⁶, etc. are mentioned several times in the chemical structures and units disclosed and described herein. Any recitation of R¹, R², R³, R⁴, R⁵, and R⁶, etc. in the specification applies to any structure or unit that recites R¹, R², R³, R⁴, R⁵, R⁶, etc. respectively, unless otherwise specified.

As used herein, the term "fused ring" means that two adjacent substituents may be fused to a five-or six-membered aromatic ring, or a heteroaromatic ring, such as a benzene ring, a pyridine ring, a pyrazine ring, a pyridazine ring, a m-diazepine ring, etc. and a saturated six- or seven-membered carbocyclic or carbocyclic ring, etc.

Photovoltaic devices using organic materials are becoming increasingly urgent for a number of reasons. Many of the materials used to make such devices are relatively inexpensive, so organic devices have the potential for cost advantages of inorganic devices. In addition, the inherent properties of organic materials, such as their flexibility, can make them well suited for particular applications such as fabrication on flexible substrates. Examples of organic photovoltaic devices include organic light-emitting diodes (OLED), organic phototransistors, organic photovoltaic cells, and organic photodetectors. For OLED, organic materials may have performance advantages over conventional materials. For example, the wavelength at which the organic light-emitting layer emits light can generally be easily tuned with an appropriate dopant.

Exciton decays from the singlet excited state to the ground state to produce instant luminescence, which is fluorescence. Exciton decays from the triplet excited state to the ground state to produce luminescence, which is phosphorescence. Phosphorescent metal complexes, such as platinum complexes, have shown their potential to utilize both singlet and triplet excitons to achieve 100% internal quantum efficiency due to strong spin-orbit coupling of heavy metal atoms between singlet and triplet excited states, effectively enhancing intersystem ISC. Phosphorescent metal complexes are therefore good candidates for dopants in the emissive layer of organic light-emitting diodes (OLED) and have gained great interest in academic and industrial fields. Many efforts have been made over the past decade, leading to the profitable commercialization of this technology. For example, OLED has been used for advanced displays for smartphones, televisions, and digital cameras.

However, to date, blue electroluminescent devices remain the most challenging area of technology, and the stability of blue devices is a major problem. The choice of host material has proven to be very important for the stability of the blue device. However, the lowest energy of the triplet excited state (T₁) of the blue light-emitting material is very high, which means that the lowest energy of the triplet excited state (T₁) of the host material of the blue device should be higher. This leads to increased difficulty in developing the body material of the blue device.

The metal complexes of the present invention can be tailored or tuned to specific applications where specific emission or absorption characteristics are desired. The optical properties of the metal complexes in the present disclosure can be tuned by changing the structure of the ligand around the metal center or changing the structure of the fluorescent emitter on the ligand. For example, metal complexes having an electron-withdrawing substituent ligand or an electron-donating substituent ligand may generally exhibit different optical properties in emission and absorption spectra. The color of the metal complex can be tuned by modifying the conjugated groups on the fluorescent emitter and the ligand.

The emission of such complexes of the invention can be modulated, for example, by changing the ligand or fluorescent emitter structure, for example from ultraviolet to near-infrared. A fluorescent emitter is a group of atoms in an organic molecule that can absorb energy to produce a singlet excited state, and a singlet exciton decays rapidly to produce instant luminescence. In one aspect, the complexes of the invention can provide emission in a substantial portion of the visible spectrum. In particular examples, the complexes of the invention can emit light in the range of about 400 nm to about 700 nm. On the other hand, the complexes of the present invention have improved stability and efficiency over conventional emissive complexes. In addition, the complexes of the invention can be used as luminescent labels for e.g. biological applications, anticancer agents, emitters in organic light-emitting diodes (OLED), or combinations thereof. In another aspect, the complexes of the present invention can be used in light-emitting devices such as compact fluorescent lamps (CFL), light-emitting diodes (LED), incandescent lamps, and combinations thereof.

Disclosed herein are compounds or complexes comprising platinum. The terms compound or complex are used interchangeably herein. In addition, the compounds disclosed herein have a neutral charge.

The compound disclosed herein can exhibit desirable properties and have emission and/or absorption spectra that can be modulated by the selection of appropriate ligands. In another aspect, the invention may exclude any one or more compounds, structures, or portions thereof specifically recited herein.

The compounds disclosed herein are suitable for use in a wide variety of optical and electro-optical devices, including but not limited to light-absorbing devices, such as solar and photosensitive devices, organic light-emitting diodes (OLED), light-emitting devices or devices that are compatible with light absorption and emission, and as labels for biological applications.

As noted above, the disclosed compounds are platinum complexes. Also, the compounds disclosed herein can be used as host materials for OLED applications, such as full-color displays.

The compounds disclosed herein can be used in a variety of applications. As the light-emitting material, the compound can be used in organic light-emitting diodes (OLED), light-emitting devices and displays, and other light-emitting devices.

The compounds of the present invention can be prepared using a variety of methods, including but not limited to those described in the examples provided herein.

The compounds disclosed herein may be a delayed fluorescent and/or phosphorescent emitter. In one aspect, the compound disclosed herein may be a delayed fluorescent emitter. In one aspect, the compound disclosed herein may be a phosphorescent emitter. In another aspect, the compound disclosed herein may be a delayed fluorescence emitter and phosphorescent emitter.

The present disclosure relates to multidentate dinuclear cyclometalated complex platinum complexes useful as light-emitting materials and host materials in OLED devices.

Unless otherwise noted, all commercial reagents involved in the following experiments were used as received without further purification. Both hydrogen and carbon NMR spectra were measured in deuterated chloroform (CDCl₃) or deuterated dimethylsulfoxide (DMSO-d₆) solutions, hydrogen spectra using a 400 or 500 MHz NMR spectrometer and carbon spectra using a 100 or 126 MHz NMR spectrometer, with chemical shifts referenced to tetramethylsilane (TMS) or residual solvent. If CDCl₃ was used as a solvent, the hydrogen and carbon spectra were internally referenced to TMS (δ = 0.00 ppm) and CDCl₃ (δ = 77.00 ppm), respectively. If DMSO-d₆ was used as a solvent, the hydrogen and carbon spectra were internally referenced to TMS (δ = 0.00 ppm) and DMSO-d₆ (δ = 39.52 ppm), respectively. The following abbreviations (or combinations) are used to explain the hydrogen spectra peaks: s = singlet, d = doublet, t = triplet, q = quartet, p = pentet, m = multiplet, br = broad. High-resolution mass spectrometry was measured on the ESI-QTOF mass spectrometer of Applied Biosystems, and the sample ionization mode was electrospray ionization.

Example 1: synthesis of key chiral segment intermediates bromide and boronate: 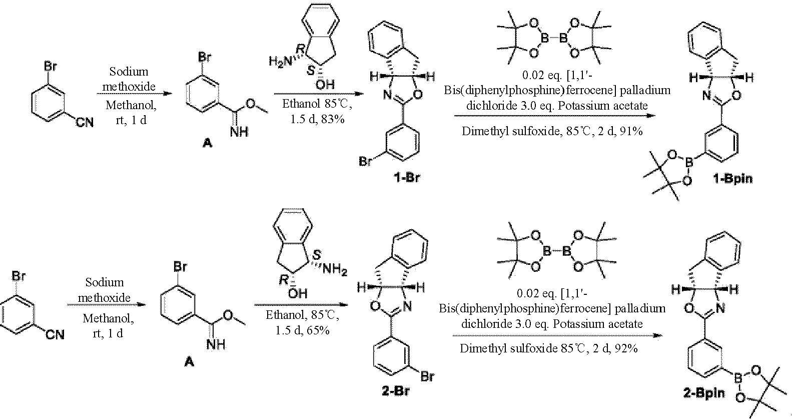
(1) Synthesis of intermediate chiral 1-Br: to a single-neck flask equipped with a magnetic rotor was added m-bromobenzonitrile (10 g, 54.94 mmol, 1.0 equivalent) followed by sodium methoxide (297 mg, 5.49 mmol, 0.1 equivalent) and stirred at room temperature for 1 day. Acetic acid was added until the solid disappeared. The solvent was distilled off under a reduced pressure to obtain crude A. (1R, 2S)-1-amino-2, 3-dihydro-1H-inden-2-ol (3.28 g, 21.97 mmol, 0.4 eq.), and absolute ethanol (30 mL) were added. The mixture was stirred in an oil bath at 85°C for the reaction for 1.5 days and cooled to room temperature. The solvent was distilled off under a reduced pressure. The crude product obtained was purified by chromatography on a silica gel column with eluent: petroleum ether/ethyl acetate = 50: 1-10: 1 to give a product 1-Br, white solid, 5.74 g, 83% yield. ¹H NMR(500 MHz, CDCl ₃):δ3.41(d, J = 18.5Hz, 1H), 3.52-3.57(m, 1H), 5.59(s, 1H), 5.81(d, J = 3.0Hz, 1H), 7.27-7.31(m, 4H), 7.60-7.65(m, 2H), 7.98-8.00(m, 1H), 8.13(s, 1H).
(2) Synthesis of intermediate chiral 1-Bpin: to a 120 ml dry sealed tube equipped with a magnetic rotor was successively added 1-Br (4.00 g, 12.70 mmol, 1.0 eq.), bis(pinacolato) diboron (4.85 g, 19.10 mmol, 1.5 eq.), [1, 1'-bis(diphenylphosphino)ferrocene] palladium dichloride (186 mg, 0.26 mmol, 0.02 eq.) and potassium acetate (3.74 g, 38.10 mmol, 3.0 eq.). The reaction system was purged with nitrogen three times and dimethyl sulfoxide (60 mL) was added under nitrogen protection. The sealed tube was stirred in an oil bath kettle at 85°C for the reaction for 2 days and cooled to room temperature. The reactant was washed with water and extracted with ethyl acetate. The aqueous layer was extracted three times with ethyl acetate. The organic phases were combined, washed once with brine, and dried over anhydrous sodium sulfate. The mixture was filtered and the solvent was distilled off under a reduced pressure. The crude product obtained was purified by chromatography on a silica gel column with eluent: petroleum ether/ethyl acetate = 15: 1-10: 1 to give a product 1-Bpin, white solid, 4.10 g, 91% yield. ¹H NMR(400 MHz, DMSO-d ₆)δ1.29(s, 12H), 3.24-3.28(m, 1H), 3.50(dd, J = 18.0, 6.8Hz, 1H), 5.49-5.56(m, 1H), 5.71(d, J = 7.6Hz, 1H), 7.23-7.31(m, 3H), 7.42-7.50(m, 2H), 7.78(d, J = 7.2Hz, 1H), 7.98-7.91(m, 1H), 8.16(s, 1H).
(3) Synthesis of intermediate chiral 2-Br: to a single-neck flask equipped with a magnetic rotor was added m-bromobenzonitrile (10 g, 54.94 mmol, 1.0 equivalent) followed by sodium methoxide (297 mg, 5.49 mmol, 0.1 equivalent) and stirred at room temperature for 1 day. Acetic acid was added until the solid disappeared. The solvent was distilled off under a reduced pressure to obtain crude A. (1S, 2R)-1-amino-2, 3-dihydro-1H-inden-2-ol (4.10g, 27.47mmol, 0.5 eq.), and absolute ethanol (30 mL) were added. The mixture was stirred in an oil bath at 85°C for the reaction for 1.5 days and cooled to room temperature. The solvent was distilled off under a reduced pressure. The crude product obtained was purified by chromatography on a silica gel column with eluent: petroleum ether/ethyl acetate = 50: 1-10: 1 to give a product 2-Br, white solid, 5.60g, 65% yield. ¹H NMR(500 MHz, CDCl ₃):δ3.40(d, J = 18.0Hz, 1H), 3.51-3.56(m, 1H), 5.57(t, J = 7.5Hz, 1H), 7.79(d, J = 8.0Hz, 1H), 7.26-7.31(m, 4H), 7.59-7.63(m, 2H), 7.96(d, J = 8.0Hz, 1H), 8.12(t, J = 2.0Hz, 1H).
(4) Synthesis of intermediate chiral 2-Bpin: to a 120 ml dry sealed tube equipped with a magnetic rotor was successively added 2-Br (4.00 g, 12.70 mmol, 1.0 eq.), bis(pinacolato) diboron (4.85 g, 19.10 mmol, 1.5 eq.), [1, 1'-bis(diphenylphosphino)ferrocene] palladium dichloride (186 mg, 0.26 mmol, 0.02 eq.) and potassium acetate (3.74 g, 38.10 mmol, 3.0 eq.). The reaction system was purged with nitrogen three times and charged with dimethyl sulfoxide (60 mL) under nitrogen protection. The sealed tube was stirred in an oil bath kettle at 85°C for the reaction for 2 days and cooled to room temperature. The reactant was washed with water and extracted with ethyl acetate. The aqueous layer was extracted three times with ethyl acetate. The organic phases were combined, washed once with brine, and dried over anhydrous sodium sulfate. The mixture was filtered and the solvent was distilled off under a reduced pressure. The crude product obtained was purified by chromatography on a silica gel column with eluent: petroleum ether/ethyl acetate = 15: 1-10: 1 to give a product 2-Bpin, white solid, 4.21 g, 92% yield. ¹H NMR(400 MHz, DMSO-d ₆)δ1.29(s, 12H), 3.24-3.28(m, 1H), 3.50(dd, J = 18.0, 6.8Hz, 1H), 5.49-5.56(m, 1H), 5.71(d, J = 7.6Hz, 1H), 7.23-7.31(m, 3H), 7.42-7.50(m, 2H), 7.78(d, J = 7.2Hz, 1H), 7.98-7.91(m, 1H), 8.16(s, 1H).

Example 2: the synthesis route of tetradentate cyclometalated platinum (II) complex *P*-PtYL1 is as follows. 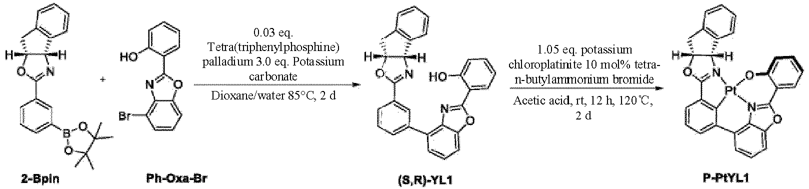
(1) Synthesis of intermediate *(S*, *R)*-YL1: to a dry schlenk tube equipped with a magnetic rotor were sequentially added 2-Bpin (325 mg, 0.90 mmol, 1.0 equivalent), Ph-Oxa-Br (261 mg, 0.90 mmol, 1.0 equivalent), tetra(triphenylphosphine) palladium (31 mg, 0.03 mmol, 0.03 equivalent), and potassium carbonate (373 mg, 2.7 mmol, 3.0 equivalent). The reaction system was purged with nitrogen three times and charged with dioxane (6 mL) and water (1 mL) under nitrogen protection. The schlenk tube was stirred in an oil bath at 85°C for the reaction for 2 days and cooled to room temperature. The solvent was distilled off under reduced pressure. The crude product obtained was purified by chromatography on a silica gel column with eluent: petroleum ether/ethyl acetate = 10: 1 to give a product *(S*, *R)*-YL1, white solid, 358 mg, 90% yield. ¹H NMR(500 MHz, DMSO-d ₆):δ(ppm)3.31-3.32(m, 1H), 3.54(dd, J = 18.0, 7.0Hz, 1H), 5.57-5.60(m, 1H), 5.77(d, J = 8.0Hz, 1H), 7.10-7.13(m, 1H), 7.16(dd, J = 8.5, 0.5Hz, 1H), 7.27-7.30(m, 2H), 7.32-7.34(m, 1H), 7.54-7.60(m, 2H), 7.65(d, J = 7.5Hz, 1H), 7.72(dd, J = 8.0, 1.0Hz, 1H), 7.88(dd, J = 8.0, 1.0Hz, 1H), 7.93(dt, J = 8.0, 1.0Hz, 1H), 8.06(dd, J = 8.0, 1.5Hz, 1H), 8.10-8.12(m, 1H), 8.54(t, J = 1.5Hz, 1H), 11.12(s, 1H).
(2) Synthesis of P-PtYL1: to a 50 mL dry three-neck flask equipped with a magnetic rotor and a condenser were sequentially added *(S, R)*-YL1 (250 mg, 0.56 mmol, 1.0 equivalent), potassium chloroplatinite (245 mg, 0.59 mmol, 1.05 equivalent), and tetra-n-butylammonium bromide (18 mg, 0.056 mmol, 10 mol%). Then, the system was purged with nitrogen three times and charged with acetic acid pre-bubbled with nitrogen gas (30 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *P*-PtYL1, light yellow solid, 237 mg, 66% yield. ¹H NMR(500 MHz, CDCl ₃):δ(ppm)3.59(d, J = 18.0Hz, 1H), 3.67(dd, J = 18.0, 6.5Hz, 1H), 5.93-5.96(m, 1H), 6.02(d, J = 7.5Hz, 1H), 6.83-6.86(m, 1H), 7.28-7.30(m, 4H), 7.39(dd, J = 8.5, 1.0Hz, 1H), 7.43(dd, J = 7.5, 1.0Hz, 1H), 7.50(t, J = 8.0Hz, 1H), 7.57-7.60(m, 2H), 8.10(d, J = 8.0Hz, 1H), 8.17(dd, J = 8.5, 1.0Hz, 1H), 8.25(dd, J = 8.0, 1.5Hz, 1H), 8.42-8.45(m, 1H).

Example 3: the synthesis route of tetradentate cyclometalated complex platinum (II) complex *M*-PtYL1 is as follows: 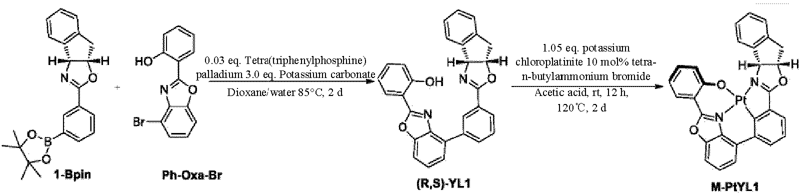
(1) Synthesis of intermediate *(R, S)*-YL1: to a dry schlenk tube equipped with a magnetic rotor were added sequentially 1-Bpin (672 mg, 1.86 mmol, 1.0 equivalent), Ph-Oxa-Br (540 mg, 1.86 mmol, 1.0 equivalent), tetra(triphenylphosphine) palladium (65 mg, 0.06 mmol, 0.03 equivalent), and potassium carbonate (772 mg, 5.58 mmol, 3.0 equivalent). The system was purged with nitrogen three times and charged with dioxane (8 mL) and water (2 mL) under nitrogen protection. The schlenk tube was stirred in an oil bath at 85°C for the reaction for 2 days and cooled to room temperature. The solvent was distilled off under reduced pressure. The crude product obtained was purified by chromatography on a silica gel column with eluent: petroleum ether/ethyl acetate = 10: 1 to give a product *(R, S)*-YL1, white solid, 797 mg, 93% yield. ¹H NMR(400 MHz, DMSO-d ₆):δ(ppm)3.30-3.38(m, 1H), 3.54(dd, J = 18.0, 6.8Hz, 1H), 5.56-5.60(m, 1H), 5.76-5.78(m, 1H), 7.09-7.13(m, 1H), 7.16(d, J = 8.4Hz, 1H), 7.26-7.34(m, 3H), 7.48-7.60(m, 3H), 7.65(t, J = 8.0Hz, 1H), 7.72(d, J = 7.6Hz, 1H), 7.88(d, J = 8.0Hz, 1H), 7.92-7.94(m, 1H), 8.06(dd, J = 8.0, 1.6Hz, 1H), 8.10-8.12(m, 1H), 8.54(t, J = 1.6Hz, 1H), 11.13(s, 1H).
(2) Synthesis of *M*-PtYL1: to a 50 mL dry three-neck flask equipped with a magnetic rotor and a condenser were sequentially added *(R, S)*-YL1 (250 mg, 0.56 mmol, 1.0 equivalent), potassium chloroplatinite (245 mg, 0.59 mmol, 1.05 equivalent), and tetra-n-butylammonium bromide (18 mg, 0.056 mmol, 10 mol%). Then, the system was purged with nitrogen three times and charged with acetic acid pre-bubbled with nitrogen gas (30 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *M*-PtYL1, light yellow solid, 213 mg, 60% yield. ¹H NMR(500 MHz, CDCl ₃):δ(ppm)3.59(d, J = 18.0Hz, 1H), 3.67(dd, J = 18.5, 6.5Hz, 1H), 5.93-5.96(m, 1H), 6.02(d, J = 7.5Hz, 1H), 6.83-6.86(m, 1H), 7.24-7.30(m, 4H), 7.39(dd, J = 8.5, 1.0Hz, 1H), 7.43(dd, J = 7.5, 1.0Hz, 1H), 7.50(t, J = 8.0Hz, 1H), 7.57-7.60(m, 2H), 8.10(d, J = 8.0Hz, 1H), 8.17(dd, J = 8.5, 1.0Hz, 1H), 8.25(dd, J = 8.0, 1.5Hz, 1H), 8.42-8.45(m, 1H).

Example 4: the synthesis route of tetradentate cyclometalated platinum (II) complex P-PtYL2 is as follows. 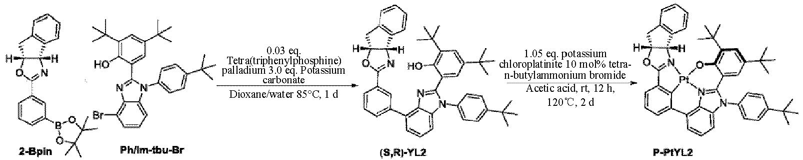
(1) Synthesis of intermediate *(S*, *R)*-YL2: to a dry schlenk tube equipped with a magnetic rotor were added sequentially 2-Bpin (203 mg, 0.56 mmol, 1.0 equivalent), Ph/Im-tbu-Br (300 mg, 0.56 mmol, 1.0 equivalent), tetra(triphenylphosphine) palladium (20 mg, 0.02 mmol, 0.03 equivalent), and potassium carbonate (232 mg, 1.68 mmol, 3.0 equivalent). The system was purged with nitrogen three times and charged with dioxane (6 mL) and water (1 mL) under nitrogen protection. The schlenk tube was stirred in an oil bath at 85°C for the reaction for 1 day and cooled to room temperature. The solvent was distilled off under reduced pressure. The crude product obtained was purified by chromatography on a silica gel column with eluent: petroleum ether/ethyl acetate = 10: 1 to give a product *(S*, *R)*-YL2, white solid, 358 mg, 93% yield. ¹H NMR(500 MHz, DMSO-d ₆):δ(ppm)0.90(s, 9H), 1.38(s, 9H), 1.43(s, 9H), 3.31-3.32(m, 1H), 3.52(dd, J = 18.0, 7.0Hz, 1H), 5.52-5.62(m, 1H), 5.76(d, J = 8.0Hz, 1H), 6.90(d, J = 2.5Hz, 1H), 7.10(dd, J = 8.0, 1.0Hz, 1H), 7.23-7.32(m, 4H), 7.41(t, J = 8.0Hz, 1H), 7.47-7.49(m, 1H), 7.52-7.55(m, 2H), 7.57(dd, J = 7.5, 1.0Hz, 1H), 7.67(t, J = 8.0Hz, 1H), 7.71-7.74(m, 2H), 7.98(dt, J = 8.0, 1.0Hz, 1H), 8.07(dt, J = 8.0, 1.0Hz, 1H), 8.59(t, J = 1.5Hz, 1H), 13.52(s, 1H).
(2) Synthesis of *P*-PtYL2: to a 50 mL dry three-neck flask equipped with a magnetic rotor and a condenser were sequentially added *(S*, *R)*-YL2 (250 mg, 0.36 mmol, 1.0 equivalent), potassium chloroplatinite (158 mg, 0.38 mmol, 1.05 equivalent), and tetra-n-butylammonium bromide (12 mg, 0.036 mmol, 10 mol%). Then, the system was purged with nitrogen three times and charged with acetic acid pre-bubbled with nitrogen gas (22 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *P*-PtYL2, yellow solid, 211 mg, 66% yield. ¹H NMR(500 MHz, DMSO-d ₆):δ(ppm)0.89(s, 9H), 1.39(s, 9H), 1.56(s, 9H), 3.51-3.55(m, 1H), 3.70(dd, J = 18.0, 6.0Hz, 1H), 5.91(d, J = 6.5Hz, 1H), 6.16(t, J = 6.5Hz, 1H), 7.15(d, J = 8.0Hz, 1H), 7.18-7.23(m, 2H), 7.28-7.35(m, 3H), 7.39(dd, J = 7.0, 1.0Hz, 2H), 7.42-7.49(m, 2H), 7.69-7.82(m, 3H), 8.04(d, J = 8.0Hz, 1H), 8.25(d, J = 8.0Hz, 1H), 8.35(dd, J = 8.5, 1.0Hz, 1H).

Example 5: the synthesis route of tetradentate cyclometalated complex platinum (II) complex *M*-PtYL2 is as follows: 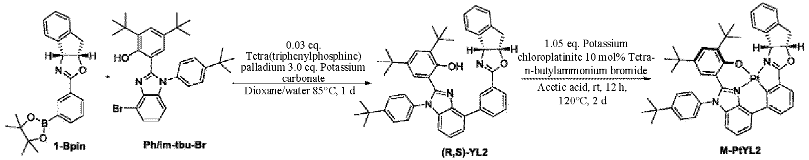
(1) Synthesis of intermediate *(R, S)*-YL2: to a dry schlenk tube equipped with a magnetic rotor were added sequentially 1-Bpin (203 mg, 0.56 mmol, 1.0 equivalent), Ph/Im-tbu-Br (300 mg, 0.56 mmol, 1.0 equivalent), tetra(triphenylphosphine) palladium (20 mg, 0.02 mmol, 0.03 equivalent), and potassium carbonate (232 mg, 1.68 mmol, 3.0 equivalent). The system was purged with nitrogen three times and charged with dioxane (6 mL) and water (1 mL) under nitrogen protection. The schlenk tube was stirred in an oil bath at 85°C for the reaction for 1 day and cooled to room temperature. The solvent was distilled off under reduced pressure. The crude product obtained was purified by chromatography on a silica gel column with eluent: petroleum ether/ethyl acetate = 10: 1 to give a product (R, S)-YL2, white solid, 333 mg, 86% yield. ¹H NMR(500 MHz, DMSO-d ₆):δ(ppm)0.90(s, 9H), 1.38(s, 9H), 1.43(s, 9H), 3.31-3.32(m, 1H), 3.52(dd, J = 18.0, 7.0Hz, 1H), 5.52-5.58(m, 1H), 5.76(d, J = 7.5Hz, 1H), 6.90(d, J = 2.5Hz, 1H), 7.10(dd, J = 8.0, 0.5Hz, 1H), 7.23-7.32(m, 4H), 7.41(t, J = 8.0Hz, 1H), 7.47-7.49(m, 1H), 7.52-7.54(m, 2H), 7.57(dd, J = 7.5, 1.0Hz, 1H), 7.67(t, J = 8.0Hz, 1H), 7.71-7.74(m, 2H), 7.98(dt, J = 8.0, 1.0Hz, 1H), 8.07(dt, J = 8.0, 1.0Hz, 1H), 8.59(t, J = 1.5Hz, 1H), 13.52(s, 1H).
(2) Synthesis of *M*-PtYL2: to a 50 mL dry three-neck flask equipped with a magnetic rotor and a condenser were sequentially added *(R, S)*-YL2 (250 mg, 0.36 mmol, 1.0 equivalent), potassium chloroplatinite (158 mg, 0.38 mmol, 1.05 equivalent), and tetra-n-butylammonium bromide (12 mg, 0.036 mmol, 10 mol%). Then, the system was purged with nitrogen three times and charged with acetic acid pre-bubbled with nitrogen gas (22 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *M*-PtYL2, light yellow solid, 206 mg, 65% yield. ¹H NMR(500 MHz, DMSO-d ₆):δ(ppm)0.89(s, 9H), 1.39(s, 9H), 1.56(s, 9H), 3.51-3.55(m, 1H), 3.70(dd, J = 18.0, 6.0Hz, 1H), 5.91(d, J = 6.5Hz, 1H), 6.16(t, J = 6.5Hz, 1H), 7.15(d, J = 8.0Hz, 1H), 7.18-7.23(m, 2H), 7.28-7.35(m, 3H), 7.39(dd, J = 7.0, 1.0Hz, 2H), 7.42-7.49(m, 2H), 7.69-7.82(m, 3H), 8.04(d, J = 8.0Hz, 1H), 8.25(d, J = 8.0Hz, 1H), 8.35(dd, J = 8.5, 1.0Hz, 1H).

Example 6: the synthesis route of tetradentate cyclometalated complex palladium (II) complex *P*-PdYL2 is as follows:

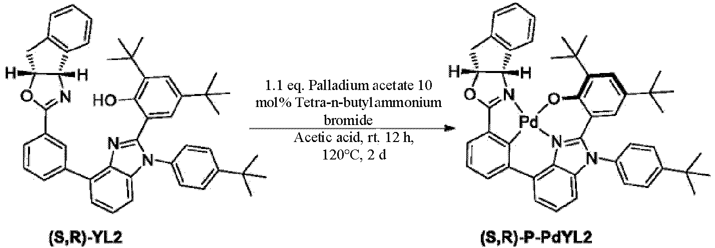

Synthesis of *P*-PdYL2: to a 50 mL dry three-neck flask equipped with a magnetic rotor and a condenser were sequentially added *(S, R)-*YL2 (300 mg, 0.44mmol, 1.0 equivalent), palladium acetate (108 mg, 0.48 mmol, 1.1 equivalent), and tetra-n-butylammonium bromide (14 mg, 0.044 mmol, 10 mol%). Then, the system was purged with nitrogen three times and charged with acetic acid pre-bubbled with nitrogen gas (26 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product P-PdYL2, light yellow solid, 208 mg, 60% yield. ¹H NMR(500 MHz, DMSO-d ₆):δ(ppm)0.88(s, 9H), 1.38(s, 9H), 1.54(s, 9H), 3.50(d, J = 18.0Hz, 1H), 3.68(dd, J = 18.0, 6.0Hz, 1H), 5.85(d, J = 7.0Hz, 1H), 6.01-6.12(m, 1H), 7.04(d, J = 2.5Hz, 1H), 7.17(d, J = 8.0Hz, 1H), 7.22(d, J = 2.5Hz, 1H), 7.25(d, J = 7.5Hz, 1H), 7.28-7.38(m, 3H), 7.38-7.41(m, 2H), 7.43(t, J = 8.0Hz, 1H), 7.65-7.82(m, 3H), 8.08(d, J = 8.0Hz, 1H), 8.17(d, J = 8.0Hz, 1H), 8.32(dd, J = 8.0, 1.0Hz, 1H).

Example 7: the synthesis route of tetradentate cyclometalated complex palladium (II) complex *M*-PdYL2 is as follows:

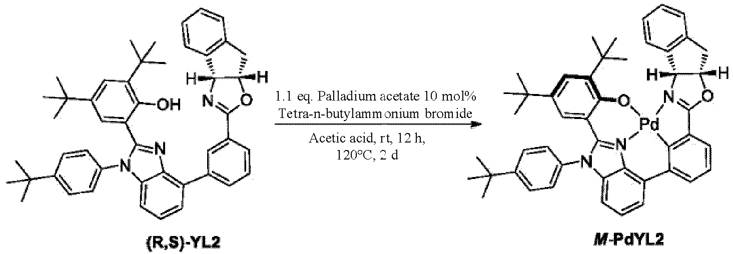

Synthesis of *M*-PdYL2: to a 50 mL dry three-neck flask equipped with a magnetic rotor and a condenser were sequentially added *(R, S)*-YL2 (250 mg, 0.36 mmol, 1.0 equivalent), palladium acetate (90 mg, 0.40 mmol, 1.1 equivalent), and tetra-n-butylammonium bromide (12 mg, 0.036 mmol, 10 mol%). Then, the system was purged with nitrogen three times and charged with acetic acid pre-bubbled with nitrogen gas (21 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *M*-PdYL2, light yellow solid, 184 mg, 64% yield. ¹H NMR(500 MHz, DMSO-d ₆):δ(ppm)0.88(s, 9H), 1.38(s, 9H), 1.54(s, 9H), 3.50(d, J = 18.0Hz, 1H), 3.68(dd, J = 18.0, 6.0Hz, 1H), 5.85(d, J = 7.0Hz, 1H), 6.01-6.12(m, 1H), 7.04(d, J = 2.5Hz, 1H), 7.17(d, J = 8.0Hz, 1H), 7.22(d, J = 2.5Hz, 1H), 7.25(d, J = 7.5Hz, 1H), 7.28-7.38(m, 3H), 7.38-7.41(m, 2H), 7.43(t, J = 8.0Hz, 1H), 7.65-7.82(m, 3H), 8.08(d, J = 8.0Hz, 1H), 8.17(d, J = 8.0Hz, 1H), 8.32(dd, J = 8.0, 1.0Hz, 1H).

Example 8: the synthesis route of tetradentate cyclometalated complex platinum (II) complex P-PtYL3 is as follows: 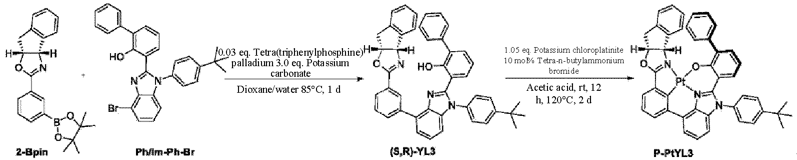
(1) Synthesis of intermediate *(S*, *R)*-YL3: to a dry schlenk tube equipped with a magnetic rotor were added sequentially 2-Bpin (181 mg, 0.50 mmol, 1.0 equivalent), Ph/Im-Ph-Br (249 mg, 0.50 mmol, 1.0 equivalent), tetra(triphenylphosphine) palladium (17 mg, 0.02 mmol, 0.03 equivalent), and potassium carbonate (207 mg, 1.50 mmol, 3.0 equivalent). The system was purged with nitrogen three times and charged with dioxane (6 mL) and water (1 mL) under nitrogen protection. The schlenk tube was stirred in an oil bath at 85°C for the reaction for 1 day and cooled to room temperature. The solvent was distilled off under reduced pressure. The crude product obtained was purified by chromatography on a silica gel column with eluent: petroleum ether/ethyl acetate = 10: 1 to give a product *(S, R)*-YL3, white solid, 238 mg, 73% yield. ¹H NMR(500 MHz, DMSO-d ₆):δ(ppm)1.41(s, 9H), 3.15-3.18(m, 1H), 3.40(dd, J = 18.0, 6.5Hz, 1H), 5.49-5.54(m, 1H), 5.73(d, J = 8.0Hz, 1H), 6.71(t, J = 8.0Hz, 1H), 6.92(dd, J = 8.0, 1.0Hz, 1H), 7.14(dd, J = 8.0, 1.0Hz, 1H), 7.19-7.27(m, 3H), 7.33(dd, J = 7.5, 1.5Hz, 1H), 7.36-7.41(m, 1H), 7.42-7.47(m, 4H), 7.55-7.60(m, 5H), 7.64(t, J = 8.0Hz, 1H), 7.72-7.74(m, 2H), 7.92(dt, J = 8.0, 1.0Hz, 1H), 8.11(dt, J = 8.0, 1.0Hz, 1H), 8.55(t, J = 1.5Hz, 1H), 13.34(s, 1H).
(2) Synthesis of *P*-PtYL3: to a 50 mL dry three-neck flask equipped with a magnetic rotor and a condenser were sequentially added *(S, R)*-YL3 (200 mg, 0.31 mmol, 1.0 equivalent), potassium chloroplatinite (134 mg, 0.32 mmol, 1.05 equivalent), and tetra-n-butylammonium bromide (10 mg, 0.031 mmol, 10 mol%). Then, the system was purged with nitrogen three times and charged with acetic acid pre-bubbled with nitrogen gas (19 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *P*-PtYL3, light yellow solid, 174 mg, 67% yield. ¹H NMR(500 MHz, DMSO-d6):δ(ppm)1.43(s, 9H), 3.41-3.44(m, 1H), 3.63(dd, J = 18.5, 7.0Hz, 1H), 5.67(d, J = 7.5Hz, 1H), 6.11-6.18(m, 1H), 6.34(dd, J = 8.5, 7.0Hz, 1H), 6.82(t, J = 7.5Hz, 1H), 6.99-7.04(m, 1H), 7.11-7.15(m, 2H), 7.20(dd, J = 8.5, 1.5Hz, 1H), 7.22-7.28(m, 3H), 7.32-7.37(m, 2H), 7.38-7.43(m, 2H), 7.50(t, J = 8.0Hz, 1H), 7.55-7.63(m, 1H), 7.69-7.79(m, 5H), 8.29(d, J = 8.0Hz, 1H), 8.38(dd, J = 8.0, 0.5Hz, 1H).

Example 9: the synthesis route of tetradentate cyclometalated complex platinum (II) complex *M*-PtYL3 is as follows: 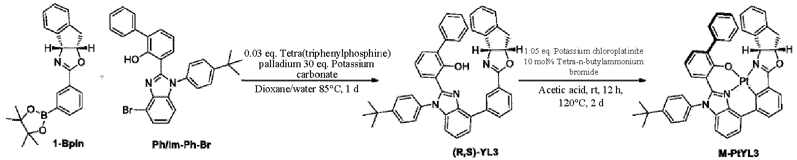
(1) Synthesis of intermediate *(R, S)*-YL3: to a dry schlenk tube equipped with a magnetic rotor were added sequentially 1-Bpin (181 mg, 0.50 mmol, 1.0 equivalent), Ph/Im-Ph-Br (249 mg, 0.50 mmol, 1.0 equivalent), tetra(triphenylphosphine) palladium (17 mg, 0.02 mmol, 0.03 equivalent), and potassium carbonate (207 mg, 1.50 mmol, 3.0 equivalent). The system was purged with nitrogen three times and charged with dioxane (6 mL) and water (1 mL) under nitrogen protection. The schlenk tube was stirred in an oil bath at 85°C for the reaction for 1 day and cooled to room temperature. The solvent was distilled off under reduced pressure. The crude product obtained was purified by chromatography on a silica gel column with eluent: petroleum ether/ethyl acetate = 10: 1 to give a product *(R, S)*-YL2, white solid, 250mg, 75% yield. ¹H NMR(500 MHz, DMSO-d ₆):δ(ppm)1.41(s, 9H), 3.15-3.18(m, 1H), 3.40(dd, J = 18.0, 6.5Hz, 1H), 5.49-5.54(m, 1H), 5.73(d, J = 8.0Hz, 1H), 6.71(t, J = 8.0Hz, 1H), 6.92(dd, J = 8.0, 1.0Hz, 1H), 7.14(dd, J = 8.0, 1.0Hz, 1H), 7.19-7.27(m, 3H), 7.33(dd, J = 7.5, 1.5Hz, 1H), 7.36-7.41(m, 1H), 7.42-7.47(m, 4H), 7.55-7.60(m, 5H), 7.64(t, J = 8.0Hz, 1H), 7.72-7.74(m, 2H), 7.92(dt, J = 8.0, 1.0Hz, 1H), 8.11(dt, J = 8.0, 1.0Hz, 1H), 8.55(t, J = 1.5Hz, 1H), 13.34(s, 1H).
(2) Synthesis of *M*-PtYL3: to a 50 mL dry three-neck flask equipped with a magnetic rotor and a condenser were sequentially added *(R, S)*-YL3 (200 mg, 0.31 mmol, 1.0 equivalent), potassium chloroplatinite (134 mg, 0.32 mmol, 1.05 equivalent), and tetra-n-butylammonium bromide (10 mg, 0.031 mmol, 10 mol%). Then, the system was purged with nitrogen three times and charged with acetic acid pre-bubbled with nitrogen gas (19 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *M*-PtYL3, light yellow solid, 173 mg, 66% yield. ¹H NMR(500 MHz, DMSO-d6):6(ppm)1.43(s, 9H), 3.41-3.44(m, 1H), 3.63(dd, J = 18.5, 7.0Hz, 1H), 5.67(d, J = 7.5Hz, 1H), 6.11-6.18(m, 1H), 6.34(dd, J = 8.5, 7.0Hz, 1H), 6.82(t, J = 7.5Hz, 1H), 6.99-7.04(m, 1H), 7.11-7.15(m, 2H), 7.20(dd, J = 8.5, 1.5Hz, 1H), 7.22-7.28(m, 3H), 7.32-7.37(m, 2H), 7.38-7.43(m, 2H), 7.50(t, J = 8.0Hz, 1H), 7.55-7.63(m, 1H), 7.69-7.79(m, 5H), 8.29(d, J = 8.0Hz, 1H), 8.38(dd, J = 8.0, 0.5Hz, 1H).

Example 10: the synthesis route of tetradentate cyclometalated complex platinum (II) complex *P*-PtYL4 is as follows: 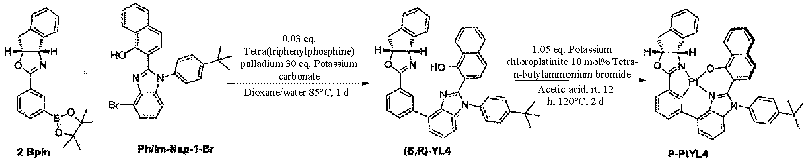
(1) Synthesis of intermediate *(S, R)*-YL4: to a dry schlenk tube equipped with a magnetic rotor were added sequentially 2-Bpin (115 mg, 0.32 mmol, 1.0 equivalent), Ph/Im-Nap-1-Br (150 mg, 0.32 mmol, 1.0 equivalent), tetra(triphenylphosphine) palladium (11 mg, 0.01 mmol, 0.03 equivalent), and potassium carbonate (132 mg, 0.96 mmol, 3.0 equivalent). The system was purged with nitrogen three times and charged with dioxane (5 mL) and water (1 mL) under nitrogen protection. The schlenk tube was stirred in an oil bath at 85°C for the reaction for 1 day and cooled to room temperature. The solvent was distilled off under reduced pressure. The crude product obtained was purified by chromatography on a silica gel column with eluent: petroleum ether/ethyl acetate = 10: 1 to give a product *(S, R)*-YL4, white solid, 79 mg, 40% yield. ¹H NMR(500 MHz, DMSO-d ₆):δ(ppm)1.42(s, 9H), 3.39-3.43(m, 1H), 3.56(dd, J = 18.0, 7.0Hz, 1H), 5.57-5.63(m, 1H), 5.79(d, J = 8.0Hz, 1H), 6.88(d, J = 9.0Hz, 1H), 7.10(d, J = 9.0Hz, 1H), 7.13(dd, J = 8.0, 1.0Hz, 1H), 7.27-7.36(m, 2H), 7.38(d, J = 7.0Hz, 1H), 7.43(t, J = 8.0Hz, 1H), 7.51(d, J = 7.0Hz, 1H), 7.58-7.64(m, 5H), 7.70(t, J = 8.0Hz, 1H), 7.72-7.76(m, 2H), 7.77-7.83(m, 1H), 7.99(dt, J = 8.0, 1.0Hz, 1H), 8.13(dt, J = 8.0, 1.0Hz, 1H), 8.30-8.36(m, 2H), 8.62(t, J = 1.5Hz, 1H), 14.60(s, 1H).
(2) Synthesis of *P*-PtYL4: to a 50 mL dry three-neck flask equipped with a magnetic rotor and a condenser were sequentially added *(S, R)*-YL4 (79 mg, 0.13 mmol, 1.0 equivalent), potassium chloroplatinite (55 mg, 0.13 mmol, 1.05 equivalent), and tetra-n-butylammonium bromide (4 mg, 0.013mmol, 10 mol%). Then, the system was purged with nitrogen three times and charged with acetic acid pre-bubbled with nitrogen gas (10 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *P*-PtYL4, light yellow solid, 55 mg, 53% yield. ¹H NMR(500 MHz, CDCl ₃):8(ppm)1.46(s, 9H), 3.66-3.75(m, 2H), 6.02-6.05(m, 1H), 6.21(d, J = 7.5Hz, 1H), 6.69(d, J = 9.0Hz, 1H), 7.13-7.19(m, 2H), 7.22(d, J = 9.0Hz, 1H), 7.26-7.28(m, 2H), 7.31(d, J = 7.5Hz, 1H), 7.33-7.40(m, 4H), 7.45-7.47(m, 1H), 7.50-7.52(m, 1H), 7.63(dd, J = 17.0, 8.0Hz, 3H), 8.13(d, J = 8.0Hz, 1H), 8.27(d, J = 8.0Hz, 1H), 8.51(d, J = 8.0Hz, 1H), 8.99(d, J = 8.0Hz, 1H).

Example 11: the synthesis route of tetradentate cyclometalated complex platinum (II) complex *M*-PtYL4 is as follows: 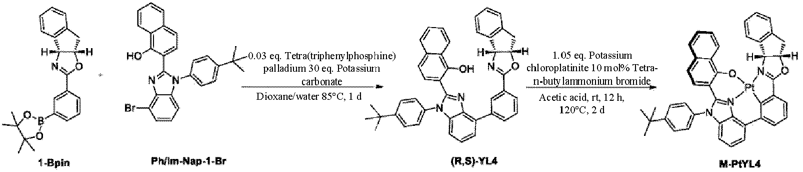
(1) Synthesis of intermediate *(R, S)*-YL4: to a dry schlenk tube equipped with a magnetic rotor were added sequentially 1-Bpin (115 mg, 0.32 mmol, 1.0 equivalent), Ph/Im-Nap-1-Br (150 mg, 0.32 mmol, 1.0 equivalent), tetra(triphenylphosphine) palladium (11 mg, 0.01 mmol, 0.03 equivalent), and potassium carbonate (132 mg, 0.96 mmol, 3.0 equivalent). The system was purged with nitrogen three times and charged with dioxane (5 mL) and water (1 mL) under nitrogen protection. The schlenk tube was stirred in an oil bath at 85°C for the reaction for 1 day and cooled to room temperature. The solvent was distilled off under reduced pressure. The crude product obtained was purified by chromatography on a silica gel column with eluent: petroleum ether/ethyl acetate = 10: 1 to give a product *(S, R)*-YL4, white solid, 100mg, 50% yield. ¹H NMR(500 MHz, DMSO-d ₆):δ(ppm)1.42(s, 9H), 3.39-3.43(m, 1H), 3.56(dd, J = 18.0, 7.0Hz, 1H), 5.57-5.63(m, 1H), 5.79(d, J = 8.0Hz, 1H), 6.88(d, J = 9.0Hz, 1H), 7.10(d, J = 9.0Hz, 1H), 7.13(dd, J = 8.0, 1.0Hz, 1H), 7.27-7.36(m, 2H), 7.38(d, J = 7.0Hz, 1H), 7.43(t, J = 8.0Hz, 1H), 7.51(d, J = 7.0Hz, 1H), 7.58-7.64(m, 5H), 7.70(t, J = 8.0Hz, 1H), 7.72-7.76(m, 2H), 7.77-7.83(m, 1H), 7.99(dt, J = 8.0, 1.0Hz, 1H), 8.13(dt, J = 8.0, 1.0Hz, 1H), 8.30-8.36(m, 2H), 8.62(t, J = 1.5Hz, 1H), 14.60(s, 1H).
(2) Synthesis of *M*-PtYL4: to a 50 mL dry three-neck flask equipped with a magnetic rotor and a condenser were sequentially added *(R, S)*-YL4 (90 mg, 0.14 mmol, 1.0 equivalent), potassium chloroplatinite (63 mg, 0.15 mmol, 1.05 equivalent), and tetra-n-butylammonium bromide (5 mg, 0.014 mmol, 10 mol%). Then, the system was purged with nitrogen three times and charged with acetic acid pre-bubbled with nitrogen gas (10 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *M*-PtYL4, light yellow solid, 64 mg, 54% yield. ¹H NMR(500 MHz, CDCl ₃):8(ppm)1.46(s, 9H), 3.66-3.75(m, 2H), 6.02-6.05(m, 1H), 6.21(d, J = 7.5Hz, 1H), 6.69(d, J = 9.0Hz, 1H), 7.13-7.19(m, 2H), 7.22(d, J = 9.0Hz, 1H), 7.26-7.28(m, 2H), 7.31(d, J = 7.5Hz, 1H), 7.33-7.40(m, 4H), 7.45-7.47(m, 1H), 7.50-7.52(m, 1H), 7.63(dd, J = 17.0, 8.0Hz, 3H), 8.13(d, J = 8.0Hz, 1H), 8.27(d, J = 8.0Hz, 1H), 8.51(d, J = 8.0Hz, 1H), 8.99(d, J = 8.0Hz, 1H).

Example 12: the synthesis route of tetradentate cyclometalated platinum (II) complex P-PtYL5 is as follows. 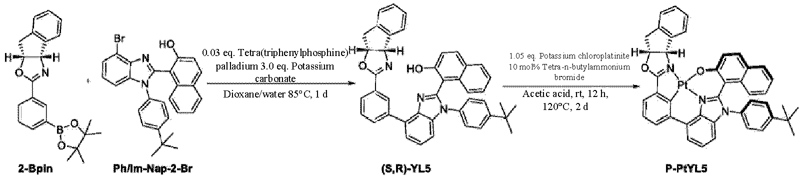
(1) Synthesis of intermediate *(S, R)*-YL5: to a dry schlenk tube equipped with a magnetic rotor were added sequentially 2-Bpin (184 mg, 0.51 mmol, 1.0 equivalent), Ph/Im-Nap-2-Br (240 mg, 0.51 mmol, 1.0 equivalent), tetra(triphenylphosphine) palladium (18 mg, 0.015 mmol, 0.03 equivalent), and potassium carbonate (211 mg, 1.53 mmol, 3.0 equivalent). The system was purged with nitrogen three times and charged with dioxane (5 mL) and water (1 mL) under nitrogen protection. The schlenk tube was stirred in an oil bath at 85°C for the reaction for 1 day and cooled to room temperature. The solvent was distilled off under reduced pressure. The crude product obtained was purified by chromatography on a silica gel column with eluent: petroleum ether/ethyl acetate = 10: 1 to give a product *(S, R)*-YL5, white solid, 204 mg, 64% yield. ¹H NMR(500 MHz, CDCl ₃):δ(ppm)1.19(s, 9H), 3.44-3.56(m, 2H), 5.51-5.55(m, 1H), 5.78(d, J = 8.0Hz, 1H), 6.90-6.95(m, 1H), 7.05(t, J = 7.5Hz, 3H), 7.19(d, J = 8.0Hz, 2H), 7.24-7.25(m, 2H), 7.27-7.29(m, 2H), 7.34(d, J = 8.5Hz, 1H), 7.40(t, J = 8.0Hz, 1H), 7.50(d, J = 8.0Hz, 1H), 7.53(t, J = 8.0Hz, 1H), 7.56-7.60(m, 3H), 7.76(d, J = 9.0Hz, 1H), 7.98(d, J = 8.0Hz, 1H), 8.27(d, J = 8.0Hz, 1H), 8.52(t, J = 1.5Hz, 1H), 10.61(s, 1H).
(2) Synthesis of *P*-PtYL5: to a 50 mL dry three-neck flask equipped with a magnetic rotor and a condenser were sequentially added *(S, R)*-YL5 (170 mg, 0.27 mmol, 1.0 equivalent), potassium chloroplatinite (118 mg, 0.29 mmol, 1.05 equivalent), and tetra-n-butylammonium bromide (9 mg, 0.027 mmol, 10 mol%). Then, the system was purged with nitrogen three times and charged with acetic acid pre-bubbled with nitrogen gas (17 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *P*-PtYL5, light yellow solid, 130 mg, 61% yield. ¹H NMR(500 MHz, DMSO-d ₆):δ(ppm)1.18(s, 9H), 1.19(s, 9H), 3.51(d, J = 5.0Hz, 1H), 3.54(d, J = 5.0Hz, 1H), 3.69(t, J = 6.5Hz, 1H), 3.72(t, J = 6.5Hz, 1H), 5.92(d, J = 8.0Hz, 1H), 5.96(d, J = 7.5Hz, 1H), 6.15-6.21(m, 2H), 6.75-6.83(m, 2H), 6.85-6.93(m, 2H), 7.06-7.34(m, 9H), 7.34-7.42(m, 9H), 7.44-7.46(m, 2H), 7.49-7.56(m, 6H), 7.62(t, J = 7.0Hz, 2H), 7.82(d, J = 9.0Hz, 1H), 7.87(d, J = 9.0Hz, 1H), 8.15(d, J = 8.0Hz, 1H), 8.26(d, J = 8.0Hz, 1H), 8.29(d, J = 8.0Hz, 1H), 8.36-8.40(m, 2H), 8.45-8.49(m, 1H).

Example 13: the synthesis route of tetradentate cyclometalated complex platinum (II) complex *M*-PtYL5 is as follows: 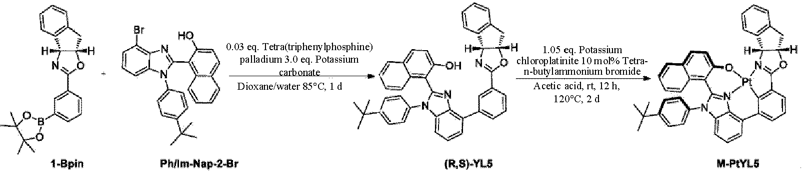
(1) Synthesis of intermediate *(R, S)*-YL5: to a dry schlenk tube equipped with a magnetic rotor were added sequentially 1-Bpin (184 mg, 0.51 mmol, 1.0 equivalent), Ph/Im-Nap-2-Br (240 mg, 0.51 mmol, 1.0 equivalent), tetra(triphenylphosphine) palladium (18 mg, 0.015 mmol, 0.03 equivalent), and potassium carbonate (211 mg, 1.53 mmol, 3.0 equivalent). The system was purged with nitrogen three times and charged with dioxane (5 mL) and water (1 mL) under nitrogen protection. The schlenk tube was stirred in an oil bath at 85°C for the reaction for 1 day and cooled to room temperature. The solvent was distilled off under reduced pressure. The crude product obtained was purified by chromatography on a silica gel column with eluent: petroleum ether/ethyl acetate = 10: 1 to give a product *(S, R)*-YL5, white solid, 190 mg, 60% yield. ¹H NMR(500 MHz, CDCl ₃):δ(ppm)1.19(s, 9H), 3.44-3.56(m, 2H), 5.51-5.55(m, 1H), 5.78(d, J = 8.0Hz, 1H), 6.90-6.95(m, 1H), 7.05(t, J = 7.5Hz, 3H), 7.19(d, J = 8.0Hz, 2H), 7.24-7.25(m, 2H), 7.27-7.29(m, 2H), 7.34(d, J = 8.5Hz, 1H), 7.40(t, J = 8.0Hz, 1H), 7.50(d, J = 8.0Hz, 1H), 7.53(t, J = 8.0Hz, 1H), 7.56-7.60(m, 3H), 7.76(d, J = 9.0Hz, 1H), 7.98(d, J = 8.0Hz, 1H), 8.27(d, J = 8.0Hz, 1H), 8.52(t, J = 1.5Hz, 1H), 10.61(s, 1H).
(2) Synthesis of M- PtYL5: to a 50 mL dry three-neck flask equipped with a magnetic rotor and a condenser were sequentially added *(R, S)*-YL5 (161 mg, 0.26 mmol, 1.0 equivalent), potassium chloroplatinite (112 mg, 0.27 mmol, 1.05 equivalent), and tetra-n-butylammonium bromide (8 mg, 0.026 mmol, 10 mol%). Then, the system was purged with nitrogen three times and charged with acetic acid pre-bubbled with nitrogen gas (16 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *M*-PtYL5, light yellow solid, 120 mg, 57% yield. ¹H NMR(500 MHz, DMSO-d ₆):δ(ppm)1.18(s, 9H), 1.19(s, 9H), 3.51(d, J = 5.0Hz, 1H), 3.54(d, J = 5.0Hz, 1H), 3.69(t, J = 6.5Hz, 1H), 3.72(t, J = 6.5Hz, 1H), 5.92(d, J = 8.0Hz, 1H), 5.96(d, J = 7.5Hz, 1H), 6.15-6.21(m, 2H), 6.75-6.83(m, 2H), 6.85-6.93(m, 2H), 7.06-7.34(m, 9H), 7.34-7.42(m, 9H), 7.44-7.46(m, 2H), 7.49-7.56(m, 6H), 7.62(t, J = 7.0Hz, 2H), 7.82(d, J = 9.0Hz, 1H), 7.87(d, J = 9.0Hz, 1H), 8.15(d, J = 8.0Hz, 1H), 8.26(d, J = 8.0Hz, 1H), 8.29(d, J = 8.0Hz, 1H), 8.36-8.40(m, 2H), 8.45-8.49(m, 1H).

Example 14: the synthesis route of tetradentate cyclometalated complex platinum (II) complex *P-*PtYL6 is as follows: 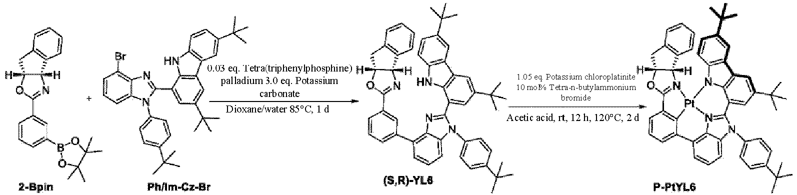
(1) Synthesis of intermediate *(S, R)*-YL6: to a dry schlenk tube equipped with a magnetic rotor were added sequentially 2-Bpin (142 mg, 0.39 mmol, 1.0 equivalent), Ph/Im-Cz-Br (250 mg, 0.41 mmol, 1.0 equivalent), tetra(triphenylphosphine) palladium (14 mg, 0.012 mmol, 0.03 equivalent), and potassium carbonate (163 mg, 1.18 mmol, 3.0 equivalent). The system was purged with nitrogen three times and charged with dioxane (4 mL) and water (1 mL) under nitrogen protection. The schlenk tube was stirred in an oil bath at 85°C for the reaction for 1 day and cooled to room temperature. The solvent was distilled off under reduced pressure. The crude product obtained was purified by chromatography on a silica gel column with eluent: petroleum ether/ethyl acetate = 10: 1 to give a product *(S, R)-*YL6, white solid, 255 mg, 86% yield. ¹H NMR(500 MHz, CDCl ₃):δ(ppm)1.11(s, 9H), 1.44(s, 9H), 1.46(s, 9H), 3.26-3.33(m, 1H), 3.41(dd, J = 18.0, 7.0Hz, 1H), 5.47-5.50(m, 1H), 5.82(d, J = 8.0Hz, 1H), 7.17(dd, J = 8.0, 1.0Hz, 1H), 7.20(d, J = 2.0Hz, 1H), 7.20-7.24(m, 1H), 7.26-7.28(m, 2H), 7.31-7.36(m, 2H), 7.42-7.48(m, 3H), 7.54(dd, J = 7.5, 1.0Hz, 1H), 7.57-7.60(m, 1H), 7.62(t, J = 8.0Hz, 1H), 7.65-7.68(m, 2H), 8.05-8.11(m, 3H), 8.30(dt, J = 8.0, 1.5Hz, 1H), 8.84(t, J = 1.5Hz, 1H), 11.17(s, 1H).
(2) Synthesis of *P*-PtYL6: to a 50 mL dry three-neck flask equipped with a magnetic rotor and a condenser were sequentially added *(S, R)*-YL6 (200 mg, 0.26 mmol, 1.0 equivalent), potassium chloroplatinite (115 mg, 0.28 mmol, 1.05 equivalent), and tetra-n-butylammonium bromide (9 mg, 0.026 mmol, 10 mol%). Then, the system was purged with nitrogen three times and charged with acetic acid pre-bubbled with nitrogen gas (16 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *P*-PtYL6, light yellow solid, 157 mg, 63% yield. ¹H NMR(500 MHz, CDCl ₃):δ(ppm)1.14(s, 9H), 1.43(s, 9H), 1.44(s, 9H), 3.45-3.53(m, 2H), 5.89-5.92(m, 1H), 6.32(d, J = 8.0Hz, 1H), 6.43(d, J = 7.0Hz, 1H), 6.69(t, J = 7.5Hz, 1H), 6.93-7.01(m, 2H), 7.05(d, J = 8.0Hz, 1H), 7.08(d, J = 7.5Hz, 1H), 7.33(t, J = 7.5Hz, 1H), 7.37(t, J = 8.0Hz, 1H), 7.43(dd, J = 8.5, 2.0Hz, 1H), 7.47(d, J = 2.0Hz, 1H), 7.48-7.53(m, 2H), 7.77-7.84(m, 3H), 8.12(d, J = 2.0Hz, 1H), 8.14(d, J = 8.0Hz, 1H), 8.31(d, J = 2.0Hz, 1H), 8.33(d, J = 8.0Hz, 1H).

Example 15: the synthesis route of tetradentate cyclometalated complex platinum (II) complex *M*-PtYL6 is as follows: 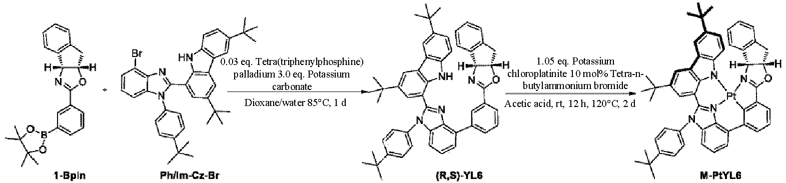
(1) Synthesis of intermediate *(R, S)*-YL6: to a dry schlenk tube equipped with a magnetic rotor were added sequentially 1-Bpin (147 mg, 0.41 mmol, 1.0 equivalent), Ph/Im-Cz-Br (300 mg, 0.41 mmol, 1.0 equivalent), tetra(triphenylphosphine) palladium (14 mg, 0.012 mmol, 0.03 equivalent), and potassium carbonate (169 mg, 1.22 mmol, 3.0 equivalent). The system was purged with nitrogen three times and charged with dioxane (4 mL) and water (1 mL) under nitrogen protection. The schlenk tube was stirred in an oil bath at 85°C for the reaction for 1 day and cooled to room temperature. The solvent was distilled off under reduced pressure. The crude product obtained was purified by chromatography on a silica gel column with eluent: petroleum ether/ethyl acetate = 10: 1 to give a product *(S, R)*-YL6, white solid, 298 mg, 80% yield. ¹H NMR(500 MHz, CDCl ₃):δ(ppm)1.11(s, 9H), 1.44(s, 9H), 1.46(s, 9H), 3.26-3.33(m, 1H), 3.41(dd, J = 18.0, 7.0Hz, 1H), 5.47-5.50(m, 1H), 5.82(d, J = 8.0Hz, 1H), 7.17(dd, J = 8.0, 1.0Hz, 1H), 7.20(d, J = 2.0Hz, 1H), 7.20-7.24(m, 1H), 7.26-7.28(m, 2H), 7.31-7.36(m, 2H), 7.42-7.48(m, 3H), 7.54(dd, J = 7.5, 1.0Hz, 1H), 7.57-7.60(m, 1H), 7.62(t, J = 8.0Hz, 1H), 7.65-7.68(m, 2H), 8.05-8.11(m, 3H), 8.30(dt, J = 8.0, 1.5Hz, 1H), 8.84(t, J = 1.5Hz, 1H), 11.17(s, 1H).
(2) Synthesis of *M*-PtYL6: to a 50 mL dry three-neck flask equipped with a magnetic rotor and a condenser were sequentially added *(R, S)*-YL6 (180 mg, 0.24 mmol, 1.0 equivalent), potassium chloroplatinite (103 mg, 0.25 mmol, 1.05 equivalent), and tetra-n-butylammonium bromide (8 mg, 0.024 mmol, 10 mol%). Then, the system was purged with nitrogen three times and charged with acetic acid pre-bubbled with nitrogen gas (15 mL). After bubbling nitrogen gas for 30 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *M*-PtYL6, light yellow solid, 120 mg, 52% yield. ¹H NMR(500 MHz, DMSO-d ₆):δ(ppm)1.11(s, 9H), 1.40(s, 9H), 1.42(s, 9H), 3.41-3.43(m, 1H), 3.54(dd, J = 18.0, 6.5Hz, 1H), 6.11(t, J = 6.5Hz, 1H), 6.16(d, J = 8.0Hz, 1H), 6.28(d, J = 7.0Hz, 1H), 6.61(t, J = 8.0Hz, 1H), 7.01(t, J = 7.5Hz, 1H), 7.04(d, J = 8.0Hz, 1H), 7.14(dd, J = 8.0, 2.5Hz, 1H), 7.19(d, J = 7.5Hz, 1H), 7.39(t, J = 7.5Hz, 1H), 7.43-7.52(m, 4H), 7.64(dd, J = 8.5, 2.5Hz, 1H), 7.78(d, J = 8.5Hz, 1H), 7.94(dd, J = 8.0, 2.5Hz, 1H), 8.05(dd, J = 8.0, 2.5Hz, 1H), 8.23(d, J = 2.0Hz, 1H), 8.33(d, J = 8.0Hz, 1H), 8.44(d, J = 2.0Hz, 1H), 8.47(dd, J = 8.0, 0.5Hz, 1H).

Example 16: the synthesis route of tetradentate cyclometalated complex platinum (II) complex *P*-PtYL35 is as follows: 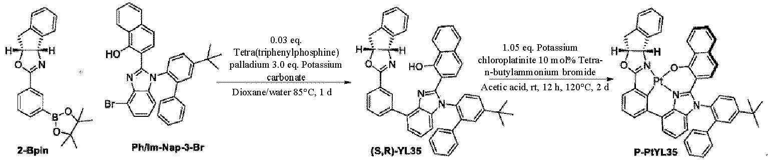
(1) Synthesis of intermediate *(S, R)-*YL35: to a 100 mL dry three-necked flask equipped with a magnetic rotor were successively added 2-Bpin (2.08 g, 5.76 mmol, 1.0 equivalent), Ph/Im-Nap-3-Br (3.15 mg, 5.76 mmol, 1.0 equivalent), tetra(triphenylphosphine) palladium (200 mg, 0.17 mmol, 0.03 equivalent), and potassium carbonate (2.39 mg, 17.30 mmol, 3.0 equivalent). The system was purged with nitrogen three times and charged with dioxane (30 mL) and water (6 mL) under nitrogen protection. The three-neck flask was stirred in an oil bath at 85°C for the reaction for 1 day and cooled to room temperature. The solvent was distilled off under reduced pressure. The crude product obtained was purified by chromatography on a silica gel column with eluent: petroleum ether/ethyl acetate = 10: 1 to give a product *(S, R)*-YL35, white solid, 3.90 g, 97% yield. ¹H NMR(500 MHz, DMSO-d ₆):δ(ppm)1.43(s, 9H), 3.36(d, J = 5.0Hz, 1H), 3.48-3.57(m, 1H), 5.53-5.59(m, 1H), 5.76(d, J = 8.5Hz, 1H), 6.84-6.88(m, 2H), 6.93-6.98(m, 3H), 7.03(t, J = 7.5Hz, 2H), 7.09(d, J = 9.0Hz, 1H), 7.26-7.36(m, 4H), 7.50(t, J = 6.5Hz, 2H), 7.57(dd, J = 6.5, 3.0Hz, 2H), 7.61-7.68(m, 3H), 7.72(dd, J = 8.5, 2.0Hz, 1H), 7.77(dd, J = 6.0, 3.0Hz, 1H), 7.92-7.98(m, 1H), 8.04(d, J = 8.0Hz, 1H), 8.26(dd, J = 6.0, 3.5Hz, 1H), 8.54-8.57(m, 1H), 14.62(s, 1H).
(2) Synthesis of *P*-PtYL35: to a 1000 mL dry three-neck flask equipped with a magnetic rotor and a condenser were sequentially added *(S, R)-*YL35 (4.98 g, 7.1 mmol, 1.0 equivalent), potassium chloroplatinite (3.09 g, 7.4 mmol, 1.05 equivalent), and tetra-n-butylammonium bromide (0.29 g, 0.71 mmol, 10 mol%). Then, the system was purged with nitrogen three times and charged with acetic acid pre-bubbled with nitrogen gas (426 mL). After bubbling nitrogen gas for 60 minutes, the reaction liquid was stirred at room temperature for 12 hours, then at 120°C for 2 days, and cooled to room temperature. The solvent was distilled off under a reduced pressure. The crude product obtained was purified by chromatography on a silica gel column with eluent: petroleum ether/dichloromethane = 1: 1 to give a product *P-*PtYL35, light yellow solid, 4.57 g, 72% yield. ¹H NMR(500 MHz, CDCl ₃):δ(ppm)1.51(s, 9H), 3.62-3.73(m, 2H), 6.02(td, J = 6.5, 5.5, 1.5Hz, 1H), 6.19(d, J = 7.5Hz, 1H), 6.75(d, J = 9.5Hz, 1H), 6.89(d, J = 8.0Hz, 1H), 6.98-7.05(m, 3H), 7.11-7.17(m, 3H), 7.24(d, J = 8.0Hz, 1H), 7.25-7.26(m, 1H), 7.29(d, J = 7.5Hz, 1H), 7.32-7.38(m, 2H), 7.42-7.49(m, 3H), 7.50-7.54(m, 1H), 7.59-7.64(m, 2H), 7.71(d, J = 2.0Hz, 1H), 8.02(d, J = 8.0Hz, 1H), 8.22(d, J = 7.5Hz, 1H), 8.45(d, J = 7.5Hz, 1H), 8.96(d, J = 8.5Hz, 1H).

### Electrochemical, photophysical testing, and theoretical calculation explanation:

Absorption spectra were measured at room temperature on an Agilent 8453 UV-Vis spectrometer; steady-state emission experiments and lifetime measurements were performed using a Horiba Jobin Yvon FluoroLog-3 spectrometer, or the steady state emission spectra were performed on a SHIMADZU RF-6000 spectrometer. Low temperature (77 K) emission spectra and lifetime were measured in 2-Methyltetrahydrofuran (2-MeTHF) solution cooled with liquid nitrogen. Pt(II) complexes were theoretically calculated using the Gaussian 09 software package, and the geometry of the ground state (S₀) molecule was optimized using density-functional theory (DFT). DFT calculations were performed using B3LYP functional where the 6-31G(d) basis set was used for C, H, O and N atoms and the LANL2DZ basis set was used for Pt and Pd atoms. Circular dichroism (CD) and circularly polarized light measurements were performed on Japanese spectrophotometers JASCO J-815 and JASCO CPL-300, respectively, and the testing conditions were all dichloromethane solution at room temperature.

### Experimental data and analysis

FIG. 1 is a conceptual diagram showing the design of an optically pure helical-chiral tetradentate cyclometalated complex circularly polarized light-emitting material centered on a metal ion. The optically pure raw materials are readily available; helical chirality can be spontaneously induced by central chirality. The circularly polarized light-emitting materials do not require chiral resolution, greatly saving the preparation cost of optically pure materials, and can be prepared in large quantities without the limitation of chiral preparative chromatographic column resolution.

In FIG. 2, it can be seen the tetradentate cyclometalated platinum (II) complex after density functional theory (DFT) calculation optimization shows that the generation of M-type helical-chiral can be actively induced for the ligand containing central chirality *(R, S),* and the generation of P-type helical-chiral can be actively induced for the ligand containing central chirality *(S, R),* and the M-type helical-chiral molecule and the P-type helical-chiral molecule are enantiomers of each other. In addition, the molecular structures of the optimized tetradentate cyclometalated complex palladium (II) complexes calculated by DFT have similar results.

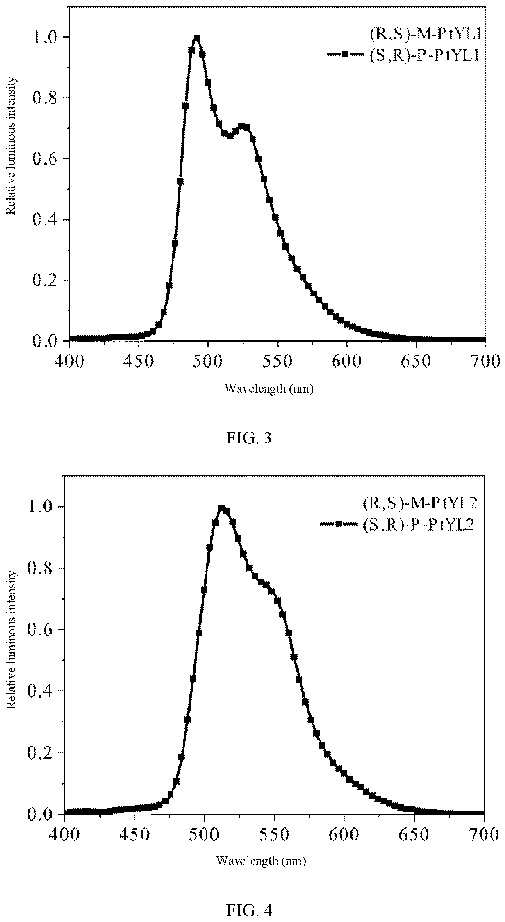

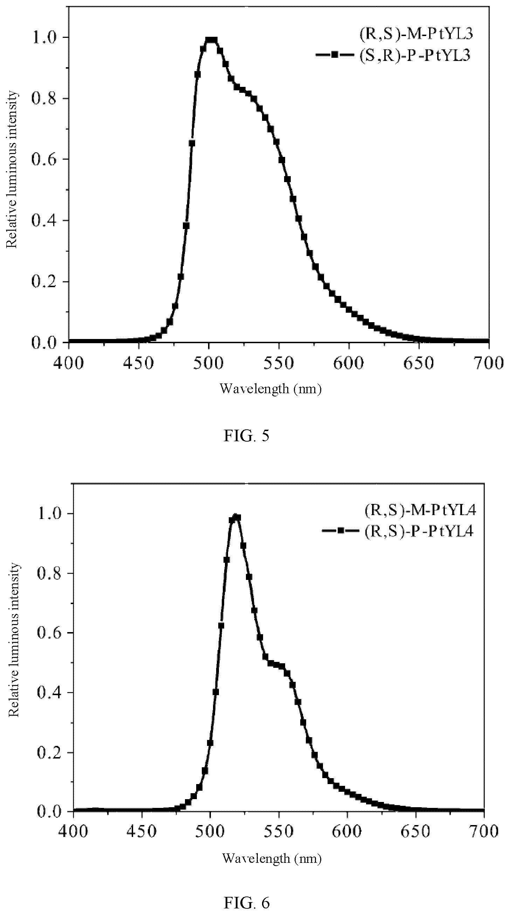

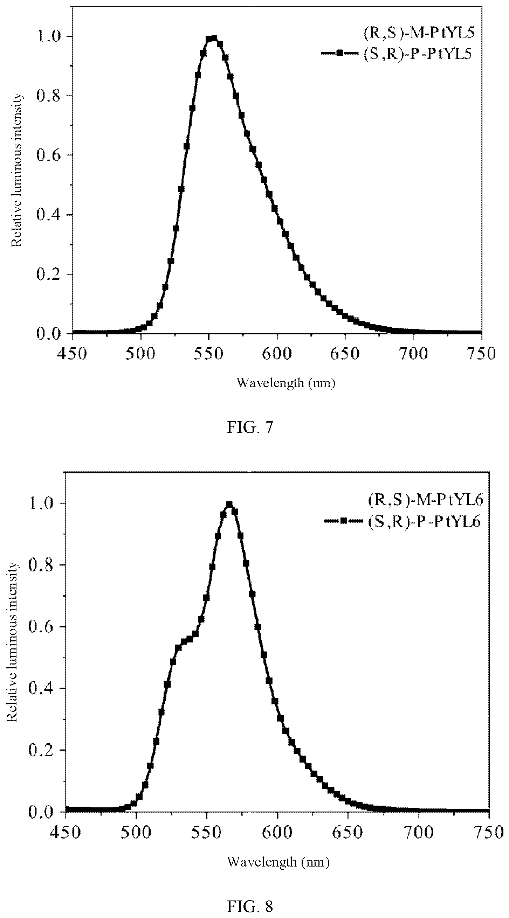

It can be seen from the emission spectra of the optically pure helical-chiral material molecules synthesized in FIGs. 3-9 in a dichloromethane solution at room temperature that the luminescent color of the cyclometalated complex can be efficiently regulated by regulating the structure of the tetradentate ligand, and the green light region of about 470 nm to the yellow light region of 570 nm can be regulated. Furthermore, the emission spectra in FIG. 3 to 9 are substantially completely coincident, further confirming that the corresponding material molecules in the Figures are enantiomers.

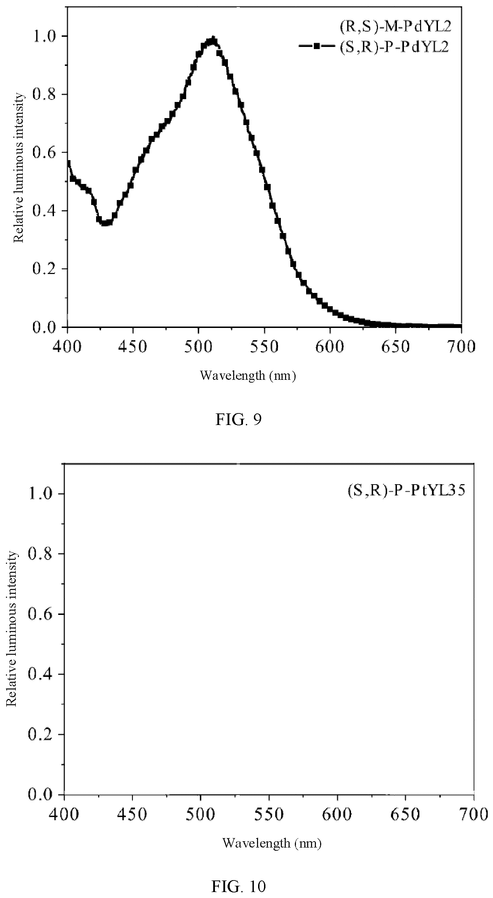

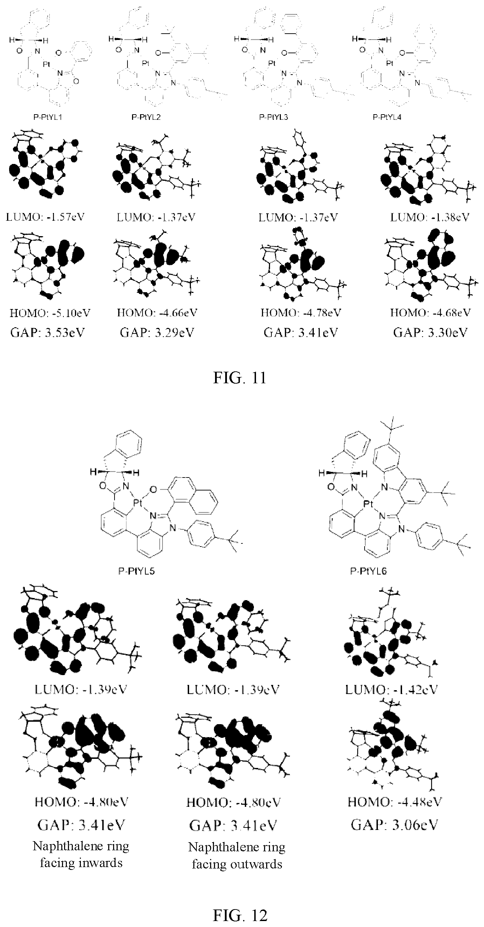

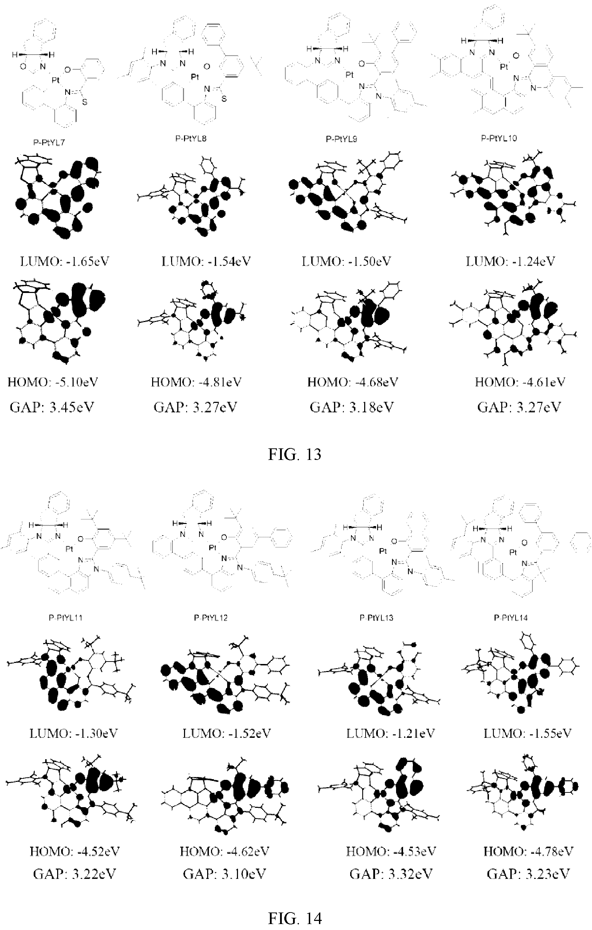

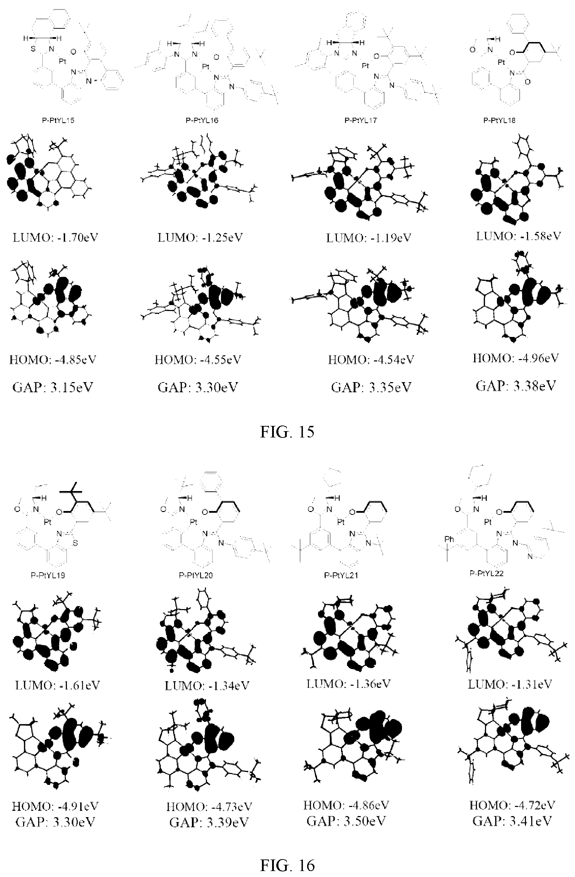

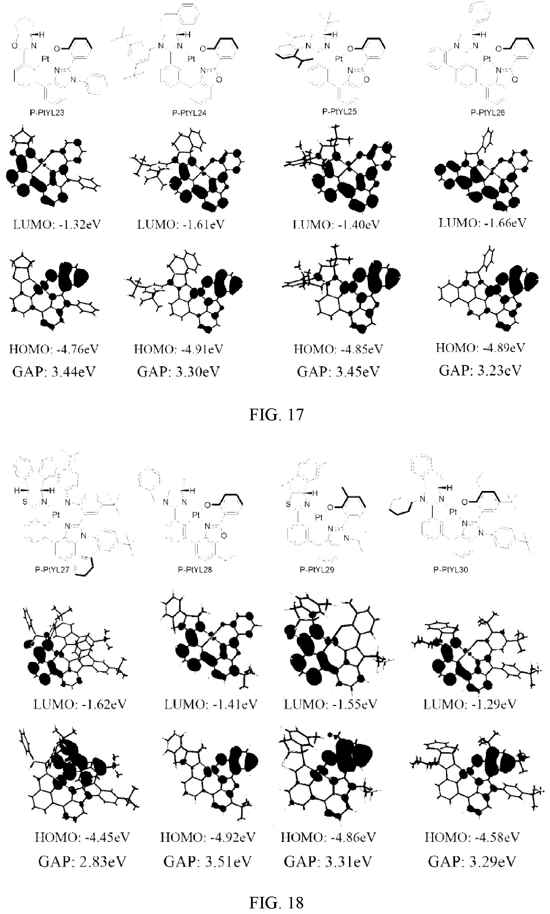

FIG. 10 to FIG. 18 are the HOMO and LUMO orbital distributions of compounds *P-*PtYL1, *P*-PtYL2, *P*-PtYL3, and *P*-PtYL34. From the calculation results of density functional theory (DFT) (Table 3), it can be seen that Pt-4, Pt-5, Pt-16, Pt-17, etc. have almost the same HOMO orbital distribution. The HOMO orbital distributions are mainly concentrated on the phenyl group connected with phenolic oxygen and the deprotonated carbazolyl group. The alkyl substitution has a slight effect on the HOMO orbital distribution. The aryl and heteroaryl also delocalize the electron cloud, reduce the HOMO energy level and increase the energy gap, resulting in a blue shift of the luminescence of the metal complex. The LUMO orbitals such as Pt-18, Pt-20, Pt-28, and Pt-30 are mainly concentrated on the phenyl group at the para-position of the phenolic oxygen, and the LUMO energy level can be effectively regulated by introducing alkyl, aryl, and hetero atoms at this position, achieving the photophysical property regulation of light-emitting materials. It can be seen from the trend of the dihedral angle in Table 3 that whether the chiral segment is rigid or not determines the size of the dihedral angle to a large extent and further influences the g value response value of the helical-chiral complex.

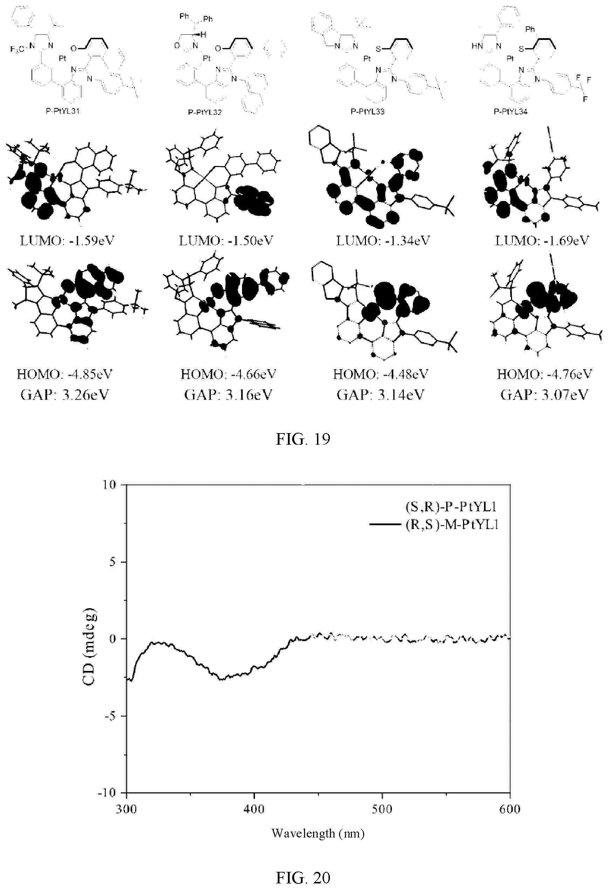

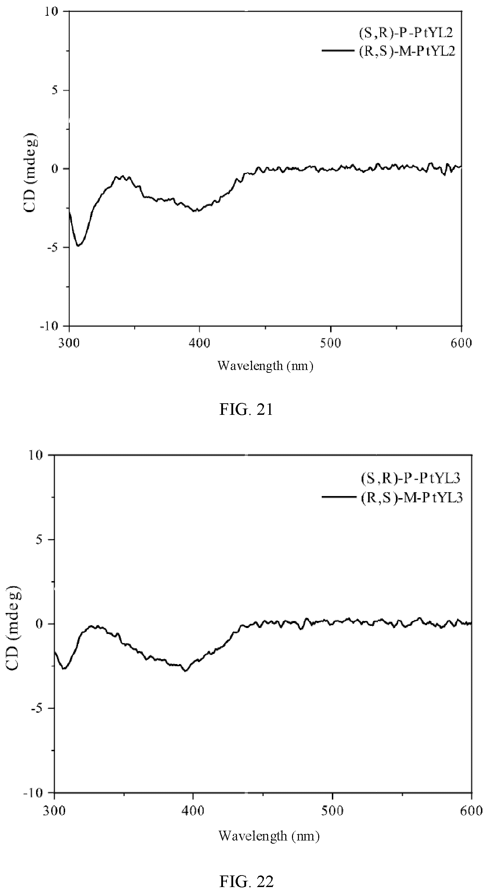

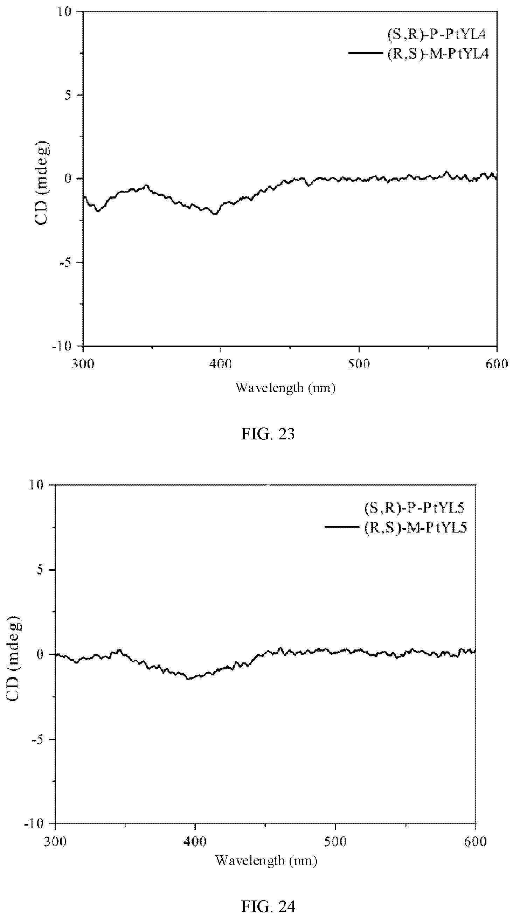

FIGs. 19 to 24 show circular dichroism spectra of compounds *(S, R)*-P-PtYL1 and *(R, S)-M-*PtYL1*, (S, R)*-*P*-PtYL2 and *(R, S)-M-*PtYL2*, (S, R)*-P-PtYL3 and (R, *S)-M-*PtYL3*, (S, R)-P*-PtYL4 and *(R, S)-M-PtYL4, (S,* R)-P-PtYL5 and *(R*, *S)-M-*PtYL5*, (S, R)-P-*PtYL6 and *(R, S)-M-*PtYL6 in dichloromethane solution, with CD representing the circular dichroism spectrum and the sample concentration being 5 x 10⁻⁵ M. The spectra have a high specular symmetry and a strong Cotton effect at about 380, 390, 400, indicating that the enantiomers such as the enantiomers *(S, R)-P*-PtYL1 and *(R*, *S)-M-*PtYL1 have a strong ability to deflect linearly polarized light.

The material has high chemical and thermal stability. The tetradentate ligands can be well coordinated with platinum (II) and palladium (II) metal ions hybridized with dsp² to form stable and rigid quadrilateral molecules with high chemical stability. At the same time, due to the designed larger steric effect between the central chiral ligand L^{a} and the other terminal ligand L¹ or L^{b}, the whole metal complex molecule can form a stable helical-chiral tetradentate cyclometalated complex, so that the racemization does not occur to lose the circularly polarized luminescence property in solution or high-temperature sublimation process.

It can be seen from the specific rotation data of some chiral raw material intermediates and chiral metal complexes in Table 1 below that even if the rotation directions of the raw material intermediates and chiral metal complexes containing the same central chirality are completely different, and the specific rotation values are greatly different, indicating that the helical-chirality centered on the metal ion of the complex has a decisive effect on the rotation properties of the whole compound. In addition, for the complexes with the same central chirality and helical-chirality, different ligand structures can cause different specific rotations, e.g., *(S, R)-P*-PtYL1 (+696.7) and *(S*, *R*)-*P*-PtYL1 (-730.0), indicating that the ligand structure has a great influence on its rotation. At the same time, due to the fact that the excitation radiation luminescence of metal complexes mainly involves the metal to ligand charge transfer state (MLCT) and the charge transfer state within the ligand (ILCT), the helical chirality and ligand structure of metal complexes also have a significant impact on their circularly polarized light properties. It can be seen from the purity of all the enantiomers being greater than 99% that the circularly polarized light-emitting materials of this series of helical-chiral tetradentate cyclometalated complexes have very high isomeric purity, and the steric hindrance of the segment of the central chirality-induced helical chirality is large enough to ensure that the platinum complex will not racemize and the configuration is stable.

It can be seen from Table 2 below that a device in which P-PtYL2 is used as a light-emitting material has a significant circularly polarized photoluminescence signal, with an asymmetry factor (*g_{PL}*) of 1.43 x 10⁻³, which indicates that this series of helical-chiral tetradentate cyclometalated complex circularly polarized light-emitting materials have a good application prospect.

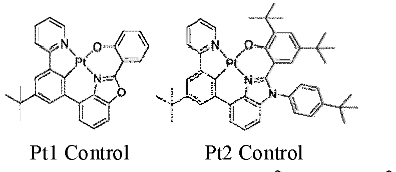

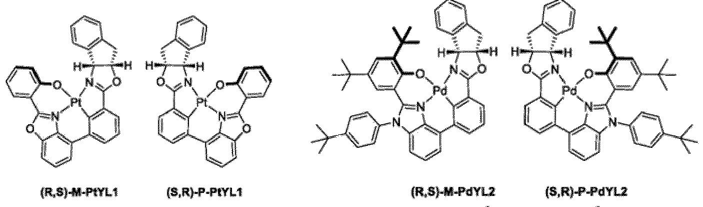

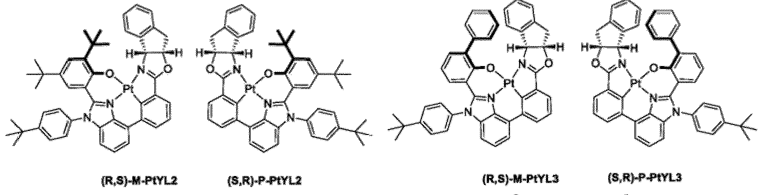

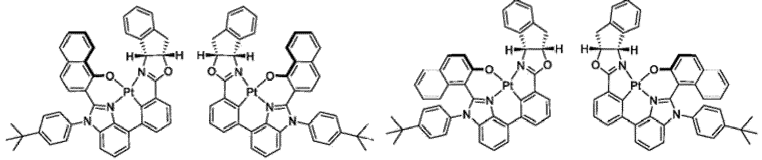

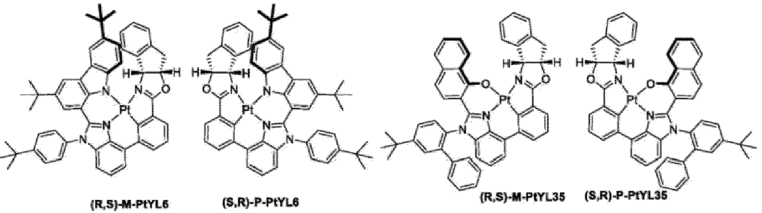

**Table 1: Purities and specific rotations of some chiral starting material intermediates and chiral metal complexes ([a]²⁰_{D})**

| Compound or metal complex | Enantiomeric purity (ee value) | Specific rotation | Compound or metal complex | Enantiomeric purity (ee value) | Specific rotation |
|---|---|---|---|---|---|
| 2-Br (1R, 2S) | >99% | +157.2 | 1-Br (1S, 2R) | >99% | -157.6 |
| *(R, S)-M-*PtYL1 | >99% | -730.0 | *(S, R)-P-*PtYL1 | >99% | +696.7 |
| *(R, S)-M-*PtYL2 | >99% | -650.7 | *(S, R)-P-*PtYL2 | >99% | +640.8 |
| *(R, S)-M-*PdYL2 | >99% | -601.3 | *(S, R)-*P-PdYL2 | >99% | +585.0 |
| *(R, S)-M-*PtYL3 | >99% | -778.6 | *(S, R)-P-*PtYL3 | >99% | +728.2 |
| *(R, S)-M-*PtYL4 | >99% | -713.8 | *(S, R)-P-*PtYL4 | >99% | +753.3 |
| *(R, S)-M-*PtYL5 | >99% | -647.8 | *(S, R)-P-*PtYL5 | >99% | +612.0 |
| *(R, S)-M-*PtYL6 | >99% | -1556.5 | *(S, R)-P-*PtYL6 | >99% | +1582.9 |
| Control Pt1 | ---- | 0 | Control Pt2 | ---- | 0 |

| | | | | | |
|---|---|---|---|---|---|
| Note: all samples were tested in a dichloromethane solution. | | | | | |

**Table 2: Maximum emission wavelength (λₘₐₓ) and asymmetry factor (g_{PL}) of chiral metal complexes**

| Metal complex | *λₘₐₓ* (nm) | *g_{PL}* (x 10⁻³) | Metal complex | *λₘₐₓ* (nm) | *g_{PL}* (x 10⁻³) |
|---|---|---|---|---|---|
| *(R, S)-M*-PtYL1 | 491 | -0.81 | *(S, R)-P-*PtYL1 | 491 | +0.79 |
| *(R, S)-M*-PtYL2 | 514 | -1.46 | *(S, R)-P-*PtYL2 | 514 | +1.43 |
| *(R, S)-M*-PtYL3 | 502 | -1.10 | *(S, R)*-P-PtYL3 | 502 | +1.10 |
| *(R, S)-M*-PtYL4 | 518 | -1.00 | *(S, R)-P-*PtYL4 | 518 | +0.84 |
| *(R, S)*-M-PtYL5 | 553 | -0.31 | *(S, R)-P-*PtYL5 | 553 | +0.24 |
| *(R, S)-M-*PtYL6 | 566 | -0.39 | *(S, R)-P-*PtYL6 | 566 | +0.31 |
| Control Pt1 | 499 | 0 | Control Pt2 | ---- | 0 |

| | | | | | |
|---|---|---|---|---|---|
| ] Note: all samples were tested in a dichloromethane solution. | | | | | |

**Table 3: Molecular configuration and frontier orbital energy levels of some chiral metal complexes**

| | Dihedral angle | HOMO/eV | LUMO/eV | GAP/eV |
|---|---|---|---|---|
| *P-*PtYL1 | 1.21 | -5.10 | -1.57 | 3.53 |
| *P*-PtYL2 | 17.37 | -4.66 | -1.37 | 3.29 |
| *P*-PtYL3 | 14.39 | -4.78 | -1.37 | 3.41 |
| *P*-PtYL4 | 12.60 | -4.68 | -1.38 | 3.30 |
| *P*-PtYL5 (naphthalene ring facing inwards) | 25.45 | -4.80 | -1.39 | 3.41 |
| *P*-PtYL5 (naphthalene ring facing outwards) | 27.99 | -4.80 | -1.39 | 3.41 |
| *P*-PtYL6 | 37.12 | -4.48 | -1.42 | 3.06 |
| *P*-PtYL7 | 14.19 | -5.10 | -1.65 | 3.45 |
| *P*-PtYL8 | 11.77 | -4.81 | -1.54 | 3.27 |
| *P*-PtYL9 | 23.83 | -4.68 | -1.50 | 3.18 |
| *P*-PtYL10 | 20.41 | -4.61 | -1.24 | 3.27 |
| *P*-PtYL11 | 22.61 | -4.52 | -1.30 | 3.22 |
| *P*-PtYL12 | 23.43 | -4.62 | -1.52 | 3.10 |
| *P*-PtYL13 | 10.38 | -4.53 | -1.21 | 3.32 |
| *P*-PtYL14 | 8.44 | -4.78 | -1.55 | 3.23 |
| *P*-PtYL15 | 12.89 | -4.85 | -1.70 | 3.15 |
| *P*-PtYL16 | 7.32 | -4.55 | -1.25 | 3.30 |
| *P*-PtYL17 | 21.40 | -4.54 | -1.19 | 3.35 |
| *P*-PtYL18 | 9.71 | -4.96 | -1.58 | 3.38 |
| *P*-PtYL19 | 18.00 | -4.91 | -1.61 | 3.30 |
| *P*-PtYL20 | 7.30 | -4.73 | -1.34 | 3.39 |
| *P*-PtYL21 | 21.67 | -4.86 | -1.36 | 3.50 |
| *P*-PtYL22 | 9.33 | -4.72 | -1.31 | 3.41 |
| *P*-PtYL23 | 13.96 | -4.76 | -1.32 | 3.44 |
| *P*-PtYL24 | 13.34 | -4.91 | -1.61 | 3.30 |
| *P*-PtYL25 | 20.27 | -4.85 | -1.40 | 3.45 |
| *P*-PtYL26 | 2.62 | -4.89 | -1.66 | 3.23 |
| *P*-PtYL27 | 28.49 | -4.45 | -1.62 | 2.83 |
| *P*-PtYL28 | 3.65 | -4.92 | -1.41 | 3.51 |
| *P*-PtYL29 | 18.26 | -4.86 | -1.55 | 3.31 |
| *P*-PtYL30 | 11.03 | -4.58 | -1.29 | 3.29 |
| *P*-PtYL31 | 33.45 | -4.85 | -1.59 | 3.26 |
| *P*-PtYL32 | 1.3 | -4.66 | -1.50 | 3.16 |
| *P*-PtYL33 | 13.03 | -4.48 | -1.34 | 3.14 |
| *P*-PtYL34 | 28.77 | -4.76 | -1.69 | 3.07 |

| | | | | |
|---|---|---|---|---|
| Note: the dihedral angle is the angle between the planes of the terminal phenyl ring and the nitrogen-containing five-membered heterocycle. | | | | |

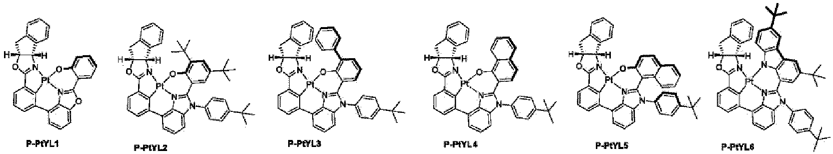

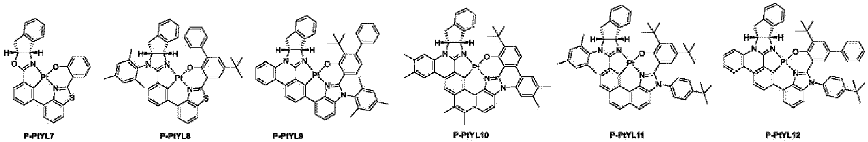

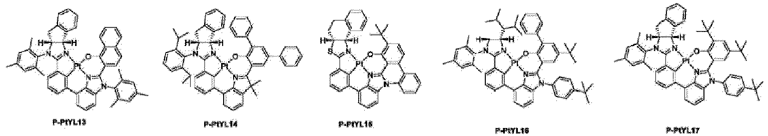

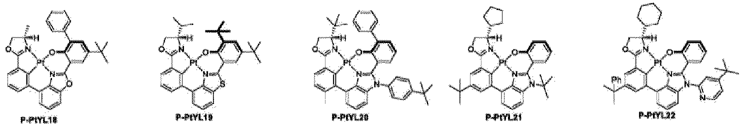

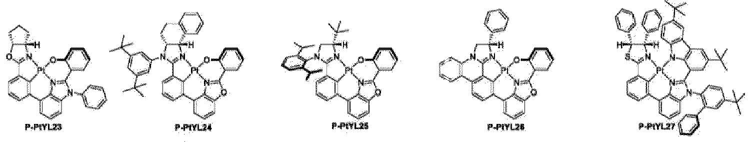

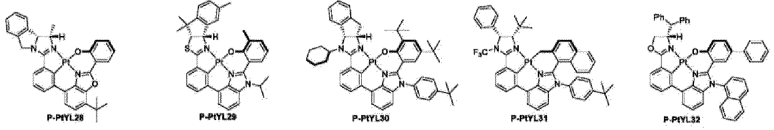

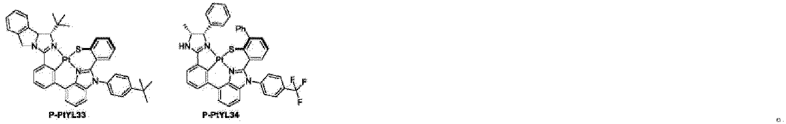

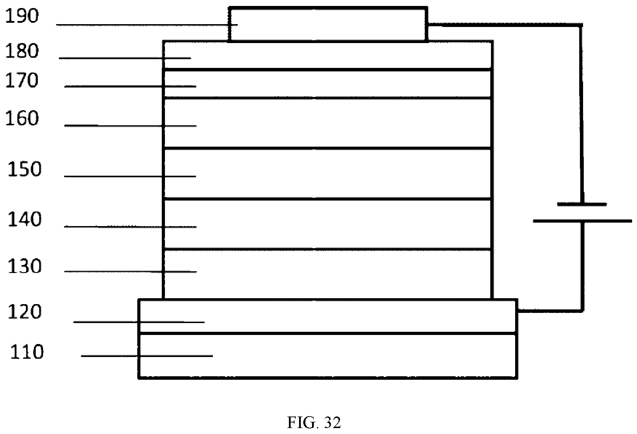

In the organic light-emitting element, carriers are injected into a light-emitting material from both positive and negative electrodes, and a light-emitting material in an excited state is generated and emits light. The complex of the present invention represented by the general formula (1) can be applied as a phosphorescent light-emitting material to an excellent organic light-emitting element such as an organic photoluminescent element or an organic electroluminescent element. The organic photoluminescent element has a structure in which at least a light-emitting layer is formed on a substrate. In addition, the organic electroluminescent element has a structure in which at least an anode, a cathode, and an organic layer between the anode and the cathode are formed. The organic layer includes at least a light-emitting layer and may be composed of only the light-emitting layer, or may have one or more organic layers other than the light-emitting layer. As such other organic layers, a hole transport layer, a hole injection layer, an electron-blocking layer, a hole blocking layer, an electron injection layer, an electron transport layer, an exciton blocking layer, and the like can be cited. The hole transport layer may also be a hole injection transport layer having a hole injection function, and the electron transport layer may also be an electron injection transport layer having an electron injection function. A structure diagram of a specific organic light-emitting element is shown in FIG. 32. In FIG. 32, 110 represents a substrate; 120 represents an anode; 130 represents a hole injection layer; 140 represents a hole transport layer; 150 represents a light-emitting layer; 160 represents a hole blocking layer; 170 represents an electron transport layer; 180 represents an electron injection layer; and 190 represents a cathode, wherein the light-emitting layer is a mixed layer in which a guest material is doped into a host material.

The layers of the organic light-emitting diode of the present invention may be formed by vacuum evaporation, sputtering, ion plating, or the like, or by wet film formation such as spin coating, printing, or the like, and the solvent used is not particularly limited.

In a preferred embodiment of the present invention, the OLED device of the present invention includes a hole transport layer. The hole transport material may preferably be selected from known or unknown materials and is particularly preferably from the following structures, but this does not mean that the present invention is limited to the following structures:

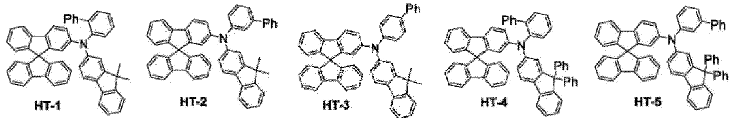

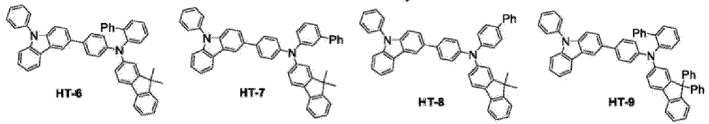

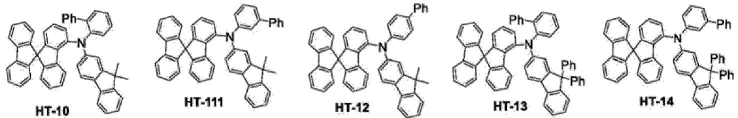

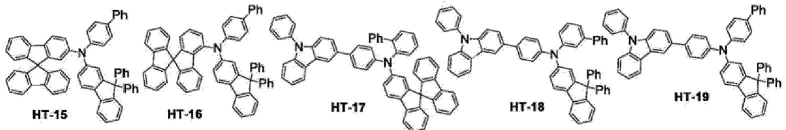

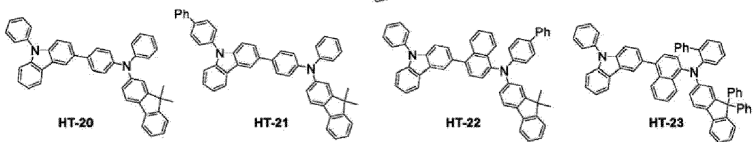

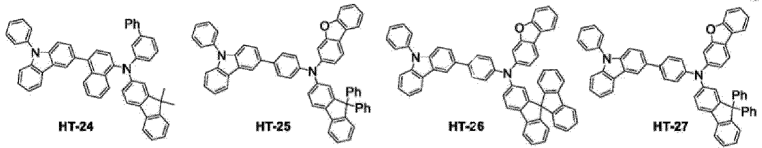

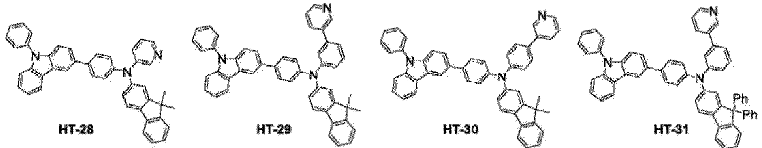

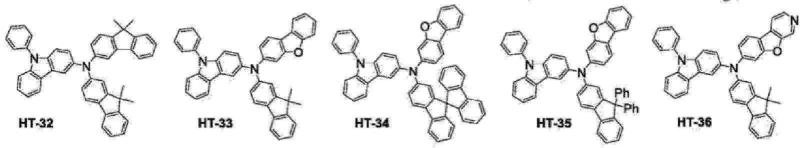

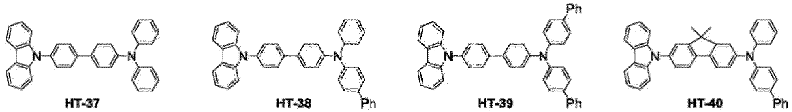

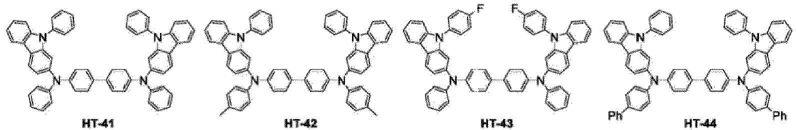

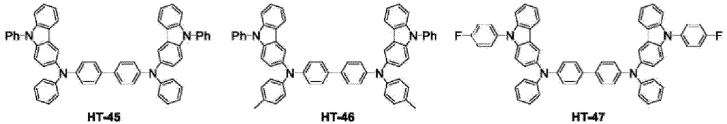

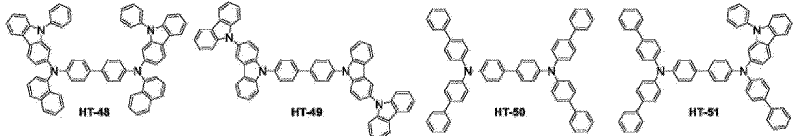

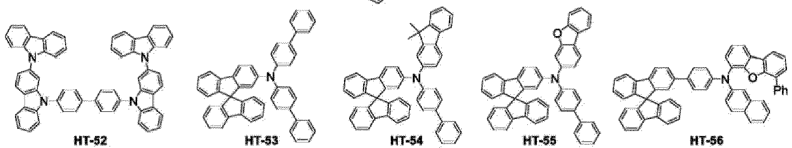

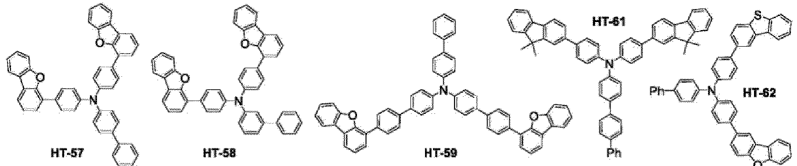

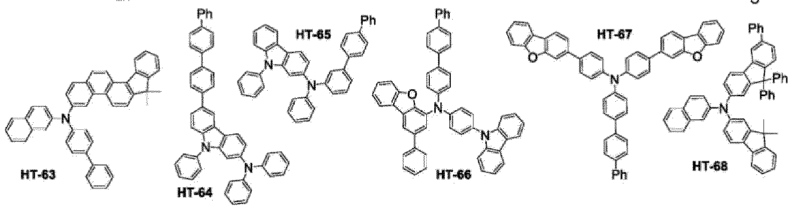

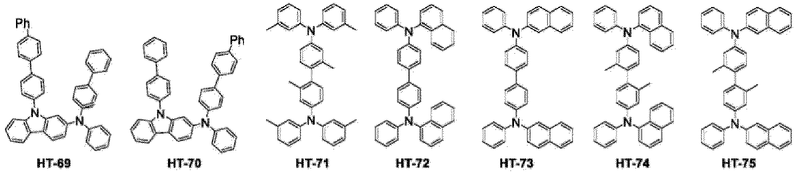

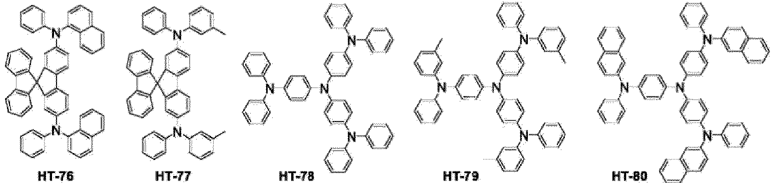

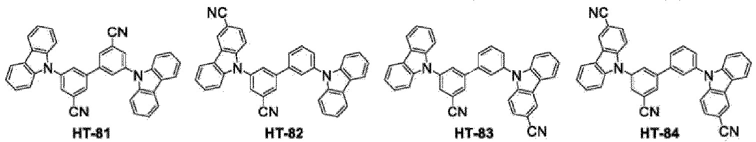

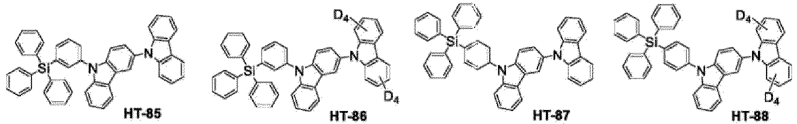

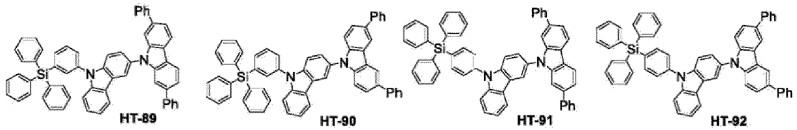

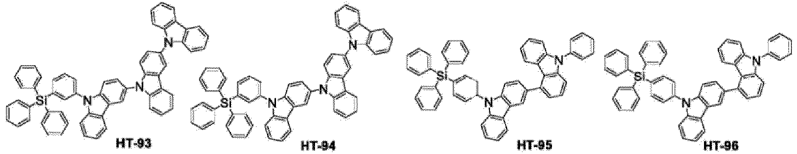

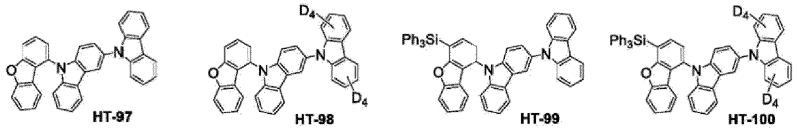

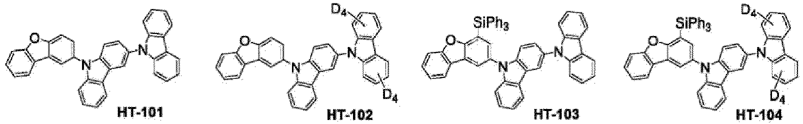

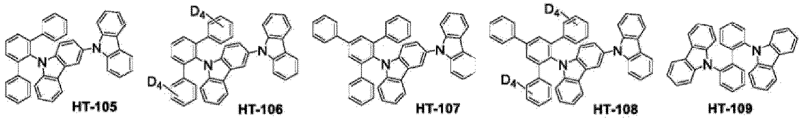

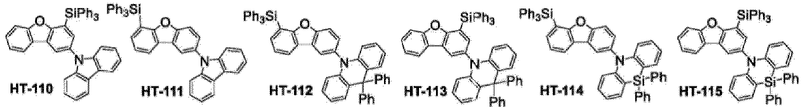

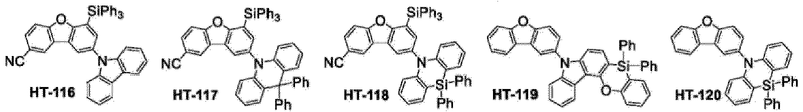

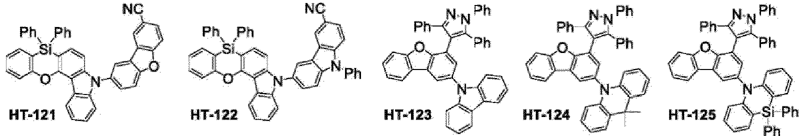

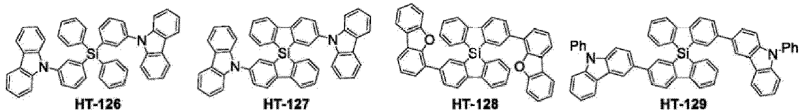

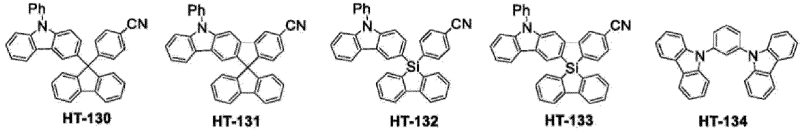

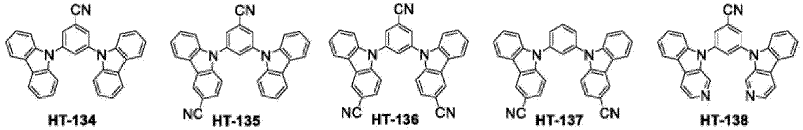

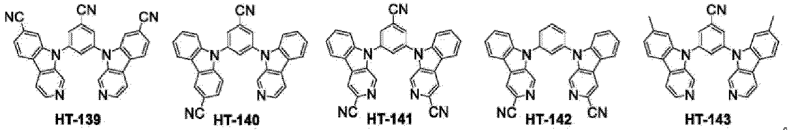

In a preferred embodiment of the invention, the hole transport layer contained in the OLED device of the invention includes one or more p-type dopants. Preferred p-type dopants of the present invention may be selected from the following structures, but this does not mean that the present invention is limited to the following structures:

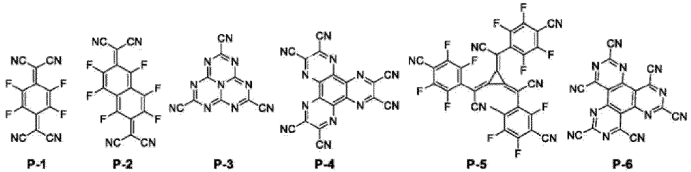

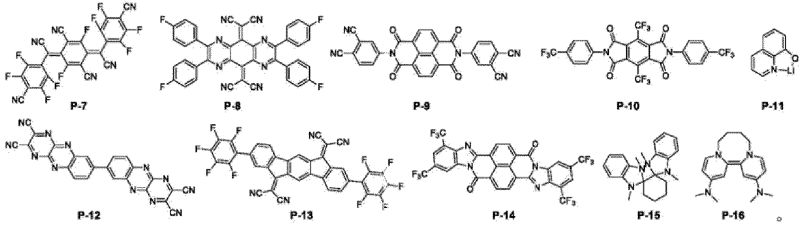

In a preferred embodiment of the invention, the electron transport layer may be selected from at least one of the compounds ET-1 to ET-77, but this does not mean that the present invention is limited to the following structures:

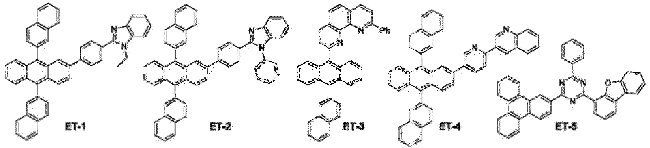

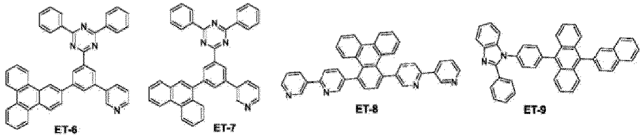

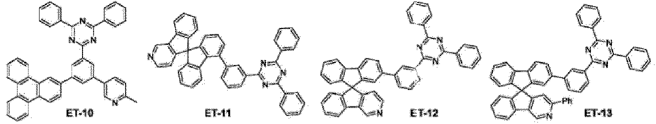

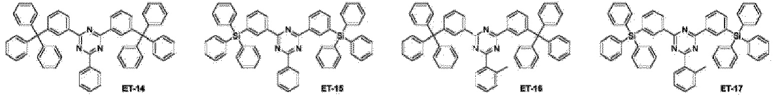

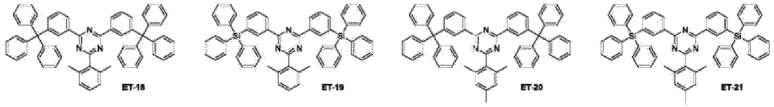

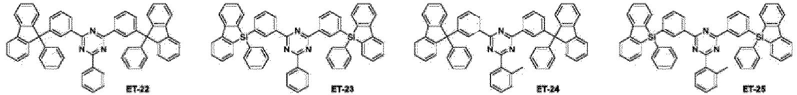

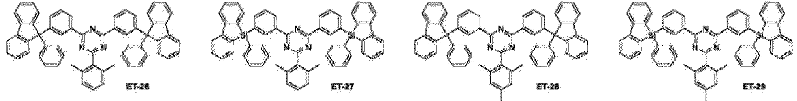

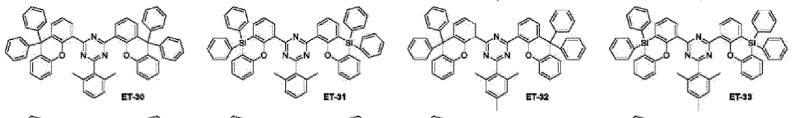

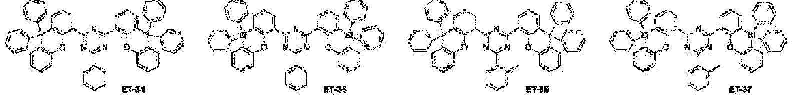

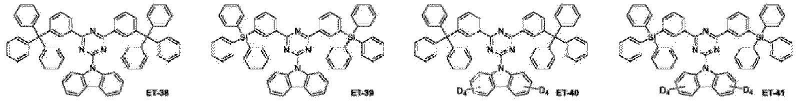

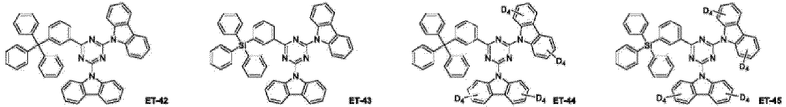

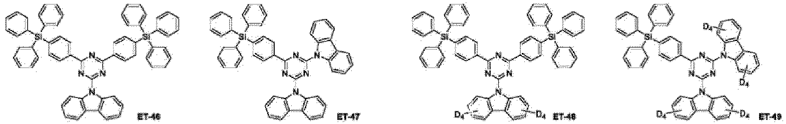

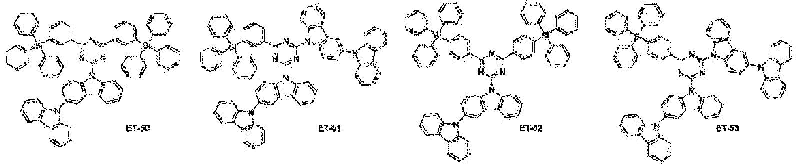

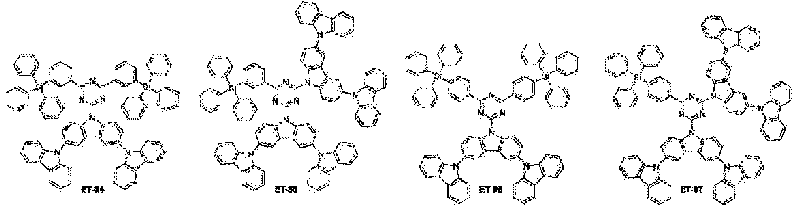

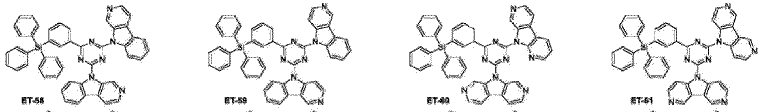

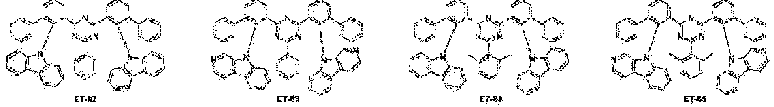

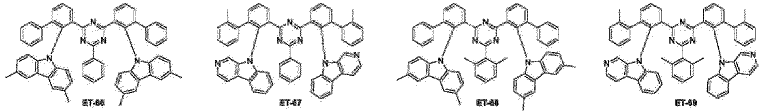

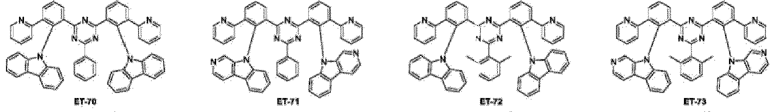

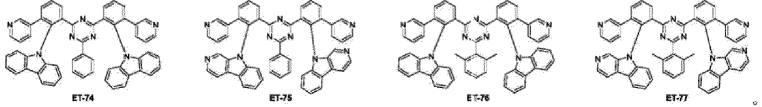

The electron transport layer may be formed from an organic material together with one or more n-type dopants (e.g., LiQ, LiTHPh, etc.).

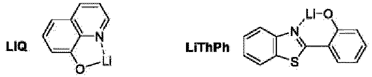

The compounds represented in the examples can be applied as circularly polarized light-emitting materials in an OLED device, the structure of which can be represented as: on glass containing ITO, the hole injection layer (HIL) can be HT-1: P-3 (95: 5 v/v%) with a thickness of 10 nm; the hole transport layer (HTL) can be HT-1 with a thickness of 90 nm; the electron-blocking layer (EBL) can be HT-10 with a thickness of 10 nm; and the light-emitting layer (EML) can be host material (H-1 or H-2 or H-3 or H-4 or H-5 or H-6): present inventive platinum metal complex (95: 5 v/v%) with a thickness of 35 nm; the electron transporting layer (ETL) can be ET-13: LiQ (50: 50 v/v%) with a thickness of 35 nm, followed by evaporation of the cathode Al of 70 nm.

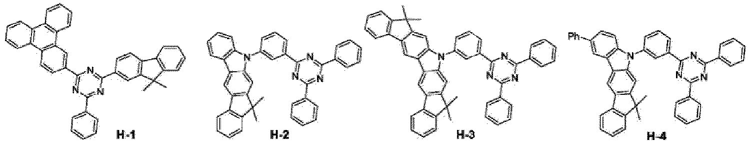

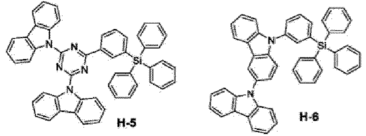

It can be seen from Table 4 below that the OLED devices doped with the helical-chiral metal complexes in the present application can all exhibit a strong circularly polarized luminescence signal, indicating that they have great application prospects in circularly polarized luminescence.

**Table 4**

| | Metal complex | *λₘₐₓ* (nm) | CE (cd/A) | *g_{EL}* (x10⁻³) |
|---|---|---|---|---|
| Device 1 | *(S, R)-P*-PtYL1 | 450 | 153 | +0.33 |
| Device 2 | *(S, R)*-*P*-PtYL2 | 516 | 146 | +0.85 |
| Device 3 | *(S, R)*-*P*-PtYL3 | 505 | 159 | +0.64 |
| Device 4 | *(S, R)-P*-PtYL4 | 521 | 148 | +0.43 |
| Device 5 | *(S, R)*-*P*-PtYL5 | 556 | 142 | +0.13 |
| Device 6 | (*S, R)*-*P*-PtYL6 | 569 | 123 | +0.22 |

| | | | | |
|---|---|---|---|---|
| [00224] Note: *g_{EL}* is the electroluminescence asymmetry factor. [00225] Note that the structure is an example of one application of the circularly polarized light-emitting material of the present invention, and does not constitute a limitation of the specific OLED device structure of the circularly polarized light-emitting material shown in the present invention, nor is the circularly polarized light-emitting material limited to the compounds represented in the examples. | | | | |

## Claims

1. A central chiral-induced helical-chiral tetradentate cyclometalated platinum (II) and palladium (II) complex circularly polarized light-emitting material, **characterized in that** it has chemical formulas as shown in general formulas (1), (1'), (2), and (2'), where (1) and (1'), (2) and (2') are enantiomers of each other: 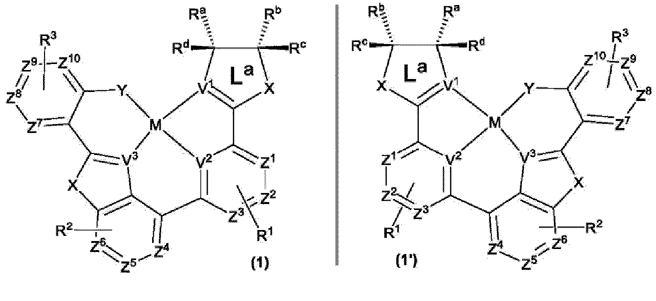 or 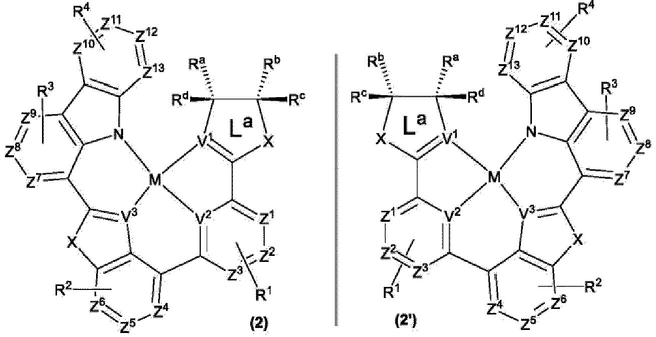
wherein M is Pt or Pd; V¹, V², and V³ are each independently N or C;
L^{a} is a five-membered central chiral carbocyclic or heterocyclic ring;
X is O, S, CR^{x}R^{y}, C = O, SiR^{x}R^{y}, GeR^{x}R^{y}, NR^{z}, PR^{z}, R^{z}P = O, AsR^{z}, R^{z}As = O, S = O, SO₂, Se, Se = O, SeO₂, BH, BR^{z}, R^{z}Bi = O, or BiR^{z}; wherein R^{x} and R^{y} are each independently a substituent on the same atom selected from C, Si and Ge, and R^{z} is a substituent on an atom selected from B, N, P, As and Bi;
Y is O, S;
Z¹, Z², Z³, Z⁴, Z⁵, Z⁶, Z⁷, Z⁸, Z⁹, Z¹⁰, Z¹¹, Z¹² , and Z¹³ are each independently N or C;
R¹, R², R³, R⁴, R^{a}, R^{b}, R^{c}, and R^{d} each independently represent mono-, di-, tri-, tetra-substituted or unsubstituted, while R¹, R², R³, R⁴, R^{a}, R^{b}, R^{c}, and R^{d} are each independently hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, acylamino, alkoxycarbonylamino, aryloxycarbonylamino, sulfonylamino, sulfamoyl, carbamoyl, alkylthio, sulfinyl, ureido, phosphoryl amino, imino, sulfo, carboxy, hydrazino, substituted silyl, or a combination thereof, wherein R^{a} and R^{b} are different substituents in the same molecule; two or more adjacent R¹, R², R³, and R⁴ are optionally linkable to form a fused ring; any two of R^{a}, R^{b}, R^{c}, and R^{d} are linkable to form a cyclic system.

2. The central chiral-induced helical-chiral tetradentate cyclometalated platinum (II) and palladium (II) complex circularly polarized light-emitting material having general formulas (1), (1'), (2), and (2') according to claim 1, preferably having following general formulas (1-A) and (2-A) and their enantiomers (1'-A) and (2'-A): 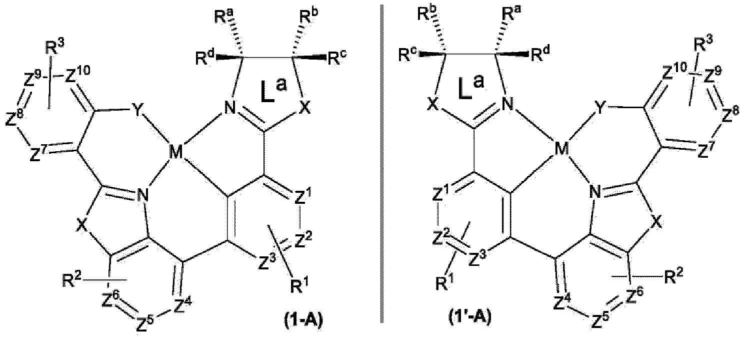 or 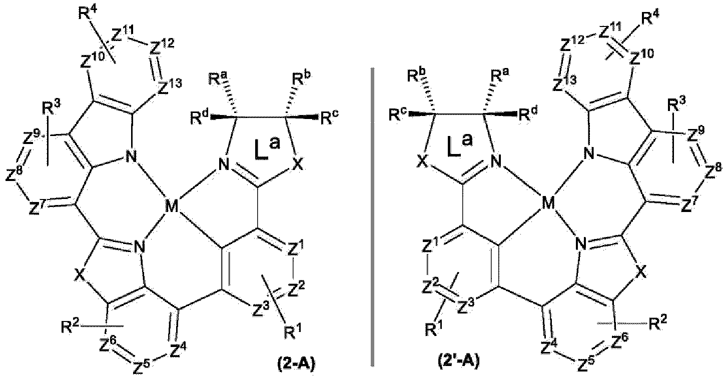
wherein M is Pt or Pd;
L^{a} is a five-membered central chiral carbocyclic or heterocyclic ring;
X is O, S, CR^{x}R^{y}, C = O, SiR^{x}R^{y}, GeR^{x}R^{y}, NR^{z}, PR^{z}, R^{z}P = O, AsR^{z}, R^{z}As = O, S = O, SO₂, Se, Se = O, SeO₂, BH, BR^{z}, R^{z}Bi = O, or BiR^{z};
Y is O, S;
Z¹, Z², Z³, Z⁴, Z⁵, Z⁶, Z⁷, Z⁸, Z⁹, Z¹⁰, Z¹¹, Z¹², and Z¹³ are each independently N or C;
R¹, R², R³, R⁴, R^{a}, R^{b}, R^{c}, and R^{d} each independently represent mono-, di-, tri-, tetra-substituted or unsubstituted, while R¹, R², R³, R⁴, R^{a}, R^{b}, R^{c}, and R^{d} are each independently hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, acylamino, alkoxycarbonylamino, aryloxycarbonylamino, sulfonylamino, sulfamoyl, carbamoyl, alkylthio, sulfinyl, ureido, phosphorylamino, imino, sulfo, carboxy, hydrazino, substituted silyl, or a combination thereof, wherein R^{a} and R^{b} are different substituents in the same molecule; two or more adjacent R¹, R², R³, and R⁴ are optionally linkable to form a fused ring; any two of R^{a}, R^{b}, R^{c}, and R^{d} are linkable to form a cyclic system.

3. The central chiral-induced helical-chiral tetradentate cyclometalated platinum (II) and palladium (II) complex circularly polarized light-emitting material having general formulas (1), (1'), (2), and (2') according to claim 1 or 2, wherein the central chiral segment L^{a} has a general structure preferably selected from, but not limited thereto, a group consisting of: 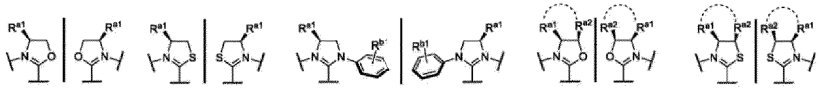 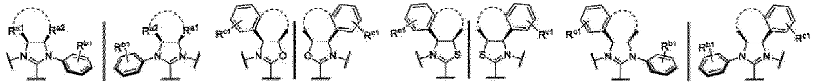 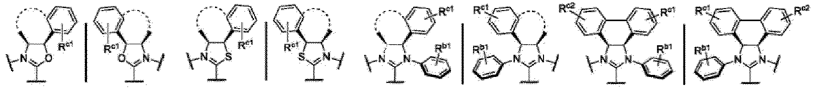 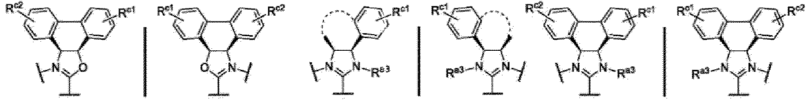
wherein R^{a1}, R^{a2}, and R^{a3} each independently represent hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, amido, alkoxycarbonylamino, aryloxycarbonylamino, sulfonylamino, sulfamoyl, carbamoyl, alkylthio, sulfinyl, ureido, phosphoryl amino, imino, sulfo, carboxy, hydrazino, substituted silyl, or combinations thereof;
wherein R^{b1}, R^{c1}, and R^{c2} each independently represent mono-, di-, tri-, tetra-substituted or unsubstituted, while R^{b1}, R^{c1}, and R^{c2} are each independently hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, amido, alkoxycarbonylamino, aryloxycarbonylamino, sulfonylamino, sulfamoyl, carbamoyl, alkylthio, sulfinyl, ureido, phosphorylamino, imino, sulfo, carboxy, hydrazino, substituted silyl, or combinations thereof; two or more adjacent R^{b1}, R^{c1}, and R^{c2} are optionally linkable to form a fused ring.

4. The central chiral-induced helical-chiral tetradentate cyclometalated platinum (II) and palladium (II) complex circularly polarized light-emitting material having general formulas (1), (1'), (2), and (2') according to claim 3, wherein the central chiral segment L^{a} has a specific structure preferably selected from, but not limited thereto, a group consisting of: 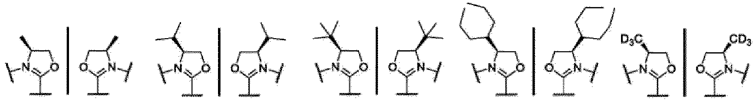 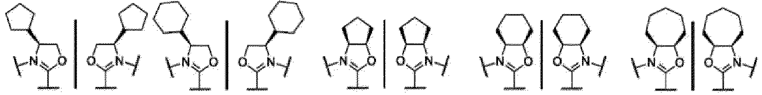 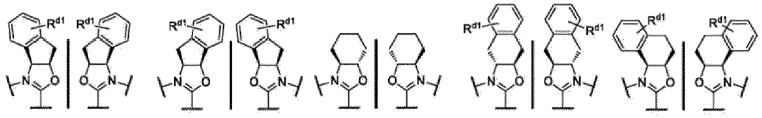 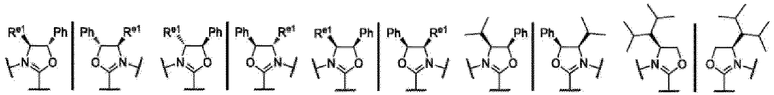 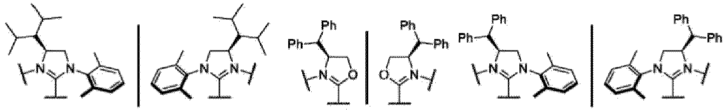 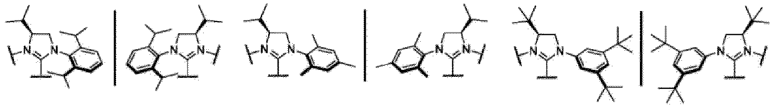 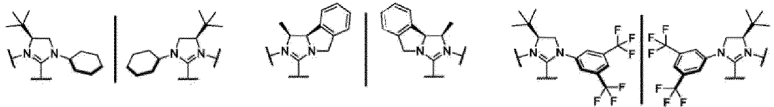 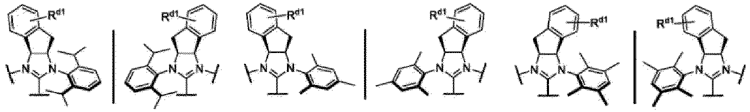 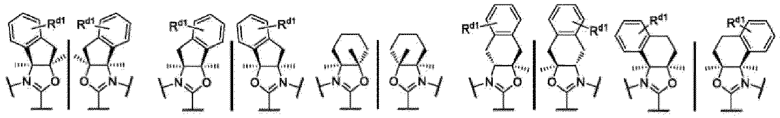 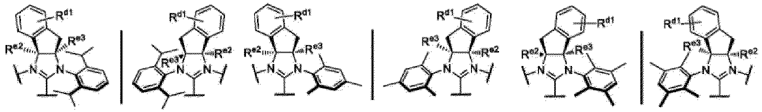 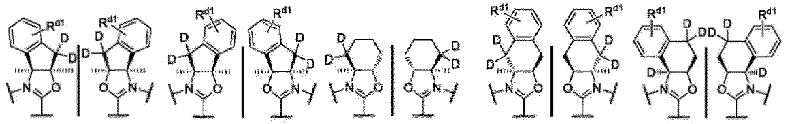 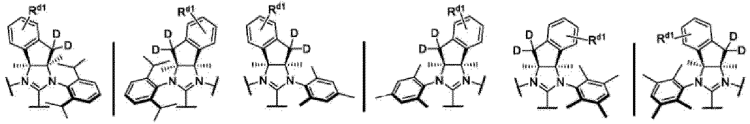 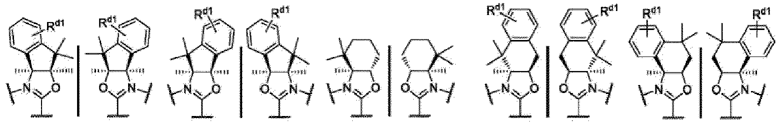 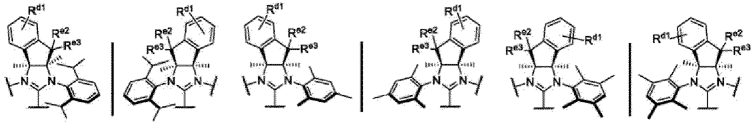 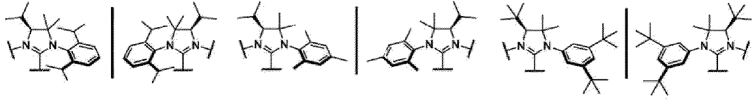 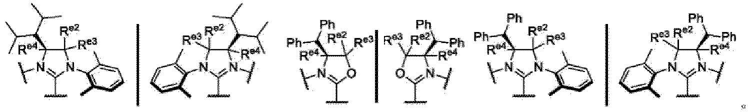
wherein R^{d1} represents mono-, di-, tri-, tetra-substituted or unsubstituted, while R^{b1} is independently hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, amido, alkoxycarbonylamino, aryloxycarbonylamino, sulfonylamino, sulfamoyl, carbamoyl, alkylthio, sulfinyl, ureido, phosphoryl amino, imino, sulfo, carboxy, hydrazino, substituted silyl, or combinations thereof; two or more adjacent R^{d1} are optionally linkable to form a fused ring.
wherein R^{e1}, R^{e2}, R^{e3}, and R^{e4} are independently represent hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, amido, alkoxycarbonylamino, aryloxycarbonylamino, sulfonylamino, sulfamoyl, carbamoyl, alkylthio, sulfinyl, ureido, phosphorylamino, imino, sulfo, carboxy, hydrazino, substituted silyl, or combinations thereof.

5. The central chiral-induced helical-chiral tetradentate cyclometalated platinum (II) and palladium (II) complex circularly polarized light-emitting material according to claim 1 or 2, having a general structure preferably selected from, but not limited thereto, a group consisting of: 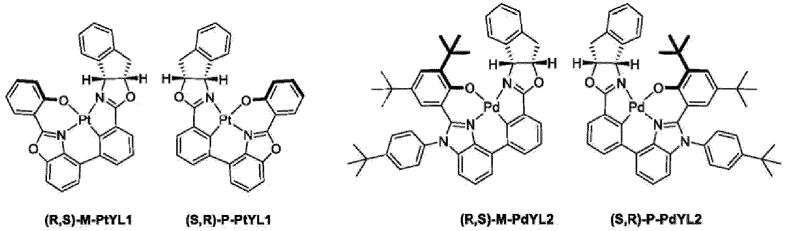 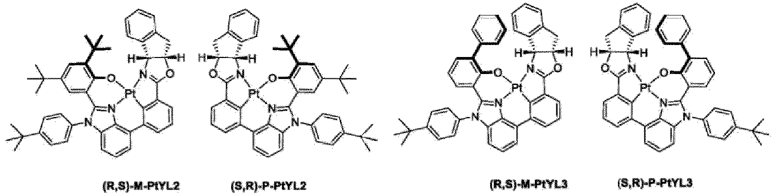 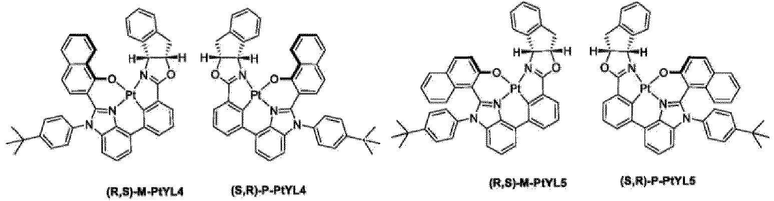 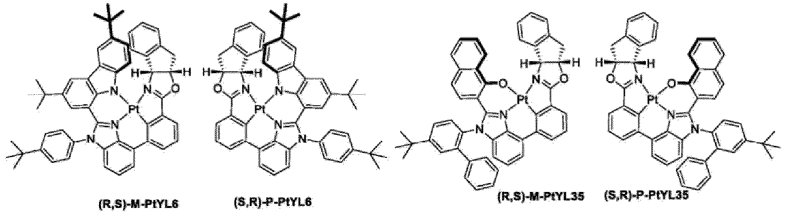 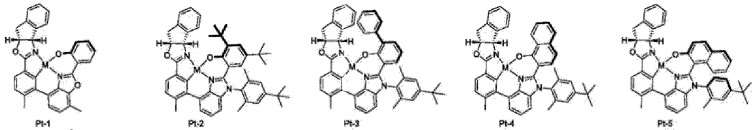 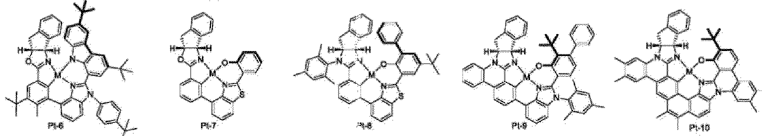 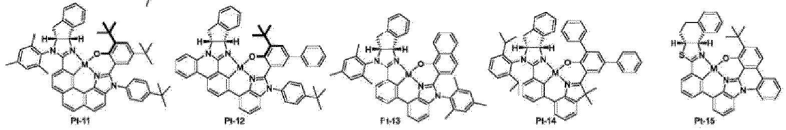 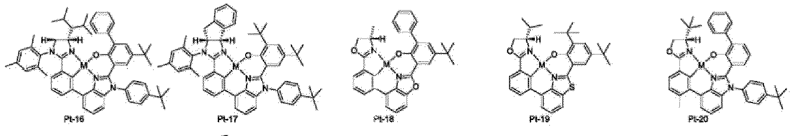 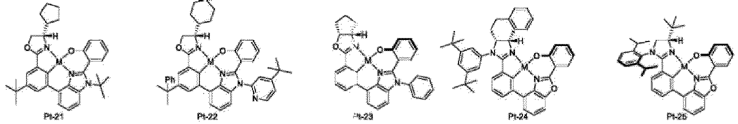 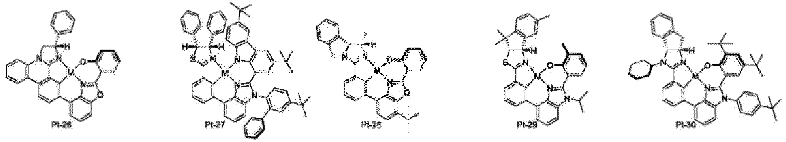 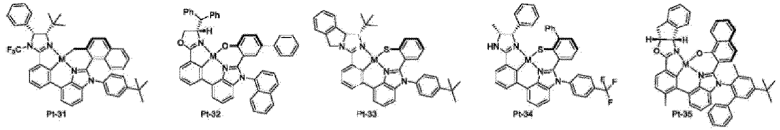 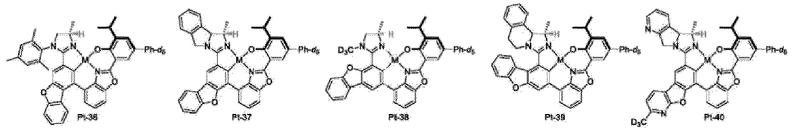 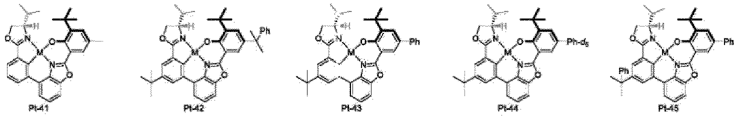 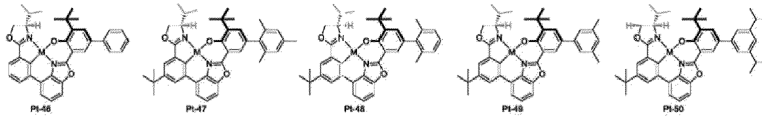 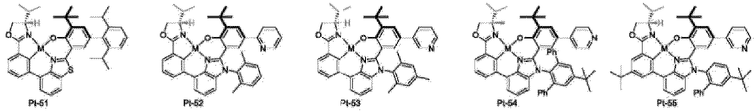 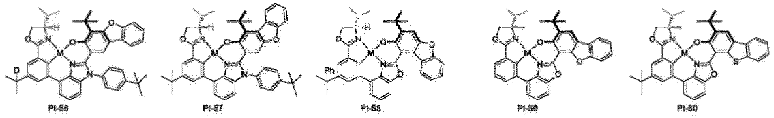 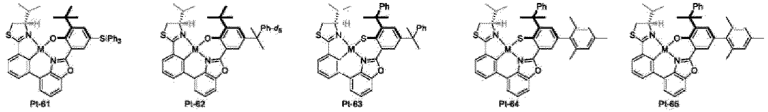 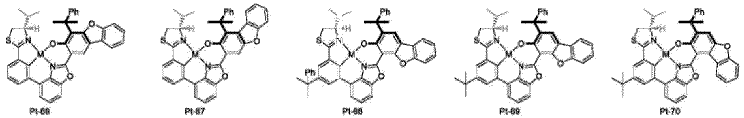 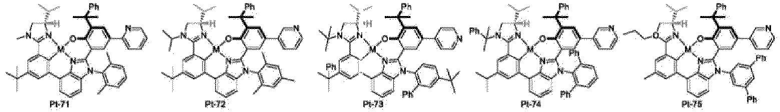 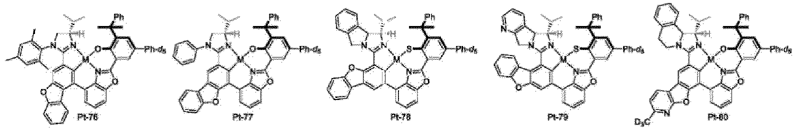 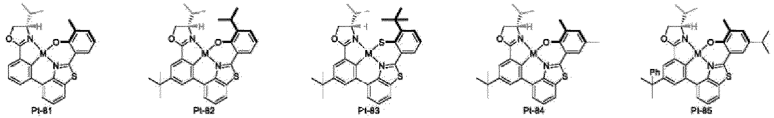 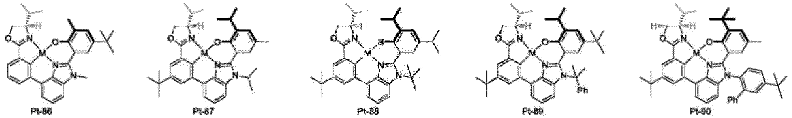 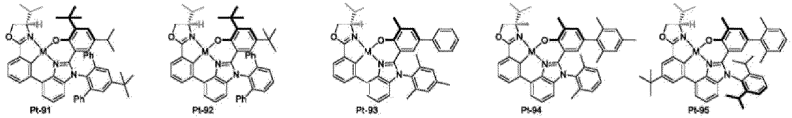 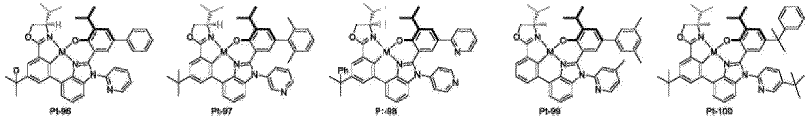 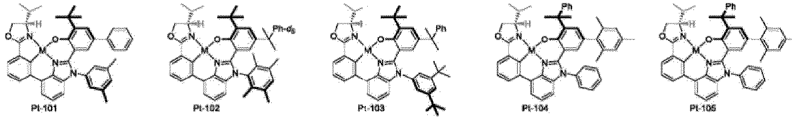 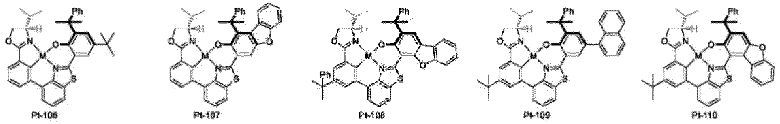 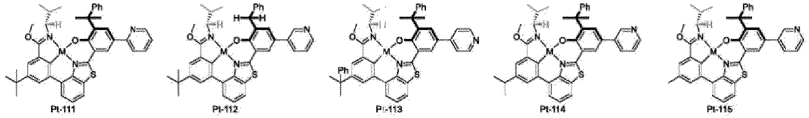 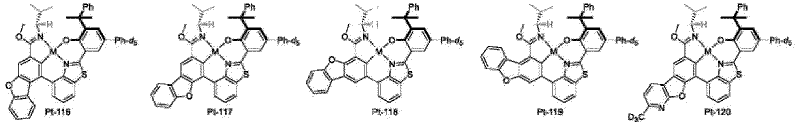 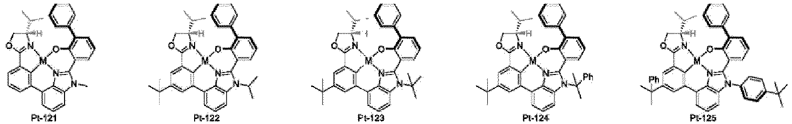 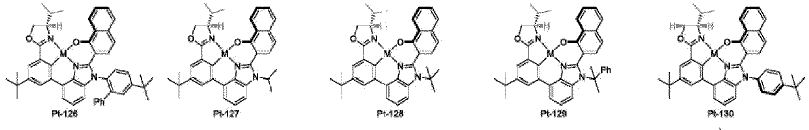 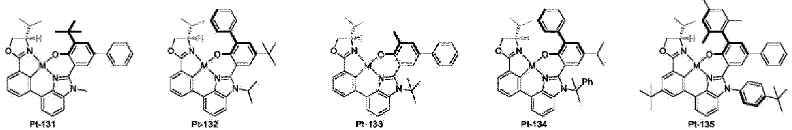 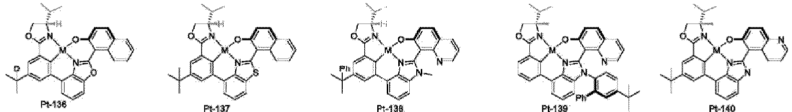 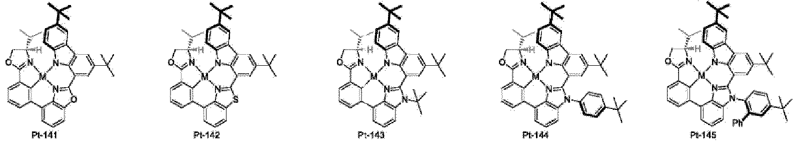 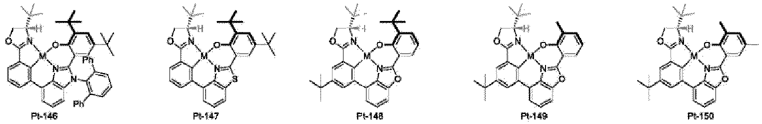 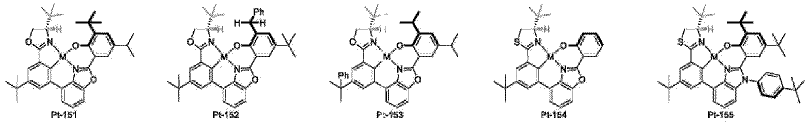 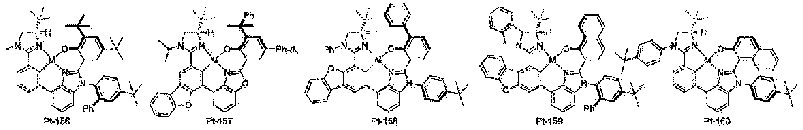 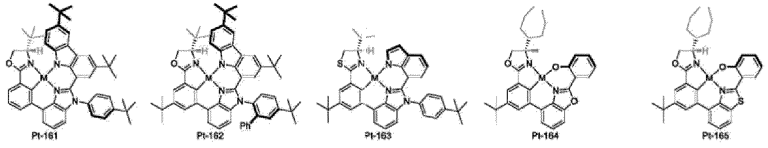 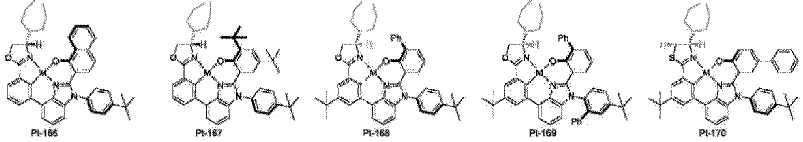 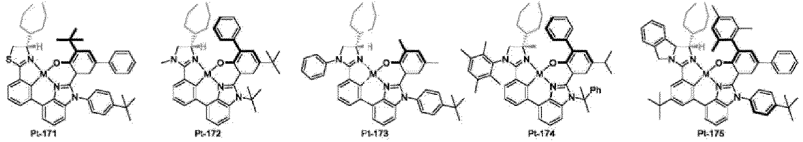 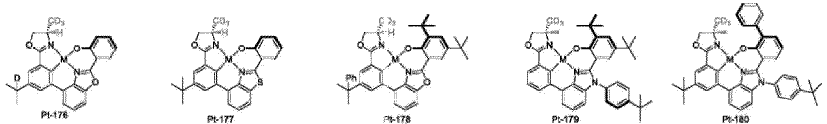 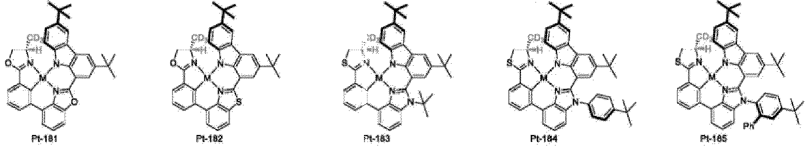 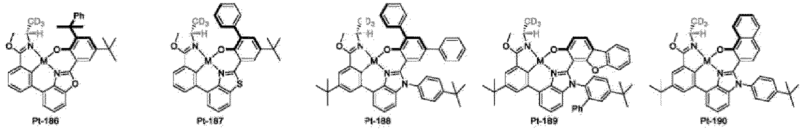 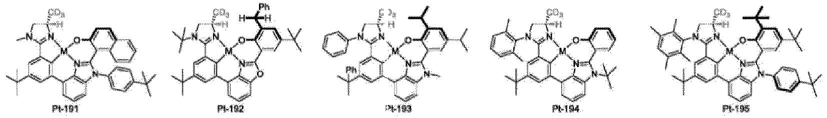 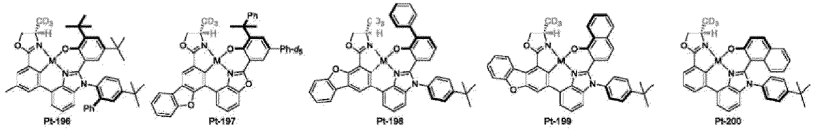 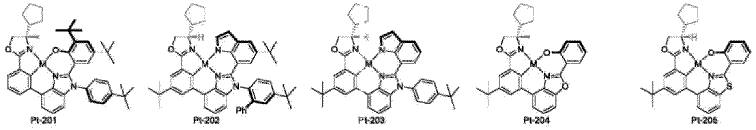 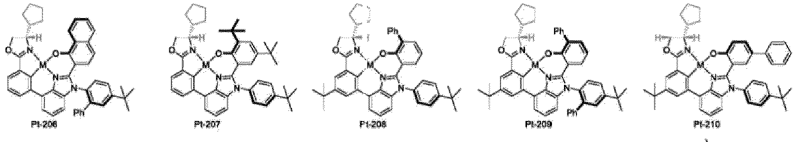 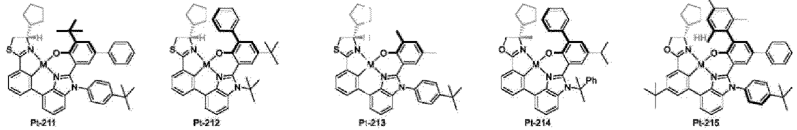 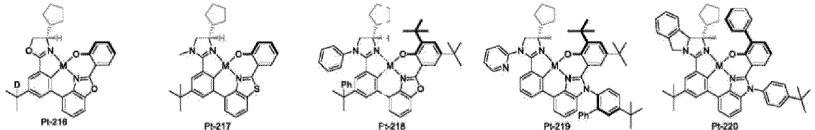 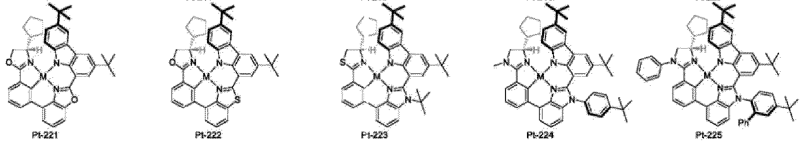 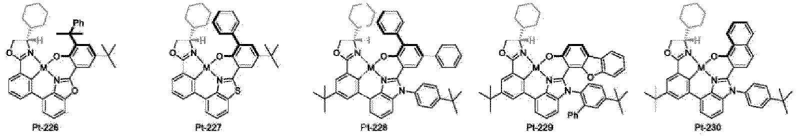 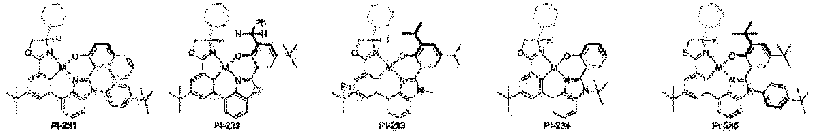 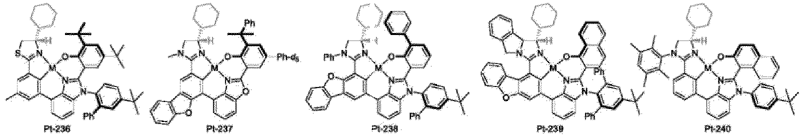 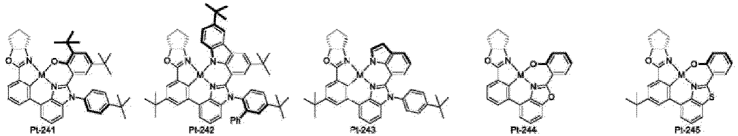 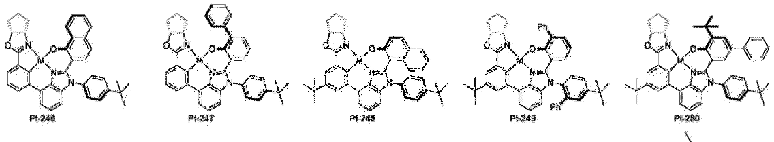 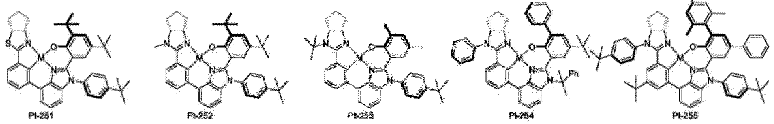 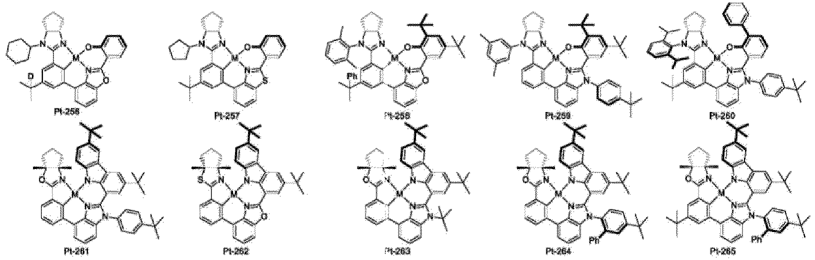 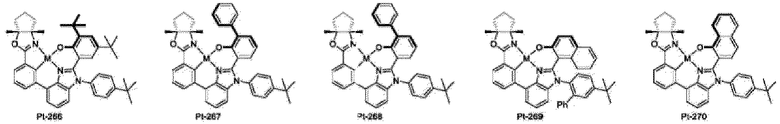 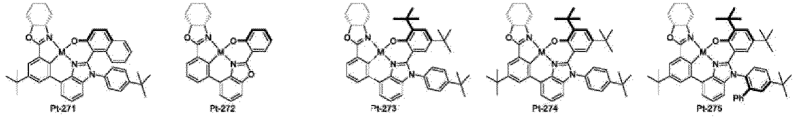 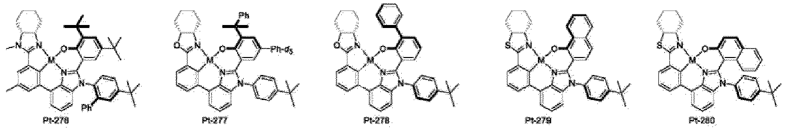 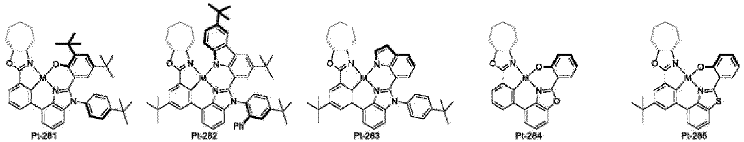 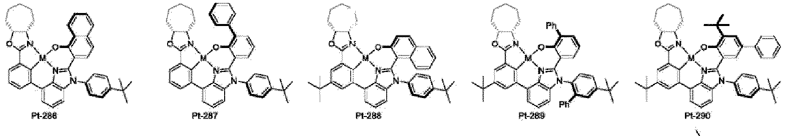 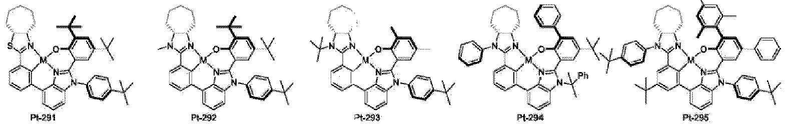 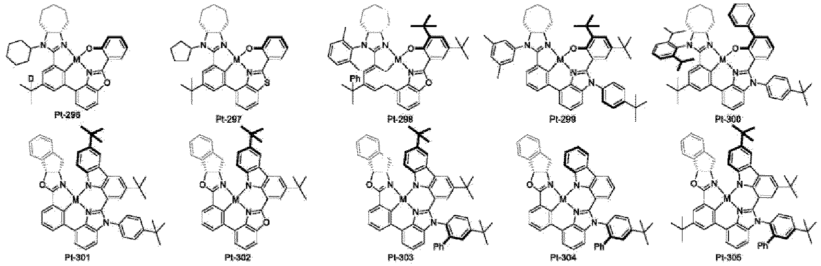 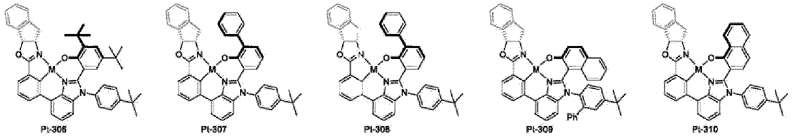 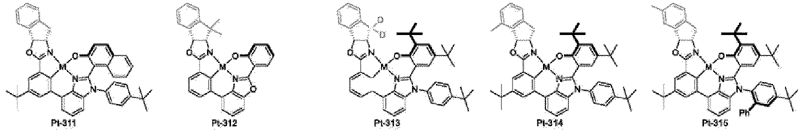 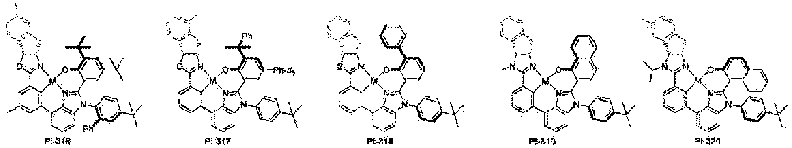 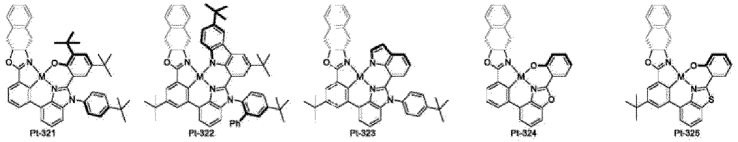 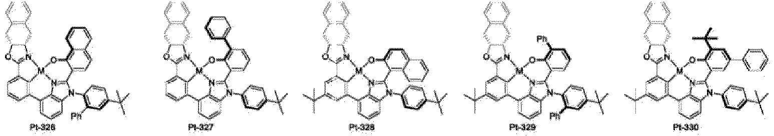 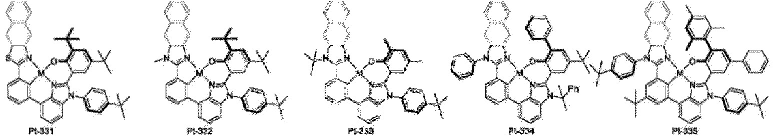 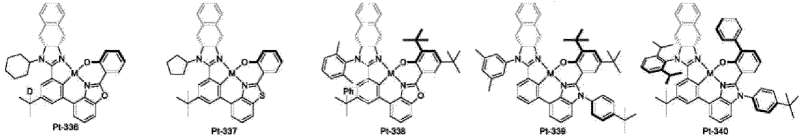 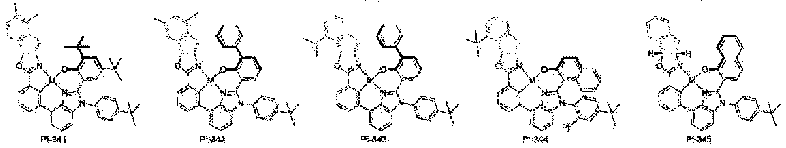 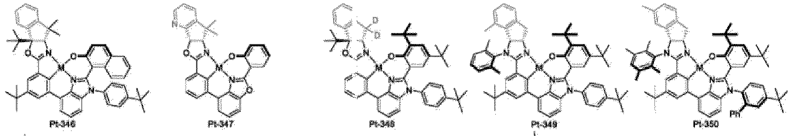 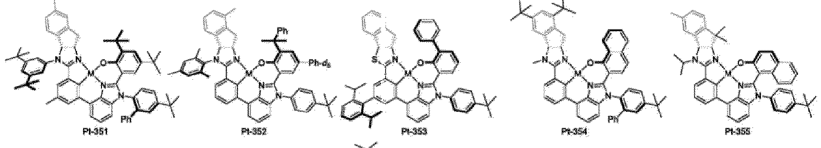 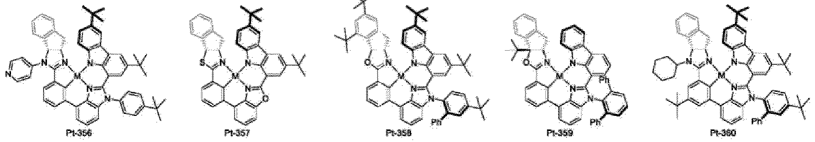 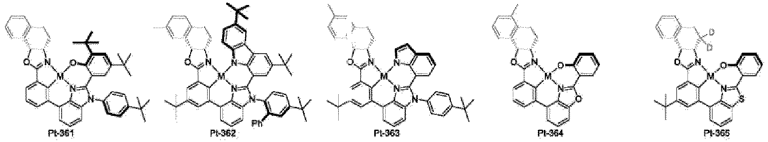 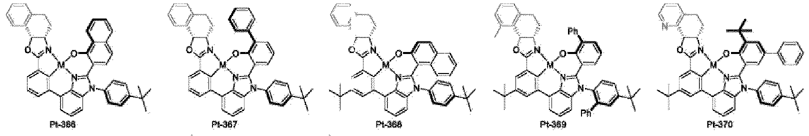 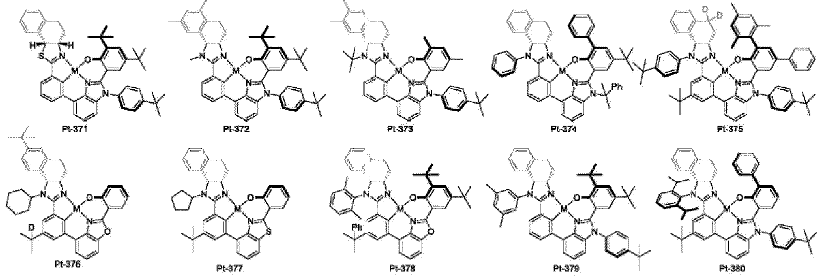 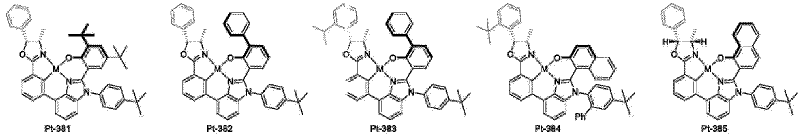 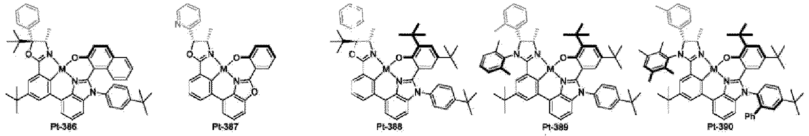 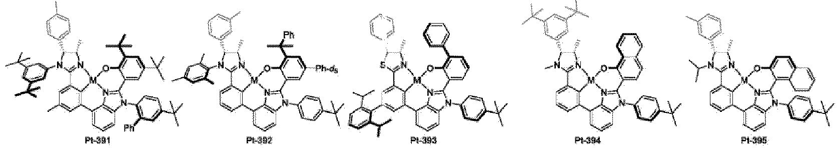 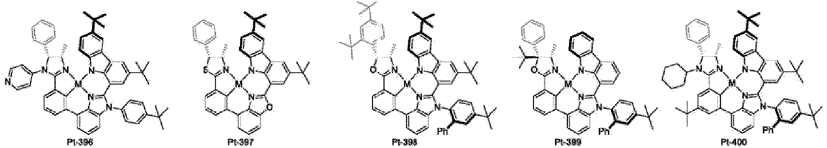 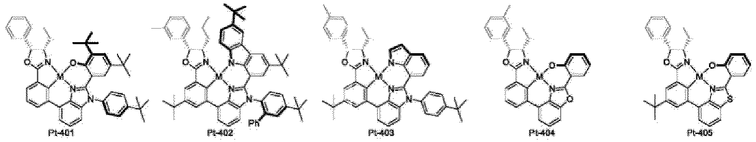 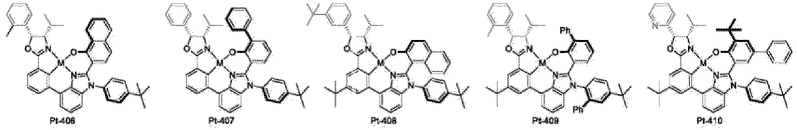 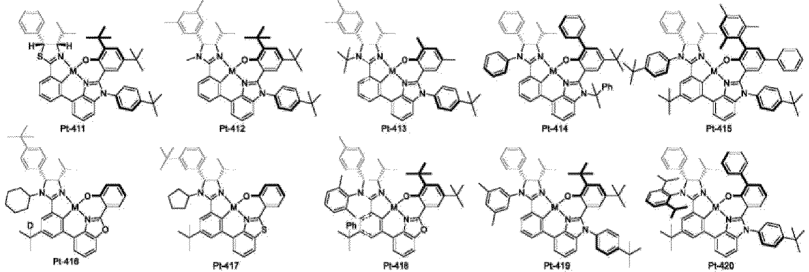 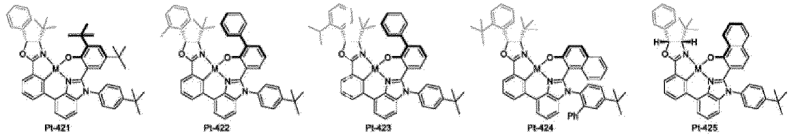 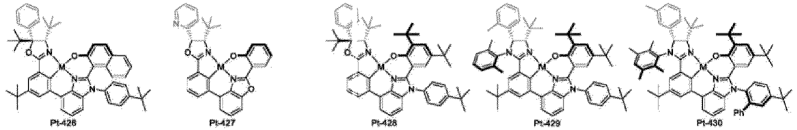 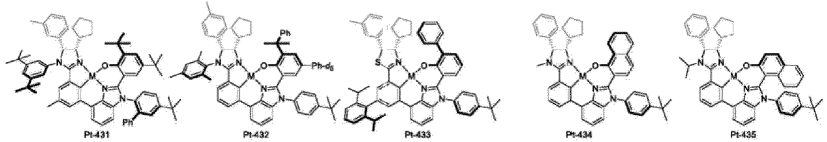 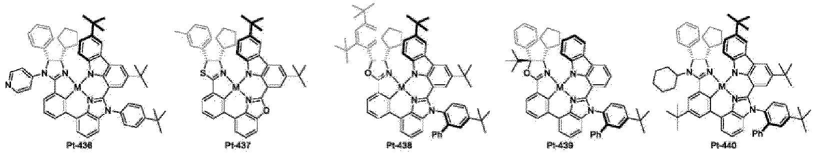 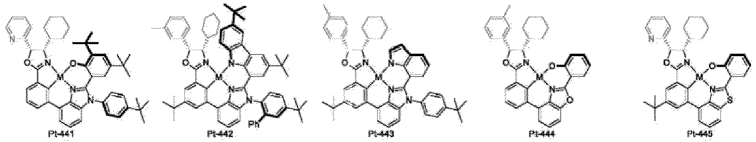 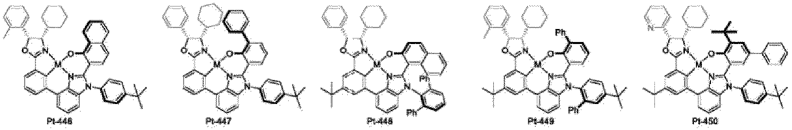 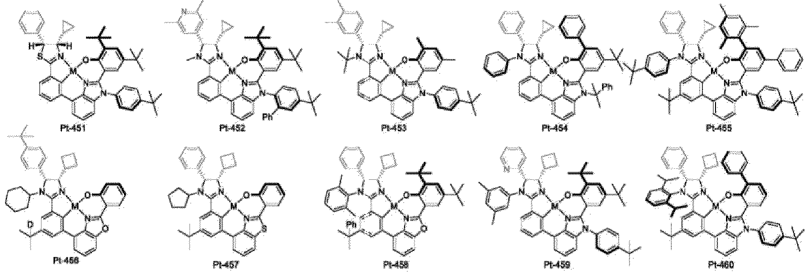 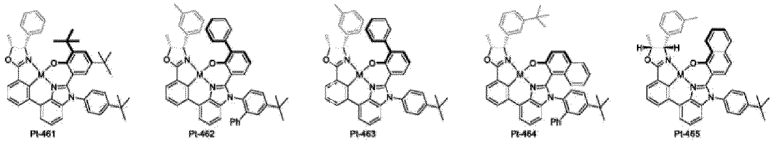 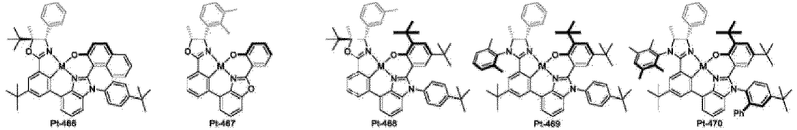 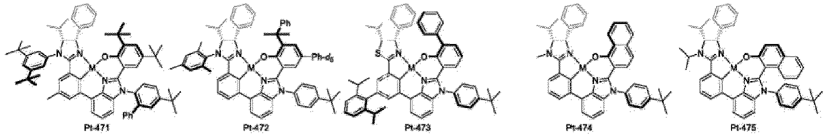 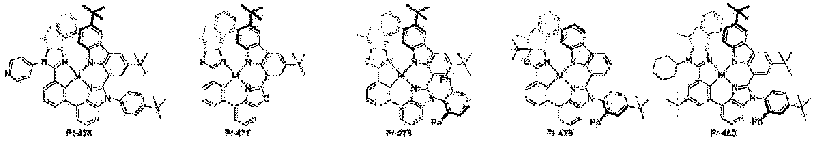 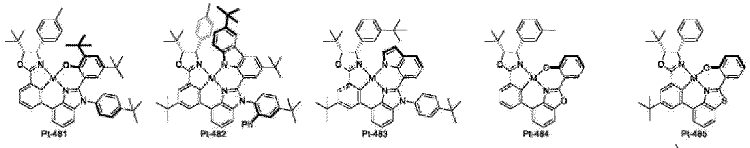 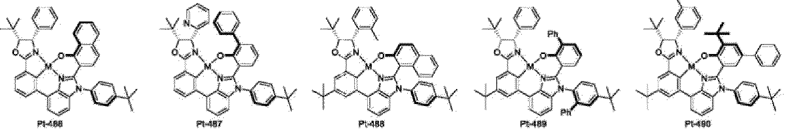 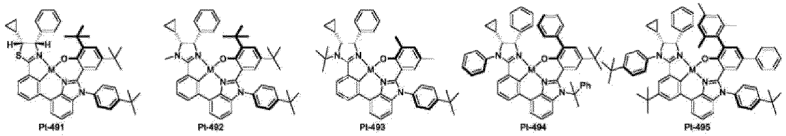 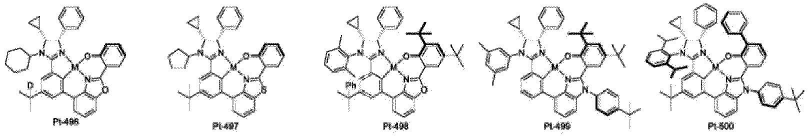 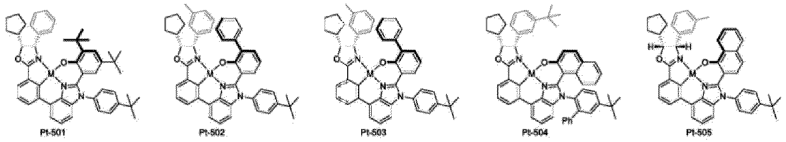 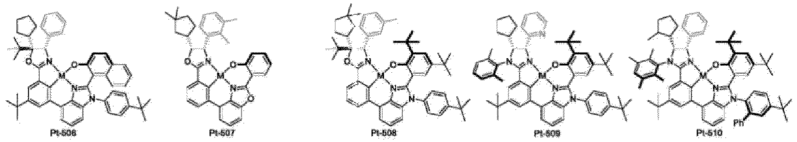 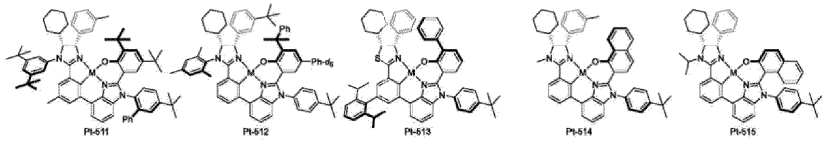 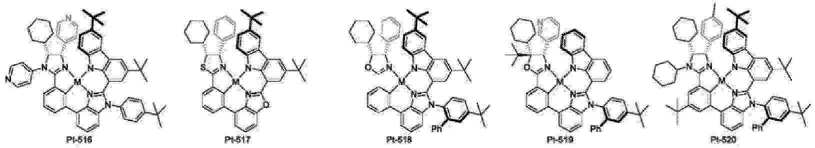 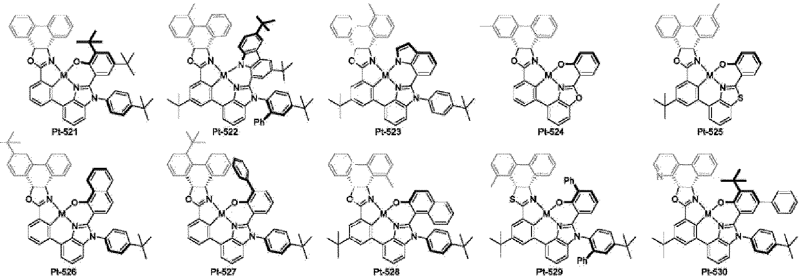 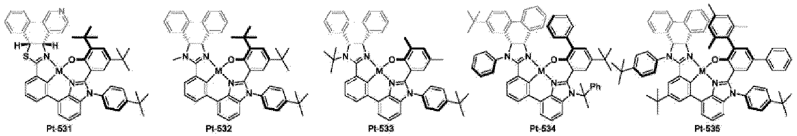 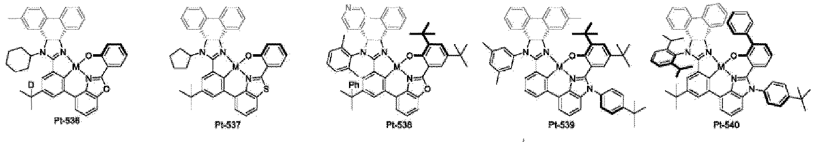 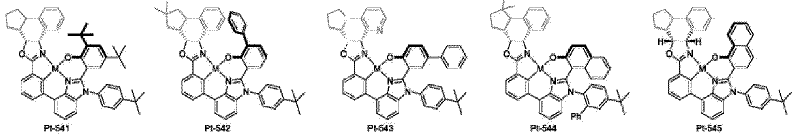 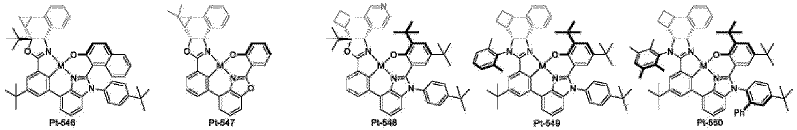 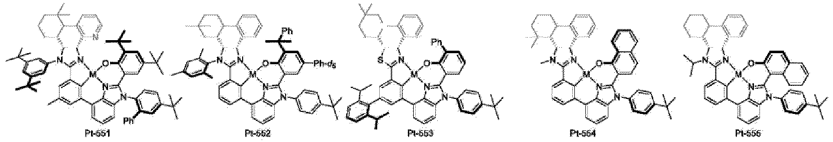 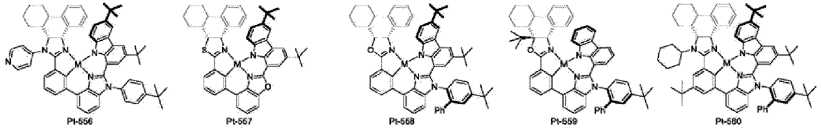 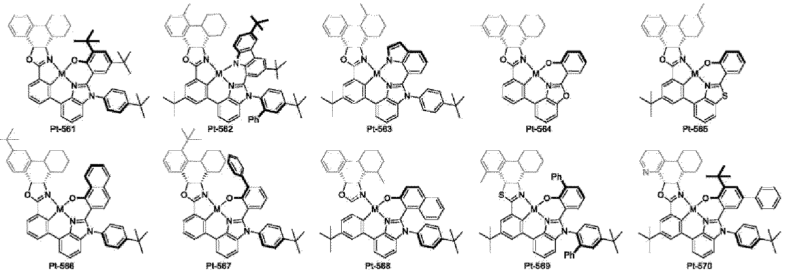 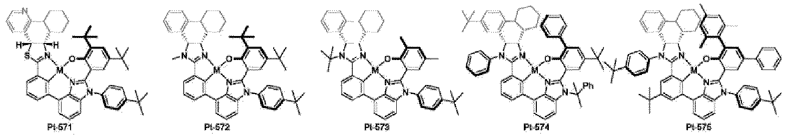 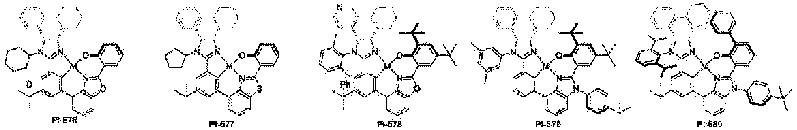 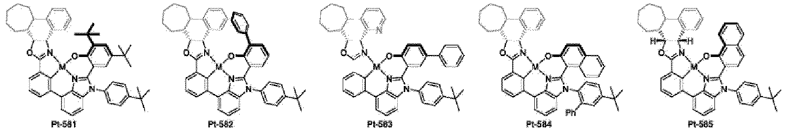 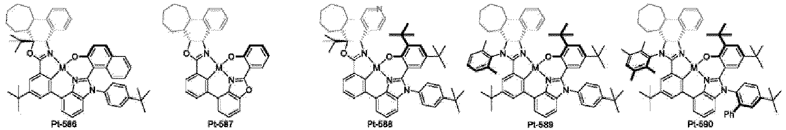 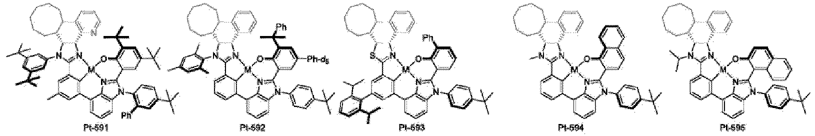 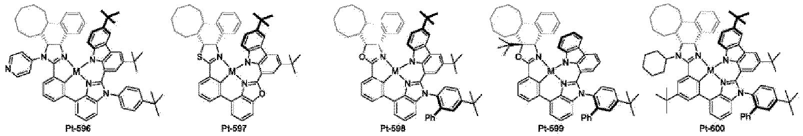 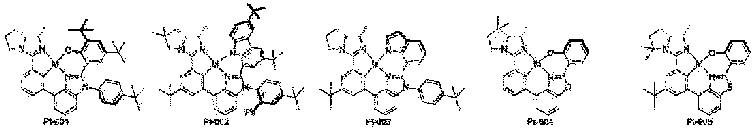 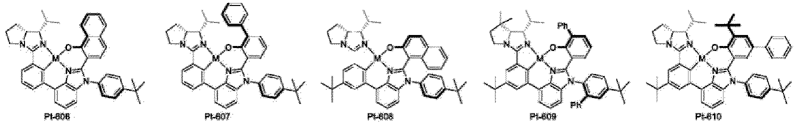 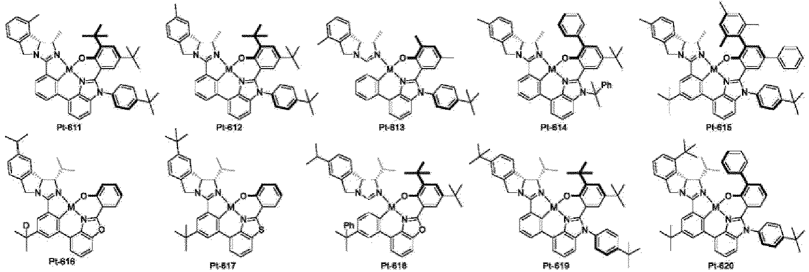 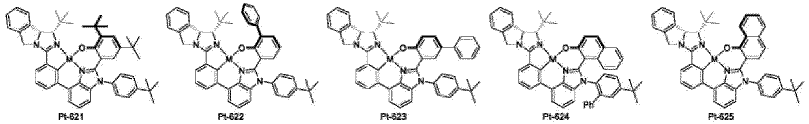 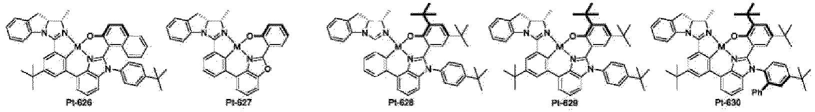 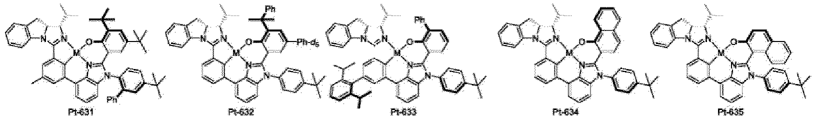 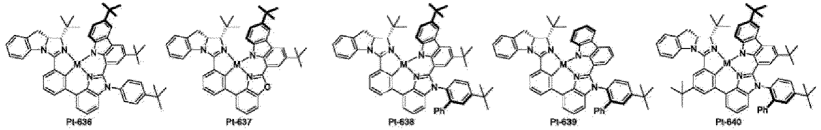 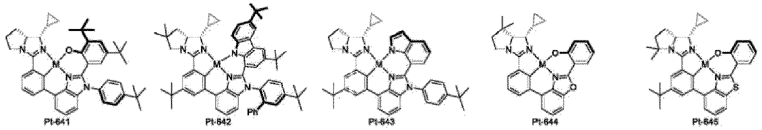 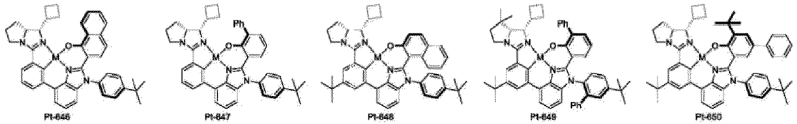 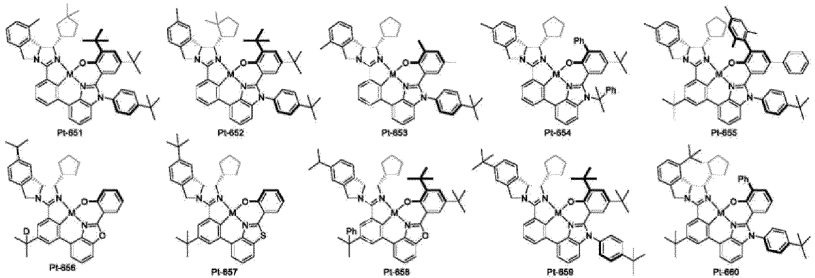 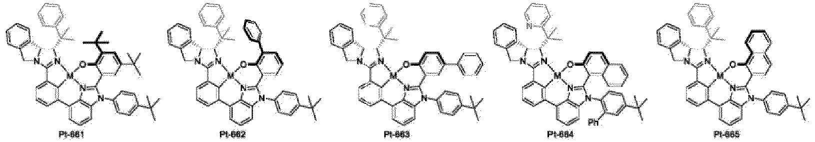 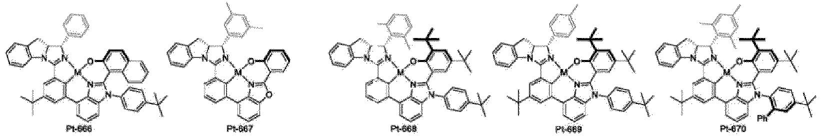 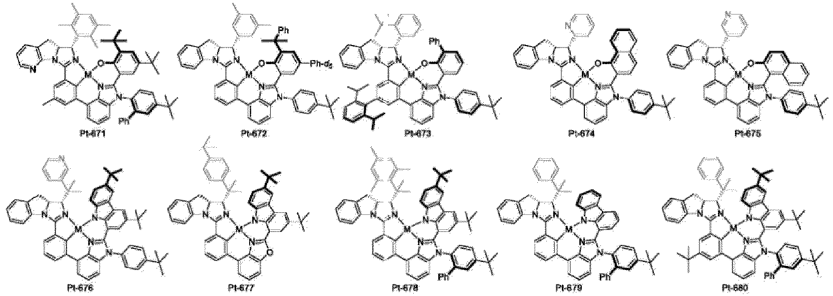 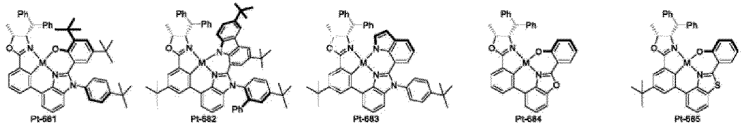 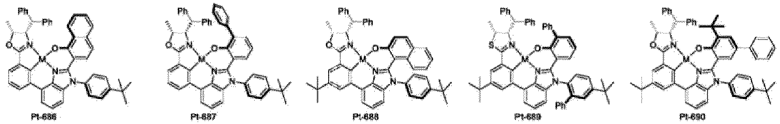 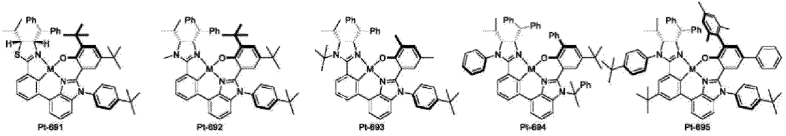 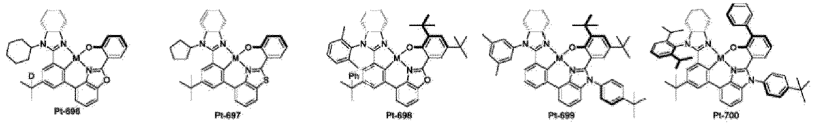 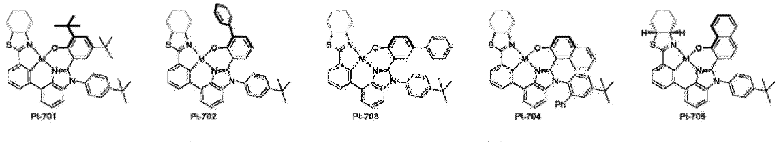 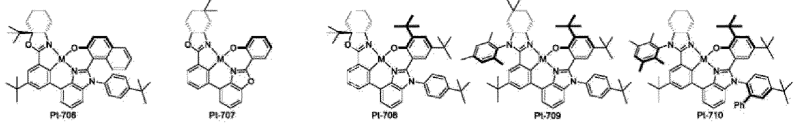 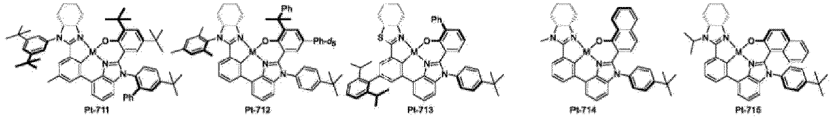 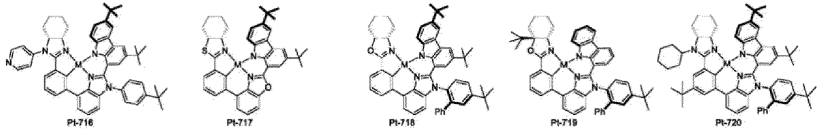 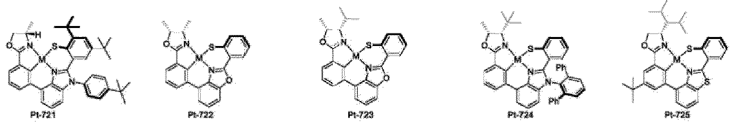 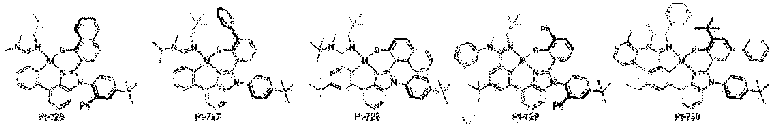 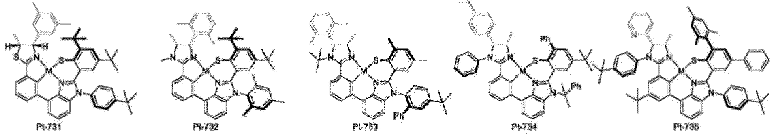 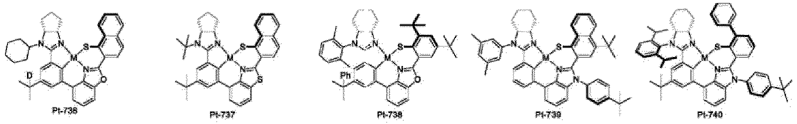 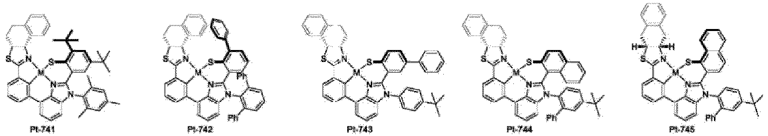 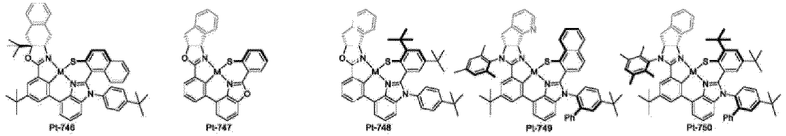 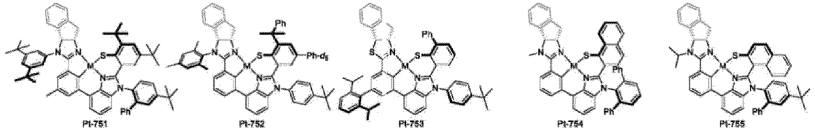 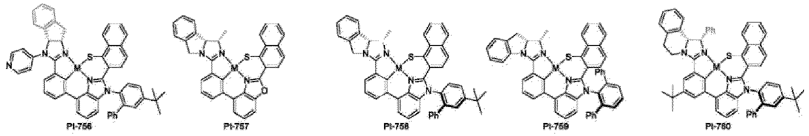 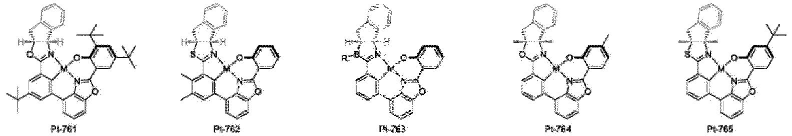 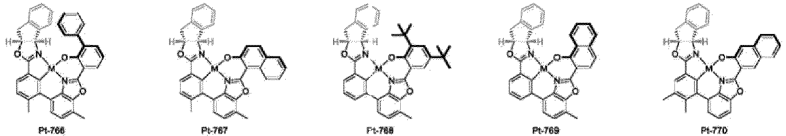 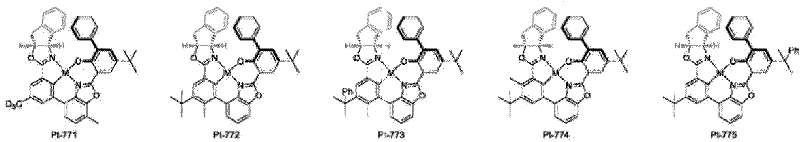 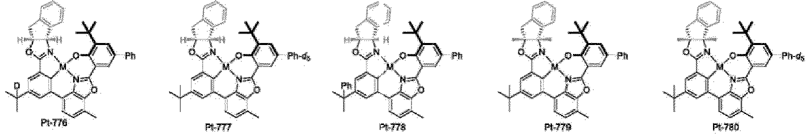 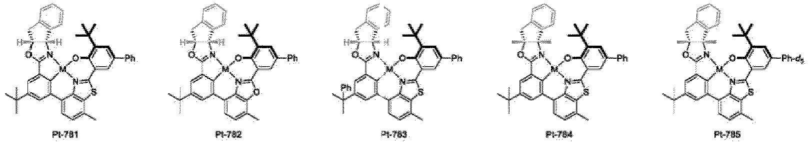 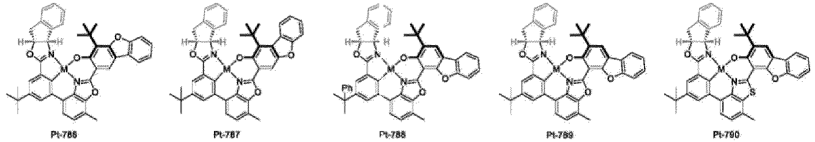 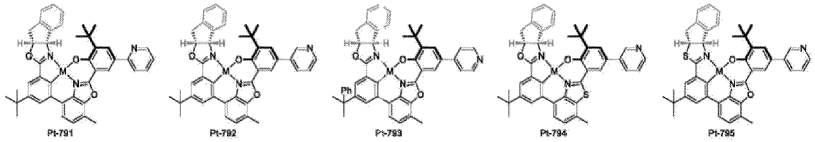 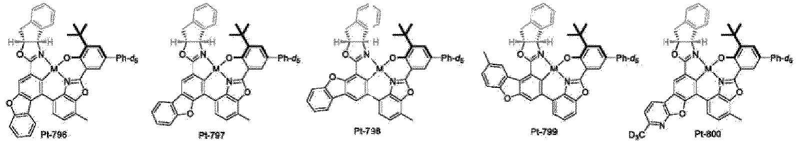 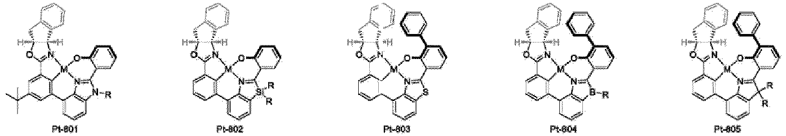 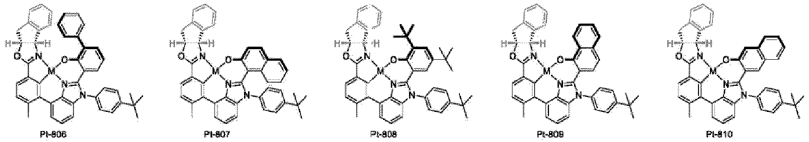 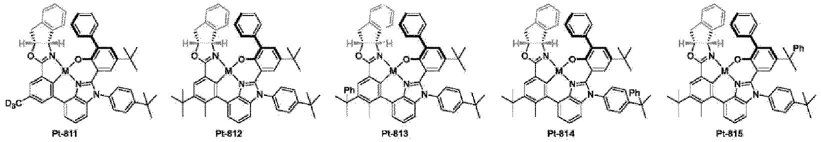 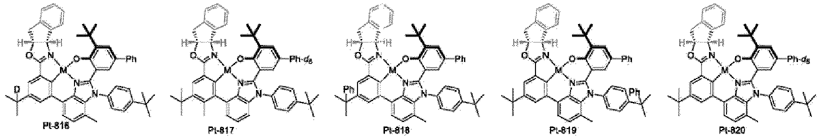 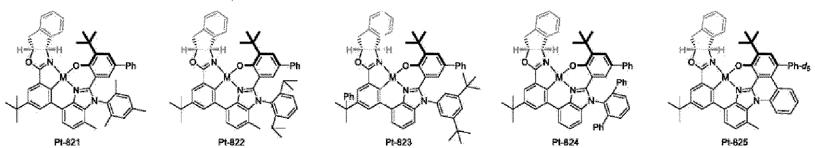 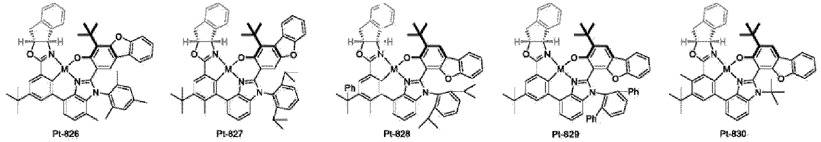 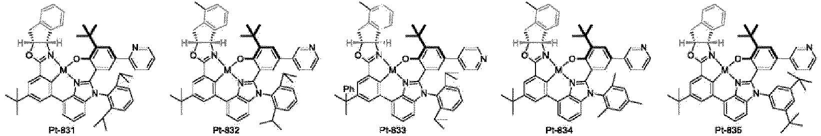 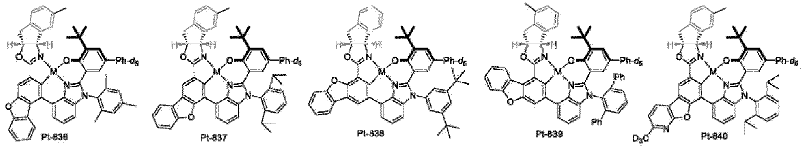 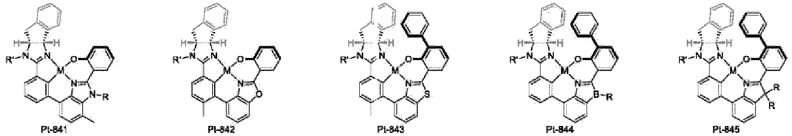 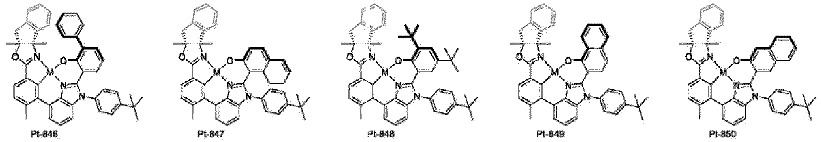 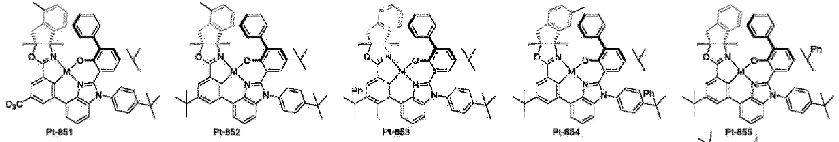 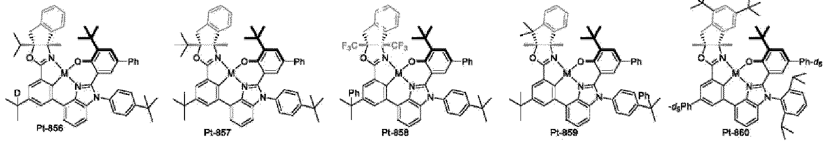 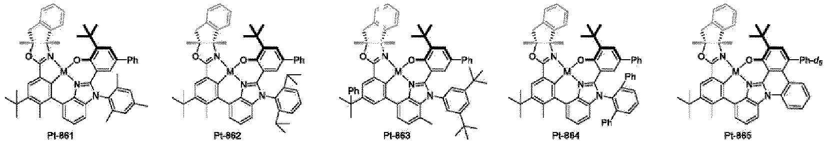 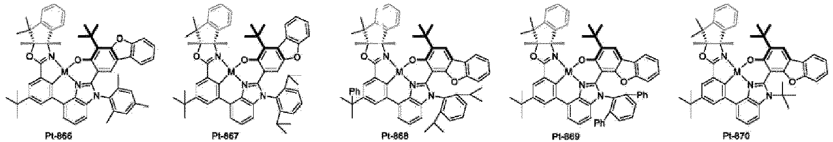 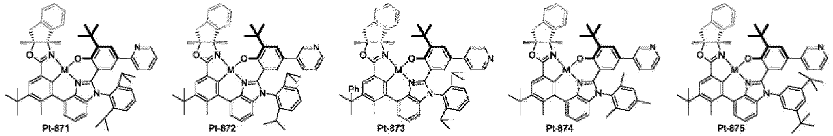 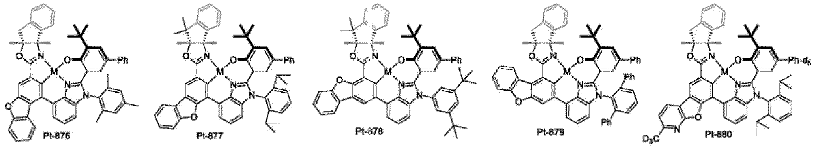 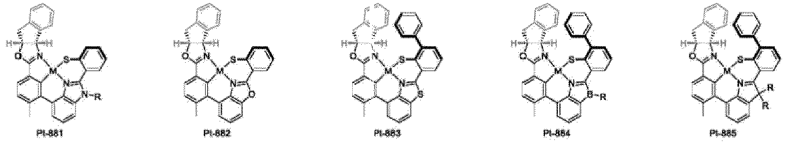 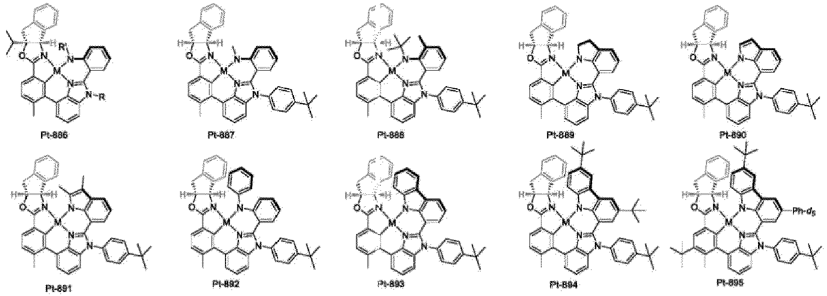 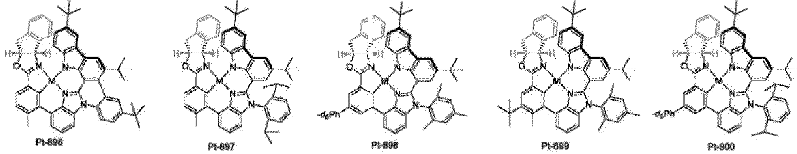 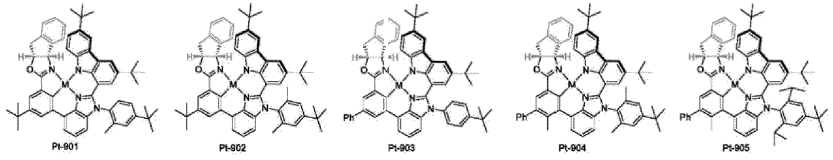 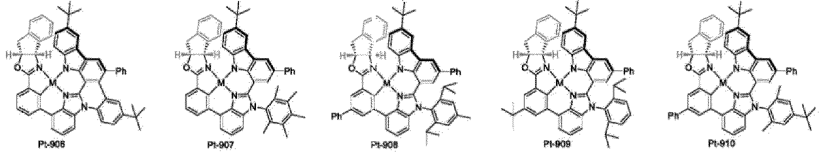 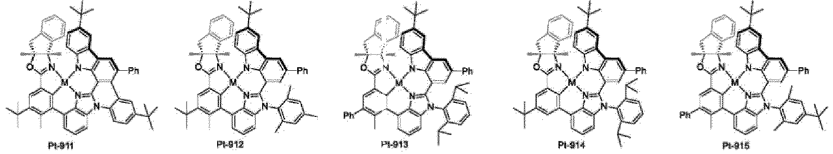 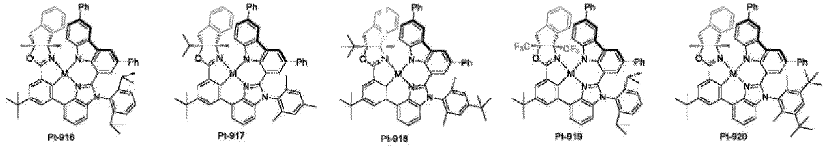 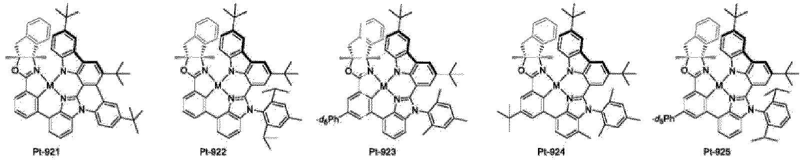 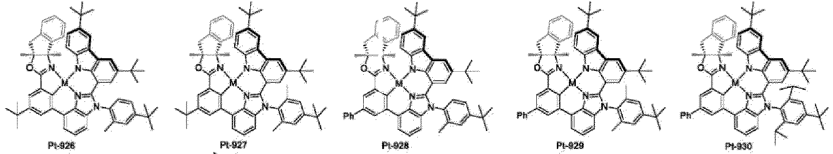 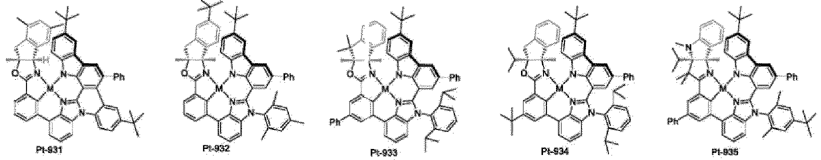 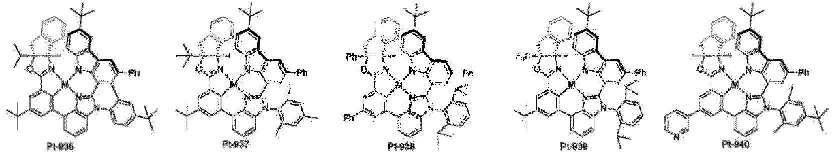 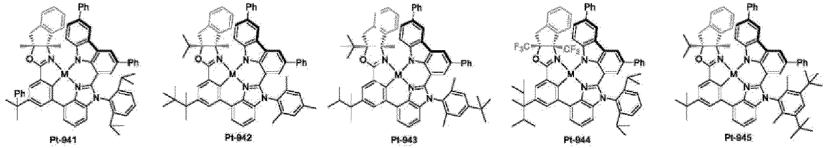 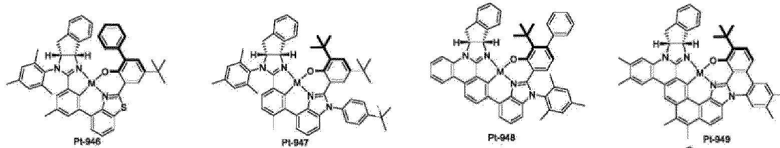 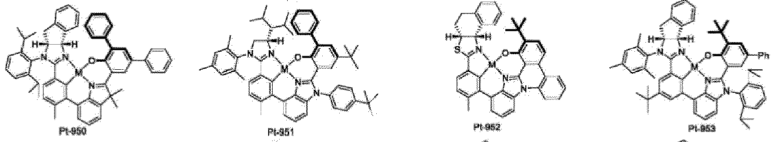 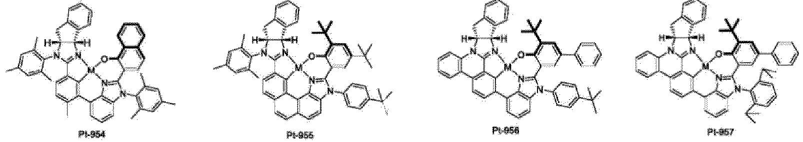 wherein M is Pt or Pd; R and R' are each independently hydrogen, deuterium, halogen, alkyl, cycloalkyl, aryl, heteroalkyl, heterocycloalkyl, heteroaryl, haloalkyl, haloaryl, haloheteroaryl, alkoxy, aryloxy, alkenyl, cycloalkenyl, alkynyl, hydroxy, mercapto, nitro, cyano, amino, mono- or dialkylamino, mono- or diarylamino, ester, nitrile, isonitrile, heteroaryl, alkoxycarbonyl, amido, alkoxycarbonylamino, aryloxycarbonylamino, sulfonylamino, sulfamoyl, carbamoyl, alkylthio, sulfinyl, ureido, phosphoryl amino, imino, sulfo, carboxy, hydrazino, substituted silyl.

6. Use of the helical-chiral tetradentate cyclometalated platinum (II) and palladium (II) complex circularly polarized light-emitting material according to any one of claims 1 to 5 in a light-emitting device, a 3D display device, a three-dimensional imaging device, an optical information encryption device, an information storage device, a biological imaging device.

7. The use according to claim 6, wherein the light-emitting device is a light-emitting diode or a light-emitting electrochemical cell.

8. A full-color display comprising a light-emitting device, wherein the light-emitting device comprises the helical-chiral tetradentate cyclometalated platinum (II) and palladium (II) complex circularly polarized light-emitting material according to any one of claims 1 to 5.

9. A light-emitting display device comprising a light-emitting device, wherein the light-emitting device comprises the helical-chiral tetradentate cyclometalated platinum (II) and palladium (II) complex circularly polarized light-emitting material according to any one of claims 1 to 5.

10. The use according to claim 7, wherein the light-emitting device comprises a first electrode, a second electrode and at least one organic layer disposed between the first electrode and the second electrode, the organic layer comprising the helical-chiral tetradentate cyclometalated platinum (II) and palladium (II) complex circularly polarized light-emitting material according to claim 1.

11. A display apparatus comprising an organic light-emitting device, wherein the organic light-emitting device comprises a first electrode, a second electrode, and at least one organic layer disposed between the first electrode and the second electrode, the organic layer comprising the helical-chiral tetradentate cyclometalated platinum (II) and palladium (II) complex circularly polarized light-emitting material according to any one of claims 1 to 5.

## Patentansprüche

1. Zentralchiralitätsinduzierender helicale-chirale tetradentate cyclometallierte Platin(II)- und Palladium(II)-Komplex-Materialien zur Emission zirkular polarisierten Lichts, **dadurch gekennzeichnet, dass** sie chemische Formeln gemäß den allgemeinen Formeln (1), (1'), (2) und (2') aufweisen, wobei (1) und (1') sowie (2) und (2') Enantiomere voneinander sind: 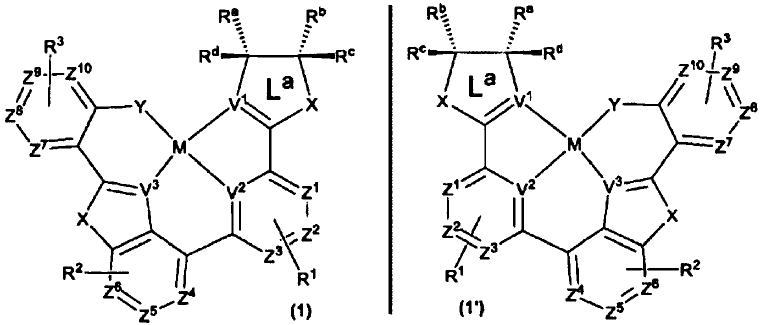 oder 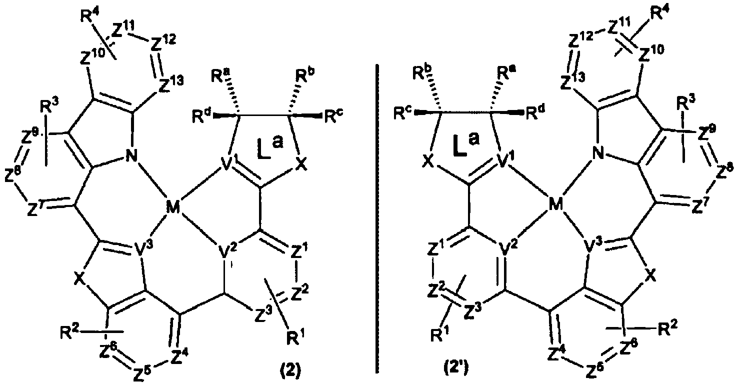
wobei M Pt oder Pd ist; V¹, V² und V³ jeweils unabhängig voneinander N oder C sind;
L^{a} ein fünfgliedriger zentralchiralitätsinduzierter carbocyclischer oder heterocyclischer Ring ist;
X O, S, CR^{x}R^{y}, C=O, SiR^{x}R^{y}, GeR^{x}R^{y}, NR^{z}, PR^{z}, R^{z}P = O, AsR^{z}, R^{z}As = O, S =O, SO₂, Se, Se = O, SeO₂, BH, BR^{z}, R^{z}Bi = O, oder BiR^{z} ist; wobei R^{x} und R^{y} jeweils unabhängig voneinander Substituenten an demselben Atom sind, ausgewählt aus C, Si und Ge, und R^{z} ein Substituent am selben Atom sind, ausgewählt aus B, N, P, As und Bi;
Y O oder S ist;
Z¹, Z², Z³, Z⁴, Z⁵, Z⁶, Z⁷, Z⁸, Z⁹, Z¹⁰, Z¹¹, Z¹², und Z¹³ jeweils unabhängig voneinander N oder C sind;
R¹, R², R³, R⁴, R^{a}, R^{b}, R^{c}, und R^{d} jeweils unabhängig voneinander mono-, di-, tri-, tetra-substituiert oder unsubstituiert sind, wobei R¹, R², R³, R⁴, R^{a}, R^{b}, R^{c} und R^{d} jeweils unabhängig voneinander Wasserstoff, Deuterium, Halogen, Alkyl, Cycloalkyl, Aryl, Heteroalkyl, Heterocycloalkyl, Heteroaryl, Haloalkyl, Haloaryl, Haloheteroaryl, Alkoxy, Aryloxy, Alkenyl, Cycloalkenyl, Alkynyl, Hydroxy, Mercapto, Nitro, Cyano, Amino, Mono- oder Dialkylamino, Mono- oder Diarylamino, Ester, Nitril, Isonitril, Heteroaryl, Alkoxycarbonyl, Acylamino, Alkoxycarbonylamino, Aryloxycarbonylamino, Sulfonylamino, Sulfamoyl, Carbamoyl, Alkylthio, Sulfinyl, Ureido, Phosphorylamino, Imino, Sulfo, Carboxy, Hydrazino, substituiertes Silyl oder eine Kombination davon sind, wobei R^{a} und R^{b} in demselben Molekül unterschiedliche Substituenten sind; wobei zwei oder mehr benachbarte R¹, R², R³, und R⁴ optional verknüpfbar sind, um einen kondensierten Ring zu bilden; wobei beliebige zwei von R^{a}, R^{b}, R^{c}, und R^{d} verknüpfbar sind, um ein cyclisches System zu bilden.

2. Zentralchiralitätsinduzierte helicale-chirale tetradentate cyclometallierte Platin(II)- und Palladium(II)-Komplex-Materialien zur Emission zirkular polarisierten Lichts mit allgemeinen Formeln (1), (1'), (2) und (2') gemäß Anspruch 1, die vorzugsweise die folgenden allgemeinen Formeln (1-A) und (2-A) sowie deren Enantiomere (1'-A) und (2'-A) aufweisen: 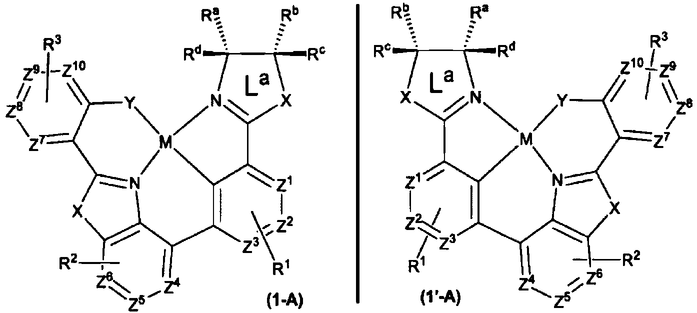 oder 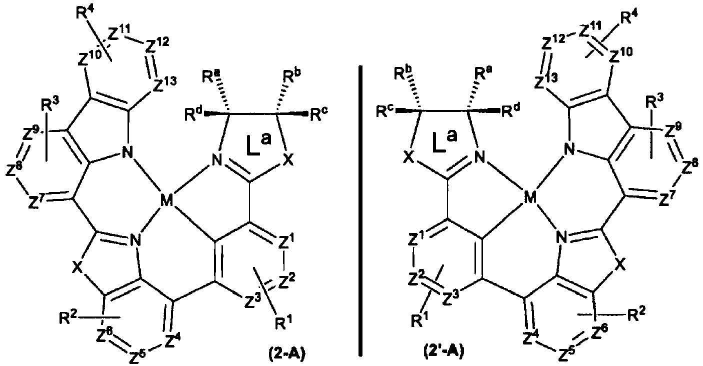
wobei M Pt oder Pd ist;
L^{a} ein fünfgliedriger zentralchiralitätsinduzierter carbocyclischer oder heterocyclischer Ring ist;
X O, S, CR^{x}R^{y}, C = O, SiR^{x}R^{y}, GeR^{x}R^{y}, NR^{z}, PR^{z}, R^{z}P = O, AsR^{z}, R^{z}As = O, S =O, SO₂, Se, Se = O, SeO₂, BH, BR^{z}, R^{z}Bi = O, oder BiR^{z} ist;
Y O oder S ist;
Z¹, Z², Z³, Z⁴, Z⁵, Z⁶, Z⁷, Z⁸, Z⁹, Z¹⁰, Z¹¹, Z¹² , und Z¹³ jeweils unabhängig voneinander N oder C sind;
R¹, R², R³, R⁴, R^{a}, R^{b}, R^{c}, und R^{d} jeweils unabhängig voneinander mono-, di-, tri-, tetra-substituiert oder unsubstituiert sind, wobei R¹, R², R³, R⁴, R^{a}, R^{b}, R^{c} und R^{d} jeweils unabhängig voneinander Wasserstoff, Deuterium, Halogen, Alkyl, Cycloalkyl, Aryl, Heteroalkyl, Heterocycloalkyl, Heteroaryl, Haloalkyl, Haloaryl, Haloheteroaryl, Alkoxy, Aryloxy, Alkenyl, Cycloalkenyl, Alkynyl, Hydroxy, Mercapto, Nitro, Cyano, Amino, Mono- oder Dialkylamino, Mono- oder Diarylamino, Ester, Nitril, Isonitril, Heteroaryl, Alkoxycarbonyl, Acylamino, Alkoxycarbonylamino, Aryloxycarbonylamino, Sulfonylamino, Sulfamoyl, Carbamoyl, Alkylthio, Sulfinyl, Ureido, Phosphorylamino, Imino, Sulfo, Carboxy, Hydrazino, substituiertes Silyl oder eine Kombination davon sind, wobei R^{a} und R^{b} in demselben Molekül unterschiedliche Substituenten sind; wobei zwei oder mehr benachbarte R¹, R², R³, und R⁴ optional verknüpfbar sind, um einen kondensierten Ring zu bilden; wobei beliebige zwei von R^{a}, R^{b}, R^{c}, und R^{d} verknüpfbar sind, um ein cyclisches System zu bilden.

3. Zentralchiralitätsinduzierte helicale-chirale tetradentate cyclometallierte Platin(II)- und Palladium(II)-Komplex-Materialien zur Emission zirkular polarisierten Lichts mit allgemeinen Formeln (1), (1'), (2) und (2') nach Anspruch 1 oder 2, wobei das zentrale chirale Segment L^{a} eine allgemeine Struktur aufweist, die vorzugsweise, jedoch nicht darauf beschränkt, aus einer Gruppe ausgewählt ist, bestehend aus: 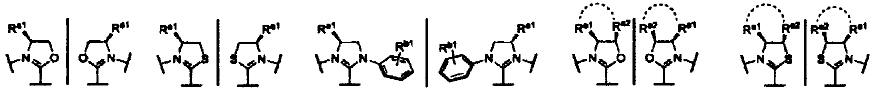 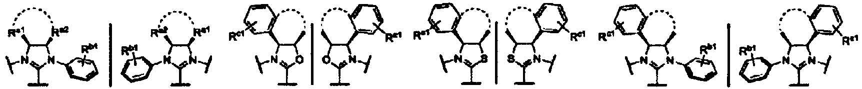 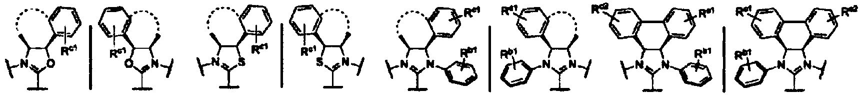 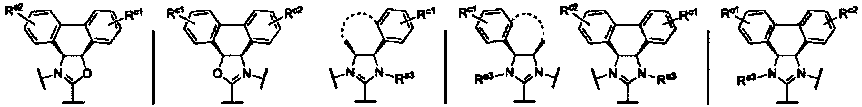
wobei R^{a1}, R^{a2} und R^{a3} jeweils unabhängig voneinander Wasserstoff, Deuterium, Halogen, Alkyl, Cycloalkyl, Aryl, Heteroalkyl, Heterocycloalkyl, Heteroaryl, Haloalkyl, Haloaryl, Haloheteroaryl, Alkoxy, Aryloxy, Alkenyl, Cycloalkenyl, Alkynyl, Hydroxy, Mercapto, Nitro, Cyano, Amino, Mono- oder Dialkylamino, Mono- oder Diarylamino, Ester, Nitril, Isonitril, Heteroaryl, Alkoxycarbonyl, Amido, Alkoxycarbonylamino, Aryloxycarbonylamino, Sulfonylamino, Sulfamoyl, Carbamoyl, Alkylthio, Sulfinyl, Ureido, Phosphorylamino, Imino, Sulfo, Carboxy, Hydrazino, substituiertes Silyl oder Kombinationen davon sind;
wobei R^{b1}, R^{c1} und R^{c2} jeweils unabhängig mono-, di-, tri- oder tetra-substituiert oder unsubstituiert sind, wobei R^{b1}, R^{c1} und R^{c2} jeweils unabhängig Wasserstoff, Deuterium, Halogen, Alkyl, Cycloalkyl, Aryl, Heteroalkyl, Heterocycloalkyl, Heteroaryl, Haloalkyl, Haloaryl, Haloheteroaryl, Alkoxy, Aryloxy, Alkenyl, Cycloalkenyl, Alkynyl, Hydroxy, Mercapto, Nitro, Cyano, Amino, Mono- oder Dialkylamino, Mono- oder Diarylamino, Ester, Nitril, Isonitril, Heteroaryl, Alkoxycarbonyl, Amido, Alkoxycarbonylamino, Aryloxycarbonylamino, Sulfonylamino, Sulfamoyl, Carbamoyl, Alkylthio, Sulfinyl, Ureido, Phosphorylamino, Imino, Sulfo, Carboxy, Hydrazino, substituiertes Silyl oder Kombinationen davon sind; wobei zwei oder mehr benachbarte R^{b1}, R^{c1} und R^{c2} optional verknüpfbar sind, um einen kondensierten Ring zu bilden.

4. Zentralchiralitätsinduzierte helicale-chirale tetradentate cyclometallierte Platin(II)- und Palladium(II)-Komplex-Materialien zur Emission zirkular polarisierten Lichts mit allgemeinen Formeln (1), (1'), (2) und (2') nach Anspruch 3, wobei das zentrale chirale Segment L^{a} eine spezifische Struktur aufweist, die vorzugsweise, jedoch nicht darauf beschränkt, aus einer Gruppe ausgewählt ist, bestehend aus: 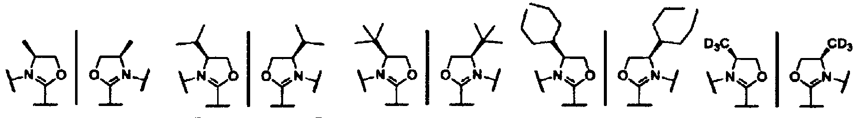 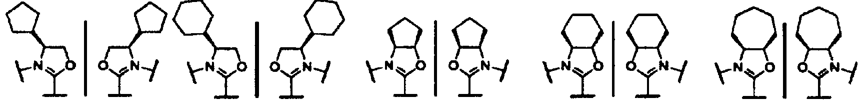 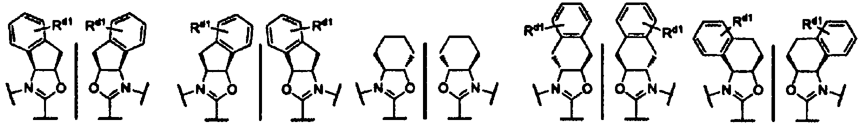 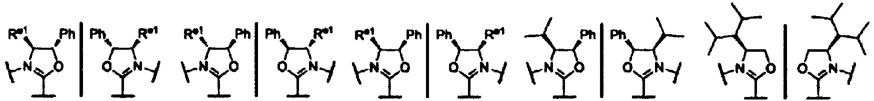 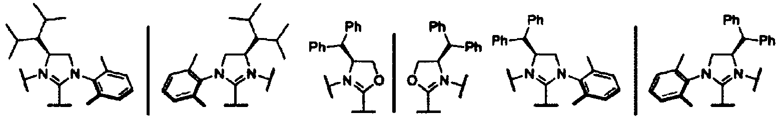 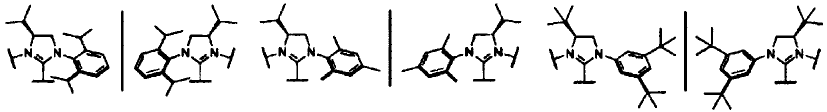 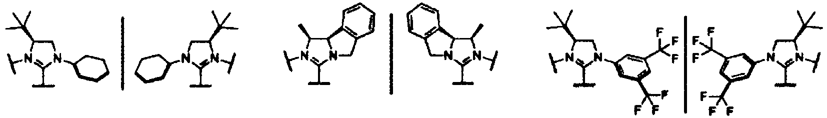 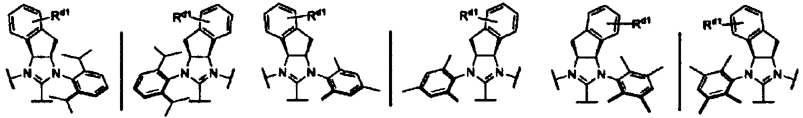 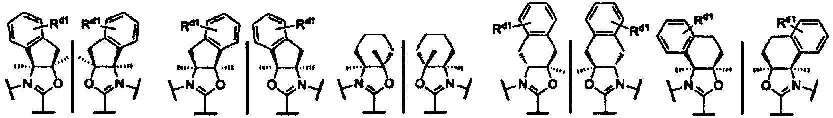 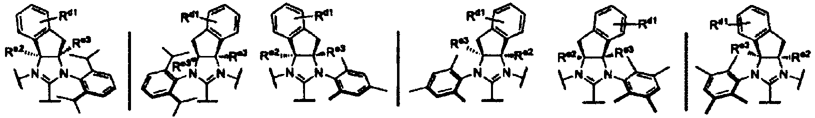 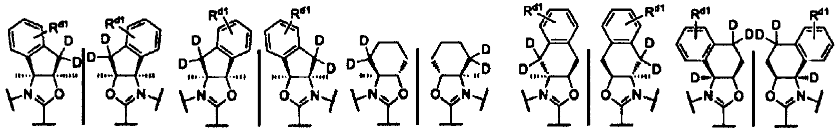 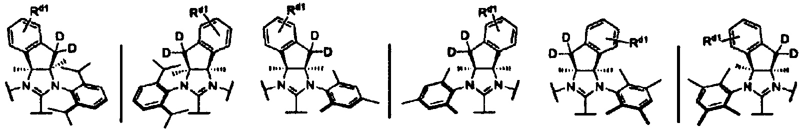 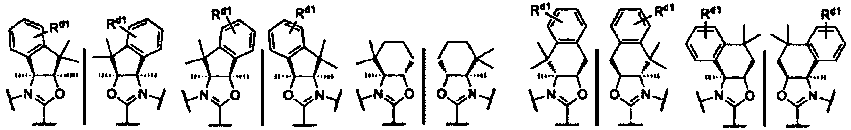 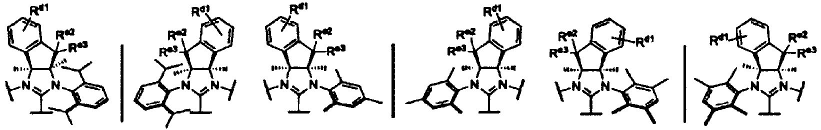 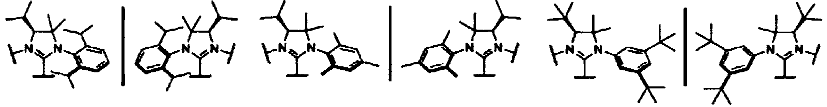 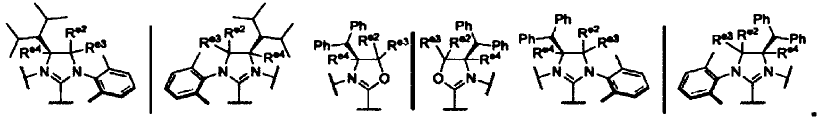
wobei R^{d1} mono-, di-, tri- oder tetra-substituiert oder unsubstituiert ist, während R^{b1} jeweils unabhängig Wasserstoff, Deuterium, Halogen, Alkyl, Cycloalkyl, Aryl, Heteroalkyl, Heterocycloalkyl, Heteroaryl, Haloalkyl, Haloaryl, Haloheteroaryl, Alkoxy, Aryloxy, Alkenyl, Cycloalkenyl, Alkynyl, Hydroxy, Mercapto, Nitro, Cyano, Amino, Mono- oder Dialkylamino, Mono- oder Diarylamino, Ester, Nitril, Isonitril, Heteroaryl, Alkoxycarbonyl, Amido, Alkoxycarbonylamino, Aryloxycarbonylamino, Sulfonylamino, Sulfamoyl, Carbamoyl, Alkylthio, Sulfinyl, Ureido, Phosphorylamino, Imino, Sulfo, Carboxy, Hydrazino, substituiertes Silyl oder Kombinationen davon ist; wobei zwei oder mehr benachbarte R^{d1} optional verknüpfbar sind, um einen kondensierten Ring zu bilden;
wobei R^{e1}, R^{e2}, R^{e3} und R^{e4} jeweils unabhängig voneinander Wasserstoff, Deuterium, Halogen, Alkyl, Cycloalkyl, Aryl, Heteroalkyl, Heterocycloalkyl, Heteroaryl, Haloalkyl, Haloaryl, Haloheteroaryl, Alkoxy, Aryloxy, Alkenyl, Cycloalkenyl, Alkynyl, Hydroxy, Mercapto, Nitro, Cyano, Amino, Mono- oder Dialkylamino, Mono- oder Diarylamino, Ester, Nitril, Isonitril, Heteroaryl, Alkoxycarbonyl, Amido, Alkoxycarbonylamino, Aryloxycarbonylamino, Sulfonylamino, Sulfamoyl, Carbamoyl, Alkylthio, Sulfinyl, Ureido, Phosphorylamino, Imino, Sulfo, Carboxy, Hydrazino, substituiertes Silyl oder Kombinationen davon sind.

5. Zentralchiralitätsinduzierte helicale-chirale tetradentate cyclometallierte Platin(II)- und Palladium(II)-Komplex-Materialien gemäß Anspruch 1 oder 2, mit einer allgemeinen Struktur, die vorzugsweise, jedoch nicht darauf beschränkt, aus einer Gruppe ausgewählt ist, bestehend aus: 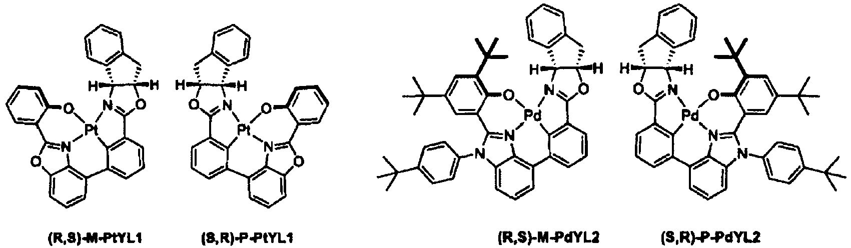 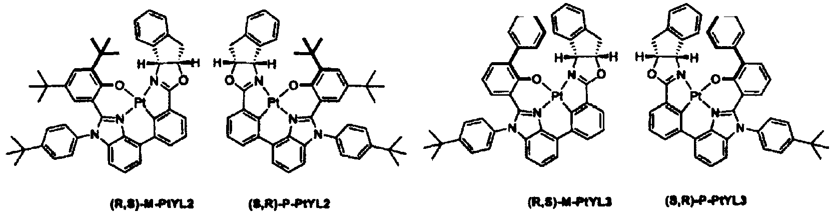 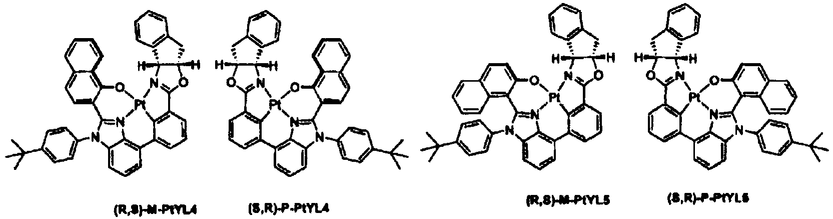 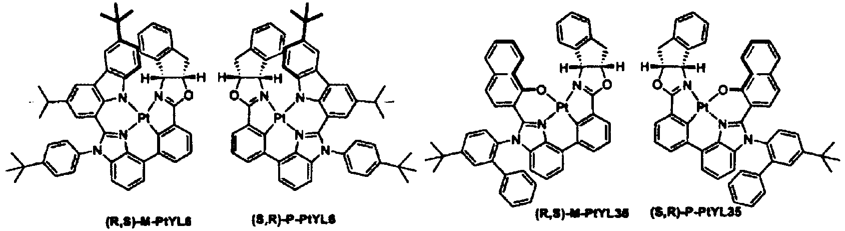 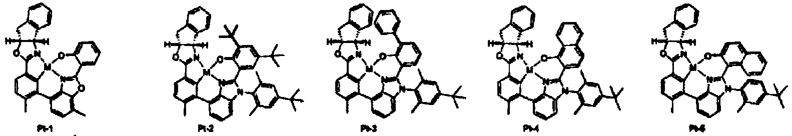 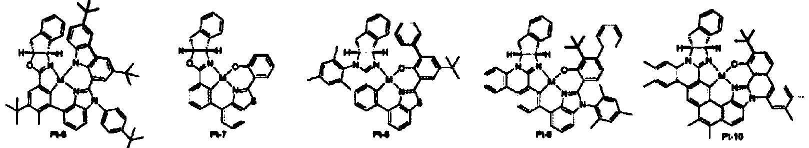 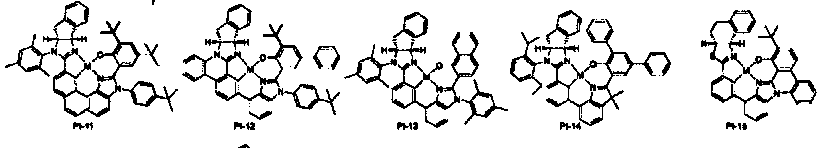 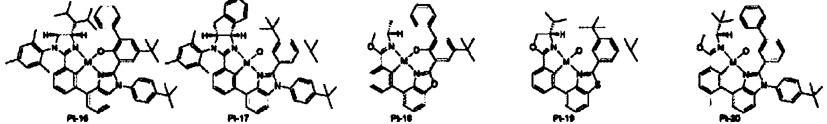 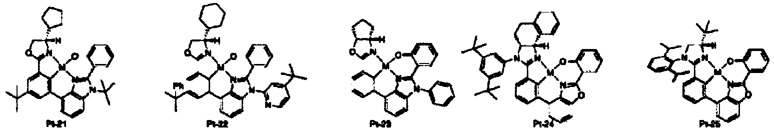 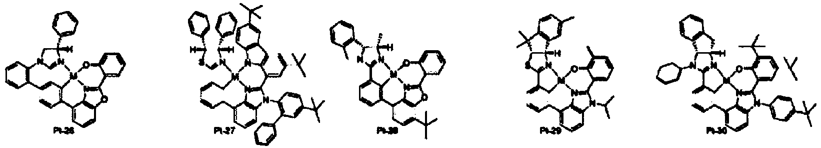 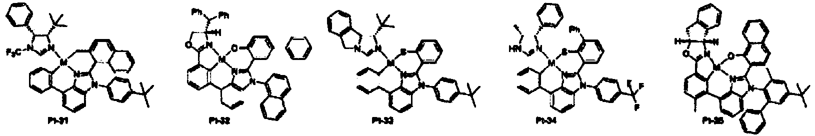 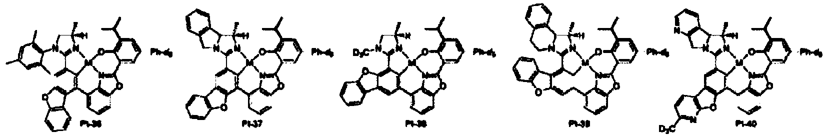 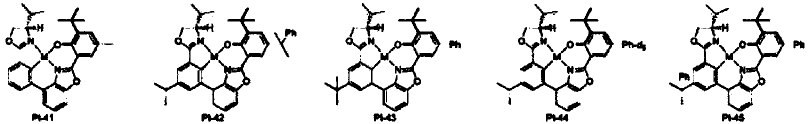 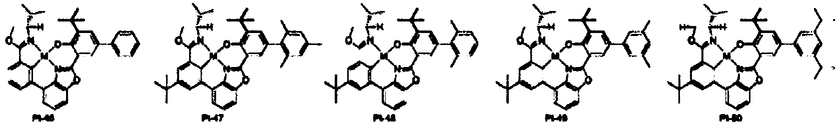 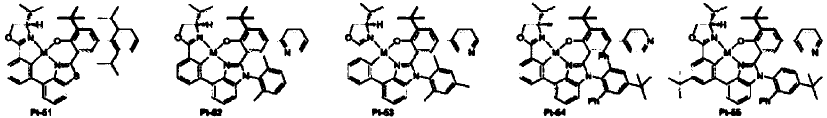 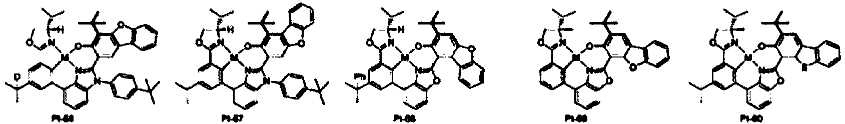 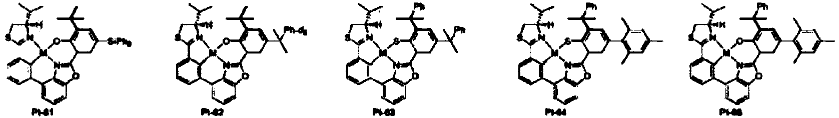 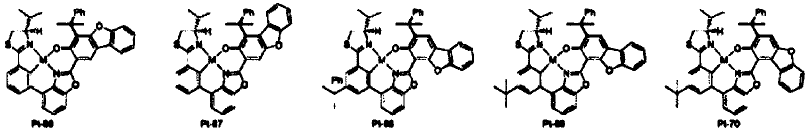 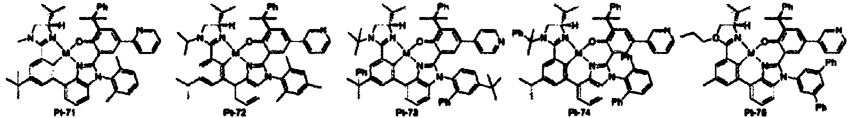 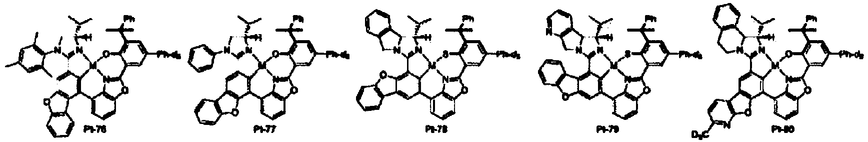 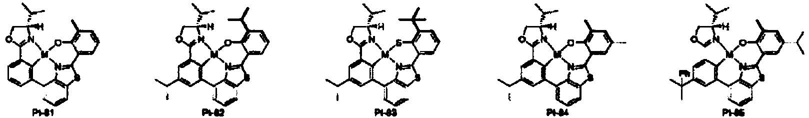 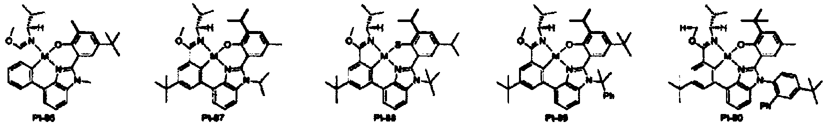 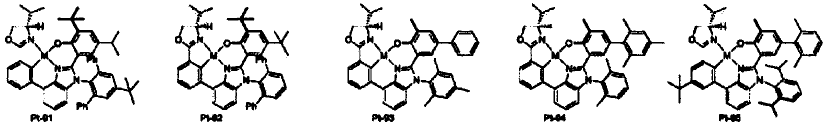 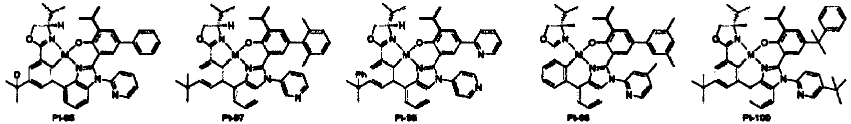 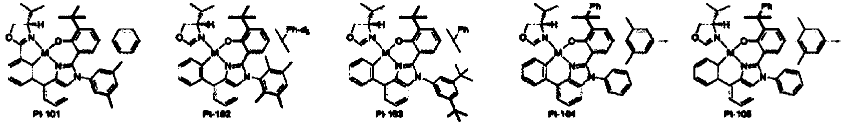 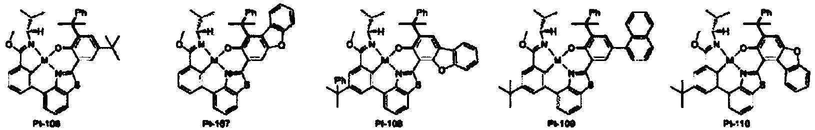 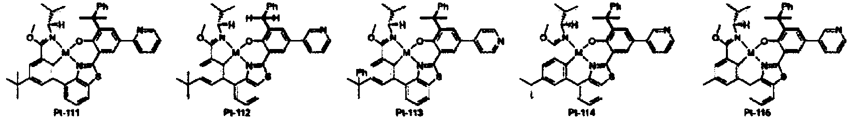 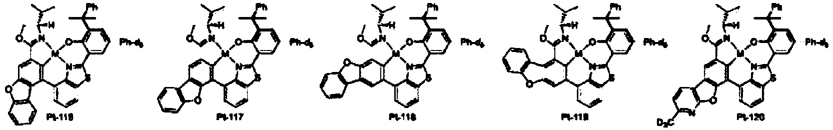 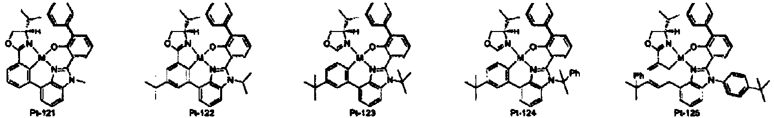 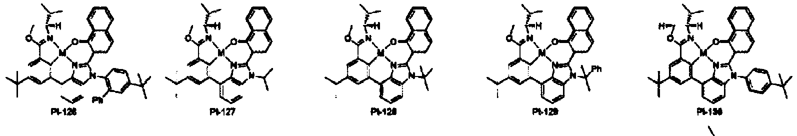 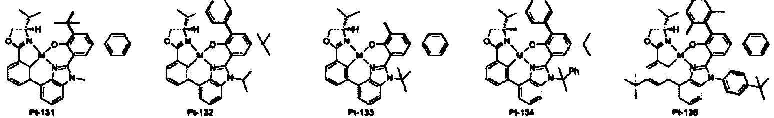 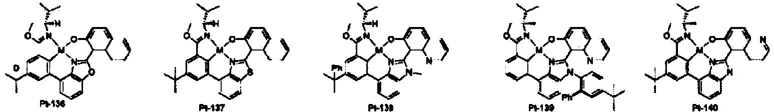 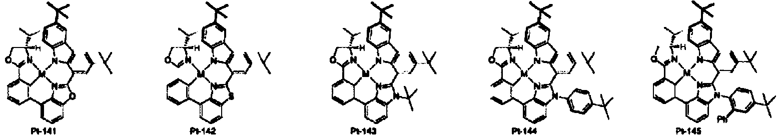 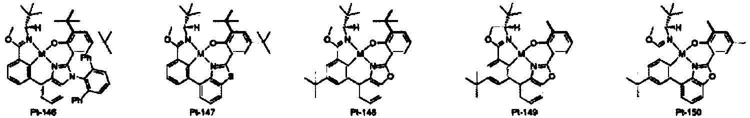 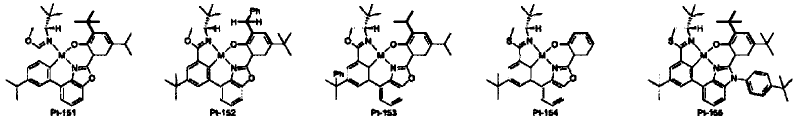 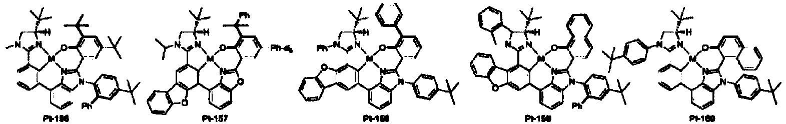 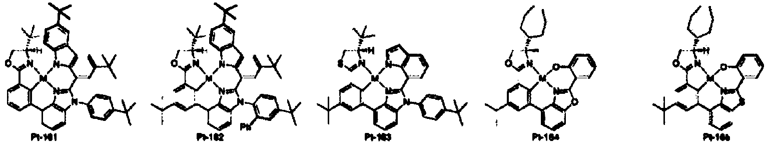 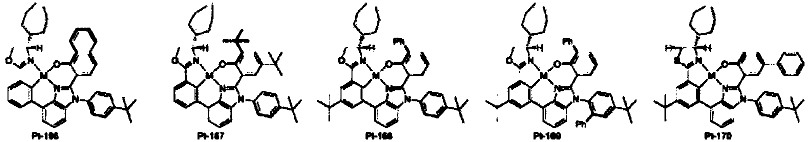 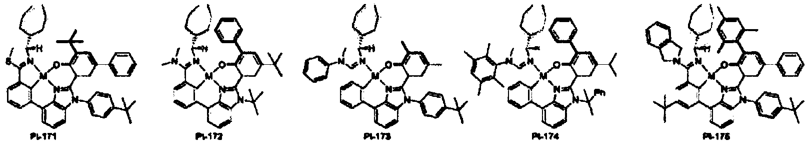 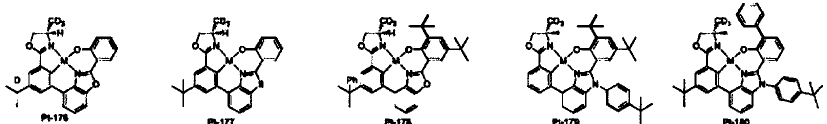 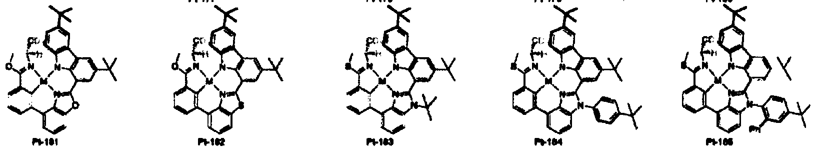 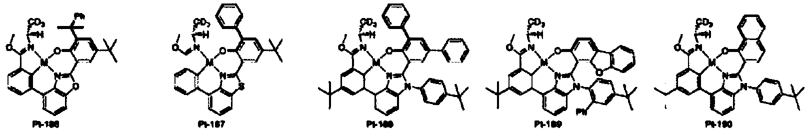 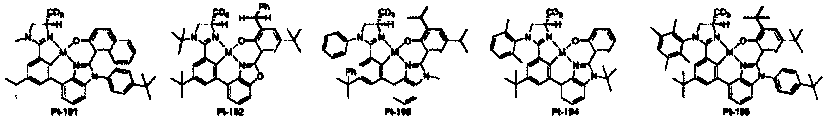 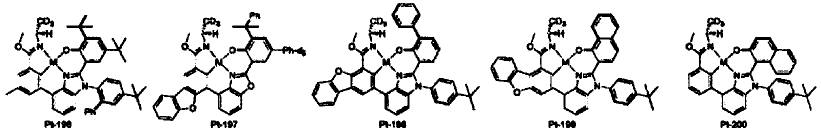 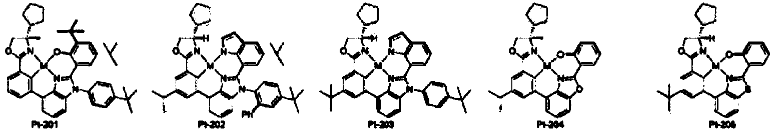 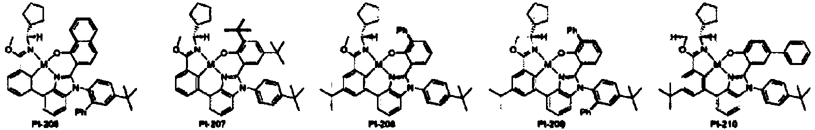 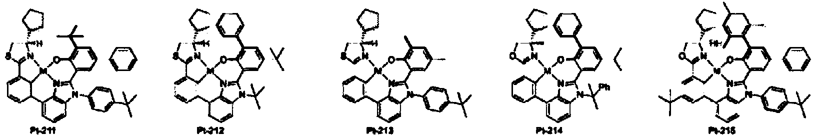 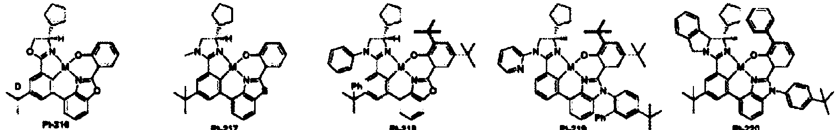 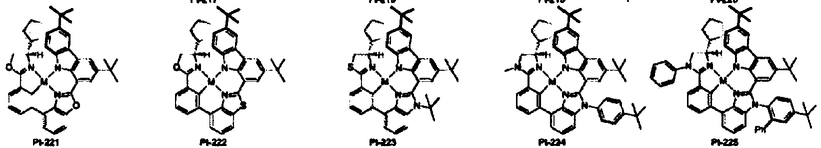 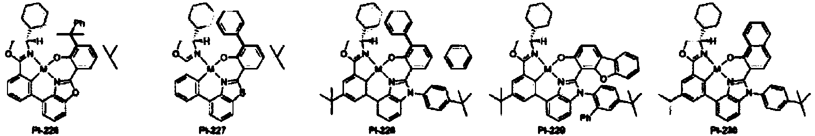 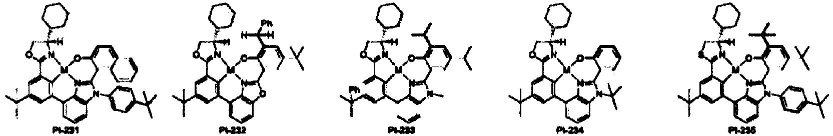 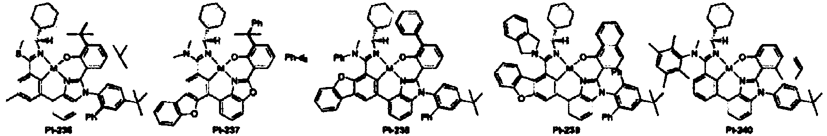 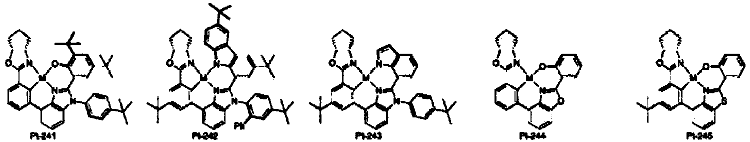 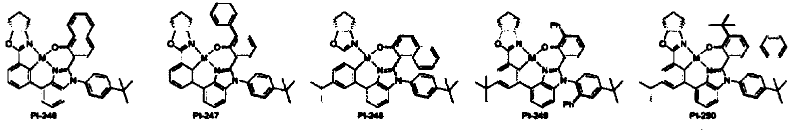 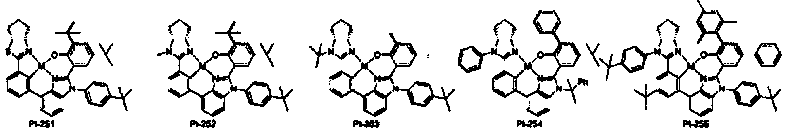 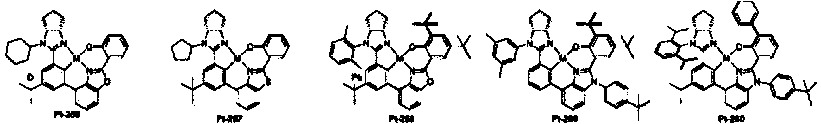 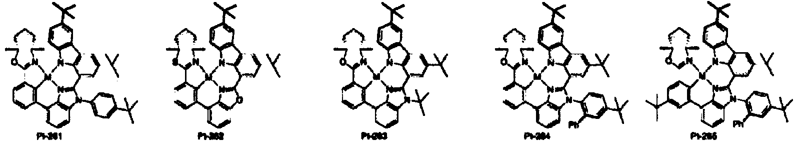 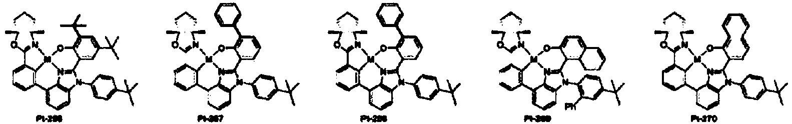 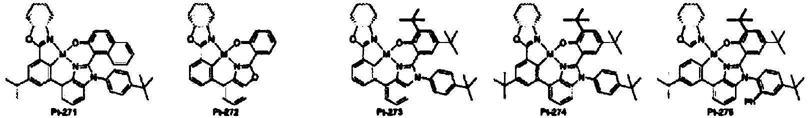 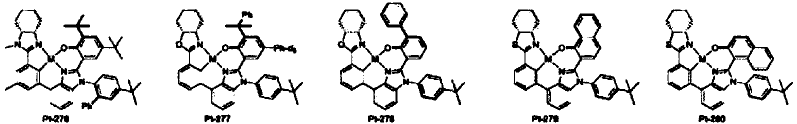 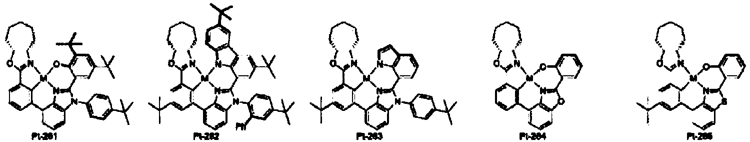 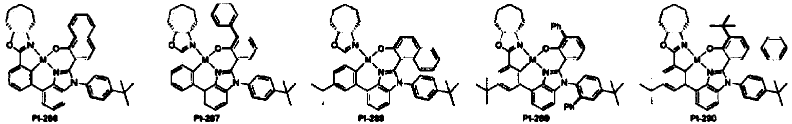 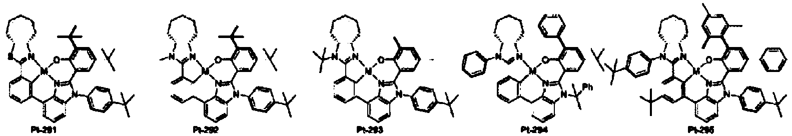 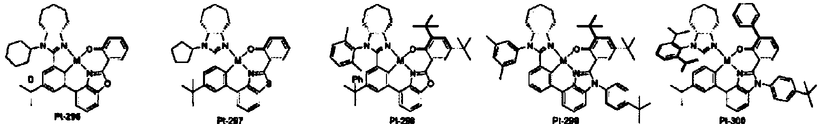 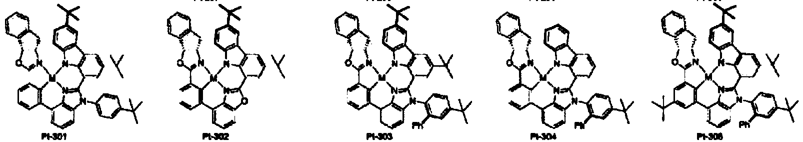 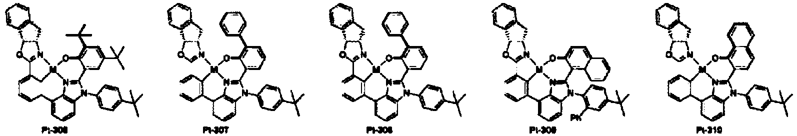 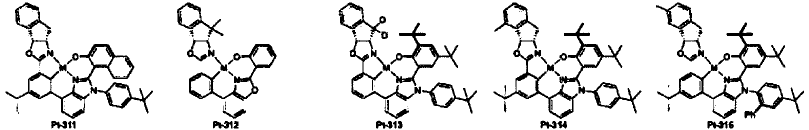 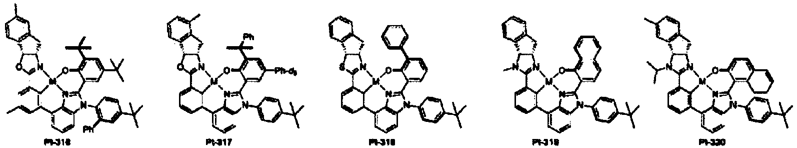 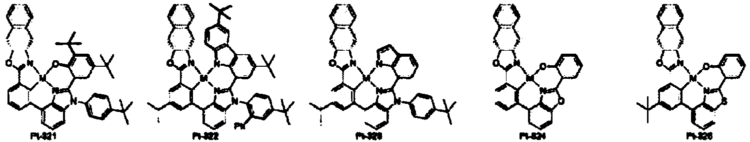 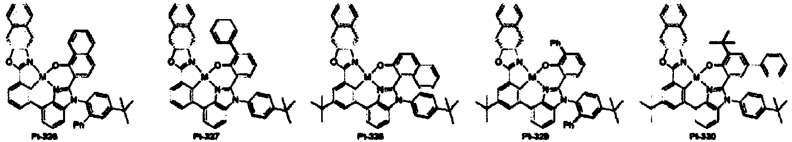 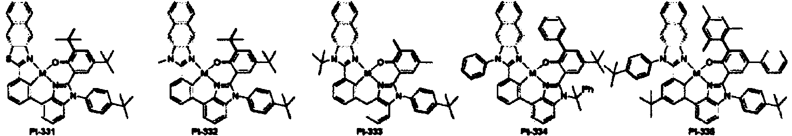 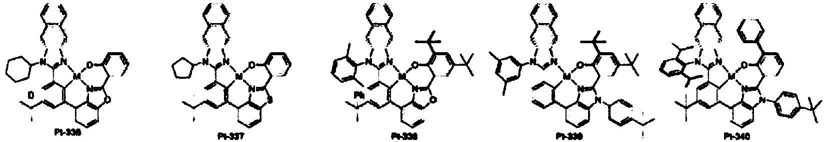 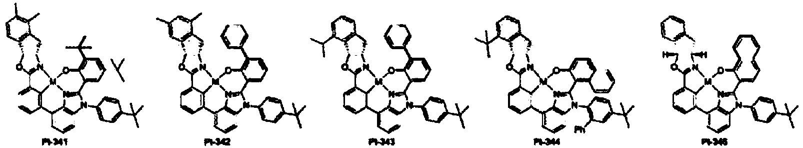 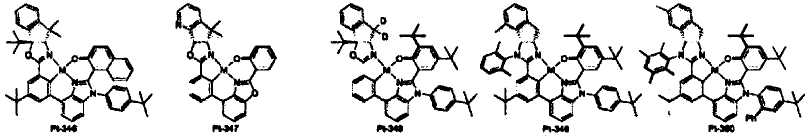 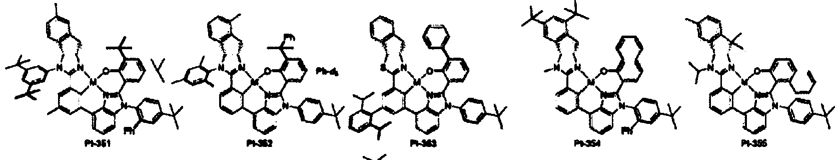 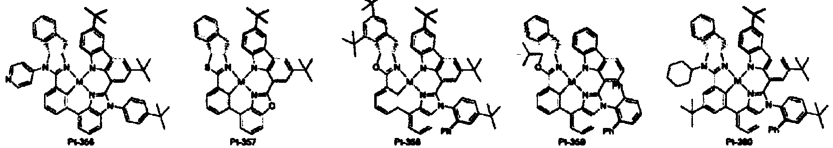 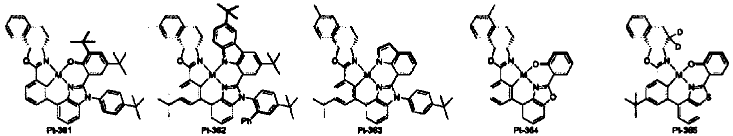 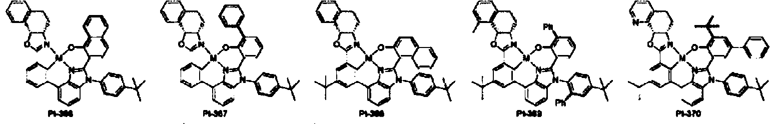 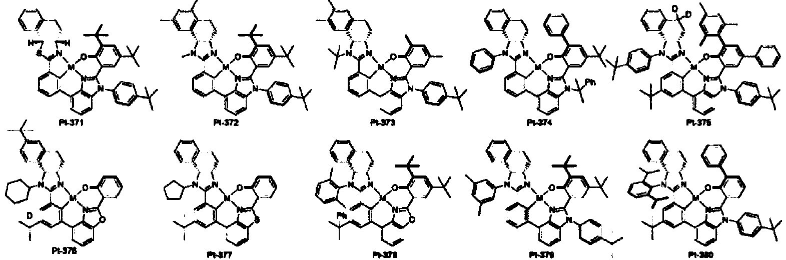 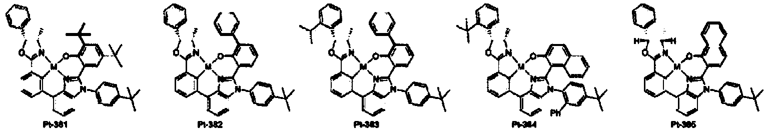 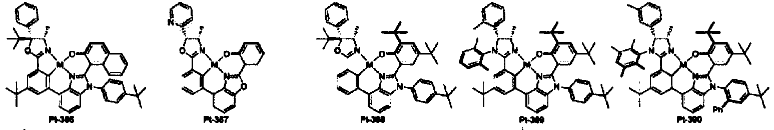 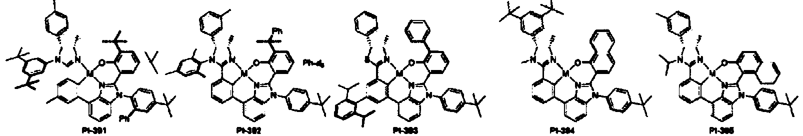 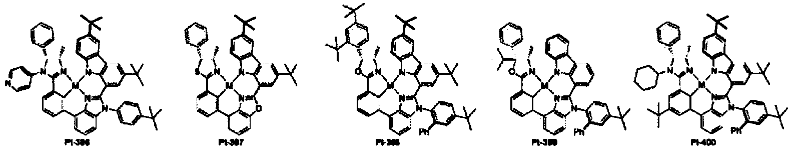 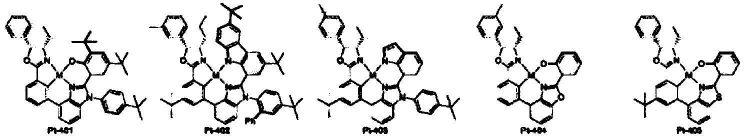 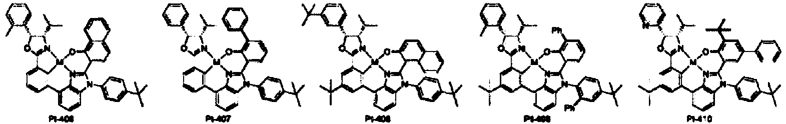 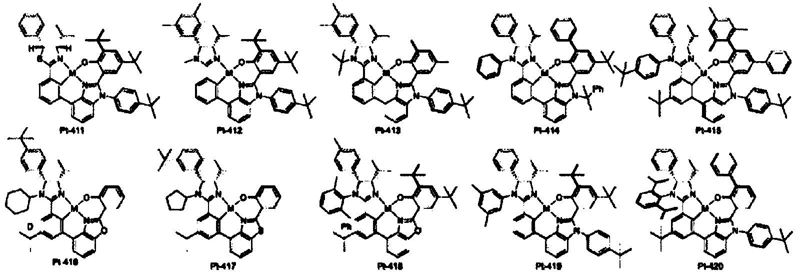 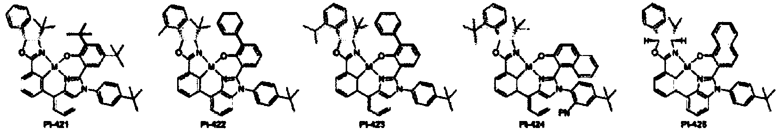 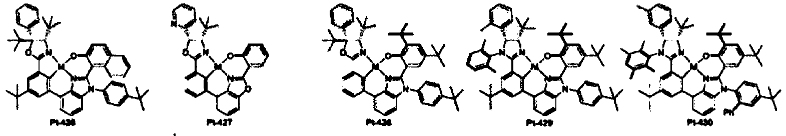 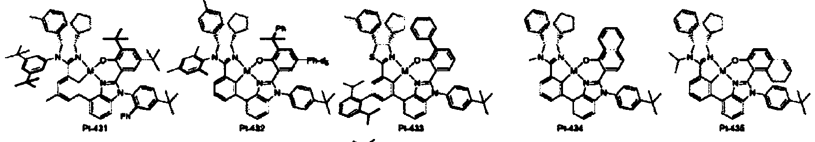 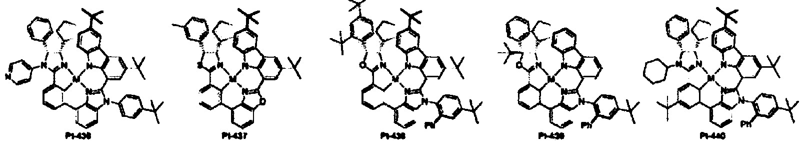 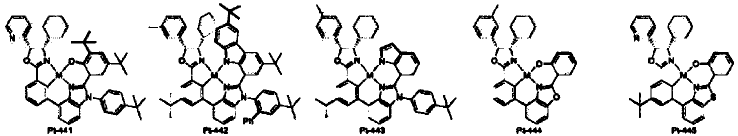 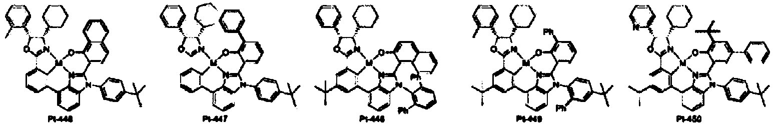 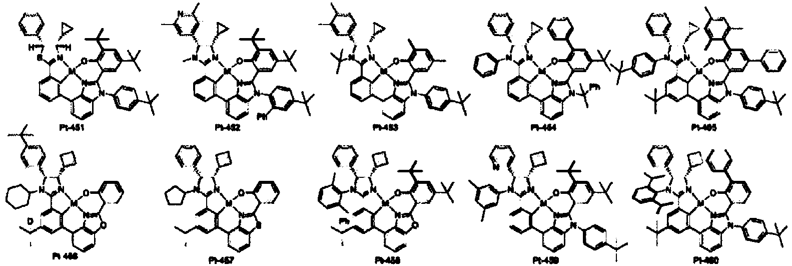 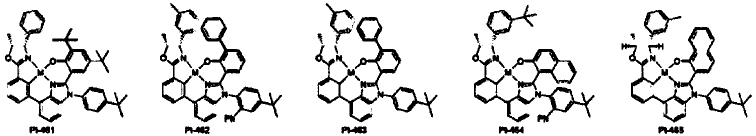 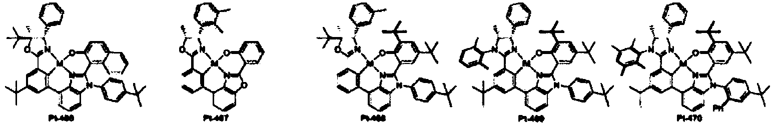 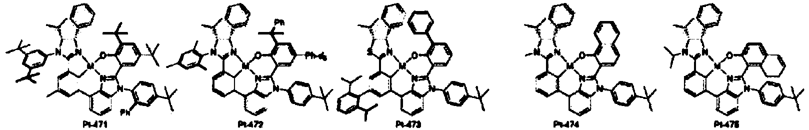 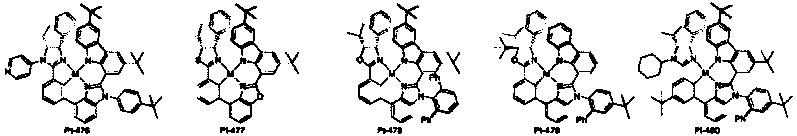 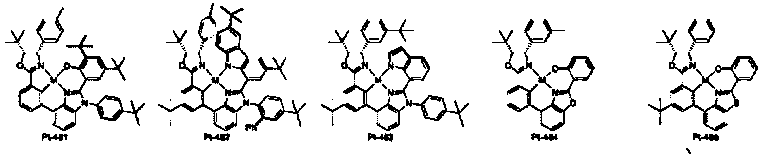 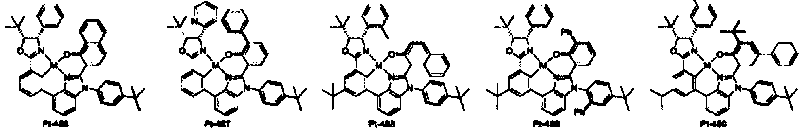 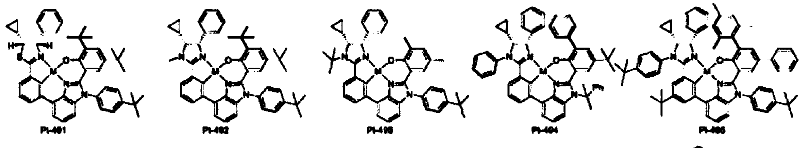 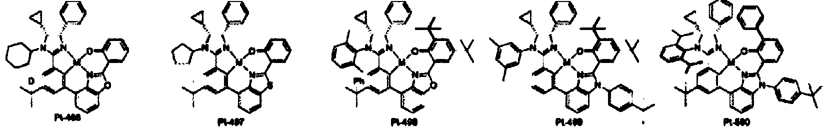 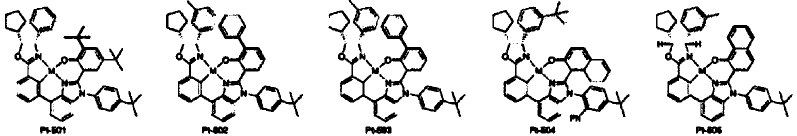 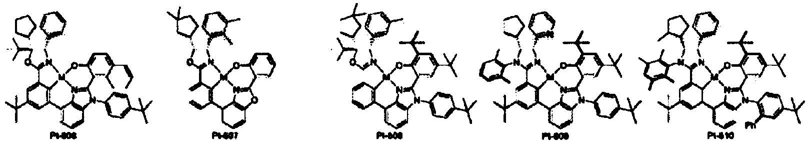 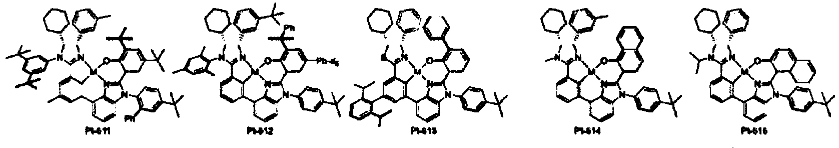 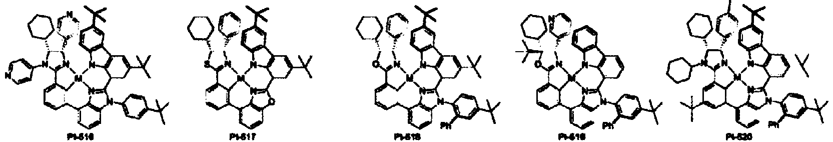 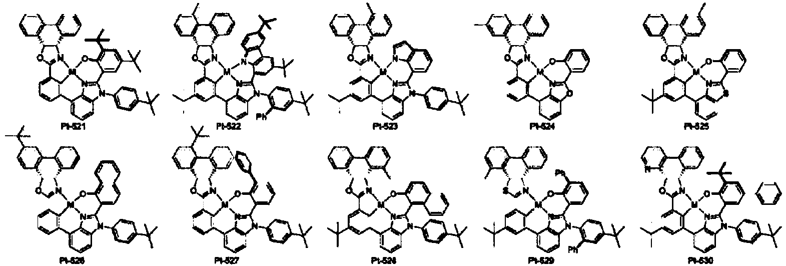 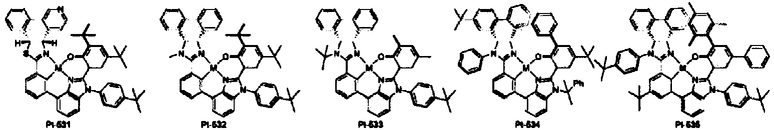 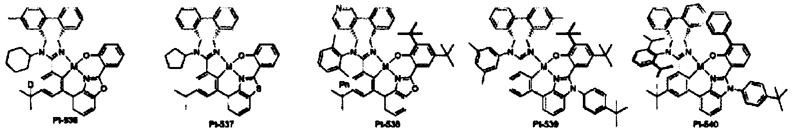 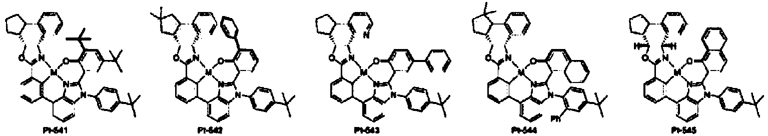 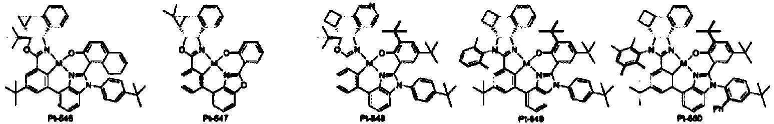 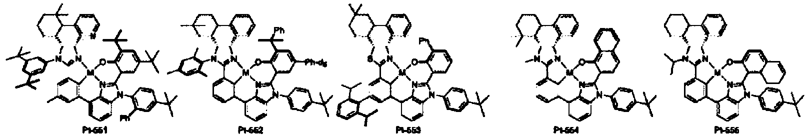 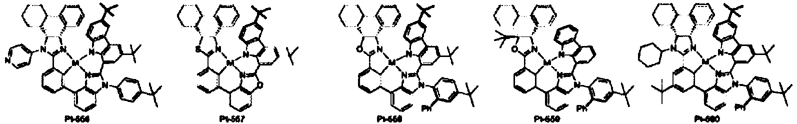 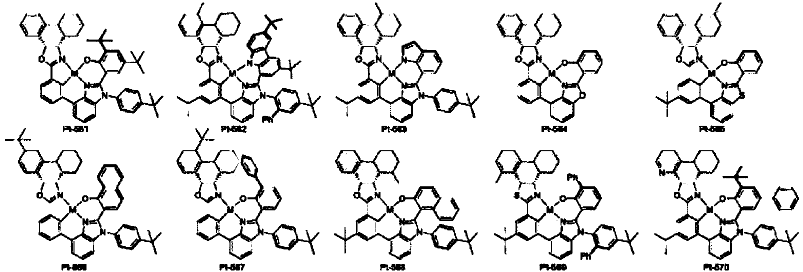 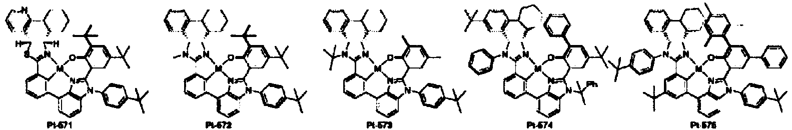 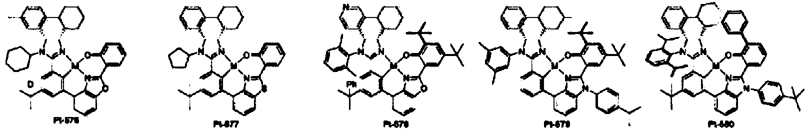 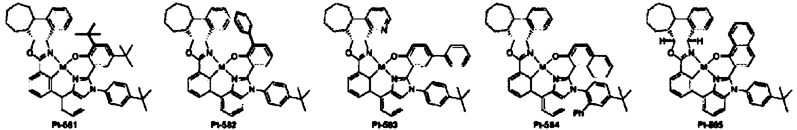 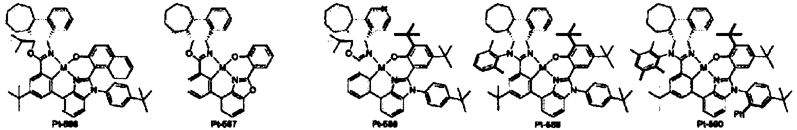 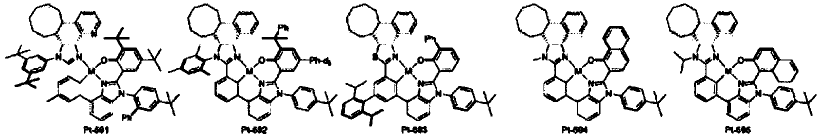 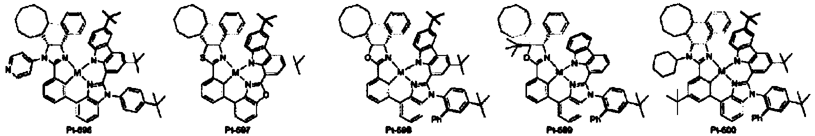 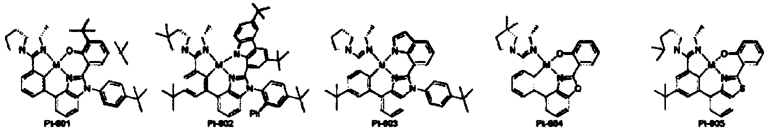 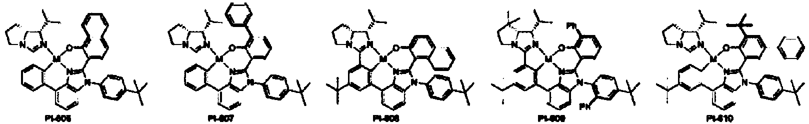 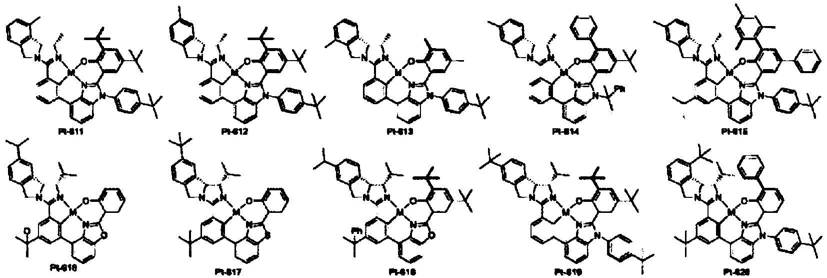 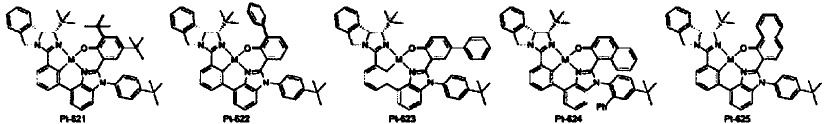 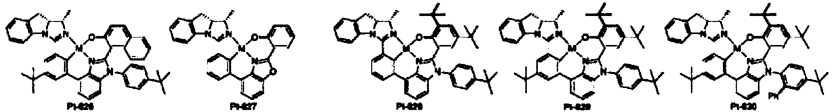 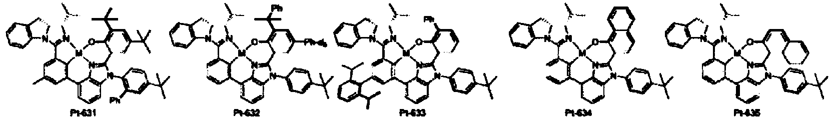 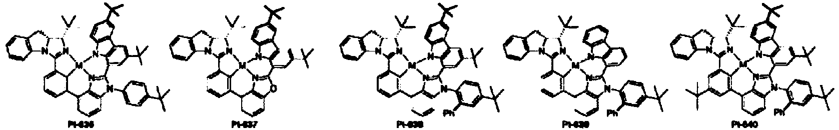 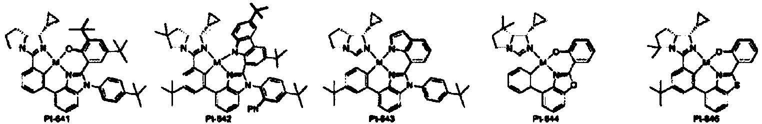 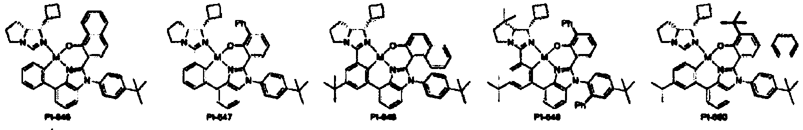 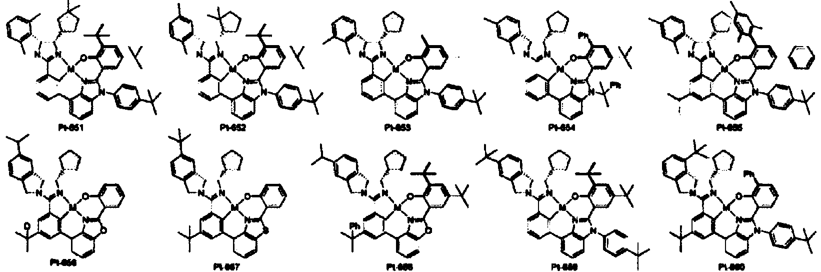 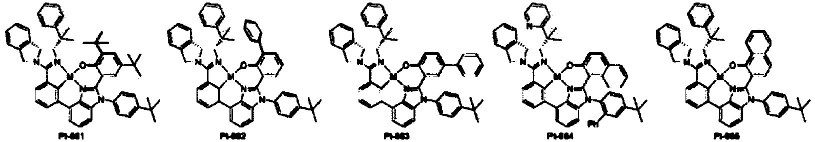 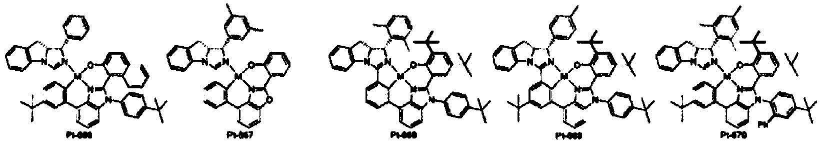 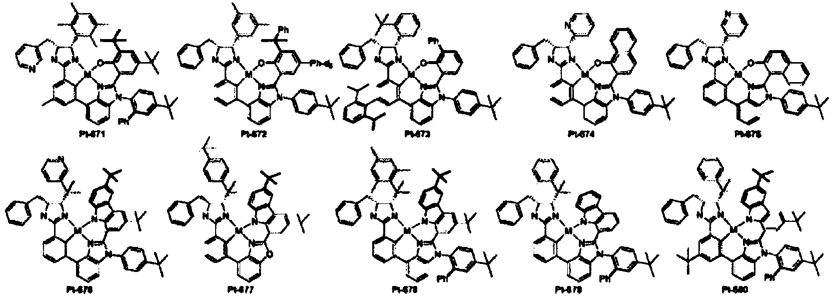 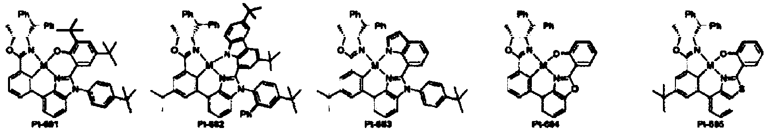 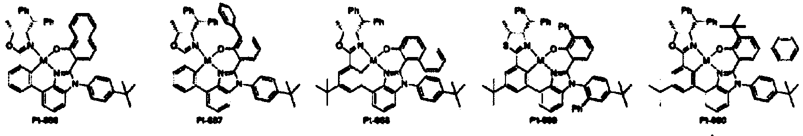 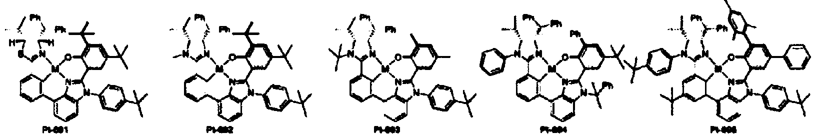 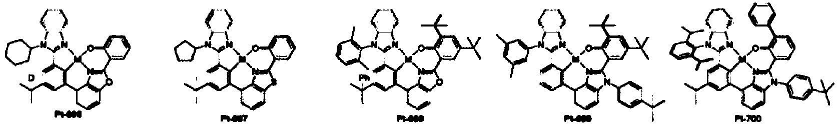 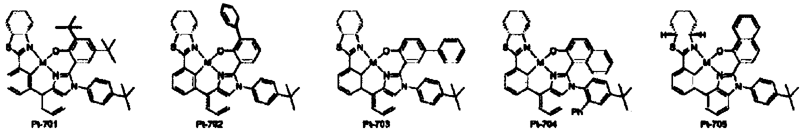 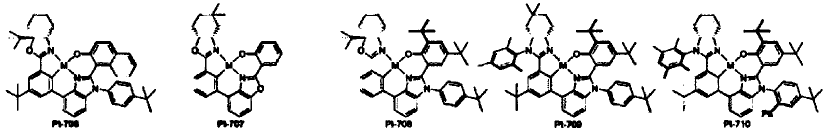 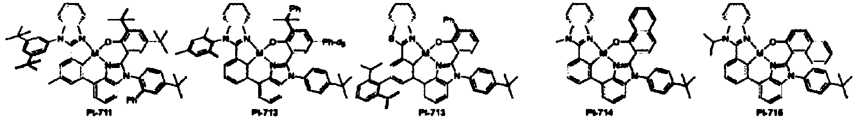 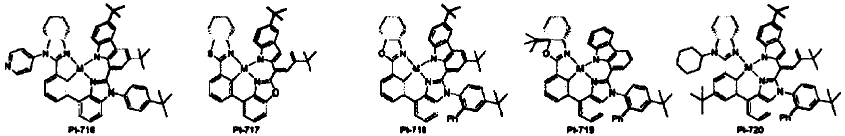 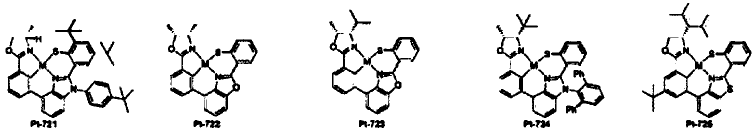 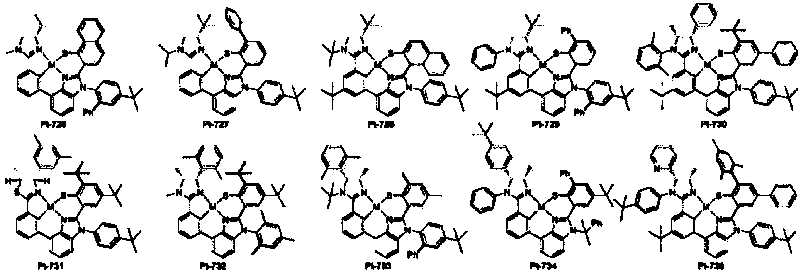 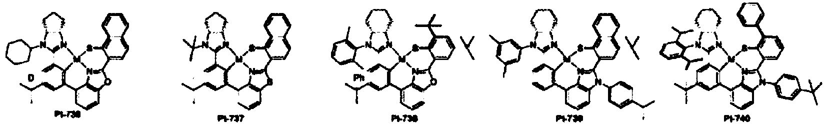 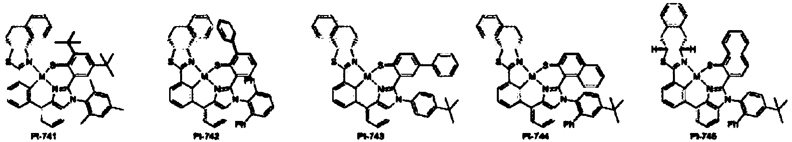 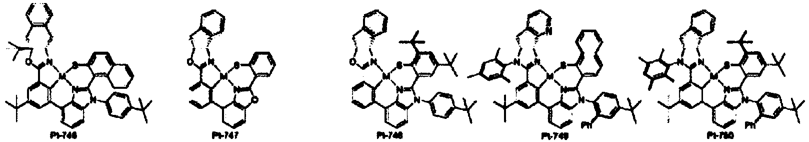 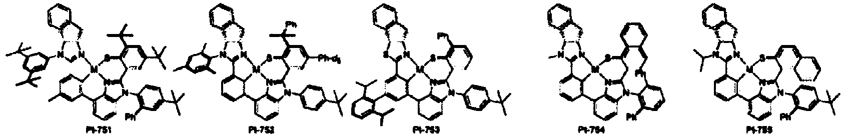 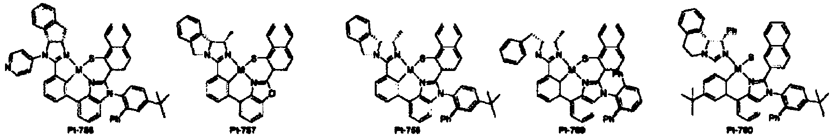 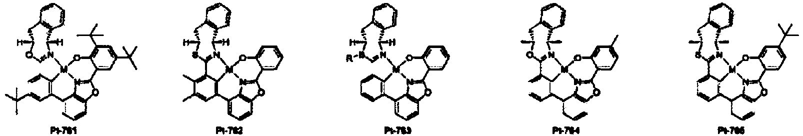 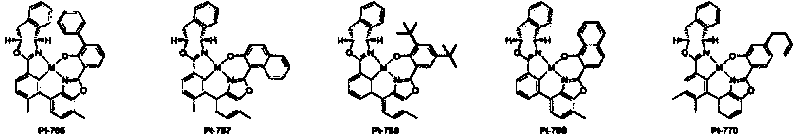 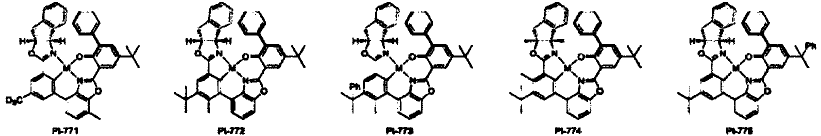 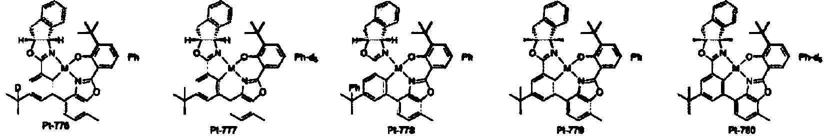 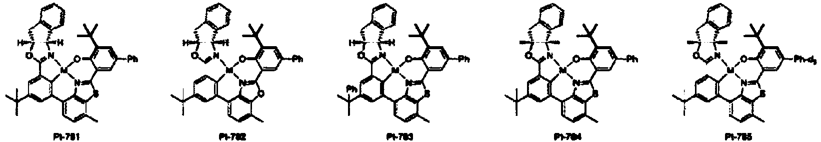 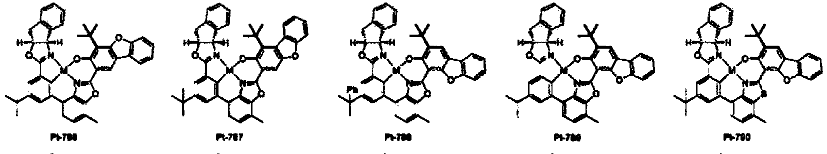 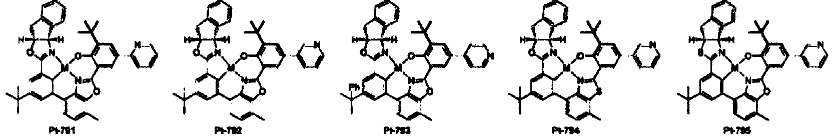 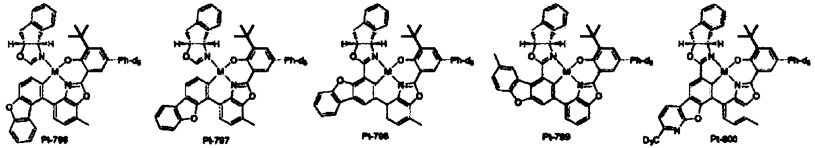 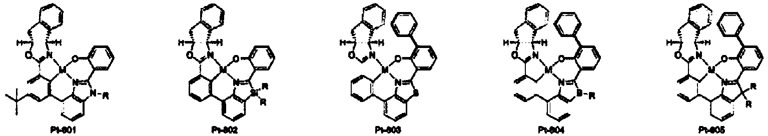 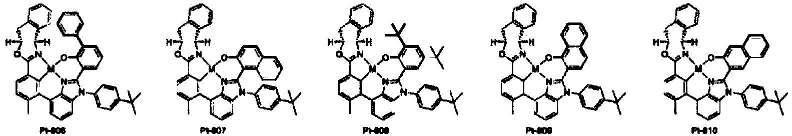 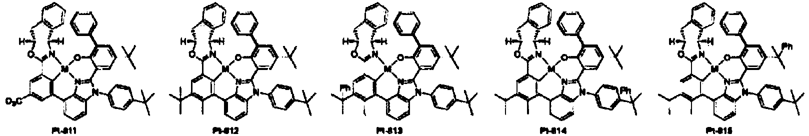 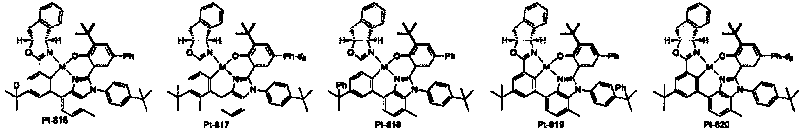 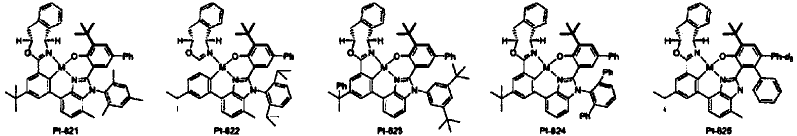 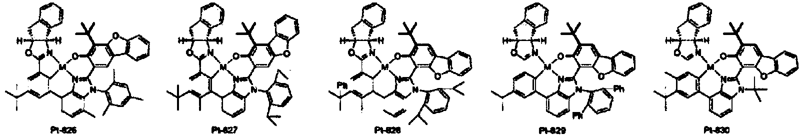 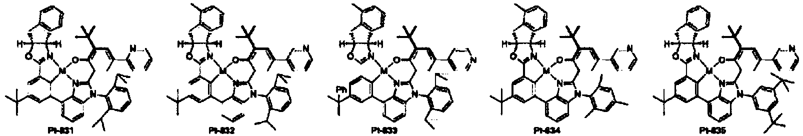 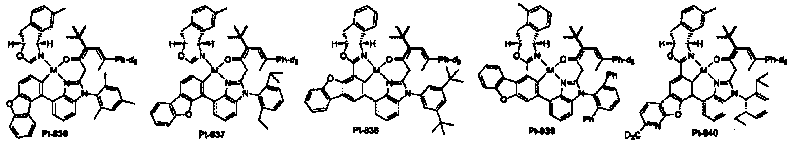 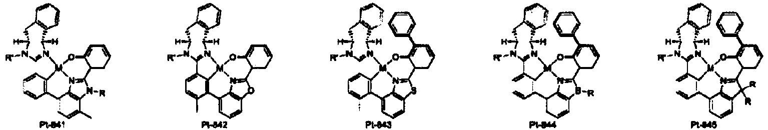 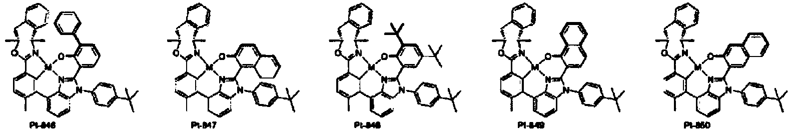 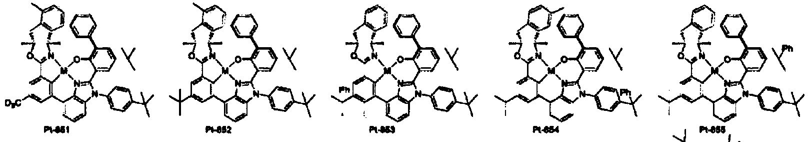 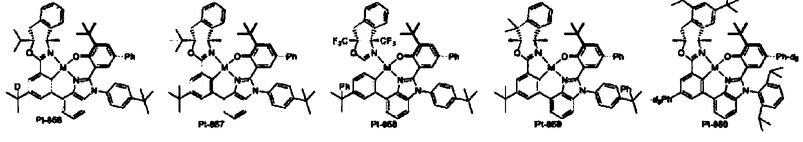 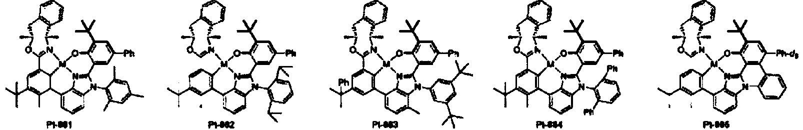 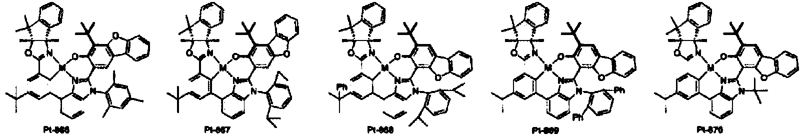 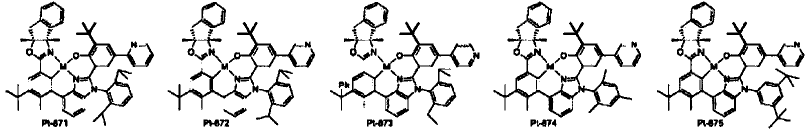 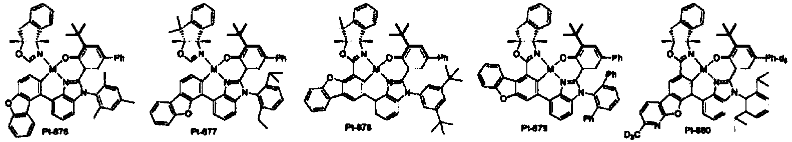 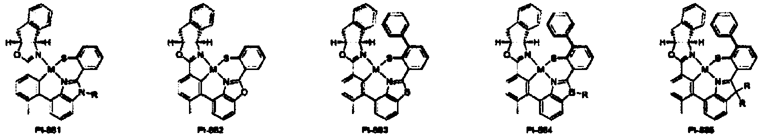 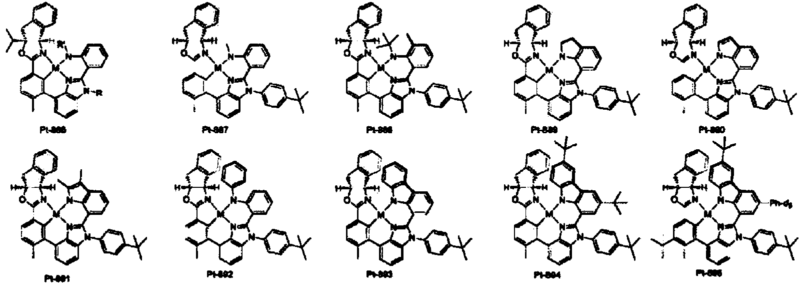 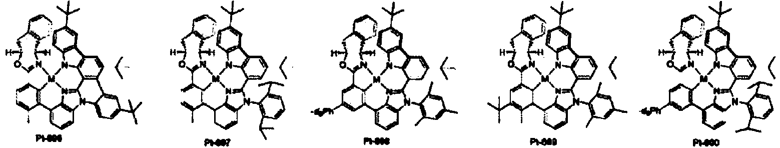 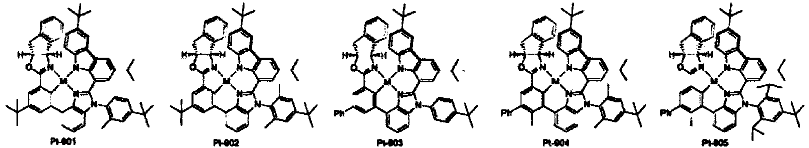 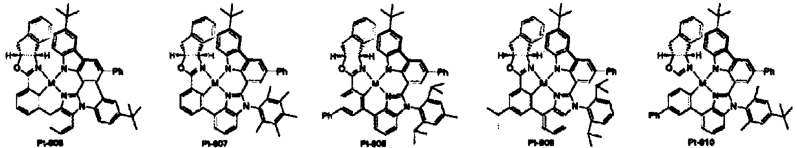 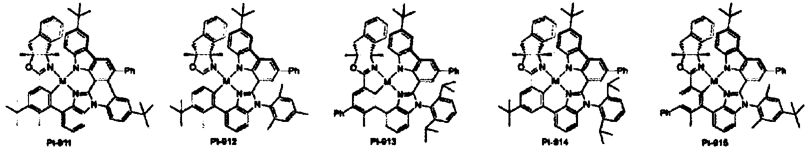 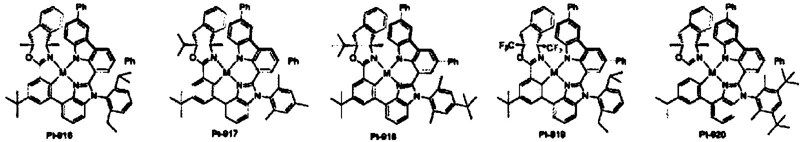 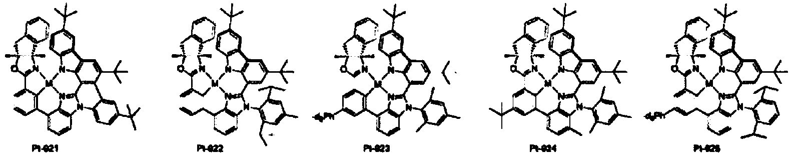 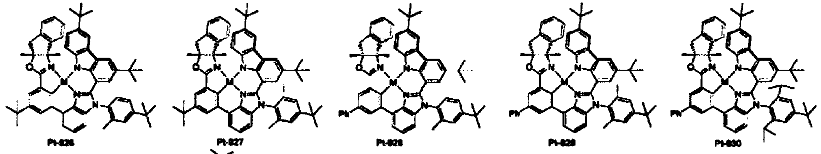 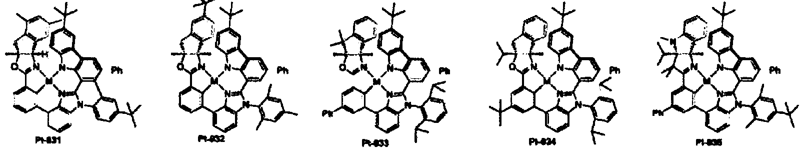 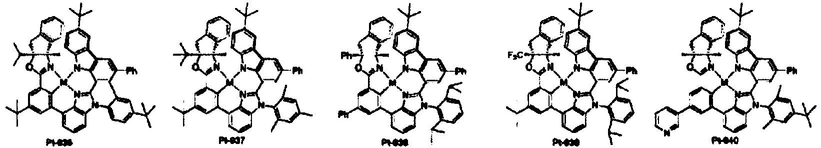 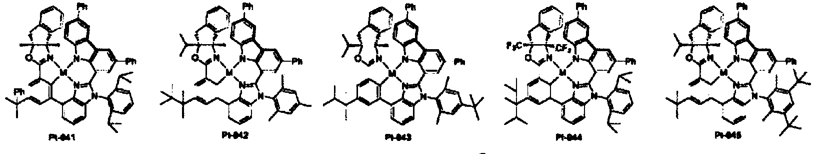 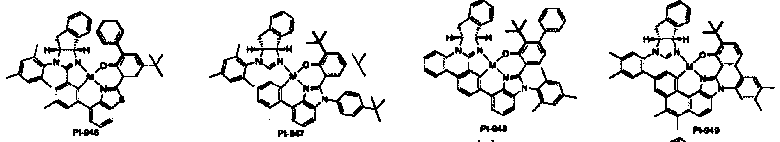 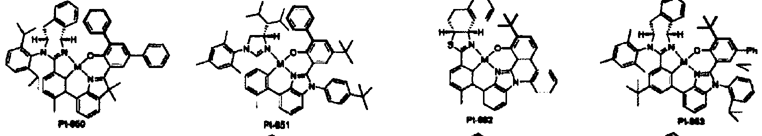 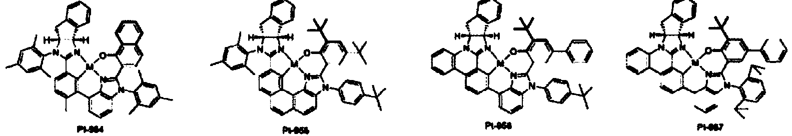 wobei M Pt oder Pd ist; R und R' jeweils unabhängig voneinander Wasserstoff, Deuterium, Halogen, Alkyl, Cycloalkyl, Aryl, Heteroalkyl, Heterocycloalkyl, Heteroaryl, Haloalkyl, Haloaryl, Haloheteroaryl, Alkoxy, Aryloxy, Alkenyl, Cycloalkenyl, Alkynyl, Hydroxy, Mercapto, Nitro, Cyano, Amino, Mono- oder Dialkylamino, Mono- oder Diarylamino, Ester, Nitril, Isonitril, Heteroaryl, Alkoxycarbonyl, Amido, Alkoxycarbonylamino, Aryloxycarbonylamino, Sulfonylamino, Sulfamoyl, Carbamoyl, Alkylthio, Sulfinyl, Ureido, Phosphorylamino, Imino, Sulfo, Carboxy, Hydrazino oder substituiertes Silyl sind.

6. Verwendung der helicalen-chiralen tetradentaten cyclometallierten Platin(II)- und Palladium(II)-Komplex-Materialien zur Emission zirkular polarisierten Lichts gemäß einem der Ansprüche 1 bis 5 in einer lichtemittierenden Vorrichtung, einer 3D-Anzeigevorrichtung, einer dreidimensionalen Bildgebungsvorrichtung, einer optischen Informationsverschlüsselungsvorrichtung, einer Informationsspeichervorrichtung oder einer biologischen Bildgebungsvorrichtung.

7. Verwendung nach Anspruch 6, wobei die lichtemittierende Vorrichtung eine Leuchtdiode oder eine lichtemittierende elektrochemische Zelle ist.

8. Vollfarbanzeige, umfassend eine lichtemittierende Vorrichtung, wobei die lichtemittierende Vorrichtung das helicale-chirale tetradentate cyclometallierte Platin(II)- und Palladium(II)-Komplex-Material zur Emission zirkular polarisierten Lichts gemäß einem der Ansprüche 1 bis 5 enthält.

9. Lichtemittierende Anzeigevorrichtung, umfassend eine lichtemittierende Vorrichtung, wobei die lichtemittierende Vorrichtung das helicale-chirale tetradentate cyclometallierte Platin(II)- und Palladium(II)-Komplex-Material gemäß einem der Ansprüche 1 bis 5 enthält.

10. Verwendung nach Anspruch 7, wobei die lichtemittierende Vorrichtung eine erste Elektrode, eine zweite Elektrode und zumindest eine organische Schicht umfasst, die zwischen der ersten Elektrode und der zweiten Elektrode angeordnet ist, wobei die organische Schicht das helicale-chirale tetradentate cyclometallierte Platin(II)- und Palladium(II)-Komplex-Material gemäß Anspruch 1 umfasst.

11. Anzeigevorrichtung, umfassend eine organische lichtemittierende Vorrichtung, wobei die organische lichtemittierende Vorrichtung eine erste Elektrode, eine zweite Elektrode und zumindest eine organische Schicht umfasst, die zwischen der ersten Elektrode und der zweiten Elektrode angeordnet ist, wobei die organische Schicht das helicale-chirale tetradentate cyclometallierte Platin(II)- und Palladium(II)-Komplex-Material gemäß einem der Ansprüche 1 bis 5 umfasst.

## Revendications

1. Matériau électroluminescent à polarisation circulaire à base de complexe de platine (II) et de palladium (II) tétradentate cyclométallé hélico-chiral central induit par chiralité, **caractérisé en ce qu'**il a des formules chimiques comme représenté dans les formules générales (1), (1'), (2) et (2'), où (1) et (1'), (2) et (2') sont des énantiomères l'un de l'autre : 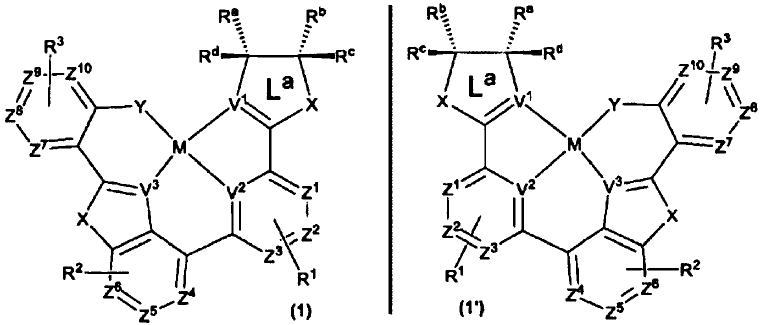 ou 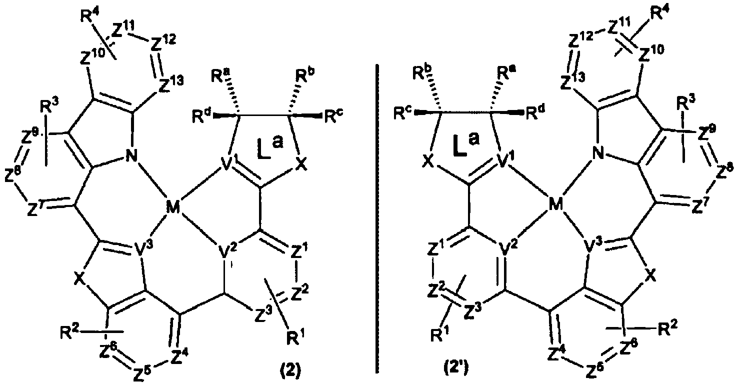
dans lequel M est Pt ou Pd ; V¹, V² et V³ sont chacun indépendamment N ou C ;
L^{a} est un cycle carbocyclique ou hétérocyclique chiral central à cinq chaînons ;
X est O, S, CR^{x}R^{y}, C = O, SiR^{x}R^{y}, GeR^{x}R^{y}, NR^{z}, PR^{z}, R^{z}P = O, AsR², R^{z}As = O, S =O, SO₂, Se, Se = O, SeO₂, BH, BR^{z}, R^{z}Bi = O, ou BiR^{z} ; dans lequel R^{x} et R^{y} sont chacun indépendamment un substituant sur le même atome choisi parmi C, Si et Ge, et R^{z} est un substituant sur un atome choisi parmi B, N, P, As et Bi ;
Y est O, S ;
Z¹, Z², Z³, Z⁴, Z⁵, Z⁶, Z⁷, Z⁸, Z⁹, Z¹⁰, Z¹¹, Z¹² et Z¹³ sont chacun indépendamment N ou C ;
R¹, R², R³, R⁴, R^{a}, R^{b}, R^{c} et R^{d} représentent chacun indépendamment un mono-, di-, tri-, tétra-substitué ou non-substitué, alors que R¹, R², R³, R⁴, R^{a}, R^{b}, R^{c} et R^{d} sont chacun indépendamment un atome d'hydrogène, un atome de deutérium, un halogène, un groupe alkyle, un groupe cycloalkyle, un groupe aryle, un groupe hétéroalkyle, un groupe hétérocycloalkyle, un groupe hétéroaryle, un groupe halo-alkyle, un groupe halo-aryle, un groupe halo-hétéroaryle, un groupe alcoxy, un groupe aryloxy, un groupe alcényle, un groupe cycloalcényle, un groupe alcynyle, un groupe hydroxy, un groupe mercapto, un groupe nitro, un groupe cyano, un groupe amino, un groupe mono- ou dialkylamino, un groupe mono- ou diarylamino, un groupe ester, un groupe nitrile, un groupe isonitrile, un groupe hétéroaryle, un groupe alcoxycarbonyle, un groupe acylamino, un groupe alcoxycarbonylamino, un groupe aryloxycarbonylamino, un groupe sulfonylamino, un groupe sulfamoyle, un groupe carbamoyle, un groupe alkylthio, un groupe sulfinyle, un groupe uréido, un groupe phosphorylamino, un groupe imino, un groupe sulfo, un groupe carboxy, un groupe hydrazino, un groupe silyle substitué, ou une combinaison de ceux-ci, dans lequel R^{a} et R^{b} sont des substituants différents dans la même molécule ; deux ou plusieurs R¹, R², R³ et R⁴ adjacents peuvent optionnellement être liés pour former un cycle fusionné ; deux quelconques parmi R^{a}, R^{b}, R^{c} et R^{d} peuvent être liés pour former un système cyclique.

2. Matériau électroluminescent à polarisation circulaire à base de complexe de platine (II) et de palladium (II) tétradentate cyclométallé hélico-chiral central induit par chiralité ayant les formules générales (1), (1'), (2) et (2') selon la revendication 1, ayant de préférence les formules générales suivantes (1-A) et (2-A) et leurs énantiomères (1'-A) et (2'-A) : 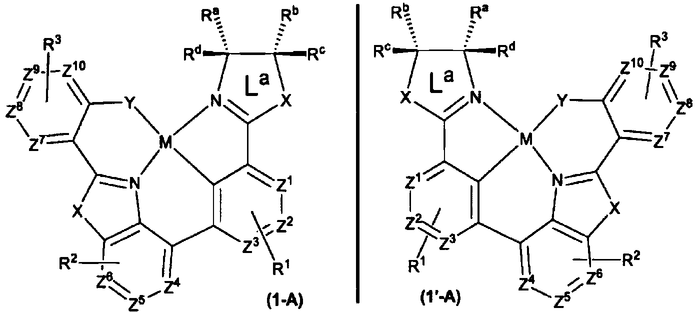 ou 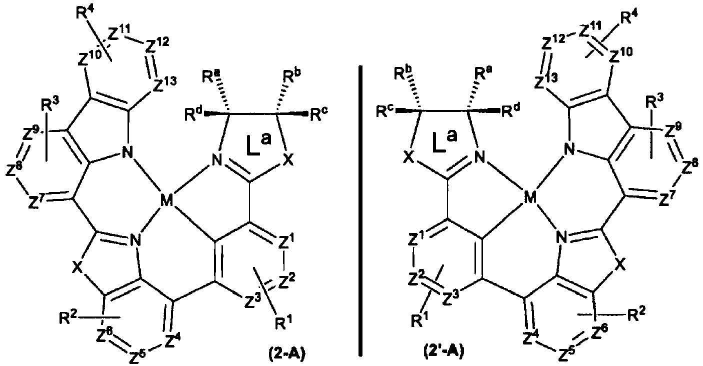
dans lequel M est Pt ou Pd ;
L^{a} est un cycle carbocyclique ou hétérocyclique chiral central à cinq chaînons ;
X est O, S, CR^{x}R^{y}, C = O, SiR^{x}R^{y}, GeR^{x}R^{y}, NR^{z}, PR^{z}, R^{z}P = O, AsR^{z}, R^{z}As = O, S =O, SO₂, Se, Se = O, SeO₂, BR, BR^{z}, R^{z}Bi = O, ou BiR^{z} ;
Y est O, S ;
Z¹, Z², Z³, Z⁴, Z⁵, Z⁶, Z⁷, Z⁸, Z⁹, Z¹⁰, Z¹¹, Z¹² et Z¹³ sont chacun indépendamment N ou C ;
R¹, R², R³, R⁴, R^{a}, R^{b}, R^{c} et R^{d} représentent chacun indépendamment un mono-, di-, tri-, tétra-substitué ou non-substitué, alors que R¹, R², R³, R⁴, R^{a}, R^{b}, R^{c} et R^{d} sont chacun indépendamment un atome d'hydrogène, un atome de deutérium, un halogène, un groupe alkyle, un groupe cycloalkyle, un groupe aryle, un groupe hétéroalkyle, un groupe hétérocycloalkyle, un groupe hétéroaryle, un groupe halo-alkyle, un groupe halo-aryle, un groupe halo-hétéroaryle, un groupe alcoxy, un groupe aryloxy, un groupe alcényle, un groupe cycloalcényle, un groupe alcynyle, un groupe hydroxy, un groupe mercapto, un groupe nitro, un groupe cyano, un groupe amino, un groupe mono- ou dialkylamino, un groupe mono- ou diarylamino, un groupe ester, un groupe nitrile, un groupe isonitrile, un groupe hétéroaryle, un groupe alcoxycarbonyle, un groupe acylamino, un groupe alcoxycarbonylamino, un groupe aryloxycarbonylamino, un groupe sulfonylamino, un groupe sulfamoyle, un groupe carbamoyle, un groupe alkylthio, un groupe sulfinyle, un groupe uréido, un groupe phosphorylamino, un groupe imino, un groupe sulfo, un groupe carboxy, un groupe hydrazino, un groupe silyle substitué, ou une combinaison de ceux-ci, dans lequel R^{a} et R^{b} sont des substituants différents dans la même molécule ; deux ou plusieurs R¹, R², R³ et R⁴ adjacents peuvent optionnellement être liés pour former un cycle fusionné ; deux quelconques parmi R^{a}, R^{b}, R^{c} et R^{d} peuvent être liés pour former un système cyclique.

3. Matériau électroluminescent à polarisation circulaire à base de complexe de platine (II) et de palladium (II) tétradentate cyclométallé hélico-chiral central induit par chiralité ayant les formules générales (1), (1'), (2) et (2') selon la revendication 1 ou 2, dans lequel le segment chiral central La a une structure générale choisie de préférence, mais sans limitation, parmi un groupe constitué de : 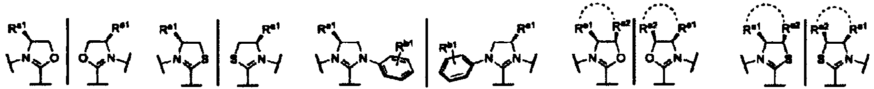 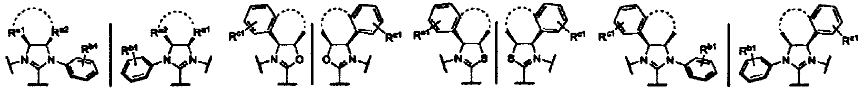 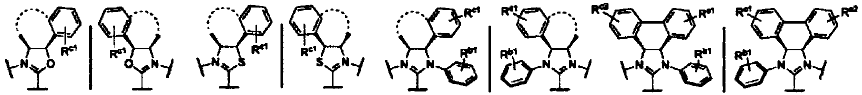 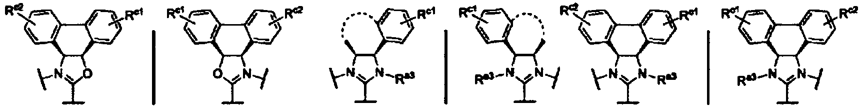
dans lequel R^{a1}, R^{a2} et R^{a3} représentent chacun indépendamment un atome d'hydrogène, un atome de deutérium, un halogène, un groupe alkyle, un groupe cycloalkyle, un groupe aryle, un groupe hétéroalkyle, un groupe hétérocycloalkyle, un groupe hétéroaryle, un groupe halo-alkyle, un groupe halo-aryle, un groupe halo-hétéroaryle, un groupe alcoxy, un groupe aryloxy, un groupe alcényle, un groupe cycloalcényle, un groupe alcynyle, un groupe hydroxy, un groupe mercapto, un groupe nitro, un groupe cyano, un groupe amino, un groupe mono- ou dialkylamino, un groupe mono- ou diarylamino, un groupe ester, un groupe nitrile, un groupe isonitrile, un groupe hétéroaryle, un groupe alcoxycarbonyle, un groupe amido, un groupe alcoxycarbonylamino, un groupe aryloxycarbonylamino, un groupe sulfonylamino, un groupe sulfamoyle, un groupe carbamoyle, un groupe alkylthio, un groupe sulfinyle, un groupe uréido, un groupe phosphoryle amino, un groupe imino, un groupe sulfo, un groupe carboxy, un groupe hydrazino, un groupe silyle substitué, ou des combinaisons de ceux-ci ;
dans lequel R^{b1}, R^{c1} et R^{c2} représentent chacun indépendamment un mono-, di-, tri-, tétra-substitué ou non-substitué, alors que R^{b1}, R^{c1} et R^{c2} sont chacun indépendamment un atome d'hydrogène, un atome de deutérium, un halogène, un groupe alkyle, un groupe cycloalkyle, un groupe aryle, un groupe hétéroalkyle, un groupe hétérocycloalkyle, un groupe hétéroaryle, un groupe halo-alkyle, un groupe halo-aryle, un groupe halo-hétéroaryle, un groupe alcoxy, un groupe aryloxy, un groupe alcényle, un groupe cycloalcényle, un groupe alcynyle, un groupe hydroxy, un groupe mercapto, un groupe nitro, un groupe cyano, un groupe amino, un groupe mono- ou dialkylamino, un groupe mono- ou diarylamino, un groupe ester, un groupe nitrile, un groupe isonitrile, un groupe hétéroaryle, un groupe alcoxycarbonyle, un groupe amido, un groupe alcoxycarbonylamino, un groupe aryloxycarbonylamino, un groupe sulfonylamino, un groupe sulfamoyle, un groupe carbamoyle, un groupe alkylthio, un groupe sulfinyle, un groupe uréido, un groupe phosphoryl amino, un groupe imino, un groupe sulfo, un groupe carboxy, un groupe hydrazino, un groupe silyle substitué, ou des combinaisons de ceux-ci ; deux ou plusieurs R^{b1}, R^{c1} et R^{c2} adjacents peuvent optionnellement être liés pour former un cycle fusionné.

4. Matériau électroluminescent à polarisation circulaire à base de complexe de platine (II) et de palladium (II) tétradentate cyclométallé hélico-chiral central induit par chiralité ayant les formules générales (1), (1'), (2) et (2') selon la revendication 3, dans lequel le segment chiral central L^{a} a une structure spécifique choisie de préférence, mais sans limitation, parmi un groupe constitué de : 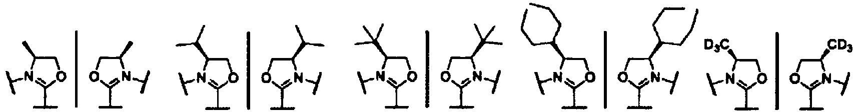 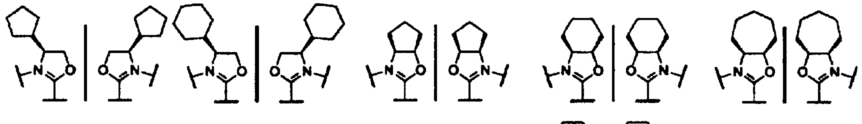 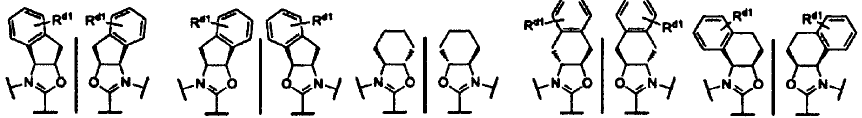 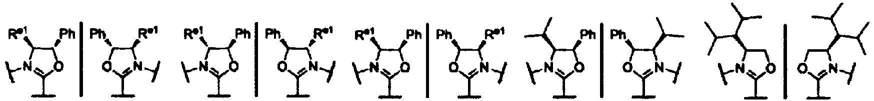 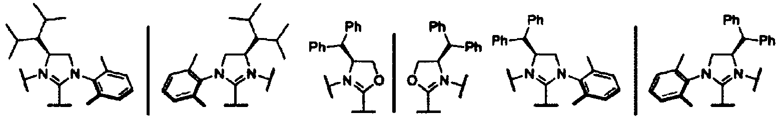 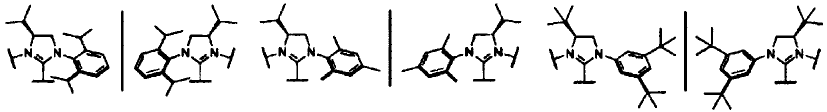 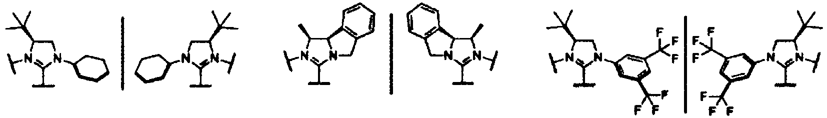 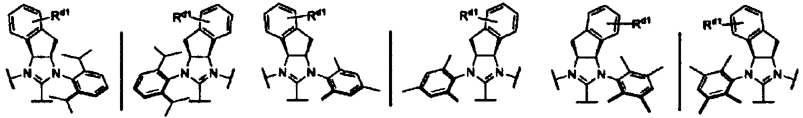 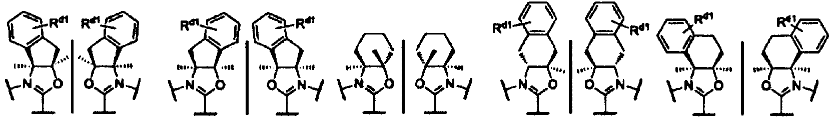 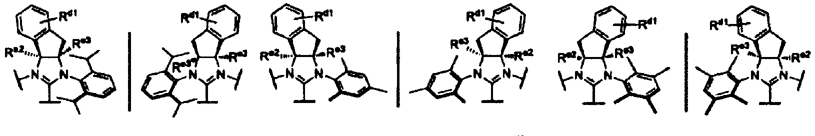 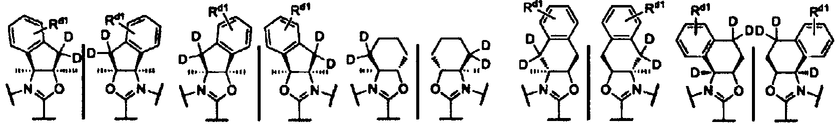 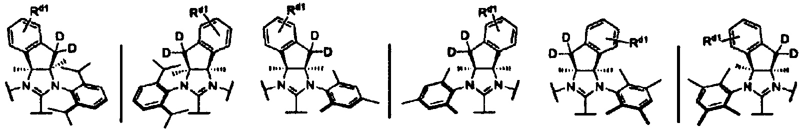 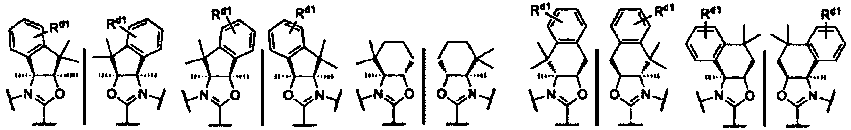 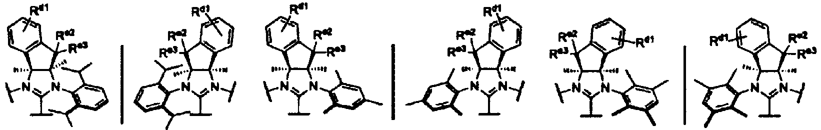 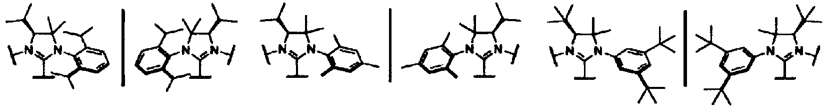 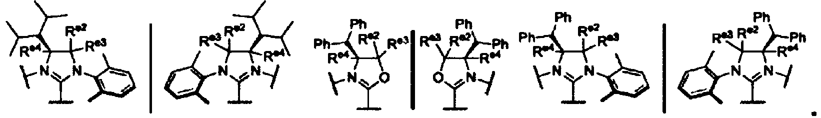
dans lequel R^{d1} représente un mono-, di-, tri-, tétra-substitué ou non-substitué, alors que R^{b1} est indépendamment un atome d'hydrogène, un atome de deutérium, un halogène, un groupe alkyle, un groupe cycloalkyle, un groupe aryle, un groupe hétéroalkyle, un groupe hétérocycloalkyle, un groupe hétéroaryle, un groupe halo-alkyle, un groupe halo-aryle, un groupe halo-hétéroaryle, un groupe alcoxy, un groupe aryloxy, un groupe alcényle, un groupe cycloalcényle, un groupe alcynyle, un groupe hydroxy, un groupe mercapto, un groupe nitro, un groupe cyano, un groupe amino, un groupe mono- ou dialkylamino, un groupe mono-ou diarylamino, un groupe ester, un groupe nitrile, un groupe isonitrile, un groupe hétéroaryle, un groupe alcoxycarbonyle, un groupe amido, un groupe alcoxycarbonylamino, un groupe aryloxycarbonylamino, un groupe sulfonylamino, un groupe sulfamoyle, un groupe carbamoyle, un groupe alkylthio, un groupe sulfinyle, un groupe uréido, un groupe phosphorylamino, un groupe imino, un groupe sulfo, un groupe carboxy, un groupe hydrazino, un groupe silyle substitué, ou des combinaisons de ceux-ci ; deux ou plusieurs R^{d1} adjacents peuvent optionnellement être liés pour former un cycle fusionné ;
dans lequel R^{e1}, R^{e2}, R^{e3} et R^{e4} représentent indépendamment un atome d'hydrogène, un atome de deutérium, un halogène, un groupe alkyle, un groupe cycloalkyle, un groupe aryle, un groupe hétéroalkyle, un groupe hétérocycloalkyle, un groupe hétéroaryle, un groupe halo-alkyle, un groupe halo-aryle, un groupe halo-hétéroaryle, un groupe alcoxy, un groupe aryloxy, un groupe alcényle, un groupe cycloalcényle, un groupe alcynyle, un groupe hydroxy, un groupe mercapto, un groupe nitro, un groupe cyano, un groupe amino, un groupe mono- ou dialkylamino, un groupe mono- ou diarylamino, un groupe ester, un groupe nitrile, un groupe isonitrile, un groupe hétéroaryle, un groupe alcoxycarbonyle, un groupe amido, un groupe alcoxycarbonylamino, un groupe aryloxycarbonylamino, un groupe sulfonylamino, un groupe sulfamoyle, un groupe carbamoyle, un groupe alkylthio, un groupe sulfinyle, un groupe uréido, un groupe phosphoryle amino, un groupe imino, un groupe sulfo, un groupe carboxy, un groupe hydrazino, un groupe silyle substitué, ou des combinaisons de ceux-ci.

5. Matériau électroluminescent à polarisation circulaire à base de complexe de platine (II) et de palladium (II) tétradentate cyclométallé hélico-chiral central induit par chiralité selon la revendication 1 ou 2, ayant une structure générale choisie de préférence, mais sans limitation, parmi un groupe constitué de : 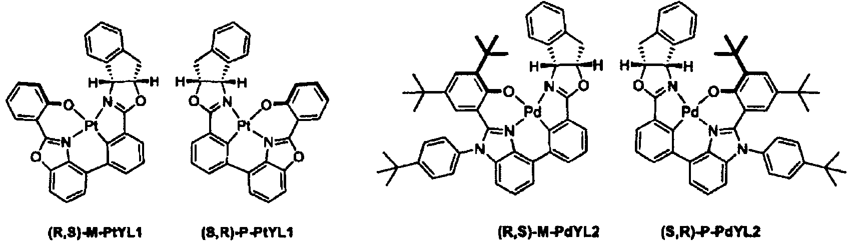 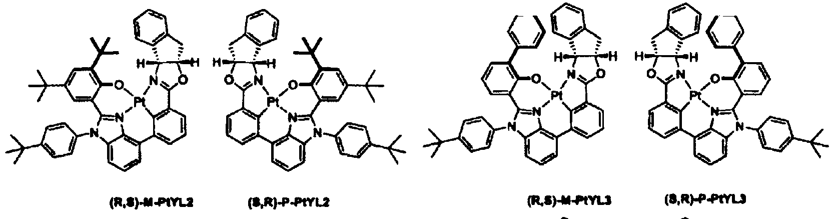 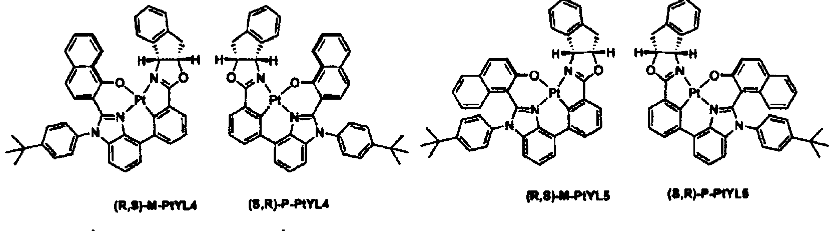 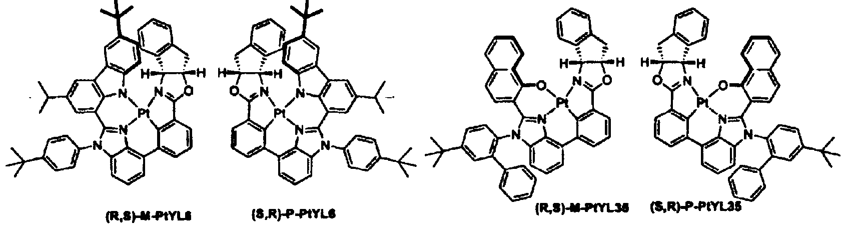 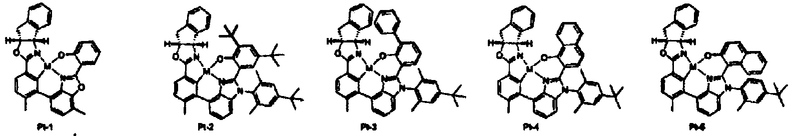 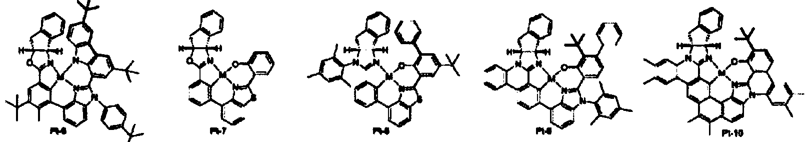 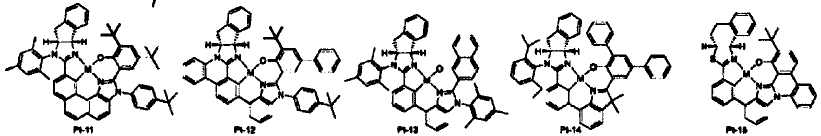 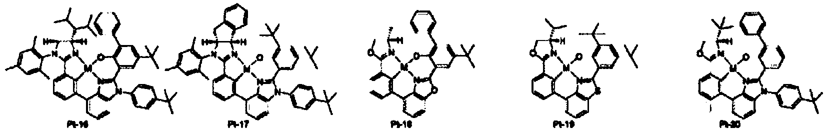 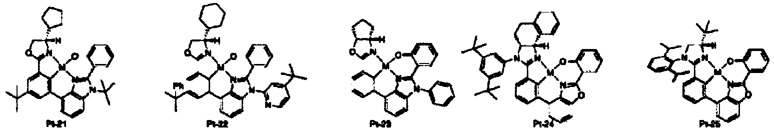 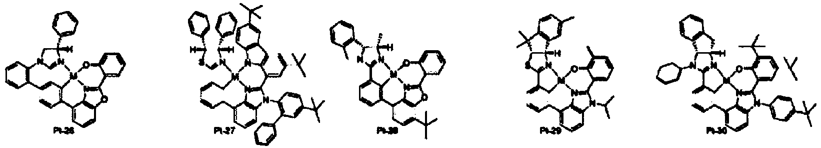 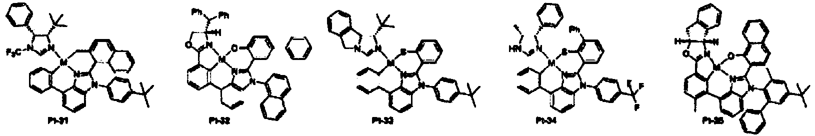 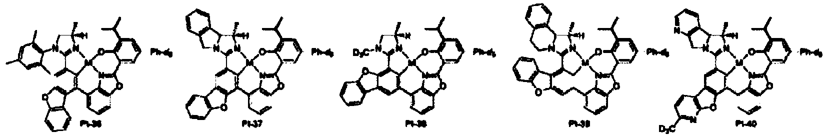 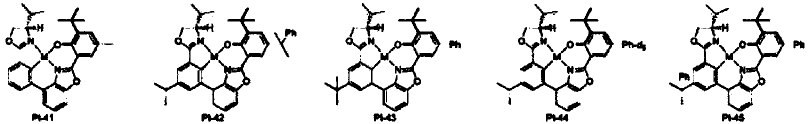 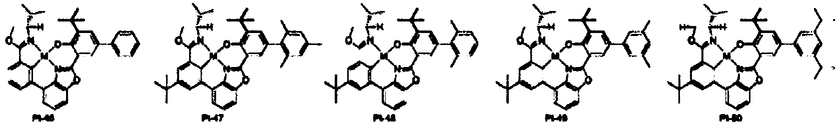 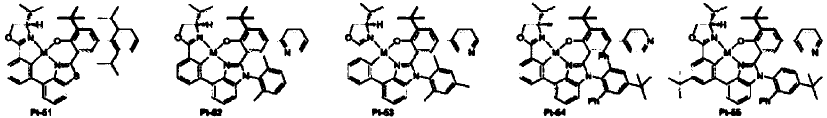 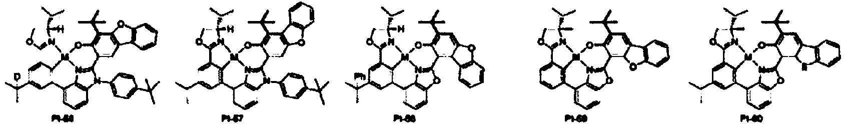 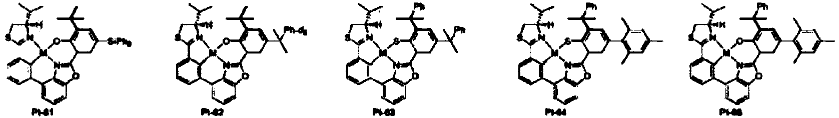 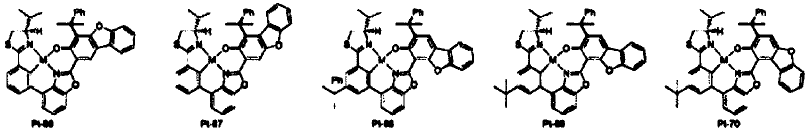 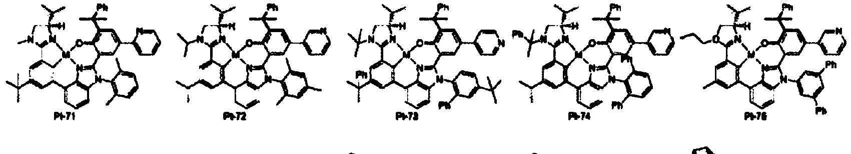 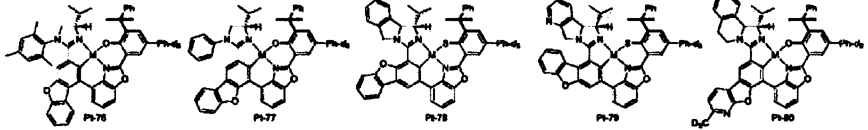 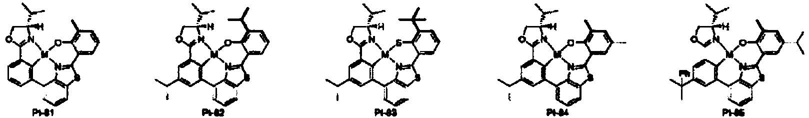 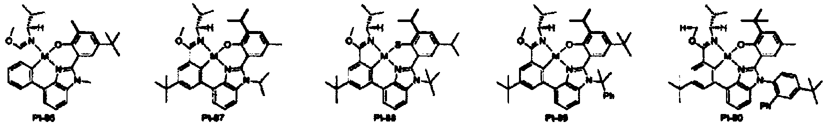 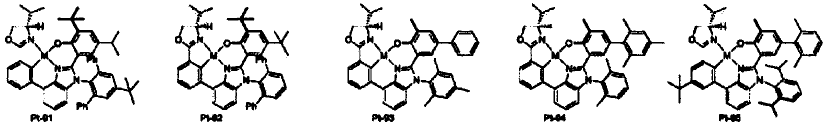 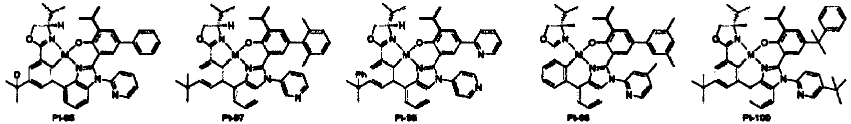 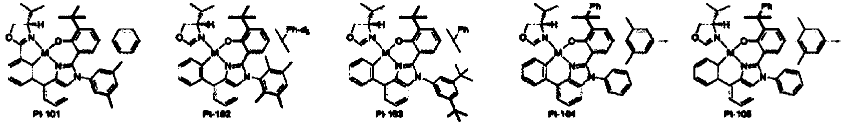 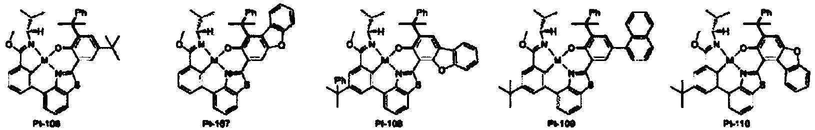 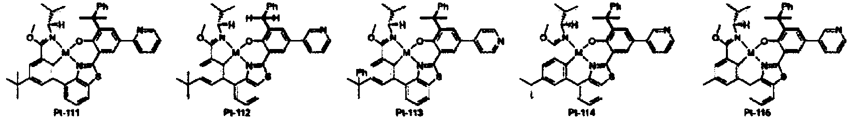 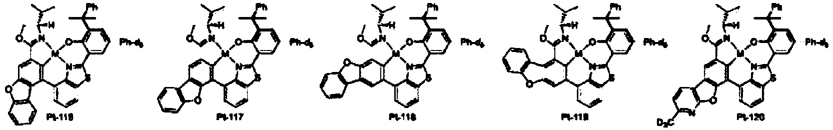 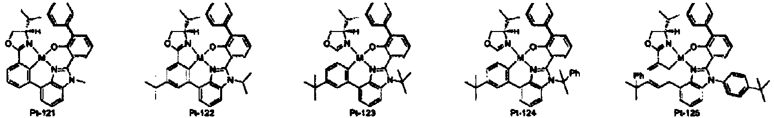 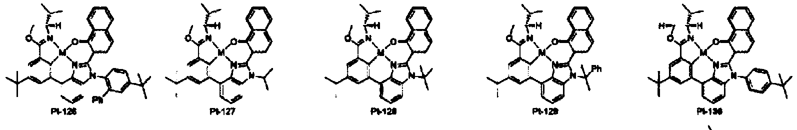 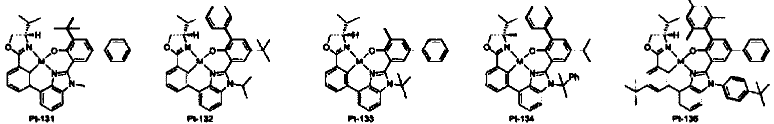 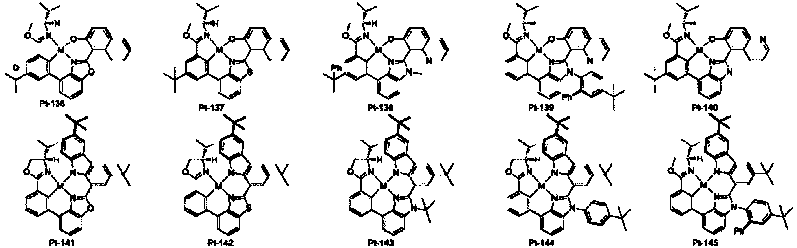 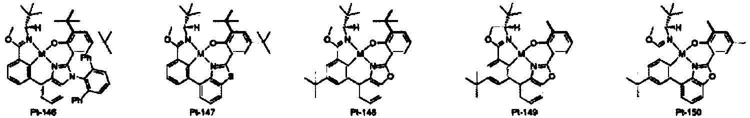 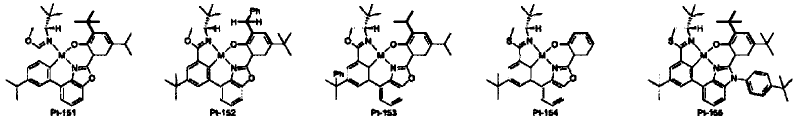 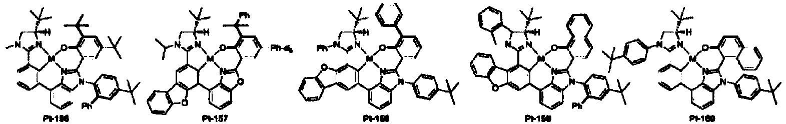 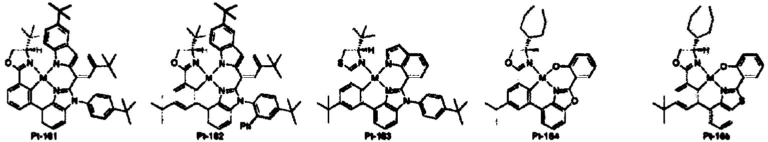 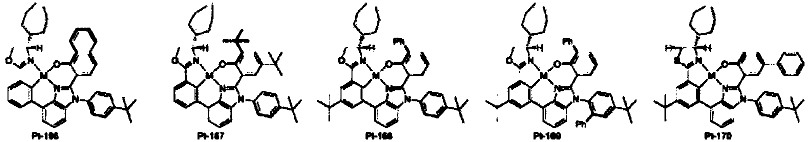 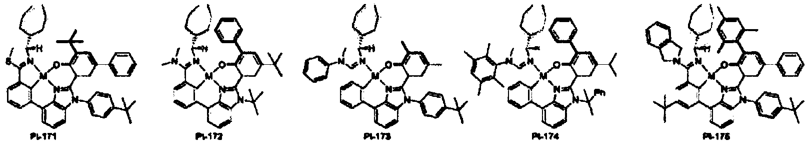 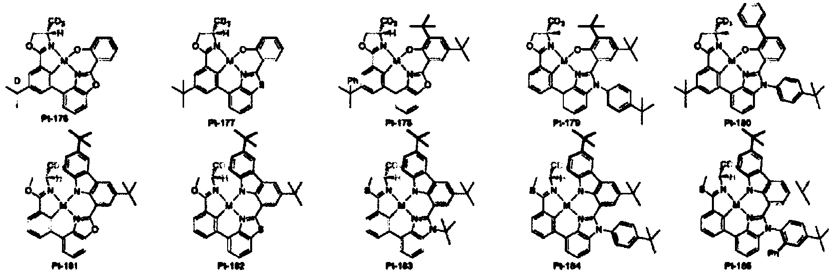 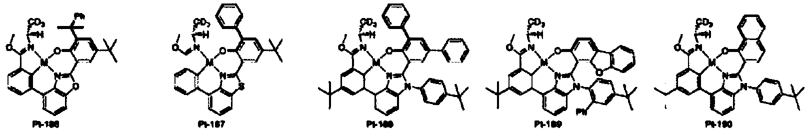 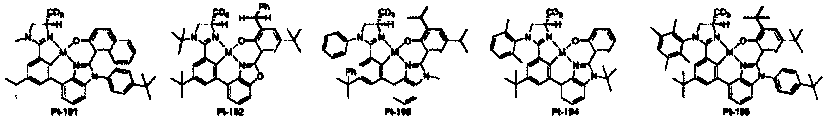 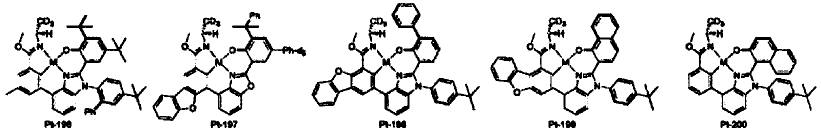 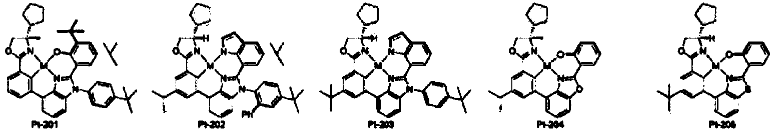 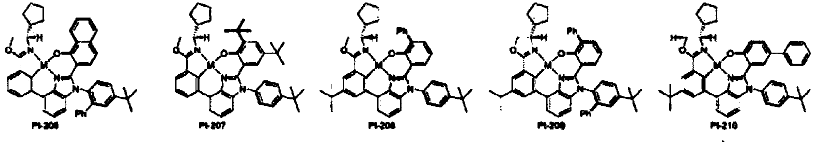 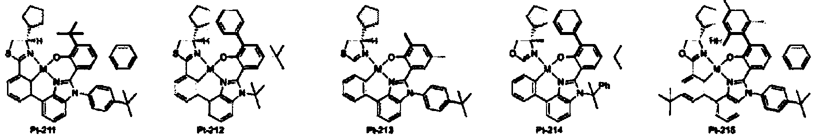 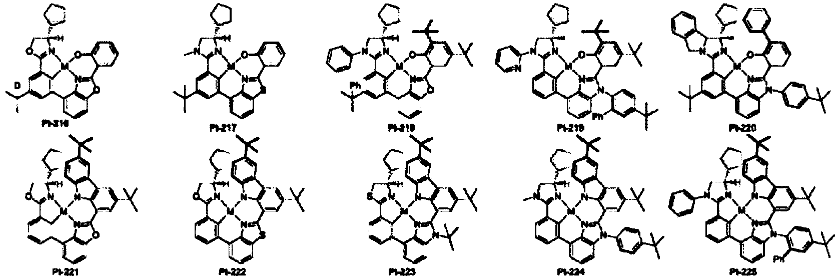 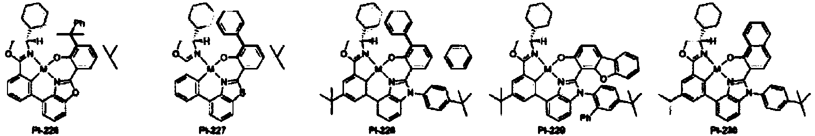 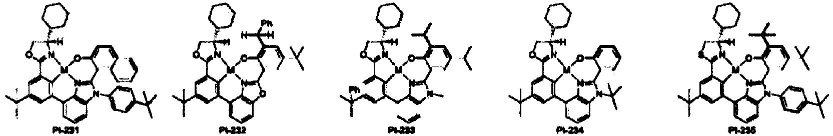 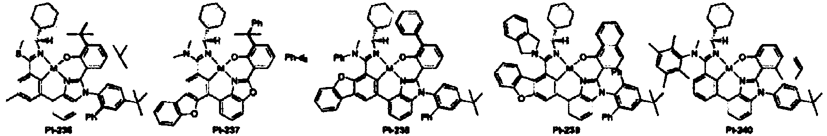 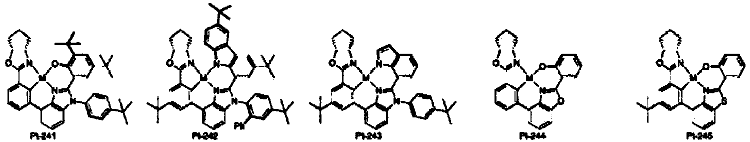 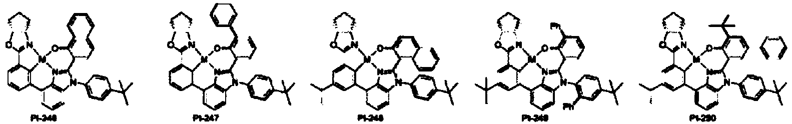 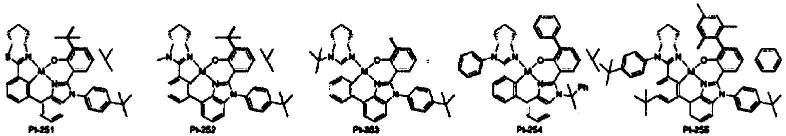 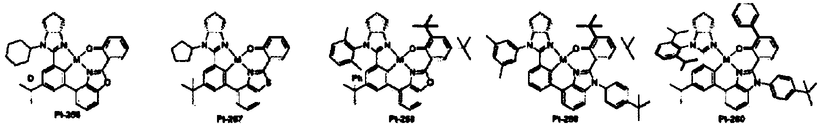 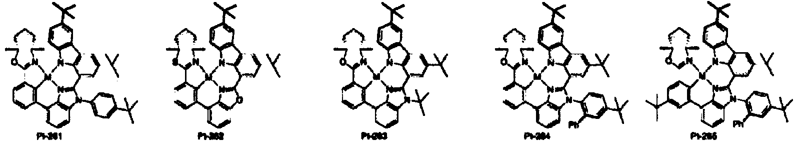 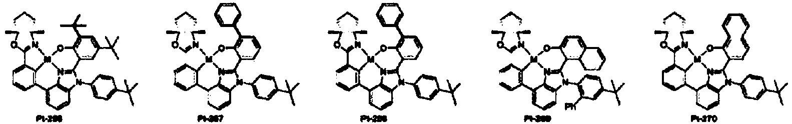 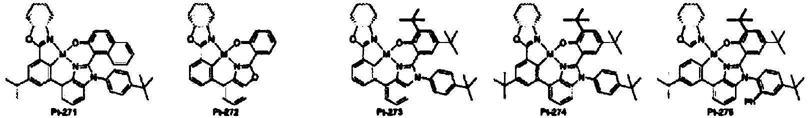 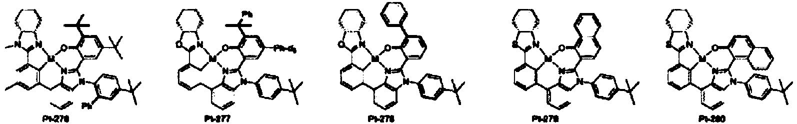 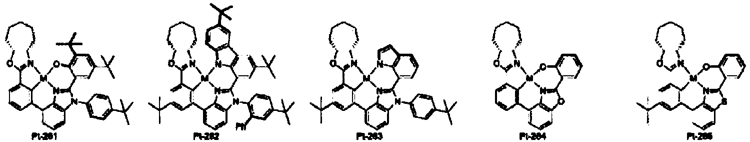 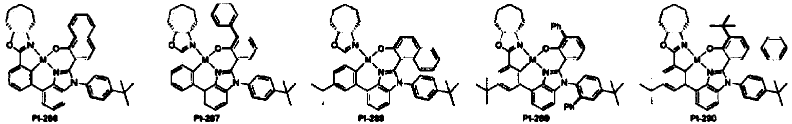 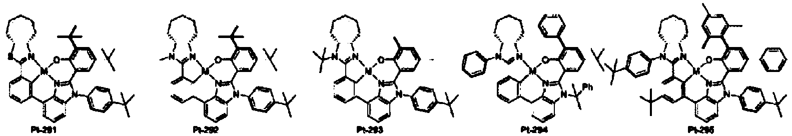 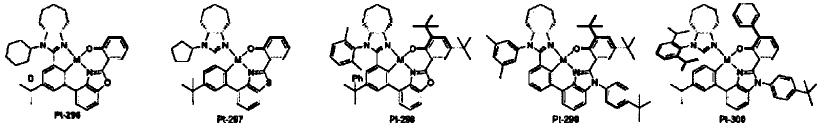 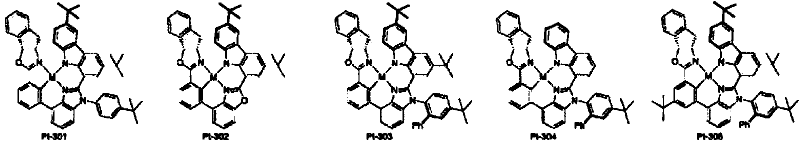 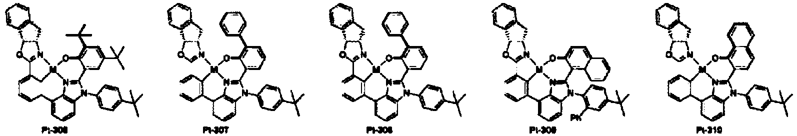 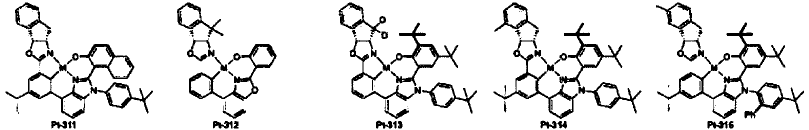 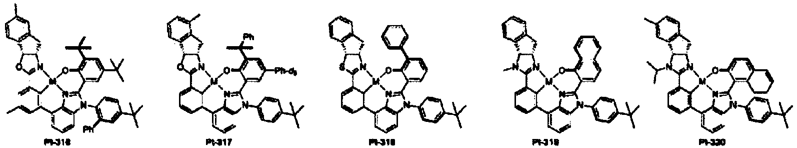 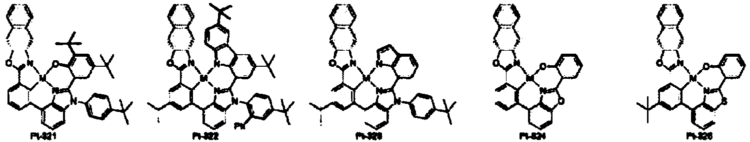 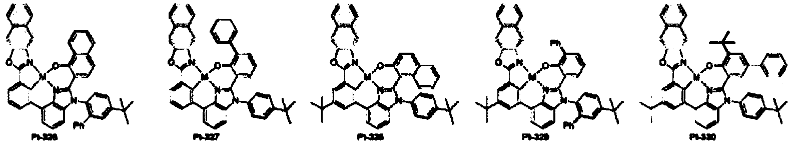 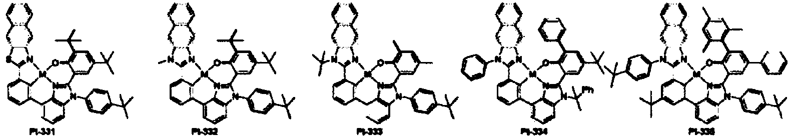 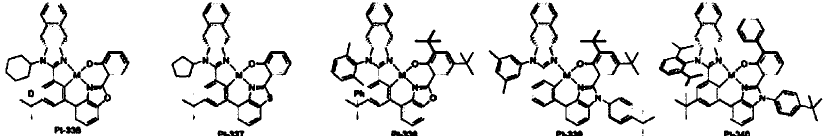 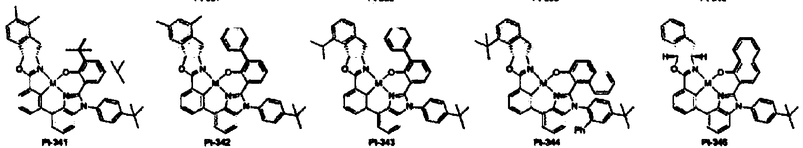 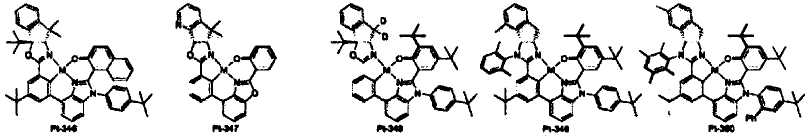 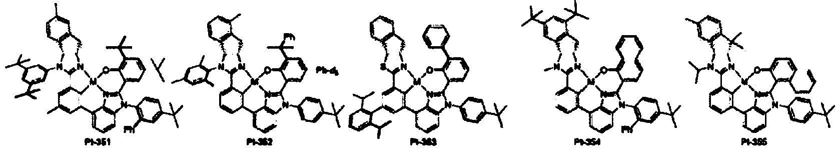 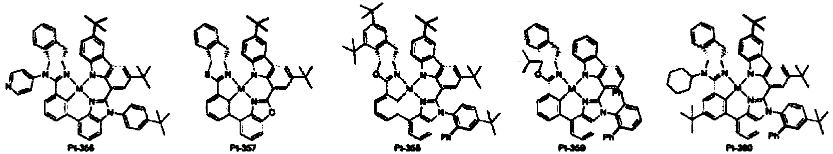 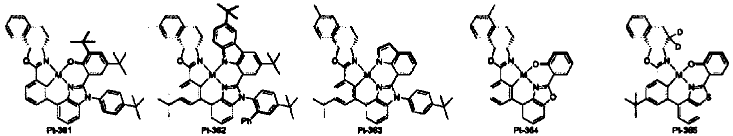 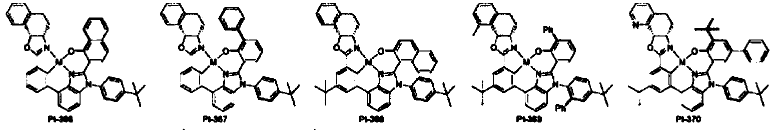 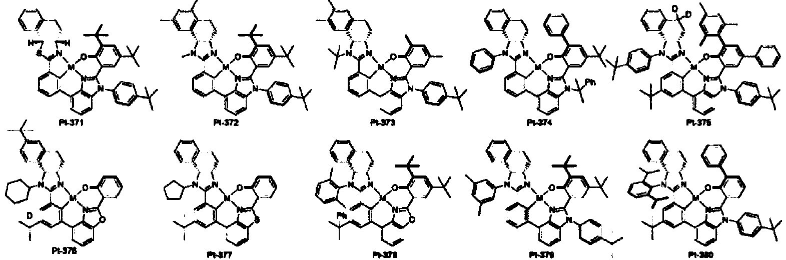 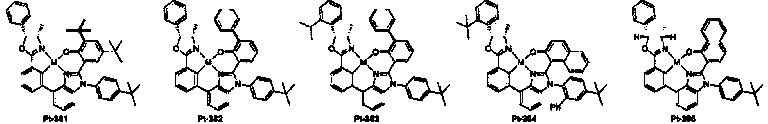 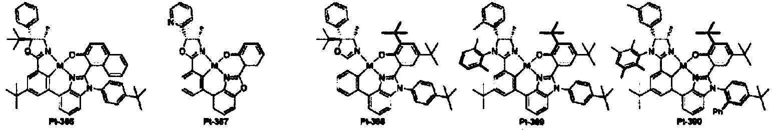 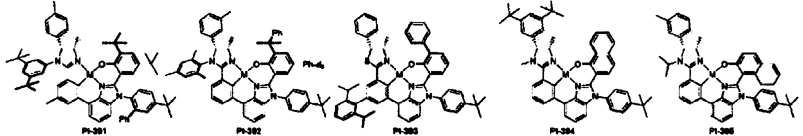 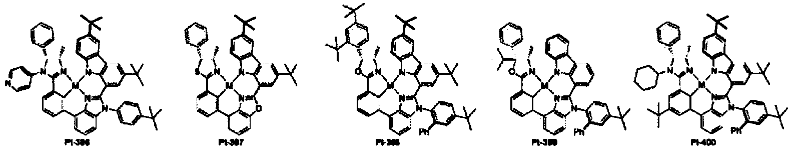 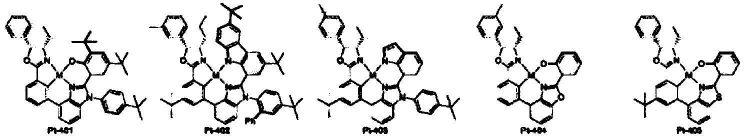 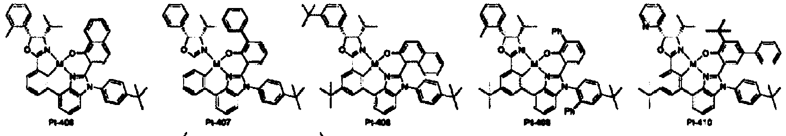 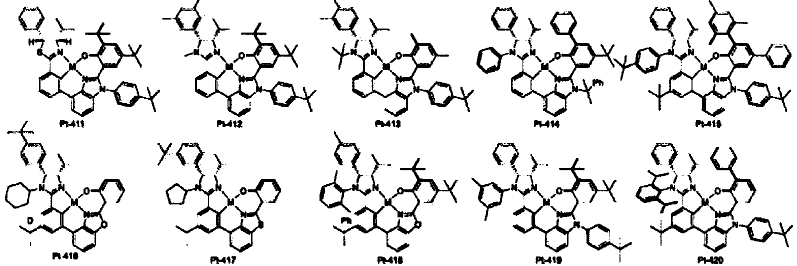 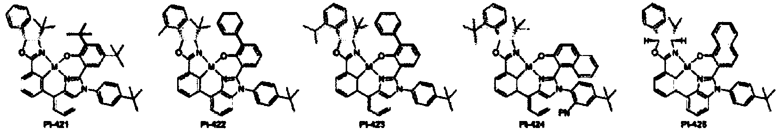 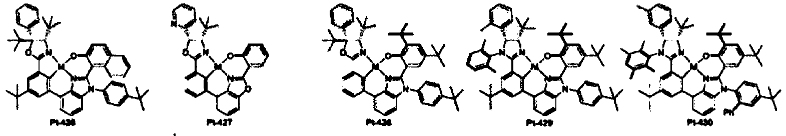 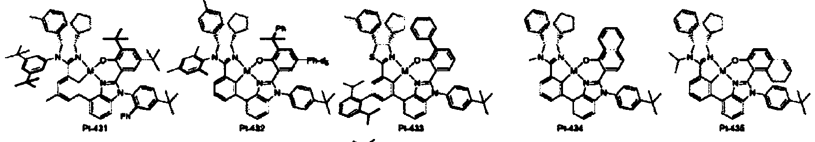 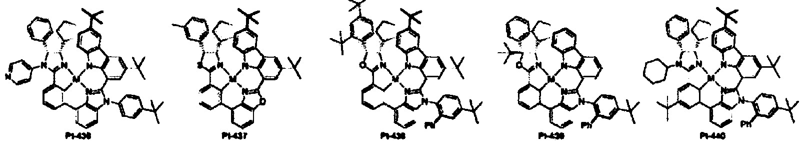 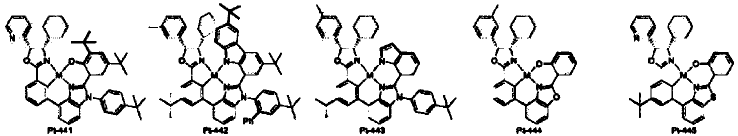 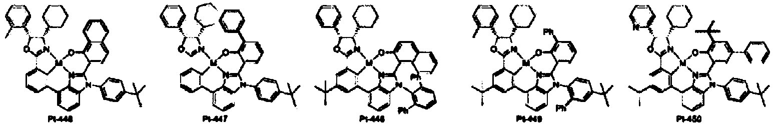 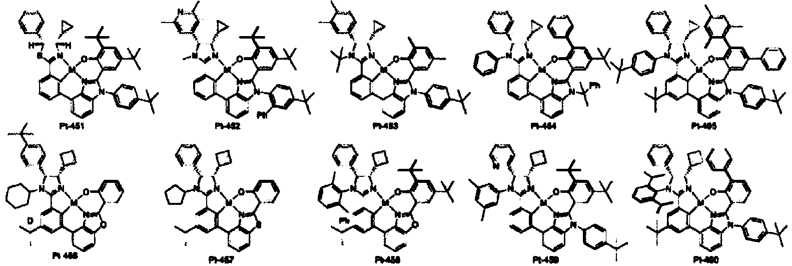 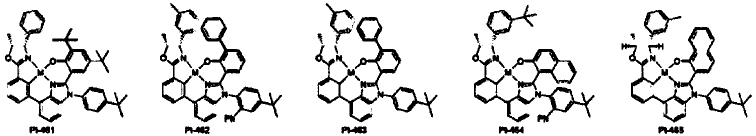 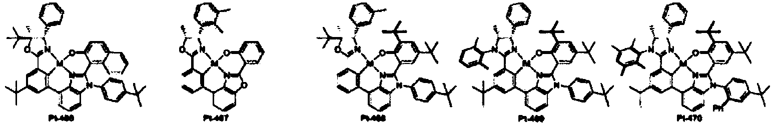 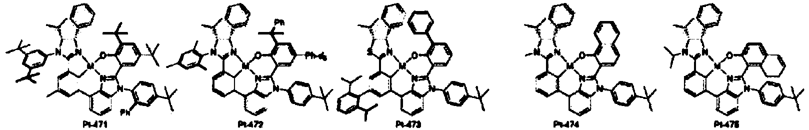 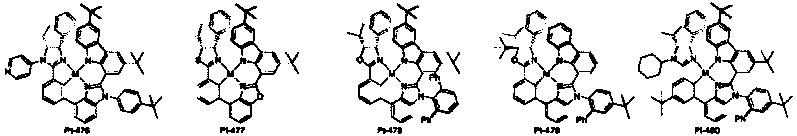 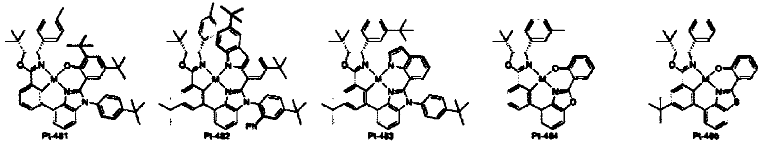 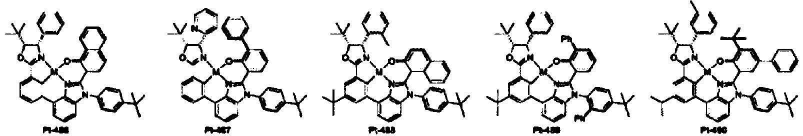 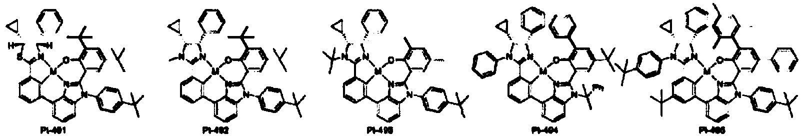 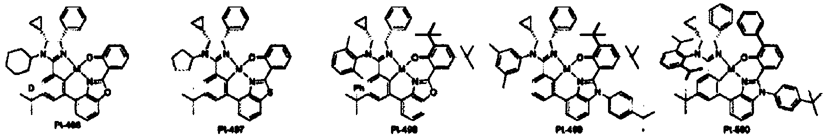 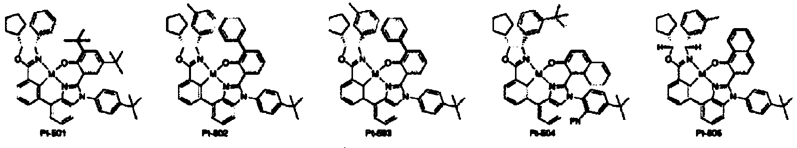 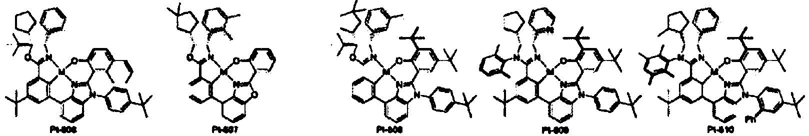 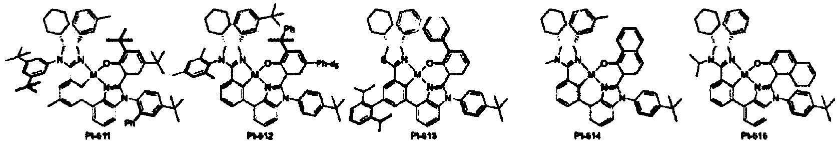 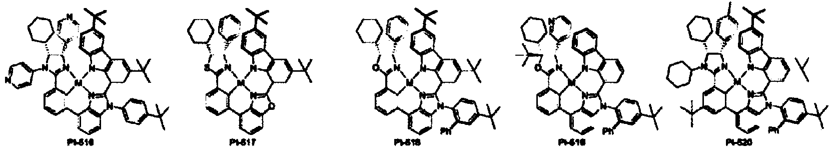 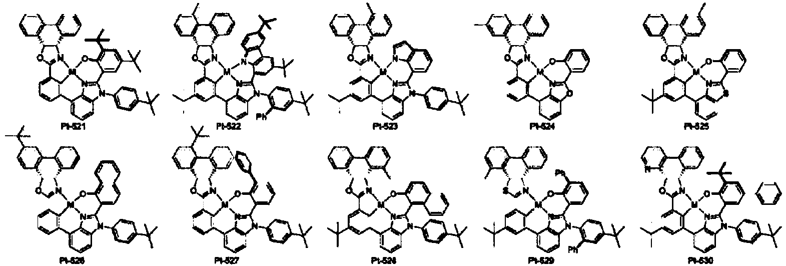 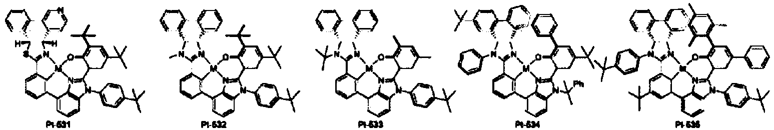 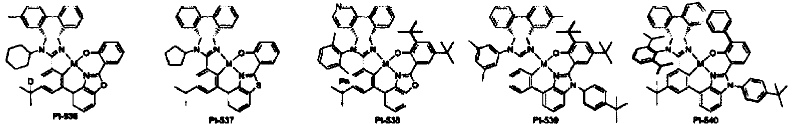 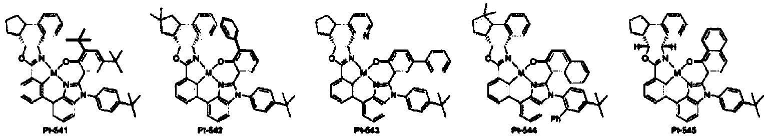 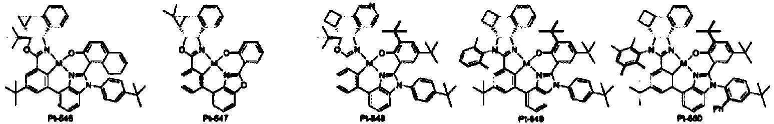 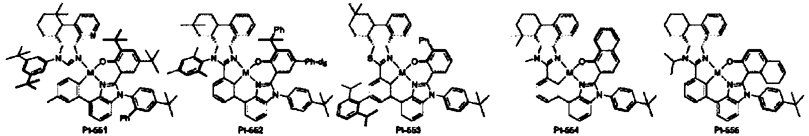 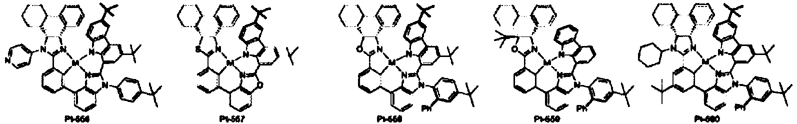 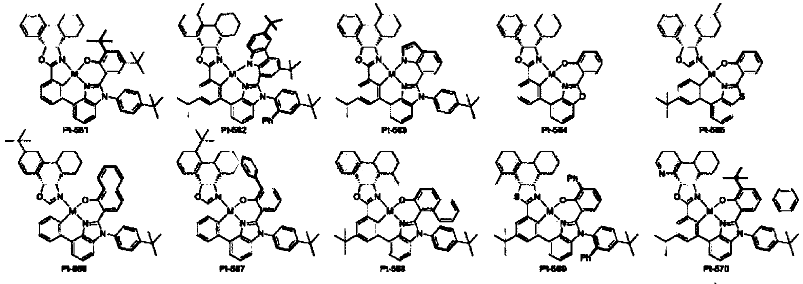 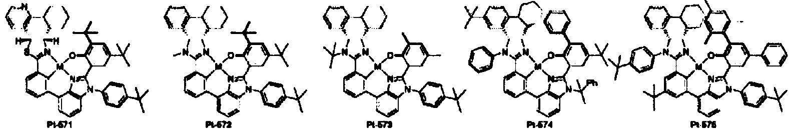 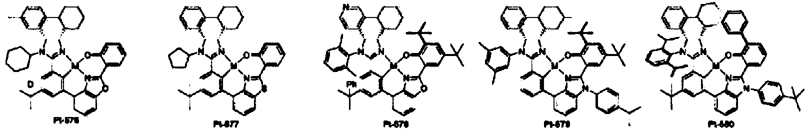 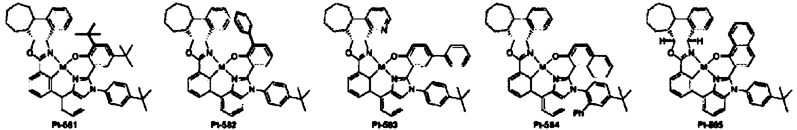 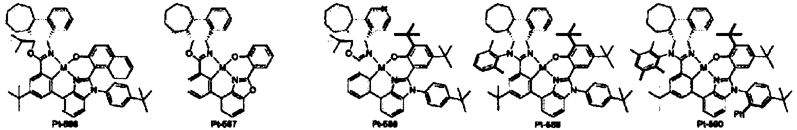 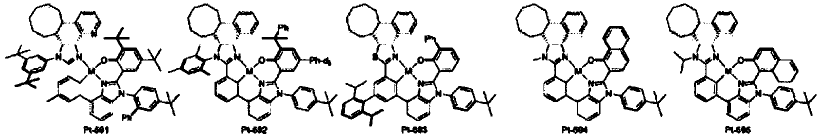 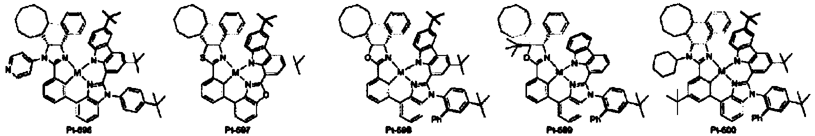 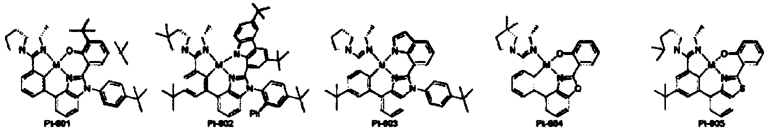 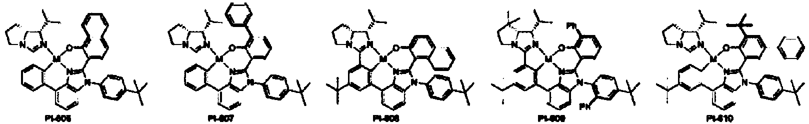 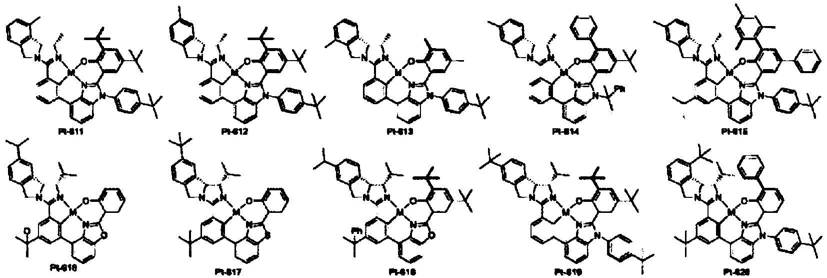 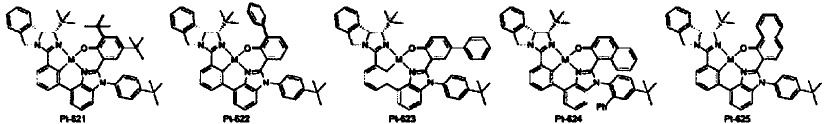 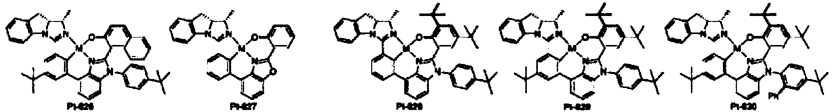 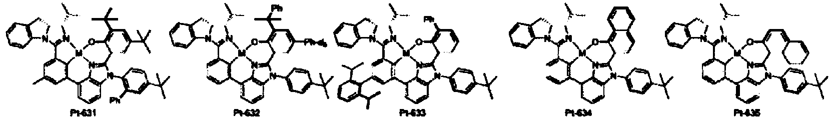 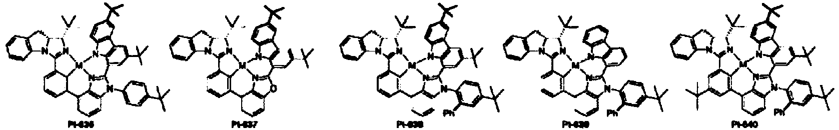 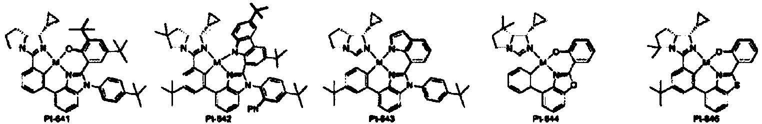 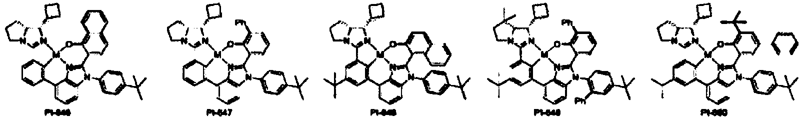 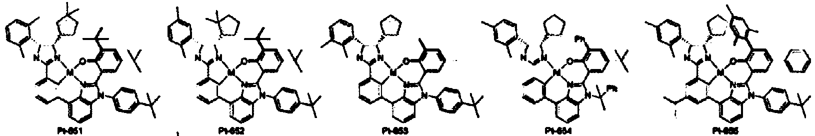 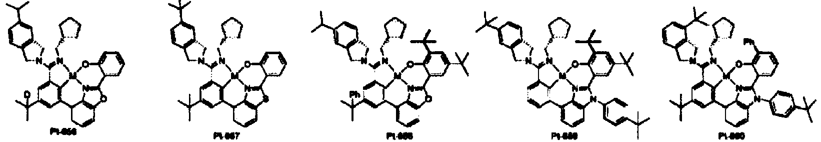 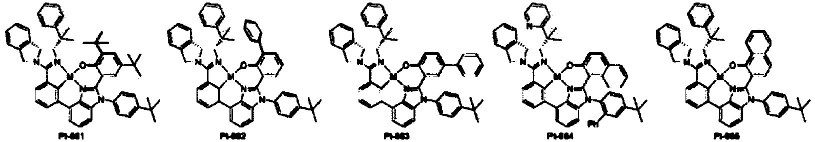 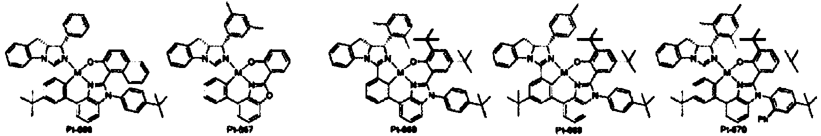 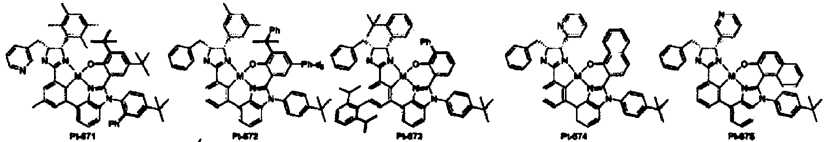 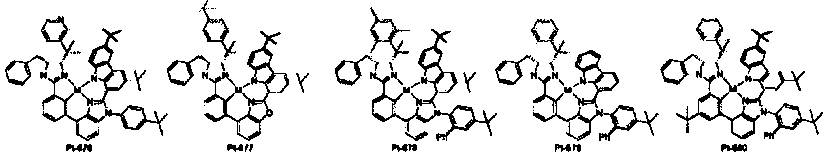 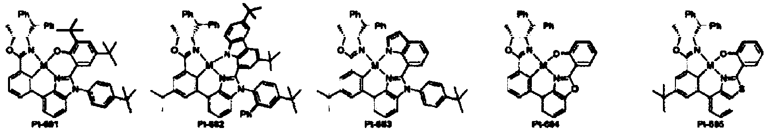 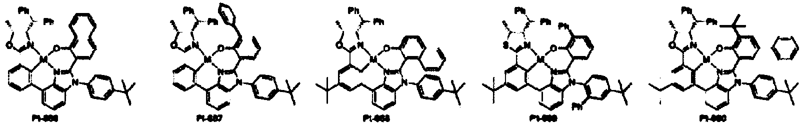 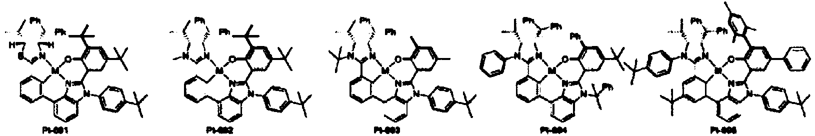 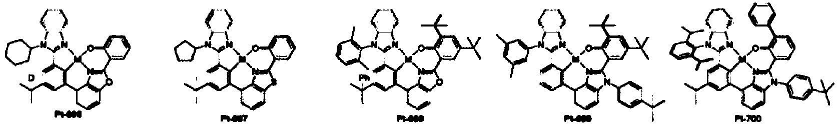 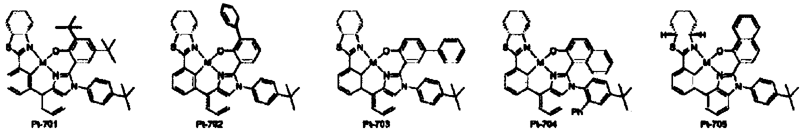 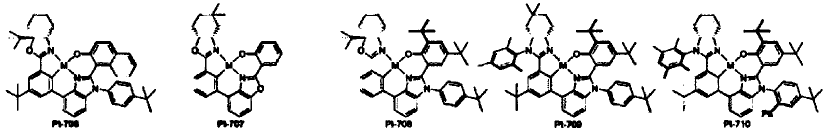 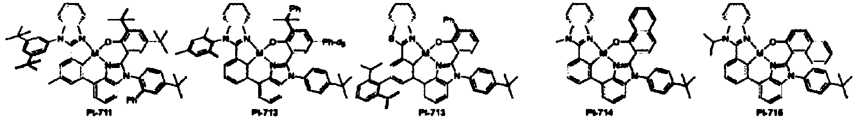 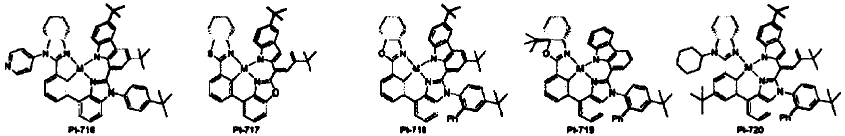 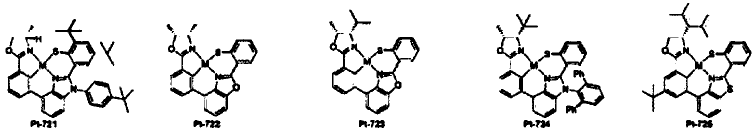 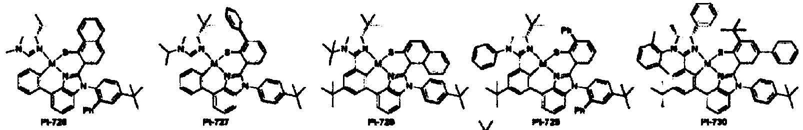 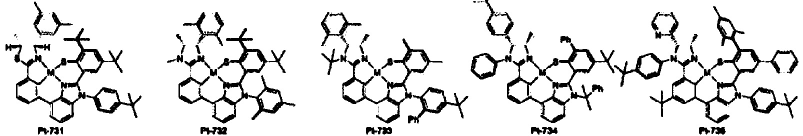 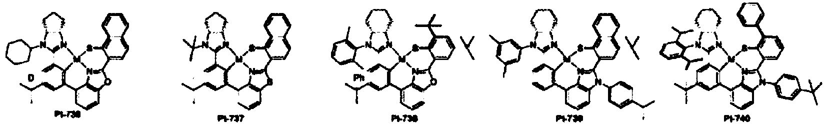 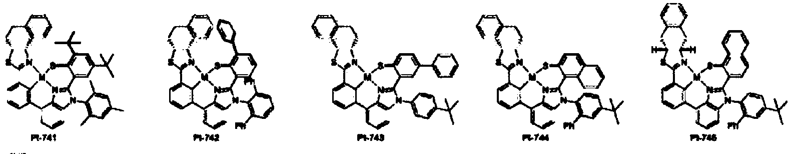 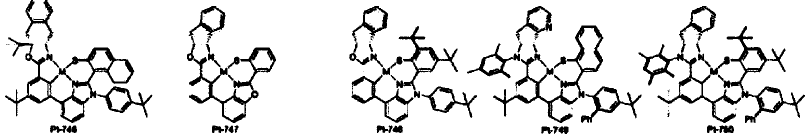 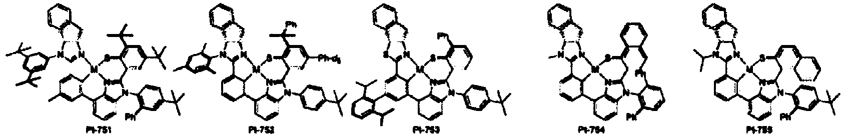 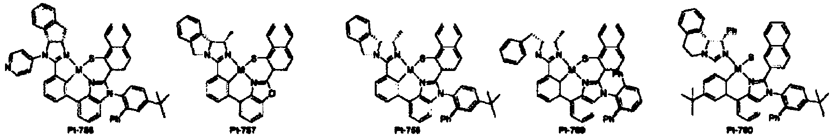 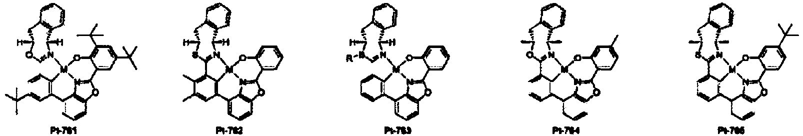 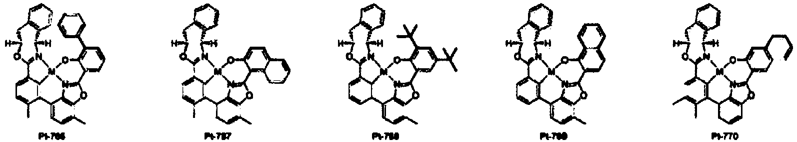 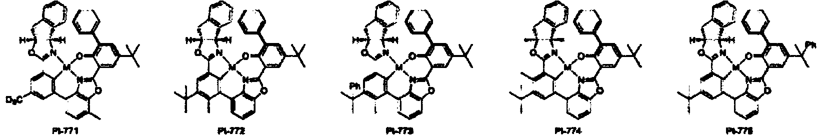 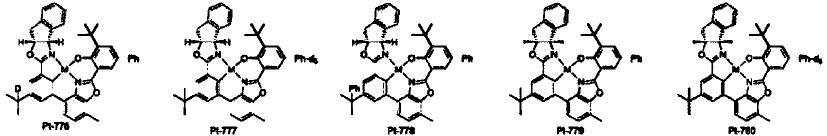 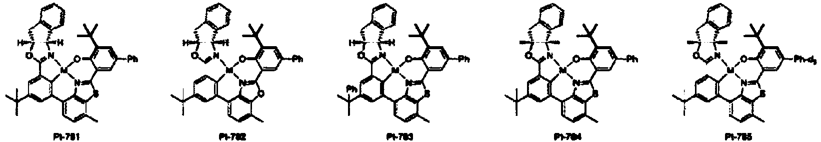 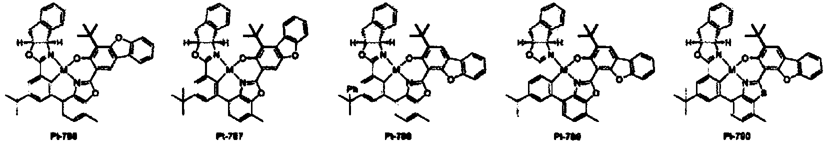 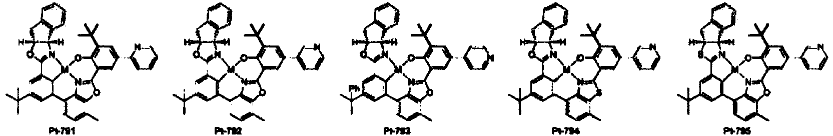 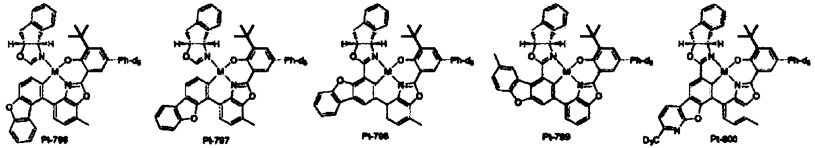 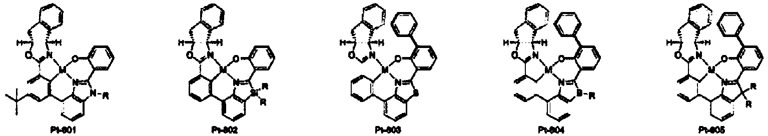 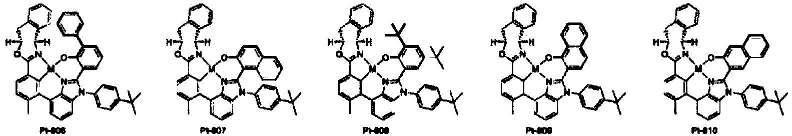 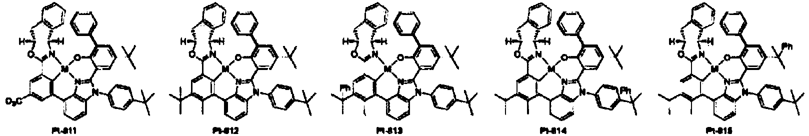 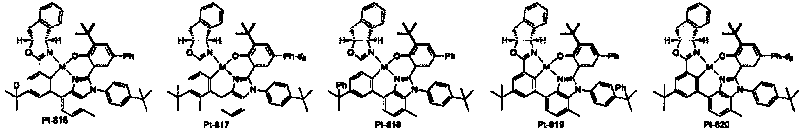 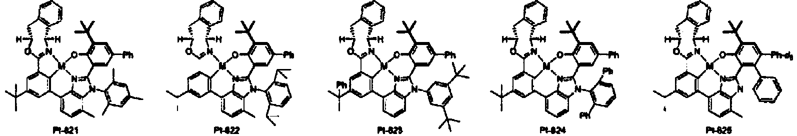 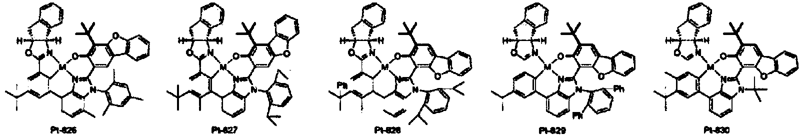 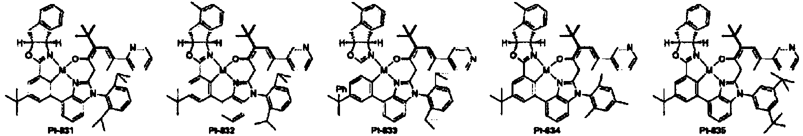 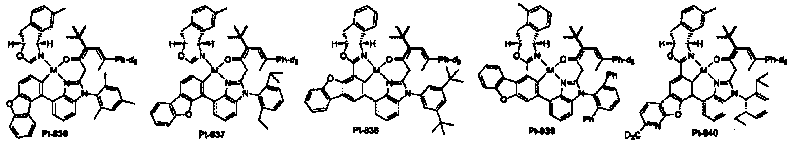 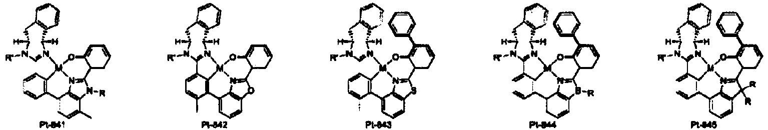 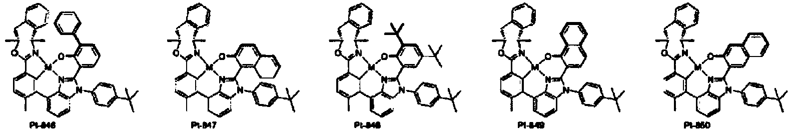 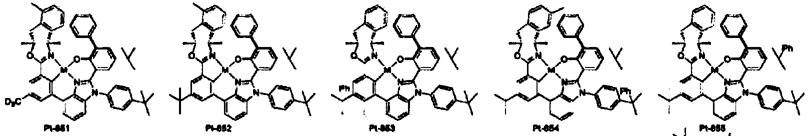 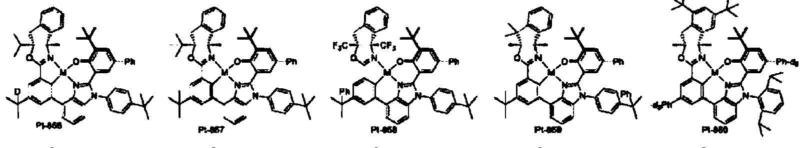 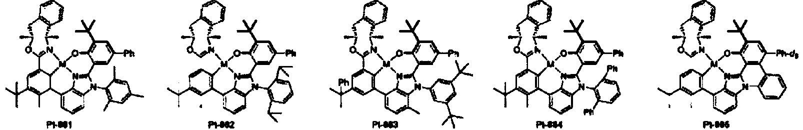 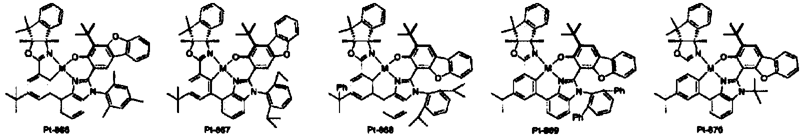 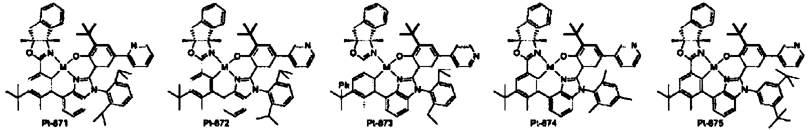 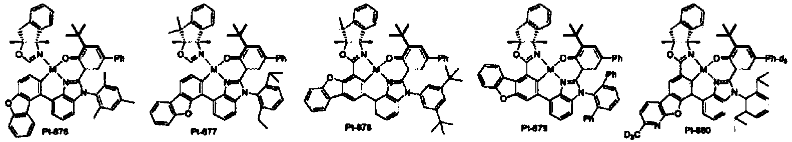 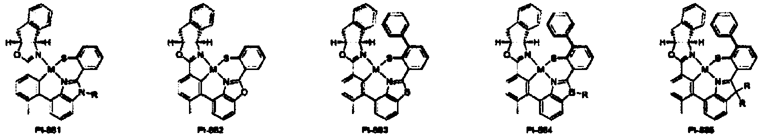 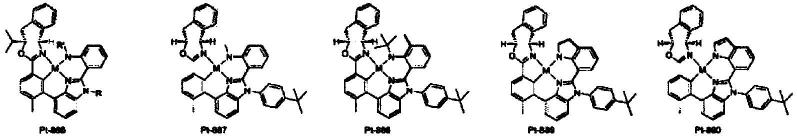 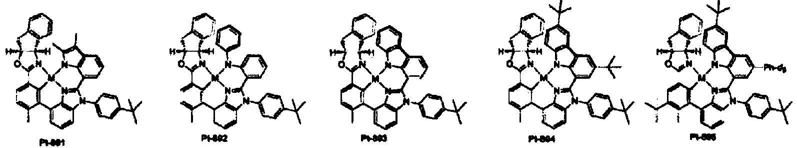 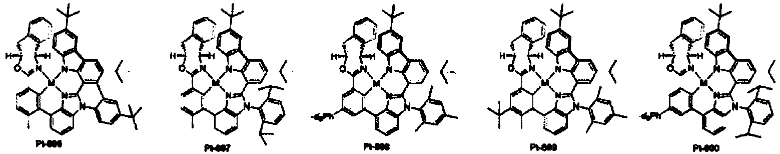 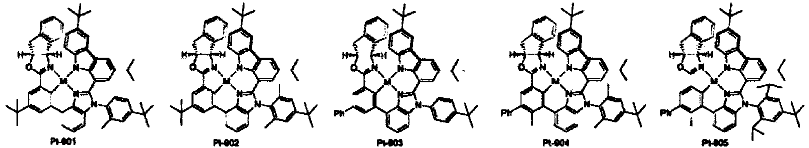 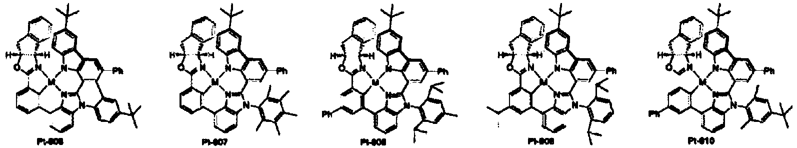 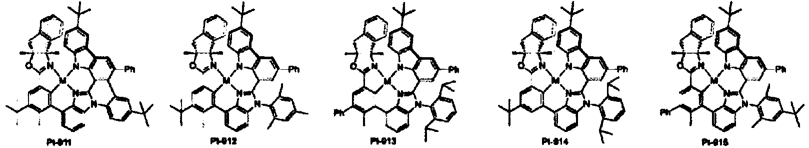 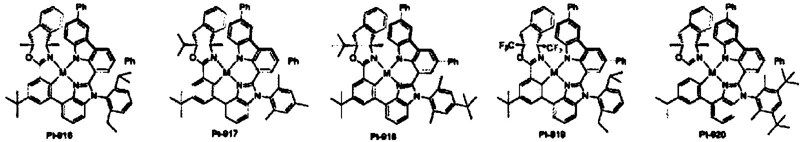 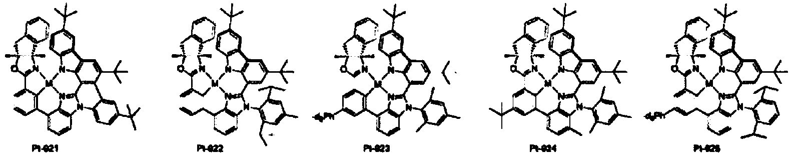 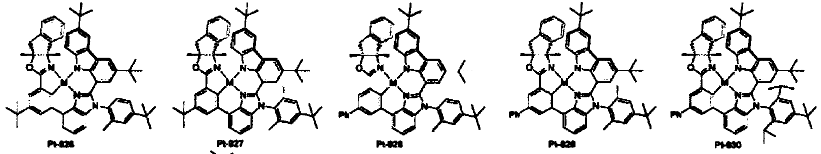 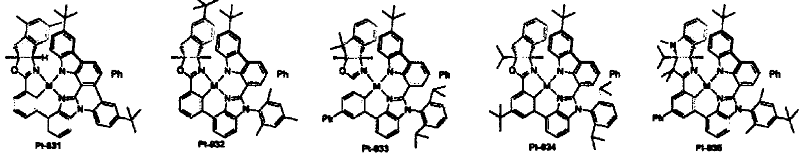 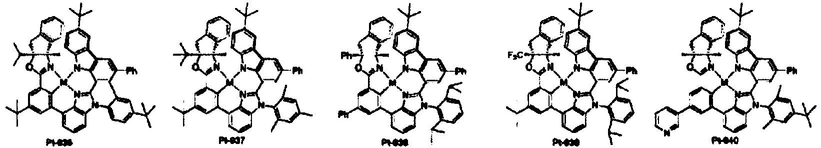 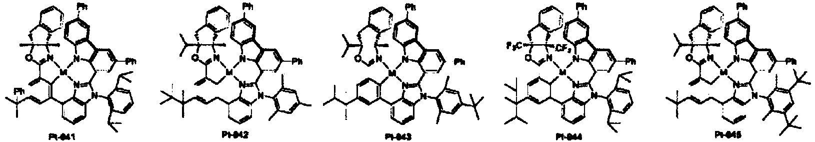 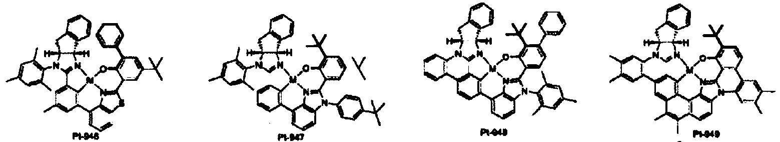 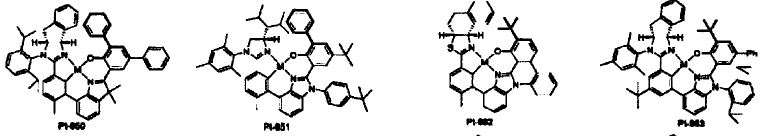 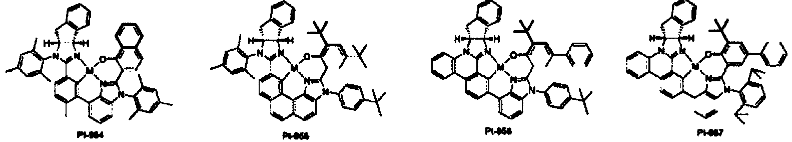 dans lequel M est Pt ou Pd ; R et R' sont chacun indépendamment un atome d'hydrogène, un atome de deutérium, un halogène, un groupe alkyle, un groupe cycloalkyle, un groupe aryle, un groupe hétéroalkyle, un groupe hétérocycloalkyle, un groupe hétéroaryle, un groupe haloalkyle, un groupe haloaryle, un groupe halohétéroaryle, un groupe alcoxy, un groupe aryloxy, un groupe alcényle, un groupe cycloalcényle, un groupe alcynyle, un groupe hydroxy, un groupe mercapto, un groupe nitro, un groupe cyano, un groupe amino, un groupe mono- ou dialkylamino, un groupe mono- ou diarylamino, un groupe ester, un groupe nitrile, un groupe isonitrile, un groupe hétéroaryle, un groupe alcoxycarbonyle, un groupe amido, un groupe alcoxycarbonylamino, un groupe aryloxycarbonylamino, un groupe sulfonylamino, un groupe sulfamoyle, un groupe carbamoyle, un groupe alkylthio, un groupe sulfinyle, un groupe uréido, un groupe phosphoryle amino, un groupe imino, un groupe sulfo, un groupe carboxy, un groupe hydrazino, un groupe silyle substitué.

6. Utilisation du matériau électroluminescent à polarisation circulaire à base de complexe de platine (II) et de palladium (II) tétradentate cyclométallé hélico-chiral selon l'une quelconque des revendications 1 à 5 dans un dispositif électroluminescent, un dispositif d'affichage 3D, un dispositif d'imagerie tridimensionnelle, un dispositif de chiffrement d'informations optique, un dispositif de stockage d'informations, un dispositif d'imagerie biologique.

7. Utilisation selon la revendication 6, dans laquelle le dispositif électroluminescent est une diode électroluminescente ou une cellule électrochimique électroluminescente.

8. Afficheur couleurs comprenant un dispositif électroluminescent, dans lequel le dispositif électroluminescent comprend le matériau électroluminescent à polarisation circulaire à base de complexe de platine (II) et de palladium (II) tétradentate cyclométallé hélico-chiral selon l'une quelconque des revendications 1 à 5.

9. Dispositif d'affichage électroluminescent comprenant un dispositif électroluminescent, dans lequel le dispositif électroluminescent comprend le matériau électroluminescent à polarisation circulaire à base de complexe de platine (II) et de palladium (II) tétradentate cyclométallé hélico-chiral selon l'une quelconque des revendications 1 à 5.

10. Utilisation selon la revendication 7, dans laquelle le dispositif électroluminescent comprend une première électrode, une deuxième électrode et au moins une couche organique disposée entre la première électrode et la deuxième électrode, la couche organique comprenant le matériau électroluminescent à polarisation circulaire à base de complexe de platine (II) et de palladium (II) tétradentate cyclométallé hélico-chiral selon la revendication 1.

11. Appareil d'affichage comprenant un dispositif électroluminescent organique, dans lequel le dispositif électroluminescent organique comprend une première électrode, une deuxième électrode, et au moins une couche organique disposée entre la première électrode et la deuxième électrode, la couche organique comprenant le matériau électroluminescent à polarisation circulaire à base de complexe de platine (II) et de palladium (II) tétradentate cyclométallé hélico-chiral selon l'une quelconque des revendications 1 à 5.
